(19) Europäisches Patentamt
European Patent Office
Office européen des brevets

(11) Publication number: **0 153 479 B1**

(12) # EUROPEAN PATENT SPECIFICATION

(45) Date of publication of patent specification: **04.09.91**

(51) Int. Cl.$^5$: **G01R 23/00**, G06F 15/20

(21) Application number: **84115608.6**

(22) Date of filing: **17.12.84**

(54) **Data processing system.**

(30) Priority: **09.01.84 US 569531**

(43) Date of publication of application:
**04.09.85 Bulletin 85/36**

(45) Publication of the grant of the patent:
**04.09.91 Bulletin 91/36**

(84) Designated Contracting States:
**DE FR GB**

(56) References cited:
**DE-A- 2 713 337**

**TEKTRONIX-Katalog 1983, pages 68, 259**

(73) Proprietor: **Hewlett-Packard Company**
**Mail Stop 20 B-O, 3000 Hanover Street**
**Palo Alto, California 94304(US)**

(72) Inventor: **Cannon, Wayne C.**
**6281 Anderson Road**
**Forestville, CA 95436(CA)**
Inventor: **Donecker, S. Bruce**
**4920 Burnside Road**
**Sebastopol, CA 95472(CA)**
Inventor: **Neering, Michael J.**
**3523 Shallow Creek Drive**
**Santa Rosa, CA 95404(CA)**

(74) Representative: **KOHLER SCHMID + PARTNER**
**Patentanwälte**
**Ruppmannstrasse 27**
**W-7000 Stuttgart 80(DE)**

**EP 0 153 479 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a data processing system in accordance with the precharacterizing part of claim 1.

Such a system is known from US Patent 42 440 24. In the known system the input of a measurement parameter is started by pressing a parameter key such as "center frequency", and the desired value may be entered subsequently via numeric keys. The entry process is terminated by striking one of a selection of terminator keys each defining a selection of power-of-ten multiples or fractional parts of measurement units such as kHz, msec, and mV to be associated with the entered numerical value.

TEK products 1983, Tektronix Inc. 1982, p. 68 and 259 describes an oscilloscope which enables plural traces to be displayed. However, this publication nowhere discloses or suggests that the traces can be displayed side-by-side. Also, the displayed variable only concerns a single independent variable displayed along a time axis as abscissa. Accordingly all over-and-under traces have the same independent variable.

Relative to the prior art in accordance with US-P-42 440 24, it is an object of the present invention to improve a data processing system in such a manner that a numeric value is automatically terminated with the proper exponent, including the proper parameter units, indicating the weight to be applied to an entered numeric value.

This object is, according to the invention solved by the features specified in claim 1.

The dependent claims characterize advantageous developments thereof.

The control panel uses a number of buttons arranged in a unique hierarcical structure to specify the complete measurement process. Several control buttons are dedicated for functions most commonly used in typical measurement applications, while less common functions are available through a series of logical menus which are accessed via several "softkeys" under control of internal firmware. Altogether, over 70 menus with over 320 functions can be reached by means of the softkeys to provide a wide range of measurements.

The present data processing system is incorporated in a vector network analyzer containing intermediate frequency (IF), signal processing, internal computing, and display circuitry, plus the operating panel. A complete measurement system in addition includes a radio frequency (RF) test set, microwave to IF frequency conversion circuitry, and a source of RF signals, such as a synthesized or swept oscillator.

The main analyzer includes a display having a variety of display modes including log and linear magnitude versus either frequency or time, linear phase, deviation from linear phase, group delay versus frequency, standard Smith Chart, compressed Smith Chart, expanded Smith Chart, inverted Smith Charts, and "Bull's Eye" polar chart. A variety of marker read out formats is also provided. Examples of the display flexibility provided include a split screen CRT with two independent formats or two responses overlaid on a common format. In addition, any or all of the CRT displays can be directly transferred to a digital printer or plotter without need of an external computer.

An embodiment of the invention will now be described in detail with reference to the accompanying drawings.

Figure 1 shows a simplified block diagram of an RF vector network analyzer;

Figure 2 shows a detailed block diagram of a portion of the RF vector network analyzer shown in figure 1;

Figures 3.1 through 3.7 show schematics for portions of the detailed block diagram as shown in figure 2;

Figure 4 shows the front panel controls of the RF vector network analyzer shown in figure 1;

Figure 5 shows a hierarical CPFR structure used in the RF vector network analyzer shown in figure 1;

Figures 6 through 15, 17, and 18 show several of the measurements which can be performed with the RF vector network analyzer shown in figure 1;

Figure 16 shows a coaxial line as measured and displayed in figure 15;

Figure 19 shows the software signal processing flow used in the RF vector network analyzer shown in figure 1; and

Figure 20 shows the software process controller used in the RF vector network analyzer shown in figure 1.

Figure 1 shows a block diagram of an RF vector network analyzer system. The measurement system consists first of a main network analyzer 101 with a second IF/detector section 103 and a data processor/display section 105. The main network analyzer 101 is fed by one of four configured test sets 107 which provide the signal separation circuitry 108 and a first IF frequency conversion circuitry 113 for reflection/transmission (one incident signal) or S-parameter (two incident signals) measurements up to either 18 or 26.5 GHz. The frequency converter 113 alone is also available to permit the addition of user supplied signal separation devices 108 for specially configured test needs. The third main component of the measurement system is a compatible RF source 109 such as an HP 8340A synthesized sweeper, available from the Hewlett-Packard Co., Palo Alto, California, which can be used in either a stepped frequency mode, in which synthesizer class frequency accuracy and repeatability can be obtained by phase locking the source 109 at each of the over 400 frequency steps over the frequency range selected by the main analyzer 101 or the swept frequency mode for applications where extreme frequency range, high stability, and spectral purity are important such as in narrow band measurements over sweeps of less than 5 MHz. An HP 8350B sweeper with HP 83500 series RF plug-ins covering the entire desired frequency range or with lesser spans can also be used in applications where a more economical source is sufficient. Both the HP 8340A and the HP 8350B include the necessary analog interface signals as well as full digital handshake compatibility with the main analyzer 101. This digital handshake compatibility allows the main analyzer 101 to act as the controller for the entire system by directly managing the source 109 to provide all of the inputs such as start frequency, stop frequency, centering, span, and modulation, as well as constraints that the source 109 normally places on itself internally. Therefore, the user need only be concerned with his interface to the main analyzer 101 and can use any source 109 that has implemented the required handshake protocols. Because the main analyzer 101 is in control of the source 109, it is also possible to automatically select a different frequency range or mode (stepped or swept) to be applied to each of the ports 1 and 2.

Integrated within each test set 107 is the first IF frequency converter 113 with three channels 113a, 113b, and 113c for reflection/transmission measurements and four channels 113a, 113b, 113c, and 113d for S-parameter measurements. RF to IF conversion is achieved through a sampling technique equivalent to harmonic mixing. An harmonic of a tunable local oscillator 115 is produced by an harmonic generator 116 to mix with the incoming RF signal to provide the first IF signal at 20 MHz for the incident signal a1 on the input port 1, the incident signal a2 on the output port 2, the reflected or transmitted signal b1 on the input port 1, and the reflected or transmitted signal b2 on the output port 2. Frequency tuning for the local oscillator 115 is controlled by a phase lock loop 117 that compares the signal a1 or a2 in the reference channel first IF to an IF reference oscillator 119 in the IF/detector section 103. Any difference between the frequency of the signal a1 or a2 in the reference channel first IF and the IF reference oscillator 119 results in an error voltage on the error voltage signal line 121 via switch 123 that tunes the local oscillator 115 to the frequency that produces the desired first IF. Switch 123 is toggled to select the most appropriate signal a1 or a2 to lock on to based either on internal criteria within the system or as defined by the user. When using the internal criteria, if the incident signal port is port 1, a1 is selected by switch 123, and if the incident signal port is port 2, a2 is selected by switch 123. This scheme allows the local oscilator 115 to track the incoming RF when the RF frequency is changing with time as in the swept mode. The integrated test set 107 permits high RF to first IF conversion efficiency even at 26.5 GHz, making possible both high sensitivity and wide dynamic range measurements. The test set architecture eliminates the extensive RF switching needed in previous test sets, removing the significant uncertainties caused by the lack of repeatability of mechanical switches. The reflection/transmission test sets 107 require no internal switching since the fourth channel 113d is not required, and the S-parameter test sets 107 use only one electronic PIN diode switch located inside of the test set 108 such that it cannot contribute to uncertainties as it is switched prior to the ratio node of the power splitter.

Several concepts have been incorporated in the IF/detector section 103 of the main analyzer 101 to increase the precision of IF processing and signal detection. Most of the phase lock hardware 125 in the phase lock loop resides in this section 103. Harmonic mixing number and local oscillator pretuning are controlled digitally via lines 127 and 129 and offer phase lock and tracking performance that is precisely repeatable from sweep to sweep. Before the first IF signals proportional to a1, a2, b1, and b2 are sent to the synchronous detectors 131 and 133, they are down converted to a second IF at 100 KHz by mixers 138 and go through a pair of multiplexers 136 and variable gain amplifiers 134 in the second IF section 135. Amplifier gain is controlled and calibrated digitally and is varied by autoranging to optimize the second IF signal levels 130 and 132 available to the synchronous detectors 131 and 133 resulting in an order of magnitude improvement in signal to noise performance and dynamic accuracy for the detector output signals x1, y1, x2, and y2. Likewise, the synchronous detectors 131 and 133 employ a digital architecture that allows for precise control of their 90 degree phase shift function which results in improved accuracy as well as common mode rejection of local oscillator phase noise effects. Finally, the detected signals x1, y1, x2, and y2 are multiplexed with a sample-and-hold/multiplexer (MUX) 137 and then digitized by an analog-to-digital converter (ADC) 139 with 19 bits of resolution. Each ADC conversion takes approximately 40 microseconds and four readings are made for each RF frequency data point to provide the real and imaginary data for both the reference signal 130 and test signal 132.

The output of the ADC 139 is then passed on a 16 bit bus 141 to a high speed central processor (CPU) 143 which includes a microprocessor such as a Motorola 68000 as well as the associated microprocesor system interrupt and I/0 control circuitry. Because the CPU 143 is integrated into the main network analyzer 101 it is possible to utilize a multi-tasking architecture to make more efficient use of time than has previously been possible. This architectural integration also permits substantial increases in data processing flexibility and system control performance. Via a dedicated system interface and bus 145, the CPU 143 controls the RF source 109, the test set 107, and, along with the sample selection and timing circuitry 146, all of the IF processing functions including the phase lock hardware 125, autoranging in the IF amplifiers 134, detection by the synchronous detectors 131 and 133, and digitization by the ADC 139. The CPU 143 periodically initiates a self calibration sequence for the IF amplifiers 134, synchronous detectors 131 and 133, and the ABC 139 and the resulting gain, offset, and circularity changes are stored in memory 147, so that the changes in the IF amplifiers 134 can be subtracted from measured results. The CPU 143 also performs all data processing functions for the system. The signals in the IF section 103 are detected as linear real and imaginary components of a vector quantity and the CPU 143 processes the detected data into a variety of formats for presentation on the CRT display 149. By digitally computing the various measurement formats, improvements in dynamic range and meaningful resolution are gained over traditional analog circuit processing techniques.

With the known network analyzer systems, an external computer was required in order to characterize and remove systematic errors. With the present RF vector network analyzer, this capability exists internally with enough storage capacity (i.e., 256K bytes of random access memory (RAM) and 256K bytes of bubble memory) in the memory 147 to retain up to two 401 point 12-term error corrected traces of data. In addition, the measured data can be converted to show the response of the DUT 111 as a function of time (time domain) using an internal Fourier transform process. All data processing takes place virtually in real time by means of parallel data processing in the CPU 143 aided by the incorporation of a dedicated, floating point, complex number, vector math processor 151 designed specifically for fast vector computations. The multiplication of two complex numbers by the vector math processor 151 requires only one operation with the product available within 20 microseconds, so that error corrected measurement results are available 1000 times faster than in the prior art. By means of an internal vector graphics generator 153, the real time processed data is then immediately presented on the CRT 149, on a digital printer/plotter 155, or via an IEEE-488 (HP-IB) interface and bus 157 to external devices. Present as well as past states of front panel controls 159, past and present traces of data, and entire system calibrations can also be stored in and recalled from the memory 147 or loaded and read from a built-in tape drive 161 by means of the system 203 interface and bus 215 (Fig.2) of the CPU 143.

As explained previously and shown in more detail in figure 2, the built-in CPU 143 with its 16-bit multitasking microprocessor 201, I/O interface circuitry 203, and interrupt system and I/O control circuitry 205, and the vector math processor 151 with its math processor circuitry 207 and math controller 209 are key to the high speed performance of the present RF vector network analyzer.

To insure maximum processing speed, processing power is distributed among several internal controllers in addition to the microprocessor 201 and the math processor 207. Similarly, both the system bus 145 and the external HP-IB bus 157 have their own internal processors 221 and 223. Finally, controllers 225, 227, and 229 are dedicated to the tape drive 161, the bubble memory 235 within memory 147, and the front panel 159 respectively.

Figures 3.1 through 3.7 show detailed schematics of portions of the block diagram shown in figure 2. The front panel interface 229 is shown on figures 3.2-3.3 and the remainder of the front panel 159 is shown on figures 3.5-3.7.

Figure 4 shows the front panel 159 of the present RF vector network analyzer with capability to set up and control two independent measurements with two measurement channels selected by channel buttons 405 and 407. When the indicator 401 or 403 above the channel buttons 405 and 407 is lit, the respective channel is selected as the channel controlled by the front panel 159. The CRT 149 is also available for viewing on the front panel 159. Annotation on the CRT 149 includes graticules if desired, labels for one or two data side by side or overlaid data traces, reference line position symbols, and channel labels for the parameter being shown, the format of the display, reference line value, horizontal and vertical scales, and the value of any markers being used. Source frequency or other stimulus information is shown on the CRT 149. An active entry menu area 409 in which no data traces are displayed is also provided on the CRT 149 for identification of the current active functions which may be selected via the CRT softkeys 411. The softkeys 411 therefore extend the accessable instrument capabilities by adding selectable functions without adding to front panel complexity. An Entry Off key 413 clears the active entry state. Prompts, indications of instrument functions, procedural instructions, error messages, and procedural advisories also appear on the CRT 149. If a message is important to the measurement, a beep sound signals the operator to look at the message. A title area 415 is also provided for up to 50 characters of information about the measurement beng viewed. To use the title function, the Auxiliary Menus System button 417 is pressed, followed by one of the softkeys 411 which will be labeled Title. The RPG knob 419 is then rotated to position an arrow symbol below the first letter desired and displayed on the CRT 149. The user then presses a Select Letter softkey 411 and the selected letter will appear in the title area 415. This process is repeated as desired along with desired Space softkeys 411 and Backspace keys 411, terminated with the Done softkey 411 and cleared with the Clear Softkey 411.

All basic measurement functions are controlled by the four groups of keys (SPFR) labeled Stimulus 423, Parameter 425, Format 427, and Response 429 which respectively are used to set the stimulus, select the parameter, select the format, and adjust the response for the desired measurement. The Stimulus keys 423 provide direct control of the source 109 to set the frequencies, source power, sweep time, and other related functions. The Parameter keys 425 select the parameter to be measured. With the source 109 applied to port 1, $S_{11}$ is selected for reflection (return loss) and $S_{21}$ is selected for transmission (insertion loss or gain). Likewise, with the source 109 applied to port 2, $S_{22}$ is selected for reflection and $S_{12}$ is selected for transmission. Appropriate control of the test set 107 is enabled automatically depending on the parameter selected. The Format keys 427 place measured parameter data in the desired format: logarithmic (dB), phase, group delay, and Smith Chart, or, alternatively, SWR, linear magnitude, R + jX impedance, and others. The Response keys 429 set the scale per division, reference value, or reference position, or let the AUTO function via the Auto key 430 automatically place all the measured data on the entire display 149 with pleasing values for a reference value and scale. Additional Response functions include averaging, smoothing, and an electronic line stretcher.

An hierarchical Channel-Parameter-Format-Response (CPFR) structure as shown in figure 5 is used in the present invention. Once a particular path through the CPFR structure has been chosen, this path is stored in the memory 147 for later reference. Then, when one of the CPFR structure items is changed, such as changing the Parameter from $S_{11}$ to $S_{22}$, the entire path previously associated with the new item is automatically reestablished for use by the entire system. Thus, for example, if Channel 1 is presently being used to measure the Parameter $S_{11}$ with the display in log magnitude Format and a 0.2 dB/division vertical Scale, and if Channel 1 was previously used to measure the Parameter $S_{22}$ with the display in linear magnitude Format and a 5 milliunits/division vertical Scale, then when the Parameter is changed from $S_{11}$ to $S_{22}$ the Format automatically changes from log magnitude to linear magnitude and the Scale automatically changes from 0.2 dB/division to 5 milliunits/division. In addition, since the CPFR structure is an hierarchical tree and since Parameters are lower in the hierarchy than Channels, the Channel number will not be changed when the Parameter is changed as in the present example. Similarly, if the Channel is changed, the Parameter, Format, and Response are all subject to automatic reestablishment, and if only the Format is changed, only the Response is subject to automatic reestablishment. Naturally, any of the CPFR values may be altered from the front panel 159 as desired by the user. The result of this hierarchical CPFR structure is a substantial added degree of speed and convenience for the user.

The numeric Entry keys 431 are used when a numeric value is to be entered, which entered value is terminated by one of the four terminator keys G/n 433, M/u 435, k/m 437 and x1 439. The four terminator keys 433-439 are used when the entered value being terminated has the order of magnitude respectively of either Giga ($10^{+9}$) or nano ($10^{-9}$), Mega ($10^{+6}$) or micro ($10^{-6}$), kilo ($10^{+3}$) or milli ($10^{-3}$), or a basic unit ($10^{0}$) such as dB, degree, second or hertz. No particular set of measurement units is permanently assigned to any of the four terminator keys 433-439.

Pressing the Save key 441 followed by one of the CRT softkeys 411 saves the current complete state of the network analyzer 101, and the controlled functions of the source 109 and the test set 107. The Recall key 443 followed by a CRT softkey 411 is used to recall the previously stored instrument state. The hierarchical CPFR structure is an integral part of the instrument state.

The Tape key 469 in the Auxiliary Menu Block 471 displays labels in area 409 for controlling the internal tape drive 241. The tape functions allow initialization of cassette tapes, storing data to tape, loading data from tape, deleting data on tape, erasing the last deletion of data, and display of a directory of tape contents on the CRT 149. When measurement data is loaded from tape to any point in the Data Processing path, the display on the CRT 149 is updated to show the loaded data with subsequent data processing. Tape data can be a combination of any of the following:

1. Measurement data after second IF and detector correction (raw data), after error correction and/or time domain conversion (data), or after formatting (formatted data) for either or both measurement channels.
2. Memory data stored after time domain conversion and before formatting from an earlier measurement, individually or all at once.
3. Graphics that the user has created on the CRT 149 Figure 4.

4. One or all sets of machine states stored by pressing the Save key 441 Figure 4.
5. One or all sets of error coefficients measured and stored by pressing the CAL key 457, and the subsequent Calibrate softkeys 411 labeled in the area 409.
6. One or all sets of calibration standard descriptions (Cal Kits).
7. A complete machine dump consisting of all sets of all data described in 1 through 6.
8. System, service, or demo software, including options, revised versions, and new software.

If an external device has control of the system using the HP-IB interface 157, pressing the Local key 445 returns control of the system to the front panel 159.

The Restart key 447 is used to restart any previously started measurement or data handling operation such as sweeping or averaging.

Three blocks of the front panel keys along with the softkeys 411 provide an additional feature called MENUS for functions which are used less frequently than the functions to which dedicated keys are assigned. The four Menu keys 449, 451, 453, and 455 provide extensions of the SPFR keys 423, 425, 247 and 429; the keys labeled Cal 457, Domain 459, Display 461, and Marker 463 in the Menus blocks allow selection of various measurement and display modes; and the keys labeled Copy 467, Tape 469, and System 417 under the Auxiliary Menus block 471 provide measurement related input and output operations. Shown in Appendix A is an example which illustrates the various MENUS along with the softkey labels, shown in quotation marks, as displayed in the menu area 409 of the CRT 149 opposite the related softkeys 411.

When a MENU is displayed on the CRT 149 any current choices are indicated by a line under the labels and mutually exclusive and/or closely related choices are connected by dots. Pressing the softkey 411 beside any label in area 409 either executes the function or presents another set of MENU labels. If the selected function requests an input, the RPG knob 419 and Entry keys 431 are used to respond. Addtional functions are selected by pressing another key. A Prior Menu key 473 is used to return to the previously displayed MENU in a series of menus. If the previously displayed MENU was the first in a series of MENUS, the MENU is cleared from the CRT 149.

Several of the wide variety of displays available either on the CRT 149 or on the printer/plotter 155 are shown in Figures 6 through 15, 17 and 18. Figure 6 shows a typical dual trace measurement of two different parameters $S_{11}$ and $S_{12}$ signified by trace number 601 and 602 respectively with the same log magnitude format used for example to adjust a circulator's impedance and isolation simultaneously in real time. Figure 7 shows two overlaid traces 701 and 702 for ports 2 and 3 respectively of a three port multiphase filter. Figure 8 shows a single trace of an amplifier and an attenuator combined to show the total closed loop response of the active circuit. Figure 9 shows a measurement trace of the same active amplifier as in figure 8 calibrated in a user defined reference plane with an electrical delay of 6.0421 nanoseconds making use of the electronic line stretcher. Figure 10 shows a unique split screen of two simultaneous measurements of two different parameters $S_{11}$ and $S_{21}$ as displayed on the CRT 149. Figure 11 shows another version of the split screen display, split to simultaneously show the response of a surface accoustical wave filter (SAW device) in both the frequency and time domains. Note the appearance of the triple travel peak 1101 on the time domain response. Figure 12 shows two different parameters displayed with two different formats (i.e., SWR and deviation from linear phase) for traces 1201 and 1202. Figure 13 shows a previous measured trace 1301 from "memory" and the current measurement trace 1302 of the same parameter $S_{21}$ which can be used for matching transmission lines to within 0.01 degrees. Figure 14 shows the display of group delay for a typical RF communications filter which with the present invention can be viewed and adjusted for optimum group delay flatness in real time. Figure 15 shows a linear display of an RF circuit in the transformed time domain along with a series of five markers 1501-1505 to mark the five different corresponding discontinuities respectively (i.e., connector 1601, connector 1602, adapter 1603, connector 1604, and termination 1606) of a coaxial line 1610 as shown in Figure 16 . Figure 17 shows a split screen of two polar plots as displayed simultaneously on the CRT 149. Each of the Figures 6 through 15 and 17 are displays of actual RF divices as shown in real time on the CRT 149. These same displays can also be printed on the printer/plotter 155 as they are shown on the CRT 149 with whatever size change is desired and in a variety of colors. If desired, various of the CRT displays can also be combined on the printer/plotter 155 as a four quadrant plot as shown in Figure 18.

Up to five different markers for the traces on the CRT 149 are accessed via the Marker key 463 along with the softkeys 411 as shown in figure 15 by markers 1501-1505. The markers are controlled in a number of different ways. The numeric entry keys 431 are used to set the markers to an exact numeric position, the RPG knob 419 is used to move the markers along the traces on the CRT 149, the up Step key 475 and the Down Step key 477 move the markers right and left one horizontal division. The precise value of the marker position is also immediately displayed on the CRT 149 as shown in figure 8 by marker 801 and the displayed value 802. The marker annotation is displayed adjacent to the marker 801. In addition, as the markers are moved along the traces, the marker annotation moves with the markers so that the user can always immediately identify which marker and related annotation is which. A further function available through the softkeys 411 is Delta Markers for reading the difference in the trace value between an Reference Marker and a Delta Marker as shown by markers 703 and 706 in figure 7. The RPG knob 419 is used to sequentially position the Reference Marker and the Delta Marker and the difference in trace value is immediately displayed on the CRT 149. Also available with the aid of the softkeys 411 are Marker to Minimum and Marker to Maximum functions to move a selected marker to the minimum or maximum value of the displayed trace as shown by markers 1001 and 1002 in figure 10. A further function is the display of marker frequency, as shown in Figure 10, or other stimulus value, as shown in Figure 15.

The equal marker key 479 enters the current stimulus or amplitude value, as appropriate, of the most recently active marker for the current active function. For example, selecting the reference value key (429 Figure 4) followed by the equal marker key 479 causes the amplitude of the marker to be entered for the reference value. Similarly, selecting the stimulus start key (423 Figure 4) followed by the equal marker key 479 causes the frequency, or other stimulus value, of the marker to be entered for the start function.

Software Signal Processing

As shown in in figure 19, signal processing in the present invention begins at the output of the synchronous detector pair 131 and 133 which provide the real (X) and imaginary (Y) parts of the test and reference signals. Offset, gain, and quadrature errors are corrected for both of the IF/detector chains via software which is arranged as blocks IF gain test 2803 and IF Correction 2805. The resulting test and reference data is then ratioed in block 2807 to produce the appropriate S-parameters and stored in the Raw Array 2809. If requested by the user, subsequent data taken at the same frequency are averaged together in the IF Averaging block 2811 to lower system noise and thus enhance dynamic range.

While the Raw Array 2809 is continually filled under control of the data acquisition software which will be discussed shortly, the data processing software concurrently removes data from the Raw Array 2809 and performs additional signal processing. Using a one term model (vector frequency response normalization), a three term model (one port model), and up to a twelve term error correction model (comprehensive two port) of the microwave measurement hardware, the Vector Error Correction software 2813 in conjunction with the Vector Math Processor 151 provides corrected data through application of the Error Array 2815 to the Raw Array. Further data manipulation is provided as desired by the user through Gating 2817 along with the separate Gate Array 2879 Electrical Length/Reference Plane Extension 2821, and Parameter Conversion 2822. The corrected data may also be converted from the frequency domain to the time domain using Chirp Z transforms. Windows 2825 and Window Array 2827 are used to remove the ringing in time domain due to band limited frequency domain input signals and then using the Chirp Z transforms 2823 to transform into the time domain. The data in the Data Array 2829 may be stored into memory in the Memory Array 2833 and used in vector computations with data from a second device. Comparisons of present data (D) and memory data (M) is accomplished through vector computations to provide all four mathematical functions of $D^*M$, D/M, D + M, and D - M. Storage of the corrected and processed data D in the Data Array 2829 and the trace math data M in the Memory Array 2833 allows rapid response to the user when making format or trace math changes.

The vector data is then formatted in the Format block 2835 into magnitude, phase, group delay, or other formats as desired. Adjacent formatted points can then be combined if desired in the Smoothing block 2837. The resulting formatted data is stored into the Format Array 2839 which provides convenient access for scale and offset changes provided by the Scale block 2843. Markers are also applied as desired to the formatted data via the Marker Readout block 2841. Scaled data is stored in a Display Array 2845 in the Display Ram 217 from which the display generator 153 hardware repetitively creates a plot on the CRT 149 for a flicker-free display.

Input and output access is provided to and from all of the arrays via the HP-IB interface 157 and via tape 161 with S-parameters available from the Data Array 2829 in addition to other applicable arrays. Direct printer output for the printer 155 is made from the Format Array 2839. Direct plotter output for plotter 155 is made from the Display Array 2845. The user may also trade off the data update rate against the number of data points used by selecting resolutions from 51 to 401 points.

Selected parts of the operating software are shown in source code format in Appendix B. Appendix B also references publications defining the program languages used in the source code listings.

The software is structured as a multi-tasking system to provide a rapid data update rate by allowing data processing to take place when the data acquisition software is not busy. Overlying command and control tasks interleave data processing with data acquisition cycles to provide both two port error correction and dual channel display modes.

The software signal process discussed previously is controlled by a process structure as shown in figure 20. This process structure is one of the reasons the present invention can process RF data essentially in real time. For example, low priority processes such as controlling the source 109, controlling the test set 107, and formatting the display 149 are only performed when the data acquisition process is not busy. Previous systems would take data, process it completely through to the display and when the end of each sweep is reached, the processor had to wait for the hardware to reset. Instead, the present invention actually performs processing while the control functions such as resetting for a subsequent sweep or while switching S parameter are proceeding. The Command Sources 2901 accept user commands via the front panel 159 and the HP-IB interface 157, parses and converts the commands to a common internal command token regardless of source and puts the commands into a command queue 2903. The Command Processor 2905 takes the commands from the command queue 2903 and implements them. Any one time precomputation that will later improve run time efficiency is done at this time. The Command Processor 2905 modifies the instrument state and performs one time operations, such as updating a trace after a scale change, outputting an array of data, and copying the Data Array into the Memory Array. Based on the instrument state, Control 2907 is responsible for insuring that the desired data is acquired in the specified manner and conditions. This includes control of source 109, test set 107, phase lock 125, IF multiplexers 136, ADC 139, and set up of the data acquisition and processing. Swept and stepped, alternate and chopped, single and continuous signal sweeps are implemented within Control 2907. Sweep maintenance is also managed in the Control 2907 to keep track of bandcrossings and frequency stepping. Acquisition 2909 services the ABC 139 interrupt, IF gain auto-ranging, ratioing, averaging and storing data into the Raw Array 2809. Processing 2911 processes data from the Raw Array 2809 until the data are displayed on the CRT 149 including vector error correction of external errors, parameter conversion, (gating, windowing, and transformation), trace math (D*M, D/M, D + M, D - M), formatting (log, linear, and delay), and response (scale, reference value, and split screen).

The machine state variables that are used to derive control variables 2913 include: parameter descriptions such as test set set-up, receiver set-up, and ratio/non-ratio; user selections for frequency, power, sweep time, formats, scale per division, averaging information, number of points to be taken, error correction type, and time domain factors; and, internal housekeeping pointers to the raw data error coefficients, corrected data, formatted data, memory data, and display data arrays. Acquisition variables 2915 provide data reduced from the control variables 2913 for efficiency that are related to controlling the ADC 139 until the data is stored in the raw array. The Acquisition variables 2915 include: IF gain, receiver error, ratioing, averaging, and current pointer poisition in the raw array. The Processing variables 2917 provide data reduced from the group control variables for efficiency that are related to controlling the processing of data from the raw array through the display. The Processing variables 2917 include: current position pointers for the arrays, error correction type, time domain information, trace math, format, and response. The Signals 2919 provide synchronization between programs that otherwise function independently of one another.

## APPENDIX A

## EXAMPLE OF A MENU DISPLAY

```
REDEF_NUM2_MENU

===========

"100 KHZ"+sk-bracket-8
"TEST CAL"

===========

"100 KHZ"
"REF CAL"

===========

"DETECTOR"
"GROUND"

===========

"ADC GROUND"

===========

"VCAL"

===========

"VREF"

===========

"TEMP. 1"

===========

"TEMP. 2"

===========
```

## APPENDIX B

## SELECTED PARTS OF SOURCE CODE LISTINGS OF OPERATING SOFTWARE

Programming Languages:

Algol: see Algol R Manual, Hewlett-Packard Company, 1976, Part No. 02116-9072

Assembler: see MC68000, 16 Bit Microprocessor Users Manual, Motorola Corporation, 3rd. Ed. 1982

```
COMMENT  These constants must correspond with the active function
         display annotation in SACTIVE.
;
INTEGER CONSTANT  active_off                   :=  0,    & * see below &
                  active_start                 :=  1,
                  active_stop                  :=  2,
                  active_center                :=  3,
                  active_span                  :=  4,    & * see below &
                  active_cw                    :=  5,
                  active_sweep_time            :=  6,
                  active_source_power          :=  7,
                  active_power_slope           :=  8,
                  active_atten_port1           :=  9,
                  active_atten_port2           := 10,
                                           & end of source functions &
                  last_source_function         := 10,

                  active_ref_pos               := 11,
                  active_scale                 := 12,    & * see below &
                  active_ref_value             := 13,    & * see below &
                  active_unused_2              := 14,
                  active_title                 := 15,    & * see below &
                  active_n_groups_hpib         := 16,
                  active_if_avg_factor         := 17,
                  active_smoothing_aperture    := 18,    & * see below &
                  active_srq_mask_primary      := 19,
                  active_srq_mask_secondary    := 20,
                  active_revision              := 21,    & * see below &
                  active_aux_out               := 22,
                  active_keycode               := 23,
                  active_electrical_length     := 24,
                  active_phase_offset          := 25,
                  active_marker1               := 26,
                  active_marker2               := 27,
                  active_marker3               := 28,
                  active_marker4               := 29,
                  active_marker5               := 30,
                  active_address               := 31,
                  active_peek                  := 32,
                  active_poke                  := 33,
                  active_open_c0               := 34,
                  active_open_c1               := 35,
                  active_open_c2               := 36,
                  active_gate_start            := 37,
                  active_gate_stop             := 38,
                  active_gate_center           := 39,
                  active_gate_span             := 40,
                  active_magnitude_slope       := 41,
                  active_magnitude_offset      := 42,
                  active_stimulus_slope        := 43,
                  active_stimulus_offset       := 44,
                  active_ref_plane_1           := 45,
                  active_ref_plane_2           := 46,
                  active_system_z0             := 47,
                  active_8510_hpib_addr        := 48,
```

```
                    active_system_bus_hpib_addr  := 49,
                    active_pass_thru_hpib_addr   := 50,
                    active_source_hpib_addr      := 51,
                    active_testset_hpib_addr     := 52,
                    active_plotter_hpib_addr     := 53,
                    active_printer_hpib_addr     := 54,
                    active_ch_cmd_hpib_addr      := 55,
                    active_offset_delay          := 56,
                    active_offset_loss           := 57,
                    active_offset_z0             := 58,
                    active_offset_min_freq       := 59,
                    active_offset_max_freq       := 60,
                    active_std_id                := 61,
                    active_std_class             := 62,
                    active_n_groups_kbd          := 63,
                    active_previous              := -1;    & * see below &

& * These constants also appear in cactv1.work and should be changed   &
&   there if they are changed here. &



M68KL,P,"active"
BEGIN

#FILE cchtable.work;                               & for ch_... constants &
#FILE fchtable.work;                          & for set_entry_ch_... etc. &
#FILE fannot.work;               & for annotate_ref_value and update scale &
#FILE fmarker.work;                                        & for mkr_... &
#FILE fkernel.work;                           & for acquire and release &
#FILE crins.work;                             & for active_function_rin &
#FILE futil.work;                                             & for tell &
#FILE fprivib.work;             & for wrt_priv_ib and wrt_priv_ib_source &
#FILE foutib.work;                                & for wrt_pubib_string &
#FILE ffmt.work;                                       & for format_quad &
#FILE ccontvar.work;                                 & for max_parameter &
#FILE fdatap.work;                                         & for min_max &
#FILE fchdata.work;                                      & for step_size &
#FILE fchpfr.work;                                   & for scale[], etc. &
#FILE cactive2.work;        & for step_up, _down, e0, ..., mkr_to_min &
#FILE factv0.work;
#FILE cactv1.work;          & for active_scale, _ref_value, _revision &
#FILE factv1.work;
#FILE factv2.work;                                           & for entry &
#FILE facttbl.work;                     & for get_active [make_positive] &
#FILE fstring.work;                        & for append_string and _ch &
#FILE fstimuli.work;                   & for entry_stimulus_at_point &
#FILE fcnv9x.work;                                         & for CNV9A &
#FILE cnewline.work;                                     & for newline &
#FILE fgratic.work;           & for graticule_type and type_of_grat &
#FILE fdispram.work;                                  & for wrt_disp_real &
```

```
#EJECT;
BYTE    TABLE    revision_array := 22,'R,'E,'V,' ,'R,'.,'x,':,' ,
                                  'J,'A,'N,' ,'9,'9,',,' ,'1,'9,'9,'9,
                                  ' ;         & to look like an ALPHA &
                            & 2nd line is $DATE$ and is filled by linker &.
SUBROUTINE dummy;    & to allow assemble statement in declaration area &
   BEGIN
      ASSEMBLE( "$DATE$  EQU    10+$revision_array";  & offset must be &
                         ENT    $DATE$                &    an even no. &
              );
   END;


#EJECT;
ALPHA TABLE keypad_suffix :=              & used by keypad_entry routine &
   & 0 &    "E-9",
   & 1 &    "E-6",
   & 2 &    "E-3",
   & 3 &    "",     & same as "E0" but faster to process &
   & 4 &    "E3",
   & 5 &    "E6",
   & 6 &    "E9",
   & 7 &    "E12",
   & 8 &    "E15",
   & 9 &    "E18",
   &10 &    "E21";

INTEGER TABLE    ch_active_marker :=
                 0,
                 ch_marker1,
                 ch_marker2,
                 ch_marker3,
                 ch_marker4,
                 ch_marker5;

BYTE    CONSTANT hpib_function := 1,
                 step_function := 2;

DOUBLE  CONSTANT initial_peek_n_poke_addr := %00000100;
```

```
#EJECT;
COMMENT                                                         rpg_entry
*************************************************************************
*
* RPG ALGORITHMS:
*   0 - rpg disabled
*   1 - hpib source update protocol
*   2 - .1% of stimulus span       value + rpg_count*span/1000
*   3 - count                      value + rpg_count
*   4 - 1                          value + 1*(sign of rpg_count)
*   5 - count/20       [scaled]    value + rpg_count/20
*   6 - .1% scale/div  [scaled]    value + rpg_count*scale/1000
*   7 - .1% value      [scaled]    value + rpg_count*value/1000
*   8 - count/10                   value + rpg_count/10
*   9 - count/100      [scaled]    value + rpg_count/100
*   A - count*count*count          value + rpg_count*rpg_count*rpg_count
*   B-F undefined
*
* [scaled] algorithms apply to active functions that are scaled (see
*    "scale_factor").
*
*************************************************************************
;
PROCEDURE  rpg_entry( rpg_word );
   VALUE   rpg_word;
   INTEGER rpg_word;                                              ENTRY;
   BEGIN & rpg_entry &
      ALPHA           rpg_cmd;
      INTEGER         rpg_count;
      DOUBLE          temp_double;
      QUAD            quad_rpg_count,
                      active_increment;
      BYTE  POINTER   rpg_ptr = rpg_cmd;

      acquire( active_function_rin );

      IF rpg_algorithm <> 0 THEN
         BEGIN & if &

            & mask off rpg count and sign extend &
            rpg_word := INTEGER( BYTE(rpg_word AND %00FF) );

            IF rpg_algorithm <> hpib_function THEN     & rate multiply &
               BEGIN & if not hpib_function &
                  rpg_count := rpg_word * (1 + RIGHT(ABS(rpg_word), 2));
                  quad_rpg_count := QUAD(rpg_count);
               END   & if not hpib_function &
            ELSE & hp-ib function &
               BEGIN & else &
                  rpg_cmd := "RBx";            & the x is a placeholder &
                  rpg_ptr[3] := rpg_word;      &       for the rpg word &
               END;  & else &

            CASE (rpg_algorithm - 1) OF
               BEGIN & case &
&  1 HP-IB     &  CASE (active_function - 1) OF
```

```
                        BEGIN & case &
     &  1 start         &  wrt_priv_ib_source( fa, rpg_cmd );
     &  2 stop          &  wrt_priv_ib_source( fb, rpg_cmd );
     &  3 center        &  wrt_priv_ib_source( cf, rpg_cmd );
     &  4 span          &  wrt_priv_ib_source( df, rpg_cmd );
     &  5 cw            &  wrt_priv_ib_source( cw, rpg_cmd );
     &  6 sweep time    &  wrt_priv_ib_source( st, rpg_cmd );
     &. 7 source power  &  ; & not used (plug-in RPG requires GET) &
     &  8 power slope   &  ; & not used (plug_in RPG requires GET) &
     &  9 atten port 1  &  ; & not used (not RPG compatible) &
     & 10 atten port 2  &  ; & not used (not RPG compatible) &
                        END;  & case &
  &  2 .1% span     &  active_increment :=
                                   ( quad_rpg_count *
                                     entry_ch_quad(ch_span_stimulus) /
                                     quad_thousand
                                   );
  &  3 direct       &  active_increment := quad_rpg_count;
  &  4 +/- 1        &  active_increment := SIGN( 1, rpg_count );
  &  5 +/- count/20 &  active_increment :=
  &        scaled   &        ( quad_rpg_count * quad_scaled_twentieth );
  &  6 .1% scale    &  active_increment := ( quad_rpg_count *
                                             QUAD( ABS( entry_ch_real(
                                                          ch_scale
                                                         )
                                                      ) *
                                                   scaled_thousandth
                                                 )
                                           );
  &  7 .1% value    &  active_increment := ( quad_rpg_count *
                                             ABS(active_fcn_value)
                                           ) / quad_thousand;
  &  8 +/- count/10 &  active_increment := QUAD(
                                          SIGN(1,rpg_count) + rpg_count/10
                                              );
  &  9 +/- count/100&  active_increment :=
  &        scaled   &        ( quad_rpg_count * quad_scaled_hundreth );
  &  A for time     &  BEGIN
                          rpg_word := rpg_word + rpg_word;     & times 2 &
                          IF rpg_word > 30 THEN
                             rpg_word := 30;
                          temp_double := SBIT( 0, rpg_word );
                          active_increment := active_fcn_value     *
                                              QUAD( temp_double ) /
                                              %0A000000;
                       END;
                    END;  & case &

                IF rpg_algorithm <> hpib_function THEN
                   BEGIN & if &
                      IF active_increment = 0 THEN
                         active_increment := quad_rpg_count;
                      active_fcn_value := active_fcn_value +
                                                    active_increment;
                      enter_active_function;
                   END;  & if &
```

```
        END;  & if &
      release( active_function_rin );
    END;  & rpg_entry &
```

```
#EJECT;
COMMENT                                                                step_125
*******************************************************************************
*
*******************************************************************************
*
* INITIAL REFINEMENT:
*
*    take absolute value -- save sign.
*
*    { find power of ten -- actually 4*10^n to ease later computations }
*    find "floor" (4*10^n immediately <= number).
*    { note that table fails for values of +1, 0, and -1, so a special
*      case handles those situations. }
*
*    { determine whether one, two, or five is nearest ordinal value }
*    IF number < 2*floor THEN    { number < 8*10^n }
*       one_two_five := five
*    ELSE IF number < 4*floor THEN    { number < 16*10^n }
*       one_two_five := one
*    ELSE (number < floor*10)         { number < 40*10^n }
*       one_two_five := two.
*
*    { do step-up and step-down stuff }
*    IF direction = up THEN
*       CASE one_two_five OF
* five:    one_two_five := one.
* one:     one_two_five := two.
* two:     BEGIN
*             one_two_five := five.
*             floor := floor * 10.
*          END
*    ELSE IF direction = down THEN
*       CASE one_two_five OF
* five:    BEGIN
*             one_two_five := two.
*             floor := floor / 10.
*          END.
* one:     one_two_five := five.
* two:     one_two_five := one
*    ELSE (no direction -- just find nearest one-two-five value)
*       do nothing here.
*
*    { compute actual one-two-five values from the table }
*    IF one_two_five = two THEN
*       number := (floor*10)/2
*    ELSE IF one_two_five = one THEN
*       number := (floor*10)/4
*    ELSE (one_two_five = five)
*       number := (floor*10)/8.
*
*    restore sign of number.
*
*******************************************************************************
;
      INTEGER CONSTANT  small_offset := 10,     & 1st entry <= 32-bits &
```

```
                              half_quad    :=  4,
                              quad_size    :=  8;

          QUAD TABLE fours_table :=
      & 9.22E18 & %7FFFFFFFFFFFFFFF,                      & top end buffer entry &
      & 4E18 &    4000000000000000000,
      & 4E17 &    400000000000000000,
      & 4E16 &    40000000000000000,
      & 4E15 &    4000000000000000,
      & 4E14 &    400000000000000,
      & 4E13 &    40000000000000,
      & 4E12 &    4000000000000,
      & 4E11 &    400000000000,
      & 4E10 &    40000000000,
      & 4E9  &    4000000000,
      & 4E8  &    400000000,
      & 4E7  &    40000000,
      & 4E6  &    4000000,
      & 4E5  &    400000,
      & 4E4  &    40000,
      & 4E3  &    4000,
      & 4E2  &    400,
      & 4E1  &    40,
      & 4E0  &    4,
      & 0    &    0;                                   & bottom end buffer entry &
          QUAD small_table = fours_table +
                              small_offset*quad_size + half_quad;

      QUAD PROCEDURE step_125(number, direction);
         VALUE   number,direction;
         QUAD    number;
         INTEGER direction;
         BEGIN & step_125 &
            LABEL end_abs,
                  large_loop,
                  small_num,
                  bigger_than_1,
                  small_loop,
                  floor_found,
                  f1,
                  f2,
                  found_125,
                  up_step,
                  down_step,
                  up_dn_done,
                  div_8,
                  div_4,
                  div_2,
                  restore_sign,
                  sign_restored;

      & rearrange things -- should have planned ahead &
            ASSEMBLE(
                     MOVE      direction, R5         step direction
                    );
```

```
& take absolute value and save sign &
     ASSEMBLE(
               CLR       R6                    R6 remembers sign, 0=+ ;
               TST.L     R0                    ;
               BGE       end_abs               ;
               NOT       R6                    remember sign -- -1=minus ;
               NEG       R5                    reverse direction for neg.;
               NEG.L     R1                    negate number ;
               NEGX.L    R0
              );
end_abs:

& find "floor" (number >= table entry) &
     ASSEMBLE(
               TST.L     R0                    is most sig. half = 0? ;
               BEQ       small_num             ;
               LEA       fours_table, R8       ;
large_loop:    ADDQ.W    =D8,      R8          quad_size ;
               CMP.L     (R8),     R0          compare most sig. halves ;
               BCS       large_loop            BCS = BLO = logical BLT ;
               BRA       floor_found           ;
small_num:     CMPI.L    =D1,      R1          is least sig. half > 1? ;
               BHI       bigger_than_1         ;
               ADD       R5,       R1          handles 0 and 1 values ;
               BGE       restore_sign          quick if result is 0 or 1 ;
               MOVEQ     =D-1,     R1          crossed 0 to become -1 ;
               MOVEQ     =D-1,     R0          ;
               BRA       restore_sign          ;
bigger_than_1: LEA       small_table, R8       ;
small_loop:    ADDQ.W    =D8,      R8          quad_size ;
               CMP.L     (R8),     R1          compare least sig. half ;
               BCS       small_loop            BCS = BLO = unsigned BLT ;
               SUBQ.W    =D4,      R8          back up to most sig. half
              );
floor_found:

& find 1-2-5 &
     ASSEMBLE(
               MOVEM.L   (R8)+,    R2-R3       get "floor" ;
               SUB.W     =D16,     R8          twice_quad, now "ceiling" ;
               MOVEQ     =D-1,     R7          five = returned result ;
               ASL.L     #1,       R3          2 x floor ;
               ROXL.L    #1,       R2          ;
               CMP.L     R2,       R0          ;
               BCS       found_125             BCS = BLO = logical BLT ;
               BHI       f1                    BHI = logical BGT ;
               CMP.L     R3,       R1          ;
               BCS       found_125             BCS = BLO = logical BLT ;
f1:            MOVEQ     =D0,      R7          one = returned result ;
               ASL.L     #1,       R3          4 x floor ;
               ROXL.L    #1,       R2          ;
               CMP.L     R2,       R0          ;
               BCS       found_125             BCS = BLO = logical BLT ;
               BHI       f2                    BHI = logical BGT ;
               CMP.L     R3,       R1          ;
               BCS       found_125             BCS = BLO = logical BLT ;
```

```
f2:             MOVEQ    =D1,     R7          two = returned result
               );
found_125:

& implement step-up and step-down &
      ASSEMBLE(
                TST      R5                   1=up, -1=down, 0=same ;
                BEQ      up_dn_done           ;
                BLT      down_step            ;
up_step:        ADDQ     #1,      R7          ;
                CMP      =D1,     R7          two ;
                BLE      up_dn_done           ;
                MOVEQ    =D-1,    R7          five,crossed 10^n boundary ;
                SUBQ.W   =D8,     R8          quad_size ;
                BRA      up_dn_done           ;
down_step:      SUBQ     #1,      R7          ;
                CMP      =D-1,    R7          five ;
                BGE      up_dn_done           ;
                MOVEQ    =D1,     R7          two, crossed 10^n boundary ;
                ADDQ.W   =D8,     R8          quad_size
               );
up_dn_done:


& calculate 1-2-5 value &
      ASSEMBLE(
                MOVEM.L  (R8)+,   R0-R1       get "ceiling" ;
                TST      R7                   -1=five, 0=one, 1=two ;
                BGT      div_2                compute "two" ;
                BEQ      div_4                compute "one" ;
div_8:          ASR.L    #1,      R0          compute "five" ;
                ROXR.L   #1,      R1          ;
div_4:          ASR.L    #1,      R0          ;
                ROXR.L   #1,      R1          ;
div_2:          ASR.L    #1,      R0          ;
                ROXR.L   #1,      R1
               );

restore_sign:
      ASSEMBLE(
                TST      R6                   ;
                BPL      sign_restored        ;
                NEG.L    R1                   ;
                NEGX.L   R0
               );
sign_restored:

& return -- result is in R0-R1 &

   END;  & step_125 &
```

```
#EJECT;
COMMENT                                                              step_entry
***************************************************************************
*
* STEP KEY ALGORITHMS:
*   0 - step keys disabled
*   1 - hpib source update protocol
*   2 - 1-2-5 sequence  [scaled or unscaled]
*   3 - 10% of span                        value + step_sign*span/10
*   4 - 1               [scaled]           value + 1*step_sign
*   5 - 1 division      [scaled]           value + step_sign*scale/div
*   6 - undefined
*   7 - 1 division                         value + step_sign*scale/div
*   8 - 10% of value    [scaled]           value + step_sign*value/10
*   9 - 1                                  value + 1*step_sign
*   A - 10              [scaled]           value + 10*step_sign
*   B-F undefined
*
* [scaled] algorithms apply to active functions that are scaled (see
*    "scale_factor").
*
***************************************************************************
;
PROCEDURE  step_entry( direction );
   VALUE   direction;
   INTEGER direction;                                               ENTRY;
   BEGIN & step_entry &
      INTEGER index;
      ALPHA   step_cmd;
      QUAD    active_increment;

      acquire( active_function_rin );

      IF step_algorithm <> 0 THEN
         BEGIN & if &

            CASE (step_algorithm - 1) OF
               BEGIN & case &
&  1 HP-IB          &  BEGIN & hpib &
                        step_cmd := IF direction = step_down THEN
                                       "DN"
                                    ELSE
                                       "UP";
                        CASE (active_function - 1) OF
                           BEGIN & case &
      &  1 start        &     wrt_priv_ib_source( fa, step_cmd );
      &  2 stop         &     wrt_priv_ib_source( fb, step_cmd );
      &  3 center       &     wrt_priv_ib_source( cf, step_cmd );
      &  4 span         &     wrt_priv_ib_source( df, step_cmd );
      &  5 cw           &     wrt_priv_ib_source( cw, step_cmd );
      &  6 sweep time   &     wrt_priv_ib_source( st, step_cmd );
      &  7 source power &     ; & not used &
      &  8 power slope  &     wrt_priv_ib_source( sl1, step_cmd );
      &  9 atten port 1 &     BEGIN & atten port 1 &
                                 wrt_priv_ib(test_set,atten1,step_cmd);
                                 enter_active_function;
```

```
                                END;  & atten port 1 &
        & 10 atten port 2 &     BEGIN & atten port 2 &
                                   wrt_priv_ib(test_set,atten2,step_cmd);
                                   enter_active_function;
                                END;  & atten port 2 &
                             END;  & case &
                          END;  & hpib &
 &  2 1-2-5  &            active_fcn_value := step_125( active_fcn_value,
                                                        direction
                                                      );
 &  3 10% of span &       active_increment :=
                             SIGN( ( entry_ch_quad(ch_span_stimulus) /
                                     quad_ten
                                   ),
                                   direction
                                 );
 &  4 +/- 1  &            active_increment :=
 &  scaled   &               SIGN( quad_scaled_one, direction );
 &  5 +/1 scale/div & BEGIN
 &  scaled   &               index := get_active( get_log_scale_div_3,
                                                  active_scale
                                                );
                             active_increment :=
                                SIGN( QUAD( entry_ch_real(ch_scale) *
                                            scale_factors[ index ]
                                          ),
                                      direction
                                    );
                          END;
 &  6 undefined     & ;
 &  7 +/- scale/div & active_increment :=
 &        unscaled  &        SIGN( QUAD( entry_ch_real(ch_scale) ),
                                   direction
                                 );
 &  8   10% of value& active_increment :=
 &         scaled   &        SIGN( ( active_fcn_value / quad_ten ),
                                   direction
                                 );
 &  9       +/- 1   & active_increment :=
 &        unscaled  &        SIGN( 1, direction );
 &  10     +/- 10   & active_increment :=
 &         scaled   &        SIGN( quad_ten_scaled, direction );
               END;  & case &


             IF step_algorithm <> hpib_function THEN
                BEGIN & if <> hpib_function &
                   IF step_algorithm <> step_function THEN
                      BEGIN & if &
                         IF active_increment = 0 THEN
                            active_increment := SIGN( 1, direction );
                         active_fcn_value := active_fcn_value +
                                             active_increment;
                      END;  & if &
                   enter_active_function;
                END;  & if <> hpib_function &
```

```
        END;  & if &
     release( active_function_rin );
  END;  & step_entry &
```

```
#EJECT;
COMMENT                                                    keypad_entry
**************************************************************************
*
* KEYPAD ALGORITHMS:
*   0 - keypad disabled
*   1 - terminator keys represent positive exponents
*   2 - terminator keys represent negative exponents
*   3-7 undefined
*
**************************************************************************
;
PROCEDURE  keypad_entry( terminator );
   VALUE   terminator;
   INTEGER terminator;                                            ENTRY;
   BEGIN & keypad_entry &
      INTEGER position;

      IF keypad_algorithm <> 0 THEN              & 0 = keypad disabled &
         BEGIN & if &
            acquire( active_function_rin );

            & 0 <= terminator <= 3 &

            CASE keypad_algorithm OF
               BEGIN & case &
& 0 keypad disabled    &   ;
& 1 positive exponent  &   terminator := 3 + terminator; & 3 <= t <= 6 &
& 2 negative exponent  &   terminator := 3 - terminator; & -3<= t <= 0 &
               END;  & case &

                              & log_scale_factor_div_3 = 4 for 1@12 &
            terminator := terminator + log_scale_factor_div_3;
                                            & 0 <= terminator <= 10 &

            entry_array[-1] := entry_array[-1] + keypad_suffix_size;
            append_string( entry, keypad_suffix[terminator] );
            position := 1;
            active_fcn_value := CNV9A( entry, position );
            entry_array[-1] := entry_array[-1] - keypad_suffix_size;

            enter_active_function;

            release( active_function_rin );
         END;  & if &

      send( entry_string_ready );               & finished with string &
                                    & comes after enter_active_function &
                                    & to hold off parser for "TSn" cmd. &
                                    & Prefer placing it before.         &

   END;  & keypad_entry &
```

```
#EJECT;
COMMENT                                                      marker_value_entry
*****************************************************************************
*
* "=MARKER" ALGORITHMS:
*   0 - "=MARKER" is inconsistent for current active function
*   1 - use marker stimulus value (e.g. for center frequency)
*   2 - use marker amplitude (e.g. for reference value)
*   3 - use marker magnitude (e.g. for magnitude offset)
*   4 - use marker phase     (e.g. for phase offset)
*   5-F undefined
*
*****************************************************************************
;
QUAD PROCEDURE quad_mkr_amplitude;
   BEGIN & quad_mkr_amplitude &
      USER3 temp_user3;
      REAL  temp_real = temp_user3 + 2;

      temp_user3 := marker_value( active_marker );
      IF scaled THEN
         BEGIN & if scaled &
            temp_real := temp_real * scale_factor;
            IF log_scale_factor_div_3 <> 4 THEN
               temp_real := temp_real *
                              1000.0 * REAL(log_scale_factor_div_3 - 4);
         END;  & if scaled &
      quad_mkr_amplitude := QUAD( temp_real + 0.5 );
   END;  & quad_mkr_amplitude &



SUBROUTINE marker_value_entry;                                          ENTRY;
   BEGIN & marker_value_entry &

      COMMENT   amplitude, magnitude, and phase are always scaled reals,
                stimulus value is always a quad.
      ;
      acquire( active_function_rin );

      CASE mkr_algorithm OF
         BEGIN & case &
& 0 &       tell( inconsistent_operation );
& 1 stim &  active_fcn_value := mkr_stimulus_at_pt(active_marker);
& 2 ampl &  active_fcn_value := quad_mkr_amplitude;
& 3 mag  &  active_fcn_value := quad_mkr_amplitude;
& 4 phase&  active_fcn_value := quad_mkr_amplitude;
         END;  & case &

      IF get_active(get_must_be_positive, active_function) =
            make_positive THEN
         active_fcn_value := ABS(active_fcn_value);

      enter_active_function;

      release( active_function_rin );



                  END;  & marker_value_entry &
```

```
#EJECT;
COMMENT                                                            marker_to
******************************************************************************
*
******************************************************************************
;
PROCEDURE  marker_to( to_min_max );
   VALUE   to_min_max;
   INTEGER to_min_max;                                                  ENTRY;
   BEGIN & marker_to &
      INTEGER min_pt,
              max_pt,
              point_number;
      REAL    min,
              max;

      min_max( entry_ch_double(ch_f_base),
               step_size,
               graticule_type(current_entry_ch) <> rectangular,
               min,
               min_pt,
               max,
               max_pt
             );

      point_number := IF to_min_max = mkr_to_min THEN min_pt
                                                 ELSE max_pt;
      set_entry_ch_quad( entry_stimulus_at_point( point_number ),
                         ch_active_marker[ active_marker ]
                       );
      select_marker( active_marker );

   END;  & marker_to &
```

```
#EJECT;
COMMENT                                                              auto_scale
***************************************************************************
*
***************************************************************************
;
PROCEDURE  auto_scale;                                                  ENTRY;
   BEGIN & auto_scale &
      BOOLEAN grat_type;
      INTEGER min_pt,
              max_pt,
              param_index,
              format_index;
      REAL    min,
              max,
              reference_value,
              reference_offset,
              center_value,
              scale_value,
              temp_real;
      QUAD    temp_quad;
      INTEGER POINTER src,
                      dst;

      SUBROUTINE compute_scale;      & centralized multiple-usage code &
         BEGIN & compute_scale &
            scale_value  := max - center_value;              & scale * 5 &
            temp_real    := center_value - min;              & scale * 5 &
            IF temp_real > scale_value  THEN
               scale_value := temp_real/5
            ELSE
               scale_value := scale_value/5;
            temp_quad   := QUAD( scale_factor * scale_value );
            temp_quad   := step_125( temp_quad, step_up );
            temp_quad   := limit_quad( temp_quad, active_scale );
            scale_value := REAL( temp_quad ) * unscale;
         END;  & compute_scale &

      grat_type := graticule_type(current_entry_ch);

      min_max( entry_ch_double(ch_f_base),
               step_size,
               grat_type <> rectangular,
               min,
               min_pt,
               max,
               max_pt
             );

      IF grat_type = rectangular THEN
         BEGIN & if rectangular &

            & find a nice number near the center-line of the data &

            center_value := (max + min) / 2;
            temp_quad := QUAD( scale_factor * center_value );
```

```
            temp_quad := step_125( temp_quad, 0 );  & 0 = no direction &
            center_value := REAL(temp_quad) * unscale;

            compute_scale; & best guess before knowing actual ref.val. &

            & center_value was the initial guess, reference position   &
            & can cause limiting or a non-nice value, so fix things up.&

            reference_offset := scale_value *
                                  (entry_ch_real(ch_ref_position) - 5.0);
            reference_value := center_value + reference_offset;
            temp_quad := QUAD( scale_factor * reference_value );
            temp_quad := step_125( temp_quad, 0 );  & 0 = no direction &
            temp_quad := limit_quad( temp_quad, active_ref_value );
            reference_value := REAL(temp_quad) * unscale;

            & Limiting and/or 1-2-5 roundoff can move reference value  &
            & significantly, so recompute scale for the new ref value. &

            center_value := reference_value - reference_offset;
            compute_scale;

         END   & if rectangular &
      ELSE
         BEGIN & else polar &
            temp_quad := QUAD( scale_factor * max );
            temp_quad := step_125( temp_quad, step_up );
            reference_value := REAL( limit_quad( temp_quad,
                                                 active_ref_value
                                               )
                                   ) * unscale;
            scale_value := 0.2 * reference_value;
         END;  & else polar &

      param_index  := entry_ch_integer(ch_param);
      format_index := entry_ch_integer(ch_format);
      IF type_of_grat[ format_index ] <> rectangular THEN
         format_index := fmt_log_polar;   & all polars use same values &

      set_entry_ch_real( reference_value, ch_ref_value );
      wrt_disp_real( ADRS( ref_value[ format_index,
                                       entry_ch_integer(ch_param),
                                       current_entry_ch
                                     ]
                         ),
                     reference_value
                   );
      annotate_ref_value;

      set_entry_ch_real( scale_value, ch_scale );
      wrt_disp_real( ADRS( scale[ format_index,
                                   entry_ch_integer(ch_param),
                                   current_entry_ch
                                 ]
                         ),
                     scale_value
```

```
                  );
    update_scale;                       & includes partial( update_f ) &

    select_active_function( active_previous );

  END;  & auto_scale &



#EJECT;
COMMENT                                                      output_active
***************************************************************************
*
***************************************************************************
;
PROCEDURE  output_active;                                            ENTRY;
  BEGIN & output_active &
    BYTE ARRAY output_array[-1:string_size];
    ALPHA      output_string;
    DOUBLE     fmt;

    acquire( active_function_rin );

    & initialize string &
    output_string := ADRS( output_array );
    output_string := init_string( output_string, string_size );

    IF display_format <> 0 THEN
      BEGIN & if &
        fmt := format_table[ output_format ];
        & enter format bias (scale factor) &
        fmt := fmt + (log_scale_factor_div_3 * 48);   & 48 <= 3*16 &
        output_string := format_quad( active_fcn_value,
                                      output_string,
                                      fmt
                                    );
      END;  & if &

    wrt_pubib_string( append_ch(output_string, newline) );

    release( active_function_rin );

  END;  & output_active &
```

```
#EJECT;
COMMENT                                                output_identifier
************************************************************************
*
************************************************************************
;
PROCEDURE  output_identifier;                                     ENTRY;
   BEGIN & output_identifier &
      BYTE ARRAY output_array[-1:string_size];
      ALPHA      output_string;

      & initialize string &
      output_string := ADRS( output_array );
      output_string := init_string( output_string, string_size );

      append_string( output_string, "HP8510A, " );
      append_string( output_string,
                     active_function_label[ active_revision ]
                   );

      wrt_pubib_string( append_ch(output_string, newline) );

   END;  & output_identifier &



#EJECT;
COMMENT                                                      init_active
************************************************************************
*
************************************************************************
;
PROCEDURE  init_active;                                           ENTRY;
   BEGIN & init_active &
      INTEGER POINTER int_ptr;
      DOUBLE  temp_dbl;
      INTEGER temp_dbl_upper = temp_dbl,
              temp_dbl_lower = temp_dbl+2;

      & use INTEGERs -- label may be in display &
      STPNTR( int_ptr, ADRS( active_function_label[active_revision] ) );
      temp_dbl := ADRS(revision_array);
      int_ptr := temp_dbl_upper;
      STPNTR( int_ptr, ADRS(int_ptr)+2 );
      int_ptr := temp_dbl_lower;

      STPNTR( peek_n_poke, initial_peek_n_poke_addr );

   END;  & init_active &

END$
```

```
M68KL,P,"acttbl"
BEGIN
#FILE catable2.work;
#FILE fatables.work;
#FILE cchtable.work;
#FILE fchtable.work;
#FILE fchtab2.work;                                            & for max_format &
#FILE cdatap.work;
```

```
#EJECT;
COMMENT                                                        ch_get_active
*************************************************************************
*
*************************************************************************
;
INTEGER PROCEDURE ch_get_active( source, function, ch );
   VALUE   source, function, ch;
   INTEGER source, function, ch;
   BEGIN & ch_get_active &
      INTEGER POINTER integer_table;
      BYTE    POINTER byte_table = integer_table;
      INTEGER         index,
                      dependency;
      BYTE            type;

      STPNTR( integer_table, active_tables[source] );
      type := active_table_type[source];

      IF type = byte_type THEN
         BEGIN
            index := byte_table[ function ];
            IF index < 0 THEN
               dependency := byte_table[index];
         END
      ELSE & type = integer_type &
         BEGIN
            index := integer_table[ function ];
            IF index < 0 THEN
               dependency := integer_table[index];
         END;

      IF index < 0 THEN
         BEGIN & if &
            IF dependency = format_dependent THEN
               index := index + ch_integer( ch_format, ch )
            ELSE IF dependency = domain_dependent THEN
               index := index + ch_integer( ch_domain, ch ) + 1
            ELSE
               index := index + ch_integer( ch_format, ch ) +
                           ch_integer( ch_domain, ch ) * max_format;

            IF type = byte_type THEN
               index := byte_table[index]
            ELSE & type = integer_type &
               index := integer_table[index];
         END;  & if &

      ch_get_active := index;

   END;  & ch_get_active &
```

```
#EJECT;
COMMENT                                                              get_active
*************************************************************************
*
*************************************************************************
;
INTEGER PROCEDURE get_active( source, function );
   VALUE   source, function;
   INTEGER source, function;                                            ENTRY;
   BEGIN & get_active &

      get_active := ch_get_active( source, function, current_entry_ch );

   END;  & get_active &



#EJECT;
COMMENT                                                       ch_active_suffix
*************************************************************************
*
*************************************************************************
;
ALPHA PROCEDURE ch_active_suffix( function, ch );
   VALUE   function, ch;
   INTEGER function, ch;                                                ENTRY;
   BEGIN & ch_active_suffix &
      ch_active_suffix := suffix[ ch_get_active( get_suffix_index,
                                                 function,
                                                 ch
                                               )
                                ];
   END;  & ch_active_suffix &


#EJECT;
COMMENT                                                          active_suffix
*************************************************************************
*
*************************************************************************
;
ALPHA PROCEDURE active_suffix( function );
   VALUE   function;
   INTEGER function;                                                    ENTRY;
   BEGIN & active_suffix &
      active_suffix := ch_active_suffix( function, current_entry_ch );
   END;  & active_suffix &
```

```
#EJECT;
COMMENT                                                      ch_active_format
*****************************************************************************
*
*****************************************************************************
;
DOUBLE PROCEDURE ch_active_format( function, ch );
   VALUE   function, ch;
   INTEGER function, ch;                                               ENTRY;
   BEGIN & ch_active_format &
      INTEGER index;
      DOUBLE  fmt;

      index := ch_get_active( get_format_index, function, ch );
      fmt := format_table[ index ];
      IF index = 2 THEN                   & value is stored in scaled form &
         BEGIN & if stored scaled &
            index := ch_get_active( get_log_scale_div_3, function, ch );
            fmt := fmt OR (index * 48);                        & 48 = 3*16 &
         END;  & if stored scaled &
      ch_active_format := fmt;

   END;  & ch_active_format &
```

```
#EJECT;
COMMENT                                                         active_format
*****************************************************************************
*
*****************************************************************************
;
DOUBLE PROCEDURE active_format( function );
   VALUE   function;
   INTEGER function;                                                   ENTRY;
   BEGIN & active_format &
      active_format := ch_active_format( function, current_entry_ch );
   END;  & active_format &
```

```
#EJECT;
COMMENT                                                          active_limits
****************************************************************************
*
****************************************************************************
;
BOOLEAN PROCEDURE active_limits( min, max, function );
   VALUE   function;
   QUAD    min, max;
   INTEGER function;                                                   ENTRY;
   BEGIN & active_limits &
      INTEGER index;

      index := get_active(get_min_limit_index, function);

      IF index <> 0 THEN
         BEGIN & if &
            min := limit[ index ];
            max := limit[ get_active( get_max_limit_index, function ) ];
         END;  & if &

      active_limits := (index <> 0);

   END;  & active_limits &
```

```
#EJECT;
COMMENT                                                      ch_set_active_limits
***********************************************************************
*
***********************************************************************
;
PROCEDURE  ch_set_active_limits( min, max, function, ch );
   VALUE   min, max, function, ch;
   QUAD    min, max;
   INTEGER function, ch;                                              ENTRY;
   BEGIN & ch_set_active_limits &
      INTEGER index;
      INTEGER POINTER source,
                      dest;
      DOUBLE  address;

      index := ch_get_active( get_min_limit_index, function, ch );

      IF index <> 0 THEN
         BEGIN & if &
            address := ADRS(limit) + ALEFT(index,3);
            STPNTR( source, ADRS(min) );
            STPNTR( dest,   address );
            MOVE dest := source, +(4);

            index := ch_get_active( get_max_limit_index, function, ch );
            address := ADRS(limit) + ALEFT(index,3);
            STPNTR( source, ADRS(max) );
            STPNTR( dest,   address );
            MOVE dest := source, +(4);
         END;  & if &

   END;  & ch_set_active_limits &


#EJECT;
COMMENT                                                         set_active_limits
***********************************************************************
*
***********************************************************************
;
PROCEDURE  set_active_limits( min, max, function );
   VALUE   min, max, function;
   QUAD    min, max;
   INTEGER function;                                                  ENTRY;
   BEGIN & set_active_limits &

      ch_set_active_limits( min, max, function, current_entry_ch );

   END;  & set_active_limits &

END$
```

```
REAL    CONSTANT scale_factor              := 1.0@12,
                 elec_delay_factor         := 1.0@15,
                 unscale                   := 1.0@-12,    & 1/scale      &
                 unscale_elec_delay        := 1.0@-15,
                 scaled_hundredth          := 1.0@10,     & scale/100    &
                 scaled_thousandth         := 1.0@9;      & scale/1000   &
QUAD    CONSTANT quad_scaled_one           := 1000000000000,
                 quad_aux_out_scaled       := 4882812500, &scaled 10/2048&
                 quad_ten                  := 10,
                 quad_ten_scaled           := 10000000000000,
                 quad_hundred              := 100,
                 quad_thousand             := 1000,
                 quad_scaled_hundreth      := 10000000000,
                 quad_scaled_twentieth     := 50000000000;
INTEGER CONSTANT string_size               := 64;
```

```
M68KL,P,"actv0"
BEGIN

#FILE fchtable.work;
#FILE fchtab2.work;                              & for ch_integer &
#FILE cchtable.work;
#FILE fmarker.work;
#FILE fkernel.work;                     & for acquire and release &
#FILE crins.work;                       & for active_function_rin &
#FILE fcontrol.work;                                 & for n_sweep &
#FILE fpubib.work;             & for request_mask and set_..._address &
#FILE cactv0.work;                          & for scale constants &
#FILE cactv1.work;                                & for active_... &
#FILE factv2.work;
#FILE ffmt.work;                  & for format_quad and format_real &
#FILE ccontvar.work;                          & for max_parameter &
#FILE fcontv2.work;                                  & for rebuild &
#FILE fdatapl.work;                    & for control_data_proc_freq &
#FILE fchpfr.work;                  & for elec_delay, scale, ref_... &
#FILE facttbl.work;                       & for get_active, etc. &
#FILE fstring.work;
#FILE fcommand.work;
#FILE fstimuli.work;        & for set_stimulus_mode and set_aux_out &
#FILE fcnv9x.work;                                     & for CNV92 &
#FILE cnewline.work;                                 & for newline &
#FILE fdomain.work;                       & for update_domain_vars &
#FILE fannot.work;          & for update_scale and annotate_rev_value &
#FILE ftrace.work;                      & for annotate_ref_position &
#FILE fstds2.work;  & for cal_std_addr, std_id, and std_class_element &
#FILE fprivib.work;         & for wrt_priv_ib and wrt_priv_ib_source &
#FILE fprivib2.work;                 & for get_ and set_priv_ib_lun &
#FILE ftitle.work;                          & for select_title_char &
#FILE futil.work;                               & for tell and warn &
#FILE fchdata2.work;                          & for srq_mask, etc. &
#FILE fdispram.work;                               & for wrt_disp_... &
#FILE fmathfun.work;                          & for speed_of_light &
#FILE ftestset.work;                          & for build_test_set &
#FILE fgratic.work;                              & for type_of_grat &

QUAD PROCEDURE CNV2A(number);
   VALUE   number;
   REAL    number;                                         EXTERNAL;
REAL PROCEDURE CNVA2(number);
   VALUE   number;
   QUAD    number;                                         EXTERNAL;
PROCEDURE signal_init(signal,count);
   VALUE   signal,count;
   INTEGER signal,count;                                   EXTERNAL;


INTEGER CONSTANT copyright := 215;
ALPHA   CONSTANT copyright_notice :=
                " Copyright "+copyright+" HEWLETT-PACKARD COMPANY 1983";
```

```
INTEGER CONSTANT max_marker := 5;                 & borrowed from smarker &

GLOBAL BOOLEAN scaled;                         & active_fcn_value is scaled &
GLOBAL INTEGER log_scale_factor_div_3;   & indicates scale factor size &
GLOBAL INTEGER active_function;
GLOBAL QUAD active_fcn_value;        & an "own" variable for this module &
QUAD    active_fcn_alt_value;        & an alternate value for display.   &

GLOBAL INTEGER POINTER peek_n_poke;               & peek and poke address &
GLOBAL BYTE     rpg_algorithm;
GLOBAL BYTE     step_algorithm;
GLOBAL BYTE     mkr_algorithm;
GLOBAL BYTE     keypad_algorithm;
GLOBAL BYTE     display_format;
INTEGER units;
REAL    scale_multiplier,
        unscale_multiplier;


#EJECT;
COMMENT                                                             limit_quad
**************************************************************************
*
**************************************************************************
;
QUAD PROCEDURE limit_quad(number, function);
   VALUE   number, function;
   QUAD    number;
   INTEGER function;                                                   ENTRY;
   BEGIN & limit_quad &
      QUAD min,
           max;

      IF active_limits( min, max, function ) THEN
         IF number <= min THEN
            limit_quad := min
         ELSE IF number >= max THEN
            limit_quad := max
         ELSE & min <= number <= max &
            limit_quad := number
      ELSE & do not limit &
         limit_quad := number;

   END;  & limit_quad &
```

```
#EJECT;
COMMENT                                              display_active_fcn_value
************************************************************************
*
************************************************************************
;
PROCEDURE  display_active_fcn_value;
   BEGIN & display_active_fcn_value &
      REAL        active_fcn_real;
      DOUBLE      fmt;
      BYTE ARRAY display_array[-1:string_size];
      ALPHA       display_string;
      QUAD POINTER value_ptr;

      & initialize string &
      display_string := ADRS( display_array );
      display_string := init_string( display_string, string_size );

      & get format     see "suffix" table for constant declarations.   &
      IF ( (units=2) OR (units=5) OR (units=15) ) THEN  & suffix is dB &
         display_format := db_format                    & avoid mdB,etc&
      ELSE  & normal (non-dB) suffix &
         display_format := get_active(get_format_index,active_function);

      IF display_format <> 0 THEN
         BEGIN & if &
            fmt := format_table[ display_format ];
            & enter format bias (scale factor) &
            fmt := fmt OR (log_scale_factor_div_3 * 48);  & 48 <= 3*16 &

            append_string( format_quad(
                  IF get_active(get_display_alt_value, active_function)
                        = display_alt THEN
                     active_fcn_alt_value
                  ELSE
                     active_fcn_value,
                  display_string,
                  fmt                    ),
                           suffix[ units ]
                          );
            IF active_function = active_scale THEN
               append_string( display_string, "/div" );
         END;  & if &

      & fill new string &
      print_big_string( display_string,
                        entry_size2,
                        IF entry_flip_flop THEN entry_display2
                                           ELSE entry2_display2
                      );
      entry_flip_flop := NOT entry_flip_flop;
      & turn off old string &
      print_string( "",
                    entry_size2,
                    IF entry_flip_flop THEN entry_display2
                                       ELSE entry2_display2
```

```
            );

      & print the auxiliary string -- may be blank &
      & active_title does some special formatting itself &
      IF active_function <> active_title THEN
         BEGIN & if &
            IF units = 6 THEN        & seconds -- add distance readout &
               BEGIN & if &
                  active_fcn_real := REAL(active_fcn_value) *
                                     speed_of_light;
                  active_fcn_real := active_fcn_real*unscale_multiplier;
                  append_string( format_real( active_fcn_real,
                                              entry_aux,
                                              format_table[
                                                     distance_format
                                                      ]
                                             ),
                                 suffix[ distance_suffix ]
                               );
                  IF active_function = active_scale THEN
                     append_string( entry_aux, "/div" );
               END;  & if &
            print_string(entry_aux,entry_aux_size2,entry_aux_display2);
         END;  & if &

   END;  & display_active_fcn_value &



#EJECT;
COMMENT                                                    activate_marker
**************************************************************************
*
**************************************************************************
;
SUBROUTINE activate_marker;
   BEGIN & activate_marker &
      & limit here for both select_ and enter_ to assure that no       &
      & marker is activated outside of the current stimulus range.     &
      active_fcn_value := limit_quad(active_fcn_value, active_function);
      set_entry_ch_quad( active_fcn_value,
                         get_active(get_chtable_index, active_function)
                       );
      active_fcn_alt_value := mkr_stimulus_value;   & align on a point &
      put_marker( active_marker );
      annotate_mkr_value;
   END;  & activate_marker &
```

```
#EJECT;
COMMENT                                                    check_update_domain
******************************************************************************
*
******************************************************************************
;
SUBROUTINE check_update_domain;
   BEGIN & check_update_domain &
      INTEGER mkr;

      IF ( (ch_integer(ch_gating,1) = gate_on) OR
           (ch_integer(ch_gating,2) = gate_on)
         ) THEN
         update_domain_vars;

      FOR mkr := max_marker TO (max_marker + 3) DO
         put_marker( mkr );

   END;  & check_update_domain &
```

```
#EJECT;
COMMENT                                                    select_active_function
*****************************************************************************
*
*****************************************************************************
;
PROCEDURE  select_active_function( which_function );
   VALUE   which_function;
   INTEGER which_function;                                               ENTRY;
   BEGIN & select_active_function &
      INTEGER algorithm,
              index,
              addr;
      REAL    active_fcn_real;
      INTEGER POINTER src,
                      dst;
      REAL POINTER    real_ptr = dst;

      acquire( active_function_rin );
      clear_string( entry_aux );

      IF which_function <> active_previous THEN
         active_function := which_function;

      & label the display &
      print_big_string( active_function_label[ active_function ],
                        function_size2,
                        function_display2
                      );

      index     := get_active( get_chtable_index, active_function );
      units     := get_active( get_suffix_index,  active_function );
      algorithm := get_active( get_algorithms,    active_function );

      step_algorithm   := algorithm AND %000F;
      algorithm        := RIGHT( algorithm, 4 );
      rpg_algorithm    := algorithm AND %000F;
      algorithm        := RIGHT( algorithm, 4 );
      mkr_algorithm    := algorithm AND %000F;
      algorithm        := RIGHT( algorithm, 4 );
      keypad_algorithm := algorithm AND %0007;


      log_scale_factor_div_3 := get_active( get_log_scale_div_3,
                                            active_function
                                          );
      scaled := (log_scale_factor_div_3 <> 0);
      scale_multiplier   := scale_factors[log_scale_factor_div_3];
      unscale_multiplier := unscale_factors[log_scale_factor_div_3];

      CASE get_active(get_chtable_type, active_function) OF
         BEGIN & case &
& none          &  ;
& byte          &  ; & bytes are no longer used in the chtable &
& integer       &  active_fcn_value := entry_ch_integer( index );
& user3         &  ; & not currently used &
```

```
& real          &  active_fcn_value := entry_ch_real( index ) *
                                                   scale_multiplier;
& double        &  ; & not currently used &
& quad          &  active_fcn_value := entry_ch_quad( index );
         END;   & case &


      & do the unique stuff &
      CASE active_function OF
         BEGIN & case &
&  0 off            &   ;
&  1 start          &   set_stimulus_mode( start_stop );
&  2 stop           &   set_stimulus_mode( start_stop );.
&  3 center         &   set_stimulus_mode( center_span );
&  4 span           &   set_stimulus_mode( center_span );
&  5 cw             &   ;
&  6 sweep time     &   ;
&  7 source power   &   ;
&  8 power slope    &   ;
&  9 port 1 atten   &   ;
& 10 port 2 atten   &   ;
& 11 ref pos'n      &   ;
& 12 scale/div      &   ;
& 13 ref value      &   ;
& 14 unused         &   warn( command_not_implemented );
& 15 title          &   BEGIN & title &
                           tell( titling_instructions );
                           active_fcn_value := 48;  & 2 x initial char &
                           select_title_char( 13 );          & 1 + n/4 &
                        END;  & title &
& 16 # groups hpib  &   ;               & must be same as # groups kbd  &
& 17 if avg factor  &   ;
& 18 smoothing aper.&   BEGIN & smoothing aperture &
                           active_fcn_real :=
                              REAL( entry_ch_quad(ch_span_stimulus) ) *
                              entry_ch_real(ch_smoothing_aperture)    /
                              100.0;
                           append_string(
                                 format_real( active_fcn_real,
                                              entry_aux,
                                              format_table[
                                                    aperture_format
                                                     ]
                                            ),
                                 active_suffix( active_span )
                                     );
                        END;  & smoothing aperture &
& 19 srq mask prim. &   active_fcn_value :=
                              srq_mask_primary;
& 20 srq mask secon.&   active_fcn_value :=
                              srq_mask_secondary;
& 21 revision       &   entry_aux := append_string( entry_aux,
                                                 copyright_notice
                                               );
& 22 aux out        &   BEGIN & auxiliary output voltage &
                           active_fcn_value := quad_aux_out_scaled *
```

```
                              entry_ch_quad( ch_center_aux_out );
                         END;  & auxiliary output voltage &
& 23 keycode        &    ;
& 24 elec delay     &    ;
& 25 phase offset   &    ;
& 26 marker1        &    activate_marker;
& 27 marker2        &    activate_marker;
& 28 marker3        &    activate_marker;
& 29 marker4        &    activate_marker;
& 30 marker5        &    activate_marker;
& 31 address        &    active_fcn_value := ADRS( peek_n_poke );
& 32 peek           &    active_fcn_value := peek_n_poke;
& 33 poke           &    active_fcn_value := 0;
& 34 open c0        &    BEGIN
                            STPNTR( real_ptr,
                                    cal_std_addr + c0_offset
                                  );
                            active_fcn_value := QUAD( scale_multiplier *
                                                      real_ptr
                                                    );
                         END;
& 35 open c1        &    BEGIN
                            STPNTR( real_ptr,
                                    cal_std_addr + c1_offset
                                  );
                            active_fcn_value := QUAD( scale_multiplier *
                                                      real_ptr
                                                    );
                         END;
& 36 open c2        &    BEGIN
                            STPNTR( real_ptr,
                                    cal_std_addr + c2_offset
                                  );
                            active_fcn_value := QUAD( scale_multiplier *
                                                      real_ptr
                                                    );
                         END;
& 37 gate start     &    ;
& 38 gate stop      &    BEGIN
                            active_fcn_value :=
                                      entry_ch_quad(ch_gate_center);
                            active_fcn_value :=
                                     active_fcn_value +
                                     active_fcn_value -
                                     entry_ch_quad(ch_gate_start);
                         END;
& 39 gate center    &    ;
& 40 gate span      &    BEGIN
                            active_fcn_value :=
                                     entry_ch_quad(ch_gate_center)
                                     entry_ch_quad(ch_gate_start);
                            active_fcn_value := active_fcn_value +
                                                    active_fcn_value;
                         END;
& 41 mag slope      &    ;
& 42 mag offset     &    ;
```

```
& 43 stimulus slope &    ;
& 44 stimulus offset&    ;
& 45 ref plane 1    &    ;
& 46 ref plane 2    &    ;
& 47 system z0      &    ;
& 48 major addr     &    active_fcn_value := get_priv_ib_lun(major);
& 49 minor addr     &    active_fcn_value := get_priv_ib_lun(minor);
& 50 pass thru addr &    active_fcn_value :=
                                   get_priv_ib_lun(priv_ib_pass);
& 51 source addr    &    active_fcn_value := get_priv_ib_lun(source);
& 52 test-set addr  &    active_fcn_value := get_priv_ib_lun(test_set);
& 53 plotter addr   &    active_fcn_value := get_priv_ib_lun(plotter);
& 54 printer addr   &    active_fcn_value := get_priv_ib_lun(printer);
& 55 ch cmd addr    &    active_fcn_value :=
                                  get_priv_ib_lun(user_device_1);
& 56 offset delay   &    BEGIN
                            STPNTR( real_ptr,
                                    cal_std_addr + delay_offset
                                  );
                            active_fcn_value := QUAD( scale_multiplier *
                                                      real_ptr
                                                    );
                         END;
& 57 offset loss    &    BEGIN
                            STPNTR( real_ptr,
                                    cal_std_addr + loss_offset
                                  );
                            active_fcn_value := QUAD( scale_multiplier *
                                                      real_ptr
                                                    );
                         END;
& 58 offset z0      &    BEGIN
                            STPNTR( real_ptr,
                                    cal_std_addr + z0_offset
                                  );
                            active_fcn_value := QUAD( scale_multiplier *
                                                      real_ptr
                                                    );
                         END;
& 59 offset min_f   &    BEGIN
                            STPNTR( real_ptr,
                                    cal_std_addr + f_min_offset
                                  );
                            active_fcn_value := real_ptr;
                         END;
& 60 offset max f   &    BEGIN
                            STPNTR( real_ptr,
                                    cal_std_addr + f_max_offset
                                  );
                            active_fcn_value := real_ptr;
                         END;
& 61 std id         &    BEGIN
                            active_fcn_value := current_std_id;
                         END;
& 62 std class      &    BEGIN
                            active_fcn_value := 1;
```

```
                        END;
& 63 # groups kbd   &    ;              & must be same as # groups hpib &
         END;  & case &

      display_active_fcn_value;

      release( active_function_rin );

   END;  & select_active_function &



#EJECT;
COMMENT                                                    select_active_off
**********************************************************************
*
*  Turns off the active function if and only if the specified function
*  (which_function) is the current active function.
*
**********************************************************************
;
PROCEDURE  select_active_off( which_function );
   VALUE   which_function;
   INTEGER which_function;                                          ENTRY;
   BEGIN & select_active_off &
      IF which_function = active_function THEN
         select_active_function( active_off );
   END;  & select_active_off &
```

```
#EJECT;
COMMENT                                                     enter_active_function
*************************************************************************************
*
*************************************************************************************
;
PROCEDURE  enter_active_function;                                           ENTRY;
   BEGIN & enter_active_function &
      BYTE   ARRAY   enter_array[-1:string_size];
      ALPHA      enter_string;
      QUAD       min,
                 temp_quad;
      REAL       active_fcn_real,
                 temp_real;
      INTEGER    position,
                 atten_nmbr,
                 ch_atten_port,
                 index;
      BYTE   POINTER  ch;

      SUBROUTINE set_atten;
         BEGIN & set_atten &
            abort_sweep;
            read_priv_ib( test_set,
                          atten_nmbr,
                          append_string( format_quad( active_fcn_value,
                                                      enter_string,
                                                      format_table[
                                                   test_set_atten_format
                                                                 ] OR
                                                             %000000C0
                                                    ),
                                         newline+"OA"
                                       ),
                          enter_string
                        );
            position := 1;
            active_fcn_real := CNV92( enter_string, position );
            set_entry_ch_real( active_fcn_real, ch_atten_port );
            active_fcn_value := active_fcn_real * scale_multiplier;
            build_test_set;
            restart_sweep;                      & also resets averaging &
         END;  & set_atten &

      & initialize string &
      enter_string := ADRS(enter_array);
      enter_string := init_string(enter_string,
                                  string_size
                                 );
      clear_string( entry_aux );

      active_fcn_value := limit_quad(active_fcn_value, active_function);


      & store value -- done here so chtable values can be used later &
      IF get_active(get_chtable_store, active_function) = store THEN
```

```
BEGIN & if &
   index := get_active( get_chtable_index, active_function );
   CASE get_active(get_chtable_type, active_function) OF
      BEGIN & case &
& none        & ;
& byte        & ; & bytes are no longer used in the chtable &
& integer     & set_entry_ch_integer( active_fcn_value, index );
& user3       & ; & not currently used &
& real        & BEGIN & real &
                   active_fcn_real := REAL(active_fcn_value) *
                                            unscale_multiplier;
                   set_entry_ch_real( active_fcn_real, index );
                END; & real &
& double      & ; & not currently used &
& quad        & set_entry_ch_quad( active_fcn_value, index );
              END; & case &
END; & if &


CASE active_function OF
   BEGIN & case &
&  0 off          &   ;
&  1 start        &   IF entry_ch_integer( ch_domain ) =
                            freq_domain THEN
                         wrt_priv_ib_source(
                                     fa,
                                     append_ch(
                                        format_quad(
                                           active_fcn_value,
                                           enter_string,
                                           format_table[
                                                  frequency_format
                                                     ]
                                                 ),
                                        newline
                                             )
                                       )
                      ELSE
                         BEGIN & else &
                            set_entry_ch_quad( active_fcn_value,
                                               ch_start_stimulus
                                             );
                            update_center;
                            check_update_domain;
                         END; & else &
&  2 stop         &   IF entry_ch_integer( ch_domain ) =
                            freq_domain THEN
                         wrt_priv_ib_source(
                                     fb,
                                     append_ch(
                                        format_quad(
                                           active_fcn_value,
                                           enter_string,
                                           format_table[
                                                  frequency_format
                                                     ]
```

```
                                                    ),
                                        newline
                                                )
                                            )
                          ELSE
                             BEGIN & else &
                                set_entry_ch_quad( active_fcn_value,
                                                   ch_stop_stimulus
                                                 );
                                update_center;
                                check_update_domain;
                             END;  & else &
& 3 center          &     IF entry_ch_integer( ch_domain ) =
                                freq_domain THEN
                             wrt_priv_ib_source(
                                      cf,
                                      append_ch(
                                         format_quad(
                                            active_fcn_value,
                                            enter_string,
                                            format_table[
                                                   frequency_format
                                                     ]
                                                  ),
                                        newline
                                                )
                                            )
                          ELSE
                             BEGIN & else &
                                set_entry_ch_quad( active_fcn_value,
                                                   ch_center_stimulus
                                                 );
                                update_start;
                                check_update_domain;
                             END;  & else &
& 4 span            &     IF entry_ch_integer( ch_domain ) =
                                freq_domain THEN
                             wrt_priv_ib_source(
                                      df,
                                      append_ch(
                                         format_quad(
                                            active_fcn_value,
                                            enter_string,
                                            format_table[
                                                   frequency_format
                                                     ]
                                                  ),
                                        newline
                                                )
                                            )
                          ELSE
                             BEGIN & else &
                                set_entry_ch_quad( active_fcn_value,
                                                   ch_span_stimulus
                                                 );
                                update_start;
```

```
                          check_update_domain;
                       END;  & else &
& 5 cw          &   IF entry_ch_integer( ch_domain ) =
                          freq_domain THEN
                       wrt_priv_ib_source(
                                    cw,
                                    append_ch(
                                       format_quad(
                                          active_fcn_value,
                                          enter_string,
                                          format_table[
                                                 frequency_format
                                                   ]
                                                ),
                                       newline
                                            )
                                          )
                    ELSE
                       BEGIN & else &
                          set_entry_ch_quad( active_fcn_value,
                                             ch_center_stimulus
                                           );
                          update_start;
                          check_update_domain;
                       END;  & else &
& 6 sweep time  &   BEGIN & sweep time &
                       wrt_priv_ib_source(
                                    st,
                                    append_ch(
                                       format_quad(
                                          active_fcn_value,
                                          enter_string,
                                          format_table[
                                                sweep_time_format
                                                   ] OR
                                              %000000C0
                                                ),
                                       newline
                                            )
                                    );
                    END;  & sweep time &
& 7 source power &  BEGIN & source power &
                       read_priv_ib( source,
                                     pl,
                                     append_string(
                                        format_quad(
                                           active_fcn_value,
                                           enter_string,
                                           format_table[
                                                source_pwr_format
                                                    ] OR
                                               %000000C0
                                                 ),
                                        newline+"OA"
                                               ),
                                     enter_string
```

```
                                  );
                    position := 1;
                    active_fcn_real := CNV92( enter_string,
                                              position
                                            );
                    set_entry_ch_real( active_fcn_real,
                                       ch_source_power
                                     );
                    active_fcn_value := active_fcn_real *
                                               scale_multiplier;
                 END;  & source power &
& 8 power slope  &  BEGIN & power slope &
                    read_priv_ib( source,
                                  sll,
                                  append_string(
                                     format_quad(
                                        active_fcn_value,
                                        enter_string,
                                        format_table[
                                                source_pwr_format
                                                   ] OR
                                             %000000C0
                                                ),
                                     newline+"OA"
                                                ),
                                  enter_string
                                 );
                    position := 1;
                    active_fcn_real := CNV92( enter_string,
                                              position
                                            );
                    set_entry_ch_real( active_fcn_real,
                                       ch_power_slope
                                     );
                    active_fcn_value := active_fcn_real *
                                               scale_multiplier;
                 END;  & power slope &
&  9 port 1 atten  &  BEGIN & port 1 atten &
                    atten_nmbr := atten1;
                    ch_atten_port := ch_atten_port1;
                    set_atten;
                 END;  & port 1 atten &
& 10 port 2 atten  &  BEGIN & port 2 atten &
                    atten_nmbr := atten2;
                    ch_atten_port := ch_atten_port2;
                    set_atten;
                 END;  & port 2 atten &
& 11 ref pos'n     &  BEGIN & ref pos'n &
                    index := entry_ch_integer(ch_format);
                    IF type_of_grat[ index ] <> rectangular THEN
                       index := fmt_log_polar;
                    wrt_disp_real( ADRS(
                       ref_position[ index,
                                     entry_ch_integer(ch_param),
                                     current_entry_ch
                                   ]
```

```
                                        ),
                                   active_fcn_real
                                 );
                    annotate_ref_position;
                    partial( update_f );
                 END;  & ref pos'n &
  & 12 scale/div      &  BEGIN & scale/div &
                    index := entry_ch_integer(ch_format);
                    IF type_of_grat[ index ] <> rectangular THEN
                       BEGIN & if polar &
                          index := fmt_log_polar;
                          temp_real := active_fcn_real * 5.0;
                          set_entry_ch_real( temp_real,
                                             ch_ref_value
                                           );
                          wrt_disp_real( ADRS( ref_value[
                                    index,
                                    entry_ch_integer(ch_param),
                                    current_entry_ch
                                                    ]
                                               ),
                                          temp_real
                                        );
                          annotate_ref_value;
                       END;  & if polar &
                    wrt_disp_real( ADRS(
                              scale[ index,
                                    entry_ch_integer(ch_param),
                                    current_entry_ch
                                  ]
                                      ),
                                  active_fcn_real
                                );
                    update_scale;
                 END;  & scale/div &
  & 13 ref value      &  BEGIN & ref value &
                    index := entry_ch_integer(ch_format);
                    IF type_of_grat[ index ] <> rectangular THEN
                       BEGIN & if polar &
                          index := fmt_log_polar;
                          temp_real := active_fcn_real * 0.2;
                          set_entry_ch_real(temp_real, ch_scale);
                          wrt_disp_real( ADRS( scale[
                                    index,
                                    entry_ch_integer(ch_param),
                                    current_entry_ch
                                                    ]
                                               ),
                                          temp_real
                                        );
                          annotate_scale;
                       END;  & if polar &
                    wrt_disp_real( ADRS(
                          ref_value[ index,
                                    entry_ch_integer(ch_param),
                                    current_entry_ch
```

```
                                       ]
                                          ),
                                       active_fcn_real
                                     );
                           update_ref_value;
                        END;  & ref value &
& 14 unused          &  ;
& 15 title           &  select_title_char(
                             1 + ARIGHT( INTEGER(active_fcn_value), 2 )
                                     );
& 16 # groups hpib   &  BEGIN          & must be same as # groups kbd  &
                                       & except for hold-off.          &
                           n_sweep( active_fcn_value );  & initializes &
                                                  & take_sweep_done &
                           release( active_function_rin );
                           wait( take_sweep_done );
                           acquire( active_function_rin );
                        END;  & # groups &
& 17 if avg factor   &  BEGIN & if averaging factor &
                           rebuild := TRUE;
                           group_number := 0; & reset averaging number &
                        END;  & if averaging factor &
& 18 smoothing aper.&   BEGIN & smoothing aperture &
                           active_fcn_real :=
                              REAL( entry_ch_quad(ch_span_stimulus) ) *
                              entry_ch_real(ch_smoothing_aperture)    /
                              100.0;
                           append_string(
                                format_real( active_fcn_real,
                                             entry_aux,
                                             format_table[
                                                          aperture_format
                                                          ]
                                            ),
                                active_suffix( active_span )
                                     );
                           partial( update_d );
                        END;  & smoothing aperture &
& 19 srq mask prim. &   BEGIN & srq mask prim. &
                           srq_mask_primary := active_fcn_value;
                           request_mask( srq_mask_primary );   & DEBUG &
                           COMMENT                             & DEBUG &
                           request_mask( LEFT(srq_mask_primary,8) OR
                                         (srq_mask_secondary AND %00FF)
                                       );
                        END;  & srq mask prim. &
& 20 srq mask secon.&   BEGIN & srq mask secon.&
                           srq_mask_secondary := active_fcn_value;
                           request_mask( LEFT(srq_mask_primary,8) OR
                                         (srq_mask_secondary AND %00FF)
                                       );
                        END;  & srq mask secon.&
& 21 revision        &  ;
& 22 aux out         &  BEGIN & auxiliary output voltage &
                           set_entry_ch_quad( active_fcn_value /
                                                    quad_aux_out_scaled,
```

```
                                        ch_center_aux_out
                                       );
                           set_aux_out;
                        END;  & auxiliary output voltage &
& 23 keycode       &    BEGIN & keycode &
                           & pass value back as next command &
                           command_token := active_fcn_value;
                           command_pending := TRUE;
                        END;  & keycode &
& 24 elec delay    &    BEGIN & electrical delay &
                           wrt_disp_real( ADRS(
                                elec_delay[ entry_ch_integer(ch_param),
                                            current_entry_ch
                                          ]
                                            ),
                                        active_fcn_real
                                      );
                           control_data_proc_freq(1);       & delay is &
                           control_data_proc_freq(2);       & coupled. &
                        END;  & electrical delay &
& 25 phase offset  &    BEGIN & phase offset &
                           control_data_proc_freq(1);
                           control_data_proc_freq(2);
                        END;  & phase offset &
& 26 marker1       &    activate_marker;
& 27 marker2       &    activate_marker;
& 28 marker3       &    activate_marker;
& 29 marker4       &    activate_marker;
& 30 marker5       &    activate_marker;
& 31 address       &    STPNTR( peek_n_poke,
                               DOUBLE( active_fcn_value ) AND %FFFFFFFE
                             );
& 32 peek          &    active_fcn_value := peek_n_poke;
& 33 poke          &    peek_n_poke := INTEGER(active_fcn_value);
& 34 open c0       &    BEGIN
                           active_fcn_real := unscale_multiplier *
                                              REAL(active_fcn_value);
                           wrt_disp_real( cal_std_addr + c0_offset,
                                          active_fcn_real
                                        );
                        END;
& 35 open c1       &    BEGIN
                           active_fcn_real := unscale_multiplier *
                                              REAL(active_fcn_value);
                           wrt_disp_real( cal_std_addr + c1_offset,
                                          active_fcn_real
                                        );
                        END;
& 36 open c2       &    BEGIN
                           active_fcn_real := unscale_multiplier *
                                              REAL(active_fcn_value);
                           wrt_disp_real( cal_std_addr + c2_offset,
                                          active_fcn_real
                                        );
                        END;
& 37 gate start    &    BEGIN
```

```
        set_entry_ch_quad(
                    entry_ch_quad(ch_gate_center) +
                    ( active_fcn_value -
                      entry_ch_quad(ch_gate_start)
                    ) / 2,
                    ch_gate_center
                         );
        set_entry_ch_quad( active_fcn_value,
                           ch_gate_start
                         );
        check_update_domain;
     END;
& 38 gate stop      &   BEGIN
        set_entry_ch_quad(
                    ( entry_ch_quad(ch_gate_start) +
                      active_fcn_value
                    ) / 2,
                    ch_gate_center
                         );
        set_entry_ch_quad( active_fcn_value,
                           ch_gate_stop
                         ); & only for gate markers &
        check_update_domain;
     END;
& 39 gate center    &   BEGIN
        set_entry_ch_quad(
                    entry_ch_quad(ch_gate_start) +
                    active_fcn_value -
                    entry_ch_quad(ch_gate_center),
                    ch_gate_start
                         );
        set_entry_ch_quad( active_fcn_value,
                           ch_gate_center
                         );
        temp_quad := active_fcn_value -
                     entry_ch_quad( ch_gate_start );
        set_entry_ch_quad(
                    entry_ch_quad(ch_gate_start) +
                          temp_quad + temp_quad,
                    ch_gate_stop
                         ); & only for gate markers &
        check_update_domain;
     END;
& 40 gate span      &   BEGIN
        temp_quad := active_fcn_value / 2;
        set_entry_ch_quad(
                    entry_ch_quad(ch_gate_center) -
                          temp_quad,
                    ch_gate_start
                         );
        set_entry_ch_quad(
                    entry_ch_quad(ch_gate_center) +
                          temp_quad,
                    ch_gate_stop
                         ); & only for gate markers &
        check_update_domain;
```

```
                             END;
& 41 mag slope       &       warn( command_not_implemented );
& 42 mag offset      &       warn( command_not_implemented );
& 43 stimulus slope  &       warn( command_not_implemented );
& 44 stimulus offset&        warn( command_not_implemented );
& 45 ref plane 1     &       BEGIN
                                control_data_proc_freq(1);      & plane is &
                                control_data_proc_freq(2);      & coupled. &
                             END;
& 46 ref plane 2     &       BEGIN
                                control_data_proc_freq(1);      & plane is &
                                control_data_proc_freq(2);      & coupled. &
                             END;
& 47 system z0       &       ;
& 48 major addr      &       BEGIN
                                set_priv_ib_lun(major,     active_fcn_value);
                                set_major_address(active_fcn_value);
                             END;
& 49 minor addr      &       BEGIN
                                set_priv_ib_lun(minor,     active_fcn_value);
                                set_minor_address(active_fcn_value);
                             END;
& 50 pass thru addr &        set_priv_ib_lun(priv_ib_pass, active_fcn_value);
& 51 source addr     &       set_priv_ib_lun(source,       active_fcn_value);
& 52 test-set addr   &       set_priv_ib_lun(test_set,     active_fcn_value);
& 53 plotter addr    &       set_priv_ib_lun(plotter,      active_fcn_value);
& 54 printer addr    &       set_priv_ib_lun(printer,      active_fcn_value);
& 55 ch cmd addr     &       set_priv_ib_lun(user_device_1,active_fcn_value);
& 56 offset delay    &       BEGIN
                                active_fcn_real := REAL(active_fcn_value) *
                                                           unscale_multiplier;
                                wrt_disp_real( cal_std_addr + delay_offset,
                                               active_fcn_real
                                             );
                             END;
& 57 offset loss     &       BEGIN
                                active_fcn_real := REAL(active_fcn_value) *
                                                           unscale_multiplier;
                                wrt_disp_real( cal_std_addr + loss_offset,
                                               active_fcn_real
                                             );
                             END;
& 58 offset z0       &       BEGIN
                                active_fcn_real := REAL(active_fcn_value) *
                                                           unscale_multiplier;
                                wrt_disp_real( cal_std_addr + z0_offset,
                                               active_fcn_real
                                             );
                             END;
& 59 offset min f    &       BEGIN
                                active_fcn_real := REAL( active_fcn_value );
                                wrt_disp_real( cal_std_addr + f_min_offset,
                                               active_fcn_real
                                             );
                             END;
& 60 offset max f    &       BEGIN
```

```
                        active_fcn_real := REAL( active_fcn_value );
                        wrt_disp_real( cal_std_addr + f_max_offset,
                                       active_fcn_real
                                     );
                     END;
& 61 std id       &  BEGIN
                        std_id(INTEGER(active_fcn_value));
                     END;
& 62 std class    &  BEGIN
                        std_class_element(INTEGER(active_fcn_value));
                     END;
& 63 # groups kbd &  n_sweep( active_fcn_value ); & must be same as &
                              & # groups hpib except for hold-off &
      END;  & case &

    display_active_fcn_value;

  END;  & enter_active_function &

END$
```

```
M68KL,P,"alabel"
BEGIN

#FILE cchars.work;

GLOBAL ALPHA TABLE active_function_label := & update CACTIVE file also &
   &  0 &  "",                                  & no active function (off) &
   &  1 &  "START",
   &  2 &  "STOP",
   &  3 &  "CENTER",
   &  4 &  "SPAN",
   &  5 &  "C.W.",
   &  6 &  "SWEEP TIME",
   &  7 &  "SOURCE POWER",
   &  8 &  "POWER SLOPE",                        & end of source functions &
   &  9 &  "PORT 1 ATTEN.",
   & 10 &  "PORT 2 ATTEN.",
   & 11 &  "REFERENCE LINE POSITION",
   & 12 &  "SCALE",
   & 13 &  "REFERENCE VALUE",
   & 14 &  "",                                                & unused    &
   & 15 &  "TITLE",
   & 16 &  "NUMBER OF GROUPS",
   & 17 &  "IF AVERAGING FACTOR",
   & 18 &  "SMOOTHING APERTURE",
   & 19 &  "SRQ MASK (PRIMARY)",
   & 20 &  "SRQ MASK (SECONDARY)",
   & 21 &  "",                & place holder for revision string address &
   & 22 &  "AUX. OUTPUT",
   & 23 &  "KEYCODE",
   & 24 &  "ELECTRICAL DELAY",
   & 25 &  "PHASE OFFSET",
   & 26 &  "MARKER 1    ",
   & 27 &  "MARKER 2    ",
   & 28 &  "MARKER 3    ",
   & 29 &  "MARKER 4    ",
   & 30 &  "MARKER 5    ",
   & 31 &  "PEEK/POKE ADDRESS",
   & 32 &  "PEEK",
   & 33 &  "POKE",
   & 34 &  half_vt+"C"+176+" (x10"+139+"-15"+138+" F)",
   & 35 &  half_vt+"C"+177+" (x10"+139+"-27"+138+" F/Hz)",
   & 36 &  half_vt+"C"+178+" (x10"+139+"-36"+138+" F/Hz"+181+")",
   & 37 &  "GATE START",
   & 38 &  "GATE STOP",
   & 39 &  "GATE CENTER",
   & 40 &  "GATE SPAN",
   & 41 &  "MAGNITUDE SLOPE",
   & 42 &  "MAGNITUDE OFFSET",
   & 43 &  "STIMULUS SLOPE",
   & 44 &  "STIMULUS OFFSET",
   & 45 &  "PORT 1 REF. PLANE",
   & 46 &  "PORT 2 REF. PLANE",
   & 47 &  "Z"+176,
   & 48 &  "8510 HP-IB ADDRESS",
```

```
& 49 &  "8510 HP-IB MINOR ADDRESS",
& 50 &  "PASS-THRU HP-IB ADDRESS",
& 51 &  "SOURCE HP-IB ADDRESS",
& 52 &  "TEST-SET HP-IB ADDRESS",
& 53 &  "PLOTTER HP-IB ADDRESS",
& 54 &  "PRINTER HP-IB ADDRESS",
& 55 &  "AUTO COMMAND HP-IB ADDRESS",
& 56 &  "OFFSET DELAY",
& 57 &  "OFFSET LOSS",
& 58 &  "OFFSET Z"+176,
& 59 &  "MIN. USABLE FREQUENCY",
& 60 &  "MAX. USABLE FREQUENCY",
& 61 &  "CALIBRATION STANDARD #",
& 62 &  "CALIBRATION STANDARD #",
& 63 &  "NUMBER OF GROUPS",
& 99 &  "";                                   & simply a place holder &

END$
```

```
M68KL,P,"atables"
BEGIN

#FILE catable2.work;
#FILE catables.work;
#FILE cchtable.work;
#FILE cchars.work;
```

```
#EJECT;
GLOBAL ALPHA TABLE suffix :=                & indexed by suffix_index &
   &  0 &   "",
   &  1 &   "Hz",
   &  2 &   "dB",          & change display_active_... if this changes &
   &  3 &   "Div",
   &  4 &   "s",                    & seconds without distance readout &
   &  5 &   "dBm",         & change display_active_... if this changes &
   &  6 &   "s",                       & seconds with distance readout &
   &  7 &   "V",
   &  8 &   degree,
   &  9 &   omega,
   & 10 &   "S",                                             & Siemen &
   & 11 &   "U.",         & Units for space critical marker annotation &
   & 12 &   "W",
   & 13 &   "Units",
   & 14 &   "% SPAN",
   & 15 &   "dB/GHz",
   & 16 &   omega+"/s",
   & 17 &   "m",                                             & meters &
   & XX &   "";

BYTE TABLE suffix_index_neg :=       & MUST BE EVEN LENGTH - PAD AT TOP &
   &-18                 &   format_dependent,
   &-17 log mag         &   2,
   &-16 lin mag         &  13,
   &-15 phase           &   8,
   &-14 delay           &   6,
   &-13 real            &  13,
   &-12 imag            &  13,
   &-11 log polar       &  13,
   &-10 lin polar       &  13,
   & -9 imag vs real    &  13,
   & -8 z smith         &  13,
   & -7 y smith         &  13,
   & -6 vswr            &   0,
   & -5                 &   domain_dependent,
   & -4 freq domain     &   1,
   & -3 time band-pass  &   6,
   & -2 time low-pass   &   6,
   & -1 aux  domain     &   7;
BYTE TABLE suffix_index :=                & indexed by active function &
   &  0 off             &   0,
   &  1 start           &  -5,
   &  2 stop            &  -5,
   &  3 center          &  -5,
   &  4 span            &  -5,
   &  5 cw              &  -5,
   &  6 sweep time      &   4,             & end of source functions &
   &  7 source power    &   5,
   &  8 power slope     &  15,
   &  9 port 1 atten    &   2,
   & 10 port 2 atten    &   2,
   & 11 ref pos'n       &   3,
   & 12 scale/div       & -18,
   & 13 ref value       & -18,
```

```
& 14 unused         &   0,
& 15 title          &   0,
& 16 # groups hpib  &   0,
& 17 if avg factor  &   0,
& 18 smoothing aper.&  14,
& 19 srq mask prim. &   0,
& 20 srq mask secon.&   0,
& 21 revision       &   0,
& 22 aux out        &   7,
& 23 keycode        &   0,
& 24 electr delay   &   6,
& 25 phase offset   &   8,
& 26 marker 1       &  -5,
& 27 marker 2       &  -5,
& 28 marker 3       &  -5,
& 29 marker 4       &  -5,
& 30 marker 5       &  -5,
& 31 address        &   0,
& 32 peek           &   0,
& 33 poke           &   0,
& 34 open c0        &   0,
& 35 open c1        &   0,
& 36 open c2        &   0,
& 37 gate start     &   6,
& 38 gate stop      &   6,
& 39 gate center    &   6,
& 40 gate span      &   6,
& 41 mag slope      &   0,
& 42 mag offset     &  13,
& 43 stimulus slope &   0,
& 44 stimulus offset&  -5,
& 45 ref plane 1    &   6,
& 46 ref plane 2    &   6,
& 47 system z0      &   9,
& 48 major addr     &   0,
& 49 minor addr     &   0,
& 50 pass thru addr &   0,
& 51 source addr    &   0,
& 52 test-set addr  &   0,
& 53 plotter addr   &   0,
& 54 printer addr   &   0,
& 55 ch cmd addr    &   0,
& 56 offset delay   &   6,
& 57 offset loss    &  16,
& 58 offset z0      &   9,
& 59 offset min f   &   1,
& 60 offset max f   &   1,
& 61 std id         &   0,
& 62 std class      &   0,
& 63 # groups kbd   &   0,
& 99 place holder   &   0;
GLOBAL BYTE TABLE mkr_real_suffix :=                & indexed by format &
                        0,
  &    log mag      &   2,
  &    lin mag      &  11, & temporary "U." for "Units" &   & DEBUG &
  &    phase        &   8,
```

```
    &   delay           &   6,
    &   real            &  11, & temporary "U." for "Units" &   & DEBUG &
    &   imag            &  11, & temporary "U." for "Units" &   & DEBUG &
    &   log polar       &   2,
    &   lin polar       &  11, & temporary "U." for "Units" &   & DEBUG &
    &   imag vs real    &  11, & temporary "U." for "Units" &   & DEBUG &
    &   z smith         &   9,
    &   y smith         &  10,
    &   vswr            &   0;
GLOBAL BYTE TABLE mkr_imag_suffix :=                & indexed by format &
                            0,
    &   log mag         &   0,
    &   lin mag         &   0,
    &   phase           &   0,
    &   delay           &   0,
    &   real            &   0,
    &   imag            &   0,
    &   log polar       &   8,
    &   lin polar       &   8,
    &   imag vs real    &  11, & temporary "U." for "Units" &   & DEBUG &
    &   z smith         &   9,
    &   y smith         &  10,
    &   vswr            &   0;
```

```
#EJECT;
& display formats &
GLOBAL DOUBLE TABLE format_table :=   & indexed by active_format_index &
   &  0 &           0,
   &  1 &   %1600140C,  & fixed exponent w/12 decimal digits &
   &  2 &   %1600140C,  & for values stored scaled -- tested by acttbl &
   &  3 &   %16051404,  & general_purpose floating point &
   &  4 &   %17001400,  & fixed integer &
   &  5 &   %1000000F,  & frequency format for private HP-IB &
   &  6 &   %1005000F,  & time and power to source &
   &  7 &   %3000180F,  & for HP-IB output &
   &  8 &   %37000800,  & for HP-IB integer output &
   &  9 &           0,  & unused &
   & 10 &   %17051404,  & forced 0 exponent &
   & 11 &   %17051400,  & fixed integer scaled &
   & 12 &   %1700140F;  & unused ? &

BYTE TABLE active_format_neg :=     & MUST BE EVEN LENGTH - PAD AT TOP &
   &-18 <min scale>    & format_dependent,
   &-17 log mag        &   3,
   &-16 lin mag        &   3,
   &-15 phase          &   3,
   &-14 delay          &   3,
   &-13 real           &   3,
   &-12 imag           &   3,
   &-11 log polar      &   3,
   &-10 lin polar      &   3,
   & -9 imag vs real   &   3,
   & -8 z smith        &   3,
   & -7 y smith        &   3,
   & -6 vswr           &  10,
   & -5 <start...>     & domain_dependent,
   & -4 freq domain    &   1,
   & -3 time band-pass &   2,
   & -2 time low-pass  &   2,
   & -1 aux  domain    &   2;
BYTE    TABLE active_format_index :=         & index into format_table &
   &  0 off            &   0,
   &  1 start          &  -5,
   &  2 stop           &  -5,
   &  3 center         &  -5,
   &  4 span           &  -5,
   &  5 cw             &  -5,
   &  6 sweep time     &   3,
   &  7 source power   &   3,
   &  8 power slope    &   3,
   &  9 port 1 atten   &   3,
   & 10 port 2 atten   &   3,
   & 11 ref pos'n      &   3,
   & 12 scale/div      & -18,
   & 13 ref value      & -18,
   & 14 unused         &   0,
   & 15 title          &   0,
   & 16 # groups hpib  &   0,
   & 17 if avg factor  &   3,
   & 18 smoothing aper.&  10,
```

```
    & 19 srq mask prim. &    4,
    & 20 srq mask secon.&    4,
    & 21 revision       &    0,
    & 22 aux out        &    3,
    & 23 keycode        &    0,
    & 24 electr delay   &    1,
    & 25 phase offset   &    3,
    & 26 marker 1       &   -5,
    & 27 marker 2       &   -5,
    & 28 marker 3       &   -5,
    & 29 marker 4       &   -5,
    & 30 marker 5       &   -5,
    & 31 address        &    4,
    & 32 peek           &    4,
    & 33 poke           &    4,
    & 34 open c0        &    3,
    & 35 open c1        &    3,
    & 36 open c2        &    3,
    & 37 gate start     &    2,
    & 38 gate stop      &    2,
    & 39 gate center    &    2,
    & 40 gate span      &    2,
    & 41 mag slope      &  -18,
    & 42 mag offset     &  -18,
    & 43 stimulus slope &    3,
    & 44 stimulus offset&   -5,
    & 45 ref plane 1    &    1,
    & 46 ref plane 2    &    1,
    & 47 system z0      &    3,
    & 48 major addr     &    4,
    & 49 minor addr     &    4,
    & 50 pass thru addr &    4,
    & 51 source addr    &    4,
    & 52 test-set addr  &    4,
    & 53 plotter addr   &    4,
    & 54 printer addr   &    4,
    & 55 ch cmd addr    &    4,
    & 56 offset delay   &    1,
    & 57 offset loss    &    3,
    & 58 offset z0      &    3,
    & 59 offset min f   &    3,
    & 60 offset max f   &    3,
    & 61 std id         &    0,
    & 62 std class      &    0,
    & 63 # groups kbd   &    0,
    & 99 place holder   &    0;
GLOBAL BYTE TABLE mkr_real_format :=                & indexed by format &
                                 0,
    &    log mag        &   10,
    &    lin mag        &    3,
    &    phase          &    3,
    &    delay          &    3,
    &    real           &    3,
    &    imag           &    3,
    &    log polar      &   10,
    &    lin polar      &    3,
```

```
    &    imag vs real   &   3,
    &    z smith        &   3,
    &    y smith        &   3,
    &    vswr           &  10;
GLOBAL BYTE TABLE mkr_imag_format :=                 & indexed by format &
                            0,
    &    log mag        &   0,
    &    lin mag        &   0,
    &    phase          &   0,
    &    delay          &   0,
    &    real           &   0,
    &    imag           &   0,
    &    log polar      &   3,
    &    lin polar      &   3,
    &    imag vs real   &   3,
    &    z smith        &   3,
    &    y smith        &   3,
    &    vswr           &   0;
```

```
#EJECT;
GLOBAL QUAD TABLE limit := & indexed by min_limit_ and max_limit_index &
&   /  .  /  /  /  /  --  / = 10**3   . = 10**12  &
                       0, &  0 no limit operation &
                       0, &  1 zero &
                       1, &  2 &
                      10, &  3 &
                      22, &  4 max number of cal standards &
                      31, &  5 maximum HP-IB address (31=off) &
                     199, &  6 (4 times max title set index) - 1 &
                    4096, &  7 &
                   65535, &  8 max integer     = %000000000000FFFF &
                  -32768, &  9 min integer     = %FFFFFFFFFFFF8000 &
               -25000000, & 10 min time (time domain) scaled &
             20000000000, & 11 max time (time domain) scaled &
                       0, & 12 min frequency (modified by test-set limits) &
                       0, & 13 min marker -- set by update_start_stop_... &
              1000000000, & 14 scaled 0.001 &
             -2147483648, & 15 min double      = %FFFFFFFF80000000 &
              4294967295, & 16 max double      = %00000000FFFFFFFF &
             10000000000, & 17 scaled 0.01 &
            100000000000, & 18 scaled 0.1 (min smoothing aperture only) &
            999000000000, & 19 max marker -- set by update_start_stop_... &
            999000000000, & 20 max frequency (modified by test-set limits) &
            999000000000, & 21 max frequency (unlimited by source/testset) &
           2000000000000, & 22 scaled 2 &
           9995117190000, & 23 scale_factor*10/2048 -- max aux out &
        -10000000000000, & 24 scaled  -10 &
         10000000000000, & 25 scaled   10 &
         20000000000000, & 26 scaled 20       = 000001D1A94A2000 &
-100000000000000000, & 27 scaled -100@15 &
 100000000000000000, & 28 scaled  100@15 &
         127000000000000, & 29 max byte scaled = %00000B8CF2FD1800 &
        -360000000000000, & 30 scaled -360 &
         360000000000000, & 31 scaled  360 &
        -500000000000000, & 32 scaled -500 &
         500000000000000, & 33 scaled  500 &
            200000000000, & 34 scaled 0.2 temporary Smith ref_value&& DEBUG &
             40000000000; & 34 scaled 0.04 temporary Smith scale &  & DEBUG &
&   \  .  \  \  \  \  --  \ = 10**3   . = 10**12  &

BYTE TABLE min_limit_index_neg :=   & MUST BE EVEN LENGTH - PAD AT TOP &
   &-32 filler          &  0,
   &-31 <min ref_value>& format_dependent,
   &-30 log mag         &  32,
   &-29 lin mag         &  32,
   &-28 phase           &  32,
   &-27 delay           &  32,
   &-26 real            &  32,
   &-25 imag            &  32,
   &-24 log polar       &  32,
   &-23 lin polar       &  32,
   &-22 imag vs real    &  32,
   &-21 z smith         &  34,
   &-20 y smith         &  34,
   &-19 vswr            &  32,
```

```
    &-18 <min scale>    & format_dependent,
    &-17 log mag        &  14,
    &-16 lin mag        &   3,
    &-15 phase          &   3,
    &-14 delay          &   3,
    &-13 real           &   3,
    &-12 imag           &   3,
    &-11 log polar      &  14,
    &-10 lin polar      &   3,
    & -9 imag vs real   &   3,
    & -8 z smith        &  35,
    & -7 y smith        &  35,
    & -6 vswr           &   3,
    & -5 <start...>     & domain_dependent,
    & -4 freq domain    &  12,
    & -3 time band-pass &  10,
    & -2 time low-pass  &  10,
    & -1 aux  domain    &  24;
BYTE TABLE min_limit_index :=                      & index into limit table &
    &  0 off            &   0,                     &  0 means no limit      &
    &  1 start          &  -5,
    &  2 stop           &  -5,
    &  3 center         &  -5,
    &  4 span           &   0,
    &  5 cw             &  -5,
    &  6 sweep time     &  17,
    &  7 source power   &   0,
    &  8 power slope    &   0,
    &  9 port 1 atten   &   1,
    & 10 port 2 atten   &   1,
    & 11 ref pos'n      &   1,
    & 12 scale/div      & -18,
    & 13 ref value      & -31,
    & 14 unused         &   0,
    & 15 title          &   1,
    & 16 # groups hpib  &   2,
    & 17 if avg factor  &   1,
    & 18 smoothing aper.&  18,
    & 19 srq mask prim. &   1,
    & 20 srq mask secon.&   1,
    & 21 revision       &   0,
    & 22 aux out        &  24,
    & 23 keycode        &   1,
    & 24 electr delay   &  27,
    & 25 phase offset   &  30,
    & 26 marker 1       &  13,   & domain dependence handled by dynamic &
    & 27 marker 2       &  13,   & limit changes with start_stop_...    &
    & 28 marker 3       &  13,
    & 29 marker 4       &  13,
    & 30 marker 5       &  13,
    & 31 address        &  15,
    & 32 peek           &   0,
    & 33 poke           &   9,
    & 34 open c0        &   0,
    & 35 open c1        &   0,
    & 36 open c2        &   0,
```

```
   & 37 gate start      &  10,
   & 38 gate stop       &  10,
   & 39 gate center     &  10,
   & 40 gate span       &  10,
   & 41 mag slope       &   0,
   & 42 mag offset      &   0,
   & 43 stimulus slope  &   0,
   & 44 stimulus offset&   0,
   & 45 ref plane 1     &  27,
   & 46 ref plane 2     &  27,
   & 47 system z0       &  22,
   & 48 major addr      &   1,
   & 49 minor addr      &   1,
   & 50 pass thru addr  &   1,
   & 51 source addr     &   1,
   & 52 test-set addr   &   1,
   & 53 plotter addr    &   1,
   & 54 printer addr    &   1,
   & 55 ch cmd addr     &   1,
   & 56 offset delay    &  27,
   & 57 offset loss     &   0,
   & 58 offset z0       &   0,
   & 59 offset min f    &   1,
   & 60 offset max f    &   1,
   & 61 std id          &   2,
   & 62 std class       &   2,
   & 63 # groups kbd    &   2,
   & 99 place holder    &   0;

BYTE TABLE max_limit_index_neg :=   & MUST BE EVEN LENGTH - PAD AT TOP &
   &-18 <max_scale>     & format_dependent,
   &-17 log mag         &  33,
   &-16 lin mag         &  33,
   &-15 phase           &  33,
   &-14 delay           &  28,
   &-13 real            &  33,
   &-12 imag            &  33,
   &-11 log polar       &  33,
   &-10 lin polar       &  33,
   & -9 imag vs real    &  33,
   & -8 z smith         &  33,
   & -7 y smith         &  33,
   & -6 vswr            &  33,
   & -5                 & domain_dependent,
   & -4 freq domain     &  20,
   & -3 time band-pass  &  11,
   & -2 time low-pass   &  11,
   & -1 aux  domain     &  23;
BYTE TABLE max_limit_index :=                 & index into limit table &
   &  0 off             &   0,                &  0 means no limit      &
   &  1 start           &  -5,
   &  2 stop            &  -5,
   &  3 center          &  -5,
   &  4 span            &   0,
   &  5 cw              &  -5,
   &  6 sweep time      &  33,
```

```
& 7 source power    &   0,
& 8 power slope     &   0,
& 9 port 1 atten    &  29,
& 10 port 2 atten   &  29,
& 11 ref pos'n      &  25,
& 12 scale/div      & -18,
& 13 ref value      &  33,
& 14 unused         &   0,
& 15 title          &   6,
& 16 # groups hpib  &   7,
& 17 if avg factor  &   7,
& 18 smoothing aper.&  26,
& 19 srq mask prim. &   8,
& 20 srq mask secon.&   8,
& 21 revision       &   0,
& 22 aux out        &  23,
& 23 keycode        &   8,
& 24 electr delay   &  28,
& 25 phase offset   &  31,
& 26 marker 1       &  19,   & domain dependence handled by dynamic &
& 27 marker 2       &  19,   & limit changes with start_stop_...    &
& 28 marker 3       &  19,
& 29 marker 4       &  19,
& 30 marker 5       &  19,
& 31 address        &  16,
& 32 peek           &   0,
& 33 poke           &   8,
& 34 open c0        &   0,
& 35 open c1        &   0,
& 36 open c2        &   0,
& 37 gate start     &  11,
& 38 gate stop      &  11,
& 39 gate center    &  11,
& 40 gate span      &  11,
& 41 mag slope      &   0,
& 42 mag offset     &  33,
& 43 stimulus slope &   0,
& 44 stimulus offset&  -5,
& 45 ref plane 1    &  28,
& 46 ref plane 2    &  28,
& 47 system z0      &  33,
& 48 major addr     &   5,
& 49 minor addr     &   5,
& 50 pass thru addr &   5,
& 51 source addr    &   5,
& 52 test-set addr  &   5,
& 53 plotter addr   &   5,
& 54 printer addr   &   5,
& 55 ch cmd addr    &   5,
& 56 offset delay   &  28,
& 57 offset loss    &   0,
& 58 offset z0      &   0,
& 59 offset min f   &  21,
& 60 offset max f   &  21,
& 61 std id         &   4,
& 62 std class      &   4,

                    & 63 # groups kbd   &   7,
                    & 99 place holder   &   0;
```

```
#EJECT;
INTEGER TABLE chtable_index_neg :=  & MUST BE EVEN LENGTH - PAD AT TOP &
   &-10               &  domain_dependent,
   & -9 freq domain    &  ch_center_stimulus,        & freq via HP-IB &
   & -8 time band-pass &  ch_center_time,
   & -7 time low-pass  &  ch_center_time,
   & -6 aux  domain    &  ch_center_aux_out,
   & -5                &  domain_dependent,
   & -4 freq domain    &  ch_start_stimulus,         & freq via HP-IB &
   & -3 time band-pass &  ch_start_time,
   & -2 time low-pass  &  ch_start_time,
   & -1 aux  domain    &  ch_start_aux_out;
INTEGER TABLE chtable_index :=               & indexed by active_function &
   &  0 off            &   0,
   &  1 start          &  -5,
   &  2 stop           &  ch_stop_stimulus, & must also be "dont_store"&
   &  3 center         & -10,
   &  4 span           &  ch_span_stimulus, & must also be "dont_store"&
   &  5 cw             & -10,
   &  6 sweep time     &  ch_sweep_time,
   &  7 source power   &  ch_source_power,
   &  8 power slope    &  ch_power_slope,
   &  9 port 1 atten   &  ch_atten_port1,   & must also be "dont_store"&
   & 10 port 2 atten   &  ch_atten_port2,   & must also be "dont_store"&
   & 11 ref pos'n      &  ch_ref_position,
   & 12 scale/div      &  ch_scale,
   & 13 ref value      &  ch_ref_value,
   & 14 unused         &   0,
   & 15 title          &   0,
   & 16 # groups hpib  &   0,
   & 17 if avg factor  &  ch_average_factor,
   & 18 smoothing aper.&  ch_smoothing_aperture,
   & 19 srq mask prim. &   0,
   & 20 srq mask secon.&   0,
   & 21 revision       &   0,
   & 22 aux out        &  ch_center_aux_out,
   & 23 keycode        &   0,
   & 24 electr delay   &  ch_elec_delay,
   & 25 phase offset   &  ch_phase_offset,
   & 26 marker 1       &  ch_marker1,
   & 27 marker 2       &  ch_marker2,
   & 28 marker 3       &  ch_marker3,
   & 29 marker 4       &  ch_marker4,
   & 30 marker 5       &  ch_marker5,
   & 31 address        &   0,
   & 32 peek           &   0,
   & 33 poke           &   0,
   & 34 open c0        &   0,
   & 35 open c1        &   0,
   & 36 open c2        &   0,
   & 37 gate start     &  ch_gate_start,
   & 38 gate stop      &  ch_gate_stop,
   & 39 gate center    &  ch_gate_center,
   & 40 gate span      &   0,
   & 41 mag slope      &  ch_magnitude_slope,
   & 42 mag offset     &  ch_magnitude_offset,
```

```
        & 43 stimulus slope &  ch_stimulus_slope,
        & 44 stimulus offset&  ch_stimulus_offset,
        & 45 ref plane 1    &  ch_ref_plane_1,
        & 46 ref plane 2    &  ch_ref_plane_2,
        & 47 system z0      &  ch_system_z0,
        & 48 major addr     &   0,
        & 49 minor addr     &   0,
        & 50 pass thru addr &   0,
        & 51 source addr    &   0,
        & 52 test-set addr  &   0,
        & 53 plotter addr   &   0,
        & 54 printer addr   &   0,
        & 55 ch cmd addr    &   0,
        & 56 offset delay   &   0,
        & 57 offset loss    &   0,
        & 58 offset z0      &   0,
        & 59 offset min f   &   0,
        & 60 offset max f   &   0,
        & 61 std id         &   0,
        & 62 std class      &   0,
        & 63 # groups kbd   &   0,
        & 99 place holder   &   0;


   BYTE TABLE chtable_type :=                       & indexed by active_function &
        &  0 off            &       ch_none,        & select_active_function uses&
        &  1 start          &  ch_quad_type,        & chtable_type to determine  &
        &  2 stop           &  ch_quad_type,        & whether to perform an auto-&
        &  3 center         &  ch_quad_type,        & value load.  ch_none == no.&
        &  4 span           &  ch_quad_type,
        &  5 cw             &  ch_quad_type,
        &  6 sweep time     &  ch_real_type,
        &  7 source power   &  ch_real_type,
        &  8 power slope    &  ch_real_type,
        &  9 port 1 atten   &  ch_real_type,
        & 10 port 2 atten   &  ch_real_type,
        & 11 ref pos'n      &  ch_real_type,
        & 12 scale/div      &  ch_real_type,
        & 13 ref value      &  ch_real_type,
        & 14 unused         &       ch_none,
        & 15 title          &       ch_none,
        & 16 # groups hpib  &       ch_none,
        & 17 if avg factor  &  ch_integer_type,
        & 18 smoothing aper.&  ch_real_type,
        & 19 srq mask prim. &       ch_none,
        & 20 srq mask secon.&       ch_none,
        & 21 revision       &       ch_none,
        & 22 aux out        &  ch_quad_type,
        & 23 keycode        &       ch_none,
        & 24 electr delay   &  ch_real_type,
        & 25 phase offset   &  ch_real_type,
        & 26 marker 1       &  ch_quad_type,
        & 27 marker 2       &  ch_quad_type,
        & 28 marker 3       &  ch_quad_type,
        & 29 marker 4       &  ch_quad_type,
```

```
& 30 marker 5       &  ch_quad_type,
& 31 address        &       ch_none,
& 32 peek           &       ch_none,
& 33 poke           &       ch_none,
& 34 open c0        &       ch_none,
& 35 open c1        &       ch_none,
& 36 open c2        &       ch_none,
& 37 gate start     &  ch_quad_type,
& 38 gate stop      &  ch_quad_type,
& 39 gate center    &  ch_quad_type,
& 40 gate span      &  ch_quad_type,
& 41 mag slope      &  ch_real_type,
& 42 mag offset     &  ch_real_type,
& 43 stimulus slope &  ch_real_type,
& 44 stimulus offset&  ch_quad_type,
& 45 ref plane 1    &  ch_real_type,
& 46 ref plane 2    &  ch_real_type,
& 47 system z0      &  ch_real_type,
& 48 major addr     &       ch_none,
& 49 minor addr     &       ch_none,
& 50 pass thru addr &       ch_none,
& 51 source addr    &       ch_none,
& 52 test-set addr  &       ch_none,
& 53 plotter addr   &       ch_none,
& 54 printer addr   &       ch_none,
& 55 ch cmd addr    &       ch_none,
& 56 offset delay   &       ch_none,
& 57 offset loss    &       ch_none,
& 58 offset z0      &       ch_none,
& 59 offset min f   &       ch_none,
& 60 offset max f   &       ch_none,
& 61 std id         &       ch_none,
& 62 std class      &       ch_none,
& 63 # groups kbd   &       ch_none,
& 99 place holder   &       ch_none;


GLOBAL REAL TABLE scale_factors :=
   1.0,        & 0 &
   1.0@3,      & 1 &
   1.0@6,      & 2 &
   1.0@9,      & 3 &
   1.0@12,     & 4 &
   1.0@15;     & 5 &
GLOBAL REAL TABLE unscale_factors :=
   1.0,        & 0 &
   1.0@-3,     & 1 &
   1.0@-6,     & 2 &
   1.0@-9,     & 3 &
   1.0@-12,    & 4 &
   1.0@-15;    & 5 &

BYTE TABLE log_scale_div_3_neg :=   & MUST BE EVEN LENGTH - PAD AT TOP &
   &-18 scale/ref value&   format_dependent,
   &-17 log mag        &                 4,
```

```
    &-16 lin mag          &          4,
    &-15 phase            &          4,
    &-14 delay            &          5,
    &-13 real             &          4,
    &-12 imag             &          4,
    &-11 log polar        &          4,
    &-10 lin polar        &          4,
    & -9 imag vs real     &          4,
    & -8 z smith          &          4,
    & -7 y smith          &          4,
    & -6 vswr             &          4,
    & -5 stimulus/mkrs    & domain_dependent,
    & -4 freq domain      &          0,
    & -3 time band-pass   &          5,
    & -2 time low-pass    &          5,
    & -1 aux  domain      &          4;
GLOBAL BYTE TABLE log_scale_div_3 :=        & indexed by active_function &
    &  0 off              &          0,              & limited to 0 to 5 &
    &  1 start            &         -5,
    &  2 stop             &         -5,
    &  3 center           &         -5,
    &  4 span             &         -5,
    &  5 cw               &         -5,
    &  6 sweep time       &          4,
    &  7 source power     &          4,
    &  8 power slope      &          4,
    &  9 port 1 atten     &          4,
    & 10 port 2 atten     &          4,
    & 11 ref pos'n        &          4,
    & 12 scale/div        &        -18,
    & 13 ref value        &        -18,
    & 14 unused           &          0,
    & 15 title            &          0,
    & 16 # groups hpib    &          0,
    & 17 if avg factor    &          0,
    & 18 smoothing aper.&            4,
    & 19 srq mask prim.   &          0,
    & 20 srq mask secon.&            0,
    & 21 revision         &          0,
    & 22 aux out          &          4,
    & 23 keycode          &          0,
    & 24 electr delay     &          5,
    & 25 phase offset     &          4,
    & 26 marker 1         &         -5,
    & 27 marker 2         &         -5,
    & 28 marker 3         &         -5,
    & 29 marker 4         &         -5,
    & 30 marker 5         &         -5,
    & 31 address          &          0,
    & 32 peek             &          0,
    & 33 poke             &          0,
    & 34 open c0          &          4,
    & 35 open c1          &          4,
    & 36 open c2          &          4,
    & 37 gate start       &          5,
    & 38 gate stop        &          5,
```

```
& 39 gate center    &           5,
& 40 gate span      &           5,
& 41 mag slope      &           4,
& 42 mag offset     &           4,
& 43 stimulus slope &           4,
& 44 stimulus offset&          -5,
& 45 ref plane 1    &           5,
& 46 ref plane 2    &           5,
& 47 system z0      &           4,
& 48 major addr     &           0,
& 49 minor addr     &           0,
& 50 pass thru addr &           0,
& 51 source addr    &           0,
& 52 test-set addr  &           0,
& 53 plotter addr   &           0,
& 54 printer addr   &           0,
& 55 ch cmd addr    &           0,
& 56 offset delay   &           5,
& 57 offset loss    &           4,
& 58 offset z0      &           4,
& 59 offset min f   &           0,
& 60 offset max f   &           0,
& 61 std id         &           0,
& 62 std class      &           0,
& 63 # groups kbd   &           0,
& 99 place holder   &           0;


BYTE TABLE chtable_store_neg :=      & MUST BE EVEN LENGTH - PAD AT TOP &
   & -6 filler        &          0,
   & -5               & domain_dependent,
   & -4 freq domain   &     dont_store,
   & -3 time band-pass &         store,
   & -2 time low-pass &          store,
   & -1 aux  domain   &          store;
BYTE TABLE chtable_store :=                 & indexed by active_function &
   &  0 off           &     dont_store,
   &  1 start         &             -5,
   &  2 stop          &     dont_store,
   &  3 center        &             -5,
   &  4 span          &     dont_store,
   &  5 cw            &             -5,
   &  6 sweep time    &     dont_store,
   &  7 source power  &     dont_store,
   &  8 power slope   &     dont_store,
   &  9 port 1 atten  &     dont_store,
   & 10 port 2 atten  &     dont_store,
   & 11 ref pos'n     &          store,
   & 12 scale/div     &          store,
   & 13 ref value     &          store,
   & 14 unused        &          store,
   & 15 title         &     dont_store,
   & 16 # groups hpib &          store,
   & 17 if avg factor &          store,
   & 18 smoothing aper.&         store,
```

```
& 19 srq mask prim. &        store,
& 20 srq mask secon.&        store,
& 21 revision       &        store,
& 22 aux out        &        store,
& 23 keycode        &        store,
& 24 electr delay   &        store,
& 25 phase offset   &        store,
& 26 marker 1       &   dont_store,
& 27 marker 2       &   dont_store,
& 28 marker 3       &   dont_store,
& 29 marker 4       &   dont_store,
& 30 marker 5       &   dont_store,
& 31 address        &   dont_store,
& 32 peek           &   dont_store,
& 33 poke           &   dont_store,
& 34 open c0        &   dont_store,
& 35 open c1        &   dont_store,
& 36 open c2        &   dont_store,
& 37 gate start     &   dont_store,
& 38 gate stop      &   dont_store,
& 39 gate center    &   dont_store,
& 40 gate span      &   dont_store,
& 41 mag slope      &        store,
& 42 mag offset     &        store,
& 43 stimulus slope &        store,
& 44 stimulus offset&        store,
& 45 ref plane 1    &        store,
& 46 ref plane 2    &        store,
& 47 system z0      &        store,
& 48 major addr     &   dont_store,
& 49 minor addr     &   dont_store,
& 50 pass thru addr &   dont_store,
& 51 source addr    &   dont_store,
& 52 test-set addr  &   dont_store,
& 53 plotter addr   &   dont_store,
& 54 printer addr   &   dont_store,
& 55 ch cmd addr    &   dont_store,
& 56 offset delay   &   dont_store,
& 57 offset loss    &   dont_store,
& 58 offset z0      &   dont.store,
& 59 offset min f   &   dont_store,
& 60 offset max f   &   dont_store,
& 61 std id         &   dont_store,
& 62 std class      &   dont_store,
& 63 # groups kbd   &        store,
& 99 place holder   &            0;
```

```
#EJECT;
COMMENT                                                              algorithms
********************************************************************************
*
* Algorithms are from routines in SACTIVE.WORK
*
* bit  15    = sign
* bits 14-12 = keypad
* bits 11- 8 = marker
* bits  7- 4 = rpg
* bits  3- 0 = step
*
* KEYPAD ALGORITHMS:
*   0 - keypad disabled
*   1 - terminator keys represent positive exponents
*   2 - terminator keys represent negative exponents
*   3-7 undefined
* "=MARKER" ALGORITHMS:
*   0 - "=MARKER" is inconsistent for current active function
*   1 - use marker stimulus value (e.g. for center frequency)
*   2 - use marker amplitude (e.g. for reference value)
*   3 - use marker magnitude (e.g. for magnitude offset)
*   4 - use marker phase     (e.g. for phase offset)
*   5-F undefined
* RPG ALGORITHMS:
*   0 - rpg disabled
*   1 - hpib source update protocol
*   2 - .1% of stimulus span       value + rpg_count*span/1000
*   3 - count                      value + rpg_count
*   4 - 1                          value + 1*(sign of rpg_count)
*   5 - count/20      [scaled]     value + rpg_count/20
*   6 - .1% scale/div [scaled]     value + rpg_count*scale/1000
*   7 - .1% value     [scaled]     value + rpg_count*value/1000
*   8 - count/10                   value + rpg_count/10
*   9 - count/100     [scaled]     value + rpg_count/100
*   A - count*count*count          value + rpg_count*rpg_count*rpg_count
*   B-F undefined
* STEP KEY ALGORITHMS:
*   0 - step keys disabled
*   1 - hpib source update protocol
*   2 - 1-2-5 sequence  [scaled or unscaled]
*   3 - 10% of stimulus span            value + step_sign*span/10
*   4 - 1               [scaled]        value + 1*step_sign
*   5 - 1 division      [scaled]        value + step_sign*scale/div
*   6 - undefined
*   7 - 1 division                      value + step_sign*scale/div
*   8 - 10% of value    [scaled]        value + step_sign*value/10
*   9 - 1                               value + 1*step_sign
*   A - 10              [scaled]        value + 10*step_sign
*   B-F undefined
*
* [scaled] algorithms apply to active functions that are scaled (see
*    "scale_factor").
*
********************************************************************************
;
```

```
INTEGER TABLE algorithms_neg :=     & MUST BE EVEN LENGTH - PAD AT TOP &
   &-20 gate markers   & domain_dependent,
   &-19 freq domain    &   %2072,
   &-18 time band-pass &   %2123,
   &-17 time low-pass  &   %2123,
   &-16 aux  domain    &   %2072,
   &-15 delays         & domain_dependent,
   &-14 freq domain    &   %2232,
   &-13 time band-pass &   %21A2,
   &-12 time low-pass  &   %21A2,
   &-11 aux  domain    &   %20A2,
   &-10 markers        & domain_dependent,
   & -9 freq domain    &   %1123,
   & -8 time band-pass &   %2123,
   & -7 time low-pass  &   %2123,
   & -6 aux  domain    &   %2123,
   & -5 stimuli        & domain_dependent,
   & -4 freq domain    &   %1111,
   & -3 time band-pass &   %2123,
   & -2 time low-pass  &   %2123,
   & -1 aux  domain    &   %2123;
INTEGER TABLE algorithms :=
   &  0 off            &   %0000,
   &  1 start          &      -5,
   &  2 stop           &      -5,
   &  3 center         &      -5,
   &  4 span           &      -5,
   &  5 cw             &      -5,
   &  6 sweep time     &   %2011,          & end of source functions &
   &  7 source power   &   %2054,
   &  8 power slope    &   %2054,
   &  9 port 1 atten   &   %100A,
   & 10 port 2 atten   &   %100A,
   & 11 ref pos'n      &   %2054,
   & 12 scale/div      &   %2062,
   & 13 ref value      &   %2265,
   & 14 unused         &   %0000,
   & 15 title          &   %1089,
   & 16 # groups hpib  &   %1000,
   & 17 if avg factor  &   %1082,
   & 18 smoothing aper.&   %1052,
   & 19 srq mask prim. &   %1000,
   & 20 srq mask secon.&   %1000,
   & 21 revision       &   %0000,
   & 22 aux out        &   %2054,
   & 23 keycode        &   %1000,
   & 24 electr delay   &     -15,
   & 25 phase offset   &   %1492,
   & 26 marker 1       &     -10,
   & 27 marker 2       &     -10,
   & 28 marker 3       &     -10,
   & 29 marker 4       &     -10,
   & 30 marker 5       &     -10,
   & 31 address        &   %1039,
   & 32 peek           &   %1000,
   & 33 poke           &   %1039,
```

```
& 34 open c0          &     %1000,
& 35 open c1          &     %1000,
& 36 open c2          &     %1000,
& 37 gate start       &       -20,
& 38 gate stop        &       -20,
& 39 gate center      &       -20,
& 40 gate span        &       -20,
& 41 mag slope        &     %2072,
& 42 mag offset       &     %2272,
& 43 stimulus slope   &     %2072,
& 44 stimulus offset&          -5,
& 45 ref plane 1      &       -15,
& 46 ref plane 2      &       -15,
& 47 system z0        &     %2072,
& 48 major addr       &     %1049,
& 49 minor addr       &     %1049,
& 50 pass thru addr   &     %1049,
& 51 source addr      &     %1049,
& 52 test-set addr    &     %1049,
& 53 plotter addr     &     %1049,
& 54 printer addr     &     %1049,
& 55 ch cmd addr      &     %1049,
& 56 offset delay     &     %21A2,
& 57 offset loss      &     %2172,
& 58 offset z0        &     %2072,
& 59 offset min f     &     %1111,
& 60 offset max f     &     %1111,
& 61 std id           &     %1000,
& 62 std class        &     %1000,
& 63 # groups kbd     &     %1000,
& 99 place holder     &     %0000;
```

```
#EJECT;
GLOBAL                                                          & DEBUG &
BYTE TABLE display_alternate_value :=
   &  0 off              &    dont_display_alt,
   &  1 start            &    dont_display_alt,
   &  2 stop             &    dont_display_alt,
   &  3 center           &    dont_display_alt,
   &  4 span             &    dont_display_alt,
   &  5 cw               &    dont_display_alt,
   &  6 sweep time       &    dont_display_alt,
   &  7 source power     &    dont_display_alt,
   &  8 power slope      &    dont_display_alt,
   &  9 port 1 atten     &    dont_display_alt,
   & 10 port 2 atten     &    dont_display_alt,
   & 11 ref pos'n        &    dont_display_alt,
   & 12 scale/div        &    dont_display_alt,
   & 13 ref value        &    dont_display_alt,
   & 14 unused           &    dont_display_alt,
   & 15 title            &    dont_display_alt,
   & 16 # groups hpib    &    dont_display_alt,
   & 17 if avg factor    &    dont_display_alt,
   & 18 smoothing aper.&      dont_display_alt,
   & 19 srq mask prim.   &    dont_display_alt,
   & 20 srq mask secon.&      dont_display_alt,
   & 21 revision         &    dont_display_alt,
   & 22 aux out          &    dont_display_alt,
   & 23 keycode          &    dont_display_alt,
   & 24 electr delay     &    dont_display_alt,
   & 25 phase offset     &    dont_display_alt,
   & 26 marker 1         &         display_alt,
   & 27 marker 2         &         display_alt,
   & 28 marker 3         &         display_alt,
   & 29 marker 4         &         display_alt,
   & 30 marker 5         &         display_alt,
   & 31 address          &    dont_display_alt,
   & 32 peek             &    dont_display_alt,
   & 33 poke             &    dont_display_alt,
   & 34 open c0          &    dont_display_alt,
   & 35 open c1          &    dont_display_alt,
   & 36 open c2          &    dont_display_alt,
   & 37 gate start       &    dont_display_alt,
   & 38 gate stop        &    dont_display_alt,
   & 39 gate center      &    dont_display_alt,
   & 40 gate span        &    dont_display_alt,
   & 41 mag slope        &    dont_display_alt,
   & 42 mag offset       &    dont_display_alt,
   & 43 stimulus slope &      dont_display_alt,
   & 44 stimulus offset&      dont_display_alt,
   & 45 ref plane 1      &    dont_display_alt,
   & 46 ref plane 2      &    dont_display_alt,
   & 47 system z0        &    dont_display_alt,
   & 48 major addr       &    dont_display_alt,
   & 49 minor addr       &    dont_display_alt,
   & 50 pass thru addr &      dont_display_alt,
   & 51 source addr      &    dont_display_alt,
   & 52 test-set addr  &      dont_display_alt,
```

```
& 53 plotter addr   &   dont_display_alt,
& 54 printer addr   &   dont_display_alt,
& 55 ch cmd addr    &   dont_display_alt,
& 56 offset delay   &   dont_display_alt,
& 57 offset loss    &   dont_display_alt,
& 58 offset z0      &   dont_display_alt,
& 59 offset min f   &   dont_display_alt,
& 60 offset max f   &   dont_display_alt,
& 61 std id         &   dont_display_alt,
& 62 std class      &   dont_display_alt,
& 63 # groups kbd   &   dont_display_alt,
& 99 place holder   &   dont_display_alt;


BYTE TABLE must_be_positive_neg :=  & MUST BE EVEN LENGTH - PAD AT TOP &
   & -6 filler          &        0,
   & -5                 & domain_dependent,
   & -4 freq domain     &        make_positive,
   & -3 time band-pass  &   dont_make_positive,
   & -2 time low-pass   &   dont_make_positive,
   & -1 aux  domain     &   dont_make_positive;
BYTE TABLE must_be_positive :=              & for =marker in delta mode &
   &  0 off             &   dont_make_positive,
   &  1 start           &        -5,
   &  2 stop            &        -5,
   &  3 center          &        -5,
   &  4 span            &        make_positive,
   &  5 cw              &        -5,
   &  6 sweep time      &        make_positive,
   &  7 source power    &   dont_make_positive,
   &  8 power slope     &   dont_make_positive,
   &  9 port 1 atten    &        make_positive,
   & 10 port 2 atten    &        make_positive,
   & 11 ref pos'n       &   dont_make_positive,
   & 12 scale/div       &        make_positive,
   & 13 ref value       &   dont_make_positive,
   & 14 unused          &   dont_make_positive,
   & 15 title           &        make_positive,
   & 16 # groups hpib   &        make_positive,
   & 17 if avg factor   &        make_positive,
   & 18 smoothing aper. &        make_positive,
   & 19 srq mask prim.  &        make_positive,
   & 20 srq mask secon. &        make_positive,
   & 21 revision        &   dont_make_positive,
   & 22 aux out         &        make_positive,
   & 23 keycode         &        make_positive,
   & 24 electr delay    &   dont_make_positive,
   & 25 phase offset    &   dont_make_positive,
   & 26 marker 1        &        make_positive,
   & 27 marker 2        &        make_positive,
   & 28 marker 3        &        make_positive,
   & 29 marker 4        &        make_positive,
   & 30 marker 5        &        make_positive,
   & 31 address         &   dont_make_positive,
   & 32 peek            &   dont_make_positive,
```

```
& 33 poke            &   dont_make_positive,
& 34 open c0         &        make_positive,
& 35 open c1         &        make_positive,
& 36 open c2         &        make_positive,
& 37 gate start      &   dont_make_positive,
& 38 gate stop       &   dont_make_positive,
& 39 gate center     &   dont_make_positive,
& 40 gate span       &        make_positive,
& 41 mag slope       &   dont_make_positive,
& 42 mag offset      &   dont_make_positive,
& 43 stimulus slope  &   dont_make_positive,
& 44 stimulus offset&   dont_make_positive,
& 45 ref plane 1     &   dont_make_positive,
& 46 ref plane 2     &   dont_make_positive,
& 47 system z0       &        make_positive,
& 48 major addr      &        make_positive,
& 49 minor addr      &        make_positive,
& 50 pass thru addr  &        make_positive,
& 51 source addr     &        make_positive,
& 52 test-set addr   &        make_positive,
& 53 plotter addr    &        make_positive,
& 54 printer addr    &        make_positive,
& 55 ch cmd addr     &        make_positive,
& 56 offset delay    &   dont_make_positive,
& 57 offset loss     &   dont_make_positive,
& 58 offset z0       &        make_positive,
& 59 offset min f    &        make_positive,
& 60 offset max f    &        make_positive,
& 61 std id          &        make_positive,
& 62 std class       &        make_positive,
& 63 # groups kbd    &        make_positive,
& 99 place holder    &   dont_make_positive;
```

```
#EJECT;
GLOBAL DOUBLE TABLE active_tables :=     & indexed by "get_" constants &
   & get_suffix_index       & ADRS( suffix_index ),
   & get_format_index       & ADRS( active_format_index ),
   & get_min_limit_index    & ADRS( min_limit_index ),
   & get_max_limit_index    & ADRS( max_limit_index ),
   & get_chtable_index      & ADRS( chtable_index ),
   & get_chtable_type       & ADRS( chtable_type ),
   & get_chtable_store      & ADRS( chtable_store ),
   & get_algorithms         & ADRS( algorithms ),
   & get_display_alt_value  & ADRS( display_alternate_value ),
   & get_must_be_positive   & ADRS( must_be_positive ),
   & get_log_scale_div_3    & ADRS( log_scale_div_3 );


GLOBAL BYTE TABLE active_table_type :=   & indexed by "get_" constants &
   & get_suffix_index       & byte_type,
   & get_format_index       & byte_type,
   & get_min_limit_index    & byte_type,
   & get_max_limit_index    & byte_type,
   & get_chtable_index      & integer_type,
   & get_chtable_type       & byte_type,
   & get_chtable_store      & byte_type,
   & get_algorithms         & integer_type,
   & get_display_alt_value  & byte_type,
   & get_must_be_positive   & byte_type,
   & get_log_scale_div_3    & byte_type;

END$
```

```
M68KL,P,"command"
BEGIN

#FILE ffifo.work;
#FILE ffifos.work;
#FILE fkernel.work;
#FILE fkernel4.work;
#FILE factive.work;
#FILE factive2.work;
#FILE fstimuli.work;
#FILE fcontrol.work;
#FILE cchtable.work;                                   & for max_ch &
#FILE fcontvar.work;
#FILE fpubib.work;
#FILE cparser.work;
#FILE crins.work;
#FILE cids.work;
#FILE fintrpt.work;
#FILE cdebugc0.work;                                      & DEBUG &
#FILE fterm.work;                                         & DEBUG &
#FILE ccmdcase.work;                     & solely for cmd_initialize &
#FILE ftpmgr2.work;                      & turning off tape directory&
#FILE fdatamgr.work;
#FILE fmenu.work;
#FILE futil.work;
#FILE fprivib.work;                      & for wrt_priv_ib & & DEBUG &
#FILE fprivib2.work;          & for set_ren_priv_ib and intrpt_priv_ib &

GLOBAL INTEGER command_token;         & the current command.          &
GLOBAL BOOLEAN command_pending;       & flag indicating that there is &
                                      & a command token to be processed&
                                      & allowing current function to  &
                                      & return a second function to be &
                                      & processed before fetching a new&
                                      & command token from the fifo.   &
GLOBAL BOOLEAN abort_command;         & flag to abort command function &
                                      & at earliest convenient time.   &
```

```
#EJECT;
COMMENT                                                                  command
*****************************************************************************
*                                                                           *
* EXTERNAL SPECIFICATION FOR command                                        *
*                                                                           *
* FUNCTION: to execute user commands from the command fifo buffer.          *
*                                                                           *
* PARAMETER INFORMATION:                                                    *
*    INPUT:   none                                                          *
*                                                                           *
*    OUTPUT:  none                                                          *
*                                                                           *
* EXTERNAL EFFECTS: none                                                    *
*                                                                           *
*****************************************************************************
*                                                                           *
* LOGIC INFORMATION FOR command                                             *
*                                                                           *
* MODULES CALLED: none                                                      *
*                                                                           *
* INITIAL REFINEMENT:                                                       *
*                                                                           *
* get_command:                                                              *
*    command := next token from command fifo buffer                         *
*                                                                           *
*    WHILE command <> done DO                                               *
*                                                                           *
*       IF command = rpg_count THEN                                         *
*          process_rpg_count                                                *
*       ELSE                                                                *
*          CASE command OF                                                  *
*             execute individual commands here.                             *
*                                                                           *
*    go to get_command.                                                     *
*                                                                           *
*****************************************************************************
;
```

```
#EJECT;
SUBROUTINE init_token_fifo;                                        ENTRY;
   BEGIN
      init_fifo( token_fifo,
                 token_fifo_size,
                 token_buffer,
                 token_buffer_not_full,
                 token_buffer_not_empty );
   END;


SUBROUTINE init_command;
   BEGIN & init_command &

      iradr(ADRS(intrpt_priv_ib),private_ib_vctr);
      set_ren_priv_ib;

      COMMENT These are in case an SRQ has been asserted since power-up,
      not allowing the edge required to detect an interrupt. ;
      wrt_priv_ib( source,   clr_fun, "CS");                      & DEBUG &
      wrt_priv_ib( test_set, clr_fun, "CS");                      & DEBUG &

      recall_power_on_state;

   END;  & init_command &
```

```
#EJECT;
PROCEDURE command;                                              ENTRY;
  BEGIN

    init_command;
    restart_sweep;                                      & starts sweep &

loop: preempt;                                 & don't hold off inputs &
    command_token := read_fifo( token_fifo );
    abort_command := FALSE;
    command_pending := TRUE;

    WHILE command_pending DO
      BEGIN & while &
        COMMENT loops if a function returns command_pending = TRUE
                to allow one function to invoke another function
                -- e.g. a soft key maps a to another function by
                setting the value of t for the new function and
                setting command_pending to TRUE.;

        command_pending := FALSE;
                                                            & DEBUG &
        IF command_debug THEN                               & DEBUG &
          BEGIN & if &                                      & DEBUG &
            WHEX(command_token); CRLF;                      & DEBUG &
          END;  & if &                                      & DEBUG &

        IF directory_on THEN         & display over tape directory &
         IF ((command_token > cmd_key_8) OR
            (command_token < cmd_key_1))      AND
            (command_token <> cmd_hpib_talk) AND
            (command_token <> cmd_output_plot)
         THEN
          directory_off;

        IF (command_token OR %00FF) = %FFFF THEN
          rpg_entry(command_token)                            & RPG &
        ELSE
        IF (command_token AND %FF00) = hpib_pass_thru THEN
          pass_thru_command (command_token)     & pass-thru byte &
        ELSE
          BEGIN                                           & not RPG &
            #FILE fprocs.work;
          END;

      END;  & while &

    GO TO loop;

  END command;


END$
```

```
& attributes &
BYTE CONSTANT  nop          := 0,
               clear        := 1,
               incroff      := 2,
               incr         := 3,
               charincroff  := 4,
               charincr     := 5,
               brightoff    := 6,
               bright       := 7,
               dimoff       := 8,
               dim          := 9,
               eodoff       := 10,
               eod          := 11,
               blinkoff     := 12,
               blink        := 13,
               testdgoff    := 14,
               testdg       := 15;
INTEGER CONSTANT
               normal       := 0,   & x-coordinate attributes &
               blank        := 1,   & "penctl"                &
               dotted       := 2,
               dotted_blank:= 3,
               slow         := 1,   & y-coordinate attributes &
               dimchr       := 2,   & "linectl"               &
               dimchr_slow := 3;
```

```
M68KL,P,"display"
BEGIN

#FILE cdisplay.work;
#FILE fiocnfig.work;

COMMENT                                                              display
************************************************************************
*                                                                      *
* EXTERNAL SPECIFICATION FOR display                                   *
*                                                                      *
* FUNCTION: to encapsulate a set of utility procedures for using the   *
*           display.                                                   *
*                                                                      *
* COMMENTS:  The routine "init_display" must be called once prior      *
*            to using any of the following routines to initialize      *
*            pointers used by the following routines.                  *
*                                                                      *
*            All of the following routines use an "a" parameter to    *
*            specify the location in the display memory where the     *
*            display instruction will be stored.  "A"=000             *
*            corresponds to the first location in the display memory  *
*            (MC68000 address %FF0000), and "a"=%3FFF corresponds     *
*            to the last location (MC68000 address %FF7FFE).  "a"     *
*            are "word" or "integer" addresses starting from the base *
*            of the display memory -- successive locations differ by  *
*            one, as opposed to two for byte addresses used by the    *
*            MC68000.                                                  *
*                                                                      *
*            Caution should be exercised in using display locations   *
*            "a"=%3000 through %3FFF to avoid damaging the            *
*            character set vectors that are stored in those locations.*
*                                                                      *
************************************************************************
;-
INTEGER CONSTANT  blanked := %1000,   & blank - x-coordinate attribute &
                  char    := %3000,   & character set block address    &
                  rtnsub  := %2000,   & opcode bits for RTS instruction&
                  coord_mask := %0FFF;
INTEGER POINTER   ldxy,
                  lda,
                  jump,
                  jumpsub;
INTEGER POINTER   dg = lda;

COMMENT
 It is faster to use an integer procedure (function) returning the
incremented display address than to pass the display address by
reference, primarily due to the time required to increment the
display address when passed by reference.
 It is also faster to index using the address and the address+1
and then return the address+2 than it is to increment the address
between the two coordinates.
;
```

```
#EJECT;
COMMENT                                                                    draw
*************************************************************************
*                                                                       *
* EXTERNAL SPECIFICATION FOR draw                                       *
*                                                                       *
* FUNCTION: Draw a line from the present "pen" position to the         *
*           coordinate (x,y).  Begin at location "a" in the display     *
*           memory and return the next available display memory        *
*           location.                                                   *
*                                                                       *
* DECLARATION INFORMATION:                                              *
*    INTEGER PROCEDURE draw(a,x,y)                                      *
*       VALUE   a,x,y                                                   *
*       INTEGER a,x,y                                                   *
*                                                                       *
*    INPUT:   a           integer    display location                   *
*                                       (0 to 16383).                   *
*             x           integer    x-coordinate (-4096 to +4095).     *
*             y           integer    y-coordinate (-4096 to +4095).     *
*                                                                       *
*    OUTPUT:  draw        integer    next available display location.   *
*                                                                       *
* EXTERNAL EFFECTS: none.                                               *
*                                                                       *
*************************************************************************
*                                                                       *
* LOGIC INFORMATION FOR draw                                            *
*                                                                       *
* MODULES CALLED: none                                                  *
*                                                                       *
* INITIAL REFINEMENT:                                                   *
*    display_memory[a]   := x                                           *
*    display_memory[a+1] := y                                           *
*    a := a + 2                                                         *
*                                                                       *
*************************************************************************
;
INTEGER PROCEDURE draw(a,x,y);
   VALUE   a,x,y;
   INTEGER a,x,y;                                                   ENTRY;
   BEGIN  & draw &
      ldxy[a]   := x AND coord_mask;
      ldxy[a+1] := y AND coord_mask;
      draw := a + 2;
   END draw;
```

```
#EJECT;
COMMENT                                                                    xdraw
*************************************************************************
*                                                                       *
* EXTERNAL SPECIFICATION FOR xdraw                                      *
*                                                                       *
* FUNCTION: Draw a line from the present "pen" position to the          *
*           coordinate (x,y).  Begin at location "a" in the display     *
*           memory and return the next available display memory        *
*           location.  Use the current display memory y-coordinate and *
*           the supplied x-coordinate.                                  *
*                                                                       *
* DECLARATION INFORMATION:                                              *
*    INTEGER PROCEDURE xdraw(a,x)                                       *
*       VALUE   a,x                                                     *
*       INTEGER a,x                                                     *
*                                                                       *
*    INPUT:   a            integer    display location                  *
*                                        (0 to 16383).                  *
*             y            integer    y-coordinate (-4096 to +4095).    *
*                                                                       *
*    OUTPUT:  xdraw        integer    next available display location.  *
*                                                                       *
* EXTERNAL EFFECTS: none.                                               *
*                                                                       *
*************************************************************************
*                                                                       *
* LOGIC INFORMATION FOR xdraw                                           *
*                                                                       *
* MODULES CALLED: none                                                  *
*                                                                       *
* INITIAL REFINEMENT:                                                   *
*    display_memory[a] := x                                             *
*    a := a + 2                                                         *
*                                                                       *
*************************************************************************
;
INTEGER PROCEDURE xdraw(a,x);
   VALUE   a,x;
   INTEGER a,x;                                                  ENTRY;
   BEGIN  & xdraw &
      ldxy[a]    := x AND coord_mask;
      xdraw := a + 2;
   END xdraw;
```

```
#EJECT;
COMMENT                                                             ydraw
***********************************************************************
*                                                                     *
* EXTERNAL SPECIFICATION FOR ydraw                                    *
*                                                                     *
* FUNCTION: Draw a line from the present "pen" position to the        *
*           coordinate (x,y).  Begin at location "a" in the display   *
*           memory and return the next available display memory      *
*           location.  Use the current display memory x-coordinate and *
*           the supplied y-coordinate.                                *
*                                                                     *
* DECLARATION INFORMATION:                                            *
*    INTEGER PROCEDURE ydraw(a,y)                                     *
*       VALUE   a,y                                                   *
*       INTEGER a,y                                                   *
*                                                                     *
*    INPUT:   a          integer    display location                  *
*                                      (0 to 16383).                  *
*             y          integer    y-coordinate (-4096 to +4095).    *
*                                                                     *
*    OUTPUT:  ydraw      integer    next available display location.  *
*                                                                     *
* EXTERNAL EFFECTS: none.                                             *
*                                                                     *
***********************************************************************
*                                                                     *
* LOGIC INFORMATION FOR ydraw                                         *
*                                                                     *
* MODULES CALLED: none                                                *
*                                                                     *
* INITIAL REFINEMENT:                                                 *
*    display_memory[a+1] := y                                         *
*    a := a + 2                                                       *
*                                                                     *
***********************************************************************
;
INTEGER PROCEDURE ydraw(a,y);
   VALUE    a,y;
   INTEGER a,y;                                                  ENTRY;
   BEGIN  & ydraw &
      ldxy[a+1] := y AND coord_mask;
      ydraw := a + 2;
   END ydraw;
```

```
#EJECT;
COMMENT                                                              move
***********************************************************************
*                                                                     *
* EXTERNAL SPECIFICATION FOR move                                     *
*                                                                     *
* FUNCTION: Draw a blank line from the present "pen" position to the  *
*           coordinate (x,y).  Begin at location "a" in the display   *
*           memory and return the next available display memory       *
*           location.                                                 *
*                                                                     *
* DECLARATION INFORMATION:                                            *
*    INTEGER PROCEDURE move(a,x,y)                                    *
*       VALUE   a,x,y                                                 *
*       INTEGER a,x,y                                                 *
*                                                                     *
*    INPUT:   a           integer    display location                 *
*                                       (0 to 16383).                 *
*             x           integer    x-coordinate (-4096 to +4095).   *
*             y           integer    y-coordinate (-4096 to +4095).   *
*                                                                     *
*    OUTPUT:  move        integer    next available display location. *
*                                                                     *
* EXTERNAL EFFECTS: none.                                             *
*                                                                     *
***********************************************************************
*                                                                     *
* LOGIC INFORMATION FOR move                                          *
*                                                                     *
* MODULES CALLED: none                                                *
*                                                                     *
* INITIAL REFINEMENT:                                                 *
*    display_memory[a]   := x  (blanked)                              *
*    display_memory[a+1] := y                                         *
*    a := a + 2                                                       *
*                                                                     *
***********************************************************************
;
INTEGER PROCEDURE move(a,x,y);
   VALUE   a,x,y;
   INTEGER a,x,y;                                              ENTRY;
   BEGIN & move &
      ldxy[a]   := blanked + (x AND coord_mask);
      ldxy[a+1] := y AND coord_mask;
      move := a + 2;
   END;  & move &

INTEGER PROCEDURE move2(a,x,y);
   VALUE   a,x,y;
   INTEGER a,x,y;                                              ENTRY;
   BEGIN & move2 &
      a     := move(a,x,y);
      move2 := move(a,x,y);
   END;  & move2 &
```

```
INTEGER PROCEDURE movech(a,row,col);
   VALUE   a,row,col;
   INTEGER a,row,col;                                          ENTRY;
   & row 1, col 1 is upper left character position &
   & movech(a,r,c) == move(a, -128*r, 64*(c-1) )   &
   BEGIN & movech &
      ldxy[a]   := blanked + LEFT((col-1 AND %003F), 6);
      ldxy[a+1] := LEFT((-row  AND %001F), 7);
      movech := a + 2;
   END;  & movech &

INTEGER PROCEDURE movech2(a,row,col);
   VALUE   a,row,col;
   INTEGER a,row,col;                                          ENTRY;
   BEGIN & movech2 &
      a       := movech(a,row,col);
      movech2 := movech(a,row,col);
   END;  & movech2 &


INTEGER PROCEDURE plot(a,x,y,penctl,linectl);
   VALUE   a,x,y,penctl,linectl;
   INTEGER a,x,y,penctl,linectl;                               ENTRY;
   BEGIN  & plot &
      ldxy[a]   := (x AND coord_mask) + LEFT((penctl AND %0003),12);
      ldxy[a+1] := (y AND coord_mask) + LEFT((linectl AND %0003),12);
      plot := a + 2;
   END plot;


INTEGER PROCEDURE printch(a,ch);
   VALUE a,ch;
   INTEGER a;
   BYTE ch;                                                    ENTRY;
   BEGIN  & printch &
      jumpsub[a] := char + (INTEGER(ch) AND %00FF);
      printch := a + 1;
   END printch;


INTEGER PROCEDURE crlf(a);
   VALUE a;
   INTEGER a;                                                  ENTRY;
   BEGIN & crlf &
      INTEGER CONSTANT  cr          := %000D,
                        lf          := %000A;
      jumpsub[a]   := char + cr;
      jumpsub[a+1] := char + lf;
      crlf := a+2;
   END crlf;
```

```
INTEGER PROCEDURE lb(a,string);
   VALUE a,string;
   INTEGER a;
   ALPHA string;                                                    ENTRY;
   BEGIN  & lb &
      INTEGER i;
      BYTE POINTER ptr = string;

      FOR i := 1 UNTIL ptr[0] DO
         BEGIN & for &
            jumpsub[a] := char + (INTEGER(ptr[i]) AND %00FF);
            a := a + 1;
         END for;
      lb := a;
   END lb;


INTEGER PROCEDURE setattribute(a, attribute);
   VALUE a,attribute;
   INTEGER a;
   BYTE attribute;                                                  ENTRY;
   BEGIN  & setattribute &
      lda[a] := LEFT( INTEGER(attribute AND %000F), 8);
      setattribute := a + 1;
   END setattribute;


INTEGER PROCEDURE jmp(a, address);
   VALUE a, address;
   INTEGER a, address;                                              ENTRY;
   BEGIN  & jmp &
      jump[a] := address AND %3FFF;
      jmp := a + 1;
   END jmp;


INTEGER PROCEDURE jsr(a, address);
   VALUE a, address;
   INTEGER a, address;                                              ENTRY;
   BEGIN  & jsr &
      jumpsub[a] := address AND %3FFF;
      jsr := a + 1;
   END jsr;


INTEGER PROCEDURE rts(a, attribute);
   VALUE a,attribute;
   INTEGER a;
   BYTE attribute;                                                  ENTRY;
   BEGIN  & rts &
      dg[a] := rtnsub OR LEFT( INTEGER(attribute AND %000F), 8);
```

```
      rts := a + 1;
   END rts;


INTEGER PROCEDURE dg_write(a, data);
   VALUE a,data;
   INTEGER a,data;                                          ENTRY;
   BEGIN & dg_write &
      dg[a] := data;
      dg_write := a + 1;
   END dg_write;


INTEGER PROCEDURE dg_read(a, data);
   VALUE a;
   INTEGER a,data;                                          ENTRY;
   BEGIN & dg_read &
      data := dg[a];
      dg_read := a + 1;
   END;  & dg_read &


INTEGER PROCEDURE dg_read_xy(a, x, y);
   VALUE a;
   INTEGER a,x,y;                                           ENTRY;
   BEGIN & dg_read_xy &
      x := dg[a];
      y := dg[a+1];
      dg_read_xy := a + 2;
   END;  & dg_read_xy &
```

```
#EJECT;
COMMENT                                                              print_hex
******************************************************************************
*                                                                            *
* EXTERNAL SPECIFICATION FOR print_hex                                       *
*                                                                            *
* FUNCTION: Display least significant byte of a number as a                  *
*           hexadecimal digit.                                               *
*                                                                            *
* DECLARATION INFORMATION:                                                   *
*    INTEGER PROCEDURE print_hex(a,num)                                      *
*       VALUE   a,num                                                        *
*       INTEGER a,num                                                        *
*                                                                            *
*    INPUT:   a            integer    display location                      *
*                                        (0 to 16383).                       *
*             num          integer    integer number to be displayed.        *
*                                                                            *
*    OUTPUT:  print_hex    integer    next available display location.       *
*                                                                            *
* EXTERNAL EFFECTS: none.                                                    *
*                                                                            *
* COMMENT:                                                                   *
*    -------------------- WARNING ------------------------                   *
*    This routine is not planned for inclusion in production software.       *
* It is provided at this time for convenience until a complete i/o          *
* formatting and driver package is completed.                                *
*                                                                            *
******************************************************************************
*                                                                            *
* LOGIC INFORMATION FOR print_hex                                            *
*                                                                            *
* MODULES CALLED: none                                                       *
*                                                                            *
* INITIAL REFINEMENT:                                                        *
*    mask off least significant byte.                                        *
*    convert to hexadecimal.                                                 *
*    output the resulting character.                                         *
*                                                                            *
******************************************************************************
;
INTEGER PROCEDURE print_hex(a,num);
   VALUE   a,num;
   INTEGER a,num;                                                     ENTRY;
   BEGIN  & print_hex &
      num := num AND %000F;
      print_hex := printch(a, num + (IF num<10 THEN 48 ELSE 55) );
   END print_hex;
```

```
#EJECT;
COMMENT                                                                  dg_hex
*****************************************************************************
*                                                                           *
* EXTERNAL SPECIFICATION FOR dg_hex                                         *
*                                                                           *
* FUNCTION: Display a specified number of least significant digits          *
*           of a number.                                                    *
*                                                                           *
* DECLARATION INFORMATION:                                                  *
*    INTEGER PROCEDURE dg_hex(a,num,digits)                                 *
*       VALUE   a,num,digits                                                *
*       DOUBLE  digits
*       INTEGER a,num                                                       *
*                                                                           *
*    INPUT:   a            integer    display location                      *
*                                        (0 to 16383).                      *
*             num          double     number to be displayed.               *
*             digits       integer    number of digits to be displayed      *
*                                                                           *
*    OUTPUT:  dg_hex       integer    next available display location.      *
*                                                                           *
* EXTERNAL EFFECTS: none.                                                   *
*                                                                           *
* COMMENT:                                                                  *
*    -------------------- WARNING -------------------------                 *
*    This routine is not planned for inclusion in production software.      *
* It is provided at this time for convenience until a complete i/o          *
* formatting and driver package is completed.                               *
*                                                                           *
*****************************************************************************
*                                                                           *
* LOGIC INFORMATION FOR dg_hex                                              *
*                                                                           *
* MODULES CALLED: none                                                      *
*                                                                           *
* INITIAL REFINEMENT:                                                       *
*    move most significant byte to the least significant position.          *
*    REPEAT digits DO                                                       *
*       convert least significant byte to hex.                              *
*       output hex byte.                                                    *
*       rotate most significant byte to the least significant position.*
*                                                                           *
*****************************************************************************
;
INTEGER PROCEDURE dg_hex(a,num,digits);
   VALUE   a,num,digits;
   DOUBLE  num;
   INTEGER a,digits;                                                  ENTRY;
   BEGIN  & dg_hex &
      num := RLEFT(num, 4*(9-digits));
      REPEAT digits DO
         BEGIN & repeat &
            a := print_hex(a,num);
            num := RLEFT(num,4);
         END repeat;
```

```
      dg_hex := a;
   END dg_hex;


INTEGER PROCEDURE init_display;                                         ENTRY;
   BEGIN & init_display &
      INTEGER addr,
              eod_attribute;
      INTEGER POINTER dg_ptr;

      eod_attribute := LEFT( INTEGER(eod AND %000F), 8 );

      STPNTR(dg_ptr, ADRS(dgram));

      REPEAT %2E7F DO       & %2E7F = 16384 - charset - monitor_display &
         BEGIN & repeat &
            dg_ptr := eod_attribute;
            STPNTR(dg_ptr, ADRS(dg_ptr[1]) );
         END;  & repeat &

      & initialize pointers &
      STPNTR(lda,     ADRS(dgram) );
      STPNTR(ldxy,    ADRS(dg_ldxy) );    & offset included in fiocnfig &
      STPNTR(jumpsub,ADRS(dgram) + %040000);
      STPNTR(jump,    ADRS(dgram) + %060000);

      & initialize display &

      COMMENT display memory is currently full of eod's.  Location 0
            will retain its eod.  Location 1 will be replaced later by
            an attribute clear.
            ;
      init_display := 2; & 0=eod, 1=eod, return 2 -- see clear_display &

   END init_display;


INTEGER PROCEDURE clear_display;                                        ENTRY;
   BEGIN & clear_display &

      init_display;                          & returned variable not used &
      setattribute( 1, clear );              &         ditto              &
      clear_display := 2;          & 0=eod, 1=clear attributes, return 2 &

   END;  & clear_display &

END$
```

```
INTEGER CONSTANT  min_x          :=  0,          & grat_specs indices &
                  max_x          :=  1,
                  min_y          :=  2,
                  max_y          :=  3,
                  grat_x         :=  4,
                  grat_y         :=  5,
                  div_x          :=  6,
                  div_y          :=  7,
                  grat_type      :=  8,
                  max_grat_index :=  8,        &.value of last entry &
                  grat_specs_size:=  max_grat_index + 1;

INTEGER CONSTANT  rectangular    :=  0, & for graticule_type,grat_specs&
                  polar          :=  1,          & for graticule_type &
                  bullseye       :=  1,              & for grat_specs &
                  smith          :=  2,              & for grat_specs &
                  no_graticule   := -1;          & for graticule_type &
```

```
M68KL,P,"graticule"
BEGIN

#FILE cchtable.work;
#FILE fchtable.work;
#FILE fchtab2.work;
#FILE fchdata.work;
#FILE fscreen.work;
#FILE cdisplay.work;
#FILE fdisplay.work;
#FILE fcircle.work;
#FILE cgratic.work;
#FILE cgratic2.work;                & constants for grat_specs_table &
#FILE fcontvar.work;
#FILE ftrace.work;
#FILE fmarker.work;
#FILE ffifo.work;
#FILE ffifos.work;
#FILE cdatap.work;
#FILE fkernel.work;                        & for acquire and release &
#FILE crins.work;                         & for processing_variables &

EXTERNAL REAL CONSTANT TwoPi;


GLOBAL BYTE TABLE type_of_grat :=                   & indexed by format &
   &  not used           0 & no_graticule,
   &  fmt_log_mag        1 &  rectangular,
   &  fmt_linear_mag     2 &  rectangular,
   &  fmt_phase          3 &  rectangular,
   &  fmt_delay          4 &  rectangular,
   &  fmt_real           5 &  rectangular,
   &  fmt_imaginary      6 &  rectangular,
   &  fmt_log_polar      7 &     bullseye,
   &  fmt_linear_polar   8 &     bullseye,
   &  fmt_imag_vs_real   9 &     bullseye,
   &  fmt_z_smith       10 &        smith,
   &  fmt_y_smith       11 &        smith,
   &  fmt_vswr          12 &  rectangular;

INTEGER TABLE grat_specs_table :=
   & rect_normal  min_x   &              x0_min,  &  0 &
   &              max_x   &              x0_max,
   &              min_y   &              y0_min,
   &              max_y   &              y0_max,
   &              grat_x  &               xgrat,
   &              grat_y  &               ygrat,
   &              div_x   &                 div,
   &              div_y   &                 div,
   &            grat_type &         rectangular,
   & rect/split_1 min_x   &              x1_min,  & 18 &
   &              max_x   &              x1_max,
   &              min_y   &              y1_min,
   &              max_y   &              y1_max,
```

```
&                grat_x   &            x1_grat,
&                grat_y   &            y1_grat,
&                div_x    &           half_div,
&                div_y    &           half_div,
&              grat_type  &        rectangular,
& rect/split_2 min_x      &             x2_min,  & 36 &
&                max_x    &             x2_max,
&                min_y    &             y2_min,
&                max_y    &             y2_max,
&                grat_x   &            x2_grat,
&                grat_y   &            y2_grat,
&                div_x    &           half_div,
&                div_y    &           half_div,
&              grat_type  &        rectangular,
&    polar/      min_x    & x0_min + max_grat/10,  & 54 &
&    normal      max_x    & x0_max - max_grat/10,
&                min_y    &             y0_min,
&                max_y    &             y0_max,
&                grat_x   &   xgrat + half_grat,
&                grat_y   &   ygrat + half_grat,
&                div_x    &                div,
&                div_y    &                div,
&              grat_type  &              polar,
&    polar/      min_x    &             x1_min,  & 72 &
&    split_1     max_x    &             x1_max,
&                min_y    & y1_min - half_grat/8,
&                max_y    & y1_max + half_grat/8,
&                grat_x   &  x1_grat + qtr_grat,
&                grat_y   &  y1_grat + qtr_grat,
&                div_x    &  (5 * half_div) / 4,
&                div_y    &  (5 * half_div) / 4,
&              grat_type  &              polar,
&    polar/      min_x    &             x2_min,  & 90 &
&    split_2     max_x    &             x2_max,
&                min_y    & y2_min - half_grat/8,
&                max_y    & y2_max + half_grat/8,
&                grat_x   &  x2_grat + qtr_grat,
&                grat_y   &  y2_grat + qtr_grat,
&                div_x    &  (5 * half_div) / 4,
&                div_y    &  (5 * half_div) / 4,
&              grat_type  &              polar;

BYTE TABLE grat_specs_grat_offset :=        & indexed by type_of_grat &
   & 0       rectangular &         0,
   & 1          bullseye &        54, & 2 bytes/integer x 9 entries &
   & 2             smith &        54; &     x 3 tables = 54         &

BYTE TABLE grat_specs_mode_offset :=    & indexed by channel if split &
   & 0            normal &         0,
   & 1   split channel 1 &        18,
   & 2   split channel 2 &        36;

DOUBLE                              & addresses into grat_specs_table &
   grat1_specs_double,
   grat2_specs_double;
DOUBLE  TABLE grat_specs :=                        & indexed by channel &
```

```
    0,
    ADRS( grat1_specs_double ),
    ADRS( grat2_specs_double );
  GLOBAL INTEGER POINTER           & provide pointers for outside world &
    grat1_specs = grat1_specs_double,
    grat2_specs = grat2_specs_double;

  INTEGER POINTER specs;                 & pointer into grat_specs_table &

  INTEGER TABLE jump_channel :=
    0,
    jump_channel1,
    jump_channel2;
  INTEGER TABLE end_ch_position :=
    0,
    end_ch1_position,
    end_ch2_position;
  INTEGER TABLE graticule_display :=
    0,
    graticule1_display,
    graticule2_display;
  INTEGER TABLE graticule_position :=
    0,
    graticule1_position,
    graticule2_position;
  INTEGER TABLE trace_display :=
    0,
    trace1_display,
    trace2_display;
  INTEGER TABLE tracem_display :=
    0,
    trace1m_display,
    trace2m_display;
  INTEGER TABLE trace_mark_display :=
    0,
    trace_mark1_display,
    trace_mark2_display;

  INTEGER addr;                      & display generator ram address  &



#EJECT;
COMMENT                                                      graticule_type
***************************************************************************
*
***************************************************************************
;
INTEGER PROCEDURE graticule_type( ch );
  VALUE   ch;
  INTEGER ch;                                                        ENTRY;
  BEGIN & graticule_type &
    graticule_type := type_of_grat[ ch_integer( ch_format, ch ) ];
  END;  & graticule_type &
```

```
#EJECT;
COMMENT                                                        rect_graticule
*************************************************************************
*
*************************************************************************
;
PROCEDURE  rect_graticule;
   BEGIN & rect_graticule &
      INTEGER i,
              grat_size,                     & graticule width in pixels &
              div_size;                      & pixels per division       &

      div_size  := specs[div_x];                         & div_x = div_y &
      grat_size := 10 * div_size;

      addr := move2( addr, specs[grat_x], specs[grat_y] );
      addr := setattribute( addr, incr );
      FOR i := 1 UNTIL 10 DO
         BEGIN & for &
            addr := move( addr, 0, 0 );                      & to settle &
            addr := plot( addr, grat_size, 0, normal, slow );
            addr := plot( addr, -grat_size, div_size, blank, slow );
         END for;
      addr := move( addr, 0, 0 );                            & to settle &
      addr := plot( addr, grat_size, 0, normal, slow );
      FOR i := 1 TO 10 DO
         BEGIN & for &
            addr := move( addr, 0, 0 );                      & to settle &
            addr := plot( addr, 0, -grat_size, normal, slow );
            addr := plot( addr, -div_size, grat_size, blank, slow );
         END for;
      addr := move( addr, 0, 0 );                            & to settle &
      addr := plot( addr, 0, -grat_size, normal, slow );
      addr := setattribute( addr, incroff );
   END;  & rect_graticule &
```

```
#EJECT;
COMMENT                                                    bullseye_graticule
******************************************************************************
*
******************************************************************************
;
PROCEDURE  bullseye_graticule;
   BEGIN & bullseye_graticule &
      INTEGER radius,
              half_size,
              x_min,
              x_max,
              y_min,
              y_max,
              x0,
              y0;
      REAL    max_r;

      half_size := 5 * specs[div_x];                          & div_x = div_y &
      max_r     := REAL( half_size  );
      x0        := specs[grat_x];
      y0        := specs[grat_y];
      x_min     := x0 - INTEGER(max_r*0.8);
      x_max     := x0 + INTEGER(max_r*0.8);
      y_min     := y0 - INTEGER(max_r);
      y_max     := y0 + INTEGER(max_r);

      FOR radius := 1 TO 5 DO
         BEGIN & for &
            addr := arc( addr,
                         x0,
                         y0,
                         radius*0.2,
                         0.0,                                  & start angle &
                         TwoPi,                                & arc angle   &
                         max_r,                                & max_radius  &
                         IF radius=5 THEN TRUE
                                     ELSE FALSE                & enhanced?   &
                       );
         END;  & for &
      & horizontal line &
      addr := plot( addr, x_min, y0, normal, slow );
      & vertical line &
      addr := move2( addr, x0, y_max );
      addr := plot( addr, x0, y_min, normal, slow );
      & diagonal lines &
      & redefine _min and _max &
      y_min := INTEGER(.28284271 * max_r);                    & 0.4 cos(pi/4) &
      y_max := INTEGER(.70710678 * max_r);                    & 1.0 cos(pi/4) &
      x_min := INTEGER(.22627417 * max_r);                    & 0.8 y_min     &
      x_max := INTEGER(.56568543 * max_r);                    & 0.8 y_max     &
      & up and to the right &
      addr := move( addr,
                    x0 - x_max,
                    y0 - y_max
                  );
```

```
    addr := draw( addr,
                  x0 - x_min,
                  y0 - y_min
                );
    addr := move( addr,
                  x0 + x_min,
                  y0 + y_min
                );
    addr := draw( addr,
                  x0 + x_max,
                  y0 + y_max
                );
    & down and to the right &
    addr := move( addr,
                  x0 - x_max,
                  y0 + y_max
                );
    addr := draw( addr,
                  x0 - x_min,
                  y0 + y_min
                );
    addr := move( addr,
                  x0 + x_min,
                  y0 - y_min
                );
    addr := draw( addr,
                  x0 + x_max,
                  y0 - y_max
                );
END;  & bullseye_graticule &
```

```
EJECT;
COMMENT                                                      smith_chart_graticule
**********************************************************************************
*
**********************************************************************************
;
PROCEDURE  smith_chart_graticule( scale );
   VALUE   scale;
   REAL    scale;              & (outer circle radius) / (r=0 radius) &
   BEGIN & smith_chart_graticule &
      INTEGER i, j,
              radius,
              half_size,
              x0,
              y0;
       REAL   max_r,
              one_over_scale,
              angle,            & intersection of r=1 and outer circle &
              u, v,                                 & real and imag.   &
              r,                                           & resistance &
              x;                                           & reactance  &

      one_over_scale := 1.0 / scale;

      half_size := 5 * specs[div_x];                     & div_x = div_y &
      max_r := REAL( half_size  );
      x0 := specs[grat_x];
      y0 := specs[grat_y];

      & outer circle &
      addr := arc( addr,
                   x0,
                   y0,
                   1.0,
                   0.0,                                  & start angle &
                   TwoPi,                                & arc angle   &
                   max_r,                                & max_radius  &
                   TRUE
                 );
      addr := r_circle( addr, x0, y0,                          & R = 1 &
                        1.00, max_r, scale
                      );
      IF ABS(scale - 1.0) > 0.001 THEN                  & scale <> 1.0 &
         addr := r_circle( addr, x0, y0,                       & R = 0 &
                           0.00, max_r, scale
                         );
      addr := x_circle( addr, x0, y0,                          & X = 0 &
                        0.00, max_r, scale              & horiz. line &
                      );

      & scale = max_gamma &
      r := (2-scale) / (2+scale);                  & for max gamma / 2 &

      addr := r_circle( addr, x0, y0,
                        r, max_r, scale
                      );
```

```
IF scale < 1.4 THEN
   addr := r_circle( addr, x0, y0,
                     1.0/r, max_r, scale
                   )
ELSE
   addr := x_circle( addr, x0, y0,
                     4.0*one_over_scale, max_r, scale
                   );

IF scale < 0.999 THEN
   BEGIN & if &
      addr := r_circle( addr, x0, y0,
                        1.0/r, max_r, scale
                      );

      angle := intersect_angle( 0.5, 0.5, scale );
      IF angle > 1.83 THEN
         angle := 1.83;         & helps meet 1.0 circle at scale=1&

      & quarter point &
      packed_sin_cos(0.25*angle);        & rtns cos/sin in R0/R1 &
      ASSEMBLE( MOVE.L R0, u;                    & u = cos(angle) &
                MOVE.L R1, v                     & v = sin(angle) &
              );
      u := 0.5 + 0.5*u;                           & 1 - real part &
      v := 0.5*v;
      x := (2*v) / ( u*u + v*v );
      addr := x_circle( addr, x0, y0,
                        x, max_r, scale
                      );
      & half point &
      packed_sin_cos(0.50*angle);        & rtns cos/sin in R0/R1 &
      ASSEMBLE( MOVE.L R0, u;                    & u = cos(angle) &
                MOVE.L R1, v                     & v = sin(angle) &
              );
      u := 0.5 + 0.5*u;                           & 1 - real part &
      v := 0.5*v;
      x := (2*v) / ( u*u + v*v );
      addr := x_circle( addr, x0, y0,
                        x, max_r, scale
                      );
      & three-quarter point &
      packed_sin_cos(0.75*angle);        & rtns cos/sin in R0/R1 &
      ASSEMBLE( MOVE.L R0, u;                    & u = cos(angle) &
                MOVE.L R1, v                     & v = sin(angle) &
              );
      u := 0.5 + 0.5*u;                           & 1 - real part &
      v := 0.5*v;
      x := (2*v) / ( u*u + v*v );
      addr := x_circle( addr, x0, y0,
                        x, max_r, scale
                      );
   END  & if &
ELSE & scale >= 0.999 &
   BEGIN & else &
```

```
    addr := x_circle( addr, x0, y0,
                      one_over_scale, max_r, scale
                    );
    addr := x_circle( addr, x0, y0,
                      2.0*one_over_scale, max_r, scale
                    );
    IF scale <= 1.999 THEN
       addr := x_circle( addr, x0, y0,
                         0.5*one_over_scale, max_r, scale
                       )
    ELSE & scale > 1.999 &
       BEGIN & else &
          r := (1-scale) / (1+scale);
          addr := r_circle( addr, x0, y0,
                            r, max_r, scale
                          );
       END;  & else &
  END;  & else &

END;  & smith_chart_graticule &
```

```
#EJECT;
COMMENT                                                   initialize_trace
**************************************************************************
*
**************************************************************************
;
PROCEDURE  initialize_trace( grat_type );
   VALUE   grat_type;
   INTEGER grat_type;
   BEGIN & initialize_trace &
      INTEGER pixels_per_point,
              grat_size,
              half_size,
              x,
              y,
              i;

      grat_size := 10 * specs[div_x];                       & div_x = div_y &
      half_size := ARIGHT( grat_size, 1 );                    & grat_size/2 &
      x         := specs[grat_x];
      y         := specs[grat_y];

      IF grat_type = rectangular THEN
         BEGIN & rectangular &
            pixels_per_point := grat_size / (stop-start);
            y := y + half_size;
            & should be done in the reverse direction &          & DEBUG &
            addr := move(addr,                                 & first point &
                         x,
                         y
                        );
            FOR i := step_size STEP step_size UNTIL stop DO
               addr := draw(addr,                         & remaining points &
                            x + (i*pixels_per_point),
                            y
                           );
         END  & rectangular &
      ELSE & polar &
         FOR i := start STEP step_size UNTIL stop DO
            addr := move(  addr,
                           x,
                           y
                        );
   END;  & initialize_trace &
```

```
#EJECT;
COMMENT                                        partial_trace_and_graticule
**************************************************************************
*
**************************************************************************
;
PROCEDURE  partial_trace_and_graticule;                             ENTRY;
   BEGIN & partial_trace_and_graticule &
      INTEGER ch,
              specs_offset,
              graticule,
              previous_graticule;
      DOUBLE POINTER grat_specs_adr;

      previous_graticule := no_graticule; & assure no match &

      FOR ch := 1 UNTIL max_ch DO
         BEGIN & for channel &

            IF ( (trace_mode = single_ch) AND
                 (current_entry_ch <> ch)
               ) THEN & don't draw graticule &
               BEGIN & if &
                  addr := jmp(jump_channel[ch], end_ch_position[ch]);
                  graticule := no_graticule;
               END   & if &
            ELSE
               BEGIN & else draw graticule &
                  & -- graticule(s) -- &

                  graticule := graticule_type( ch );

                  specs_offset := IF trace_mode = split THEN
                                     grat_specs_mode_offset[ch]
                                  ELSE
                                     0;
                  specs_offset := specs_offset +
                                  grat_specs_grat_offset[ graticule ];
                  STPNTR( grat_specs_adr, grat_specs[ch] );
                  grat_specs_adr := ADRS( grat_specs_table ) +
                                     specs_offset;
                  STPNTR( specs, grat_specs_adr );

                  & DRAW GRATICULE &
                  addr := graticule_position[ch];

                  IF graticule <> previous_graticule THEN & guaranteed &
                     BEGIN & if &                          & <> for ch1 &
                        IF graticule = rectangular THEN
                           rect_graticule
                        ELSE IF graticule = bullseye THEN
                           bullseye_graticule
                        ELSE
                           smith_chart_graticule( ch_real( ch_ref_value,
                                                           ch
                                                         )
```

```
                                        );
      END   & if &
    ELSE IF ( ( graticule = smith ) AND
              ( ch_real( ch_ref_value, 1 ) <>
                ch_real( ch_ref_value, 2 )
              )
            ) THEN      & Smith chart scales are not same &
      smith_chart_graticule( ch_real(ch_ref_value, ch) );

    previous_graticule := graticule;
    addr := jmp( addr,
                 graticule_display[ch] + graticule_size
               );

    & -- trace(s) -- &

    addr := trace_display[ch];
    initialize_trace( graticule );
    addr := jmp(addr, trace_display[ch]+trace_size);

    & trace mark &
    addr := trace_mark_display[ch];
    IF ( (trace_mode <> split) AND
         (graticule = rectangular)
       ) THEN
       BEGIN & if &
          addr := setattribute( addr, incr );
          IF ch=1 THEN
             BEGIN & if ch = 1 &
                addr := move(addr, -112, -80);
                addr := printch(addr, '1);
                addr := move(addr, -16, 0); & align mark &
                addr := printch(addr, ch1_trace_mark);
             END   & if ch = 1 &
          ELSE
             BEGIN & else ch = 2 &
                addr := move(addr, 0, -80);
                addr := printch(addr, ch2_trace_mark);
                addr := move(addr, -16, 0);
                addr := printch(addr, '2);
             END;  & else ch = 2 &
          addr := setattribute(addr, incroff);
       END;  & if &
    addr := jmp( addr,
                 trace_mark_display[ch]+trace_mark_size
               );

    & memory trace &                                  & DEBUG &
    addr := tracem_display[ch];                       & DEBUG &
    initialize_trace( graticule );                    & DEBUG &
    addr := jmp( addr,                                & DEBUG &
                 tracem_display[ch]+trace_size        & DEBUG &
               );
    addr := setattribute(jump_channel[ch], nop);
 END;  & else draw graticule &
```

```
            IF trace_mode = split THEN
               previous_graticule := no_graticule
            ELSE & not split &
               previous_graticule := graticule;

         END;  & for channel &

      annotate_ref_position;

      update_marks;

   END;  & partial_trace_and_graticule &


SUBROUTINE trace_and_graticule;                                    ENTRY;
   BEGIN & trace_and_graticule &
      acquire( processing_variables );

      partial_trace_and_graticule;

      release( processing_variables ); COMMENT  must release before the
                                       write_fifo, else if fifo is full
                                       the fifo reader cannot get the
                                       processing vars in order to empty
                                       the fifo.;
      & TELL DATA PROCESSING ABOUT THE CHANGE &
      write_fifo( array_update_fifo, %4100 );     & update ch1 dp vars &
      write_fifo( array_update_fifo, %4200 );     & update ch1 dp vars &
   END;  & trace_and_graticule &



#EJECT;
COMMENT                                                       init_gratic
*************************************************************************
*
*   Only initializes the gratx_specs pointers.
*
*************************************************************************
;
SUBROUTINE init_gratic;                                            ENTRY;
   BEGIN & init_gratic &
      STPNTR( grat1_specs, ADRS(grat_specs_table) );
      STPNTR( grat2_specs, ADRS(grat_specs_table) );
   END;  & init_gratic &

END$
```

```
M68KL,P,"kernel"
BEGIN                                    & update/status log at end of file &

#FILE cmessage.work;         & for deadlock and process_creation_error &
#FILE futil2.work;                                             & for fatal &
#FILE cdebug.work;                          & for stack_fill & & DEBUG &
#FILE fterm.work;                                                  & DEBUG &
#FILE fintrpt.work;
#FILE fiocnfig.work;
#FILE crins.work;
#FILE cids.work;
#FILE fpubib.work;              & for updating hp-ib leds during ticks &
#FILE fmarkmem.work;     & contains memory limits for stack allocation &

BYTE SUBROUTINE RCHAR;   EXTERNAL.L;                              & DEBUG &

EXTERNAL DOUBLE MYNRM;      & multiplier normalize address = %FFFFF922 &
EXTERNAL BYTE   RDEXP;      & multiplier exponent  address = %FFFFF912 &
```

```
#EJECT;
COMMENT
***************************************************************************
*
* MODULE kernel
*
* ENTRY POINT(S):
*
*    send: Send a signal to an awaiting process.
*    wait: Wait for a signal from another process.
*    waitio: Wait for a device interrupt.
*    awaited: Is a process waiting for a signal.
*    acquire: Acquire access to a resource.
*    release: Release access to a resource.
*    delay: Delay the calling process (<= 2 seconds, non-sharable)
*    pause: Delay the calling process (>= .5 second, sharable)
*
*    run: Starts (or restarts) a process at the beginning.
*    create: Initializes process record for a new process, and starts
*            the process.
*    init_kernel: Initialization routine.
*    signal_init: Initialize a signal variable.
*    resource_init: Initialize a resource variable.
*    terminate: Terminates the calling process.
*    abort: Terminates the designated process.
*    snapshot: Dumps key variables and stacks.
*
* NOTE:
*    The "main" process must not terminate.  After initializing the
*    modules and creating the processes, the "main" process should
*    end in a continuous loop which is the "idle" process.  The main
*    process has the lowest urgency (priority) of all processes.
*    The "main" or "idle" process must always remain ready, that is,
*    it may never call "acquire", "wait", or any procedure that may
*    eventually cause suspension (such as i/o) or termination (such as
*    "terminate".  The existence of the "idle" process as an always
*    ready process allows the scheduling algorithm to avoid time-
*    consuming testing.
*
* The design objective of this module is to hide all knowledge of
* processes and their synchronization (i.e. this is an informational
* strength module).  Although signal and resource identification
* numbers are inputs of this module, no other modules have any
* knowledge of their structure or operations upon them.  Hence this
* is at worst data coupled to any other module.
*
* STRUCTURE NOTES: Each of the functions are separate procedures
*                  Module-wide data definitions are
*                  global to the functions, as are supporting
*                  routines used by the functions.
*
* TIMING:  (as of 1 April 1982, for an 8 MHz MC68000.)
*    A single process swap requires about 69 microseconds (a call to
* "wait", suspension, scheduling of the next process, restoration of
* the process, and return from it's call to "wait") plus 125 nano-
* seconds for each level of process priority of the newly scheduled
```

```
* process below the highest priority.
*    A process swap due to an interrupt requires about 46
* microseconds (interrupt service, suspension, restoration of the
* interrupt service routine, and return from it's call to
* waitio).  There is no time requirement based on process priority
* level since there is no search for the highest priority process
* -- scheduling is determined by interrupt hardware.
*    A routine that was running when an interrupt occurs has all of
* its registers pushed onto the stack.  When that process finally is
* scheduled for resumption, that process swap will require 78 micro-
* seconds (instead of the 69 for a normal swap).  Basically an
*
*    For purposes of evaluating whether or not to "wait" versus
* "spin", one should count two process swaps in order to swap to do
* useful work and to swap back.
*    Basically an interrupt caused process swap will cost a
* process swap on entry and exit totalling 150 microseconds.  The
* actual exit swap may be 69 microseconds, but a process swap
* sometime will be extended from 69 to 78 microseconds, so
* count them both for the interrupt.
* -- 124 microseconds for two process swaps as a result of an
*    interrupt.  (46 + 78 = 119)
* -- 138 microseconds for two process swaps as a result of a "wait"
*    request.
*
* See Wayne Cannon's notes of 23 Sept 1981 for the assembly listing
* with it's associated timing breakdown for an 8 MHz MC68000.  1 April
* 1982 added code to use the multiplier's normalize to find the highest
* priority ready process, rather than a bit test and loop.
*
*************************************************************************
;
```

```
#EJECT;
COMMENT                                                          DATA
...............................................................
. MODULE-WIDE DATA DEFINITIONS
.
.   Note:  Queues are used to link processes awaiting access to a
.          resource instead of dequeues
.          (double-ended queues) since they are always faster for
.          removing items and faster for inserting items if
.          no items are already in the queue.  They are slower if
.          more than one item is in the queue, but this occasion
.          of multiple processes awaiting a resource occurs much less
.          often than a single process being added to an empty queue.
.
...............................................................
;
   BYTE CONSTANT false := 0;
   BYTE CONSTANT true := 1;
   INTEGER CONSTANT nil := 0;
   INTEGER CONSTANT min_registers := 0;   & These values are fixed due &
   INTEGER CONSTANT all_registers := -1;  &   to assembly bit tests.   &
   INTEGER CONSTANT max_process := 15;     & Max_process+1 incl. idle  &
                                          COMMENT
                                            (If larger than 15, than
                                            'ready' must be a double.)
                                            If max_process is changed,
                                            then "min_rin" in "frins"
                                            must be changed to be equal
                                            to max_process + 1.
                                            Update preempt_mask also.  ;
   GLOBAL                                 & global "only" for yadc!!!  &
                                          &    and kernel macros.      &
   INTEGER running;                       & "ID" of running process.   &
                                          & ID of most urgent process  &
                                          & is "max_process", least    &
                                          & urgent is 1, and the idle  &
                                          & process is 0.              &
   INTEGER delay_timer_id;                & ID of process awaiting a   &
                                          &    delay timer interrupt.  &
   GLOBAL                                 & global "only" for yadc!!!  &
                                          &    and kernel macros.      &
   INTEGER ready;                         & 16 boolean "Ready" flags.  &
                                          & (If max_process>15 then    &
                                          & ready must be double and   &
                                          & EXTS in 'schedule' must    &
                                          & be removed!                &
   INTEGER TABLE preempt_mask := %FFFE, %FFFC, %FFF8, %FFF0,
                                 %FFE0, %FFC0, %FF80, %FF00,
                                 %FE00, %FC00, %F800, %F000,
                                 %E000, %C000, %8000, %0000;
                                          & Mask for higher priorities.&
   GLOBAL                                 & global "only" for "contvar"&
                                          &    passed to yadc/data-    &
                                          &    processing via chtable. &
                                          &    and for kernel macros.  &
   BYTE ARRAY link[0:max_rin];            & Links for queues, and      &
```

```
                                          & Pointers to head of queues.&
BYTE ARRAY owner[min_rin:max_rin];        & Owners of busy resources.  &
BYTE ARRAY urgency[0:max_process];        & Urgency for scheduling.    &
                                          &    Used to initially enter &
                                          &    process information     &
                                          &    into the tables.        &
GLOBAL                                    & global "only" for "contvar"&
                                          &    passed to yadc/data-    &
                                          &    processing via chtable. &
                                          &    and for kernel macros.  &
INTEGER ARRAY counter[0:max_rin];         & Semaphore counters and     &
                                          &    delay_list delay times. &
INTEGER ARRAY datasize[0:max_process];    & Stack space required.      &
DOUBLE  ARRAY initialsp[0:max_process];&     S before any execution.  &
DOUBLE  ARRAY initialpc[0:max_process];&     P before any execution.  &
DOUBLE  ARRAY spsave[0:max_process];      & S while not running. &
DOUBLE  ARRAY max_sp[0:max_process];                         & DEBUG &
DOUBLE  ARRAY stack_limit[0:max_process];                    & DEBUG &

GLOBAL DOUBLE stack_top;                  & Next avail. stack location.&
```

```
#EJECT;
COMMENT                                                              schedule
.....................................................................
.
. EXTERNAL SPECIFICATION FOR schedule
.
. FUNCTION: To save the state of the running process, determine the
.          next process from the list of ready processes according
.          to priority, restore the state of the selected process,
.          and resume execution of the new process.
.
. DECLARATION INFORMATION:
.    SUBROUTINE schedule
.
.    INPUT: none
.
.    OUTPUT: none
.
. EXTERNAL EFFECTS: none
.
. COMMENTS:  The call to the scheduler is the
.            singular point at which processes are suspended and
.            from which they are resumed.
.
.....................................................................
.
. LOGIC INFORMATION FOR schedule
.
. MODULES CALLED: none
.
. INITIAL REFINEMENT:
.
.   Enter mutual exclusion state (done by the calling procedure).
.   Save state of current process.
.   Save stack pointer of current process.
.   Select new process (highest priority ready process).
.   Restore stack pointer of new process.
.   Restore state (registers) of new process.
.   Release mutual exclusion state (done by the procedure returned to)
.
.....................................................................
;
SUBROUTINE schedule;
   BEGIN & schedule &
      LABEL pop_min,
            pop_done;
      INTEGER cursor = REGISTER 6;
      INTEGER temp = REGISTER 9;
      ASSEMBLE( MOVE    SR,-(S) );               & Save status.         &
                                                 & Status required only &
                                                 & to match interrupts. &
      ASSEMBLE(
                MOVEM.L R13-R14,-(S);            & Push registers.      &
              & MOVE    min_registers,-(S) &     & Mark size of push.   &
                MOVE    =D0,          -(S)
                );
```

```
                                                   & spsave[running] := S &
                                                   & assemble required to &
                                                   & get access to stack  &
                                                   & pointer              &
      ASSEMBLE(
               MOVE   running,temp;
               ADD.L  temp,temp;
               ADD.L  temp,temp;
               MOVE.L S,spsave(temp)
               );
      IF spsave[running] < max_sp[running] THEN                 & DEBUG &
         max_sp[running] := spsave[running];                    & DEBUG &
      IF spsave[running] <= stack_limit[running] THEN           & DEBUG &
         BEGIN & if &                                           & DEBUG &
            WSTR("STACK SIZE ERROR for process ");              & DEBUG &
            WHex(running,2); CRLF;                              & DEBUG &
            TRAP(15);                                           & DEBUG &
         END if;                                                & DEBUG &

      ASSEMBLE(                                   & Find highest priority &
               CLR.L  cursor;                     & ready process by using&
               MOVE.W ready,    cursor;           & normalize function to &
               MOVE.L cursor,   MYNRM;            & find most significant &
               MOVE.B RDEXP+1,  cursor;           & bit.  Read back the   &
               EXTS.W cursor;                     & normalized exponent.  &
               ADD.W  #30,      cursor
               );
      running := cursor;
                                                   & Restore Stack Pointer&
                                                   & S := spsave[running] &
                                                   & temp holds (running).&
      ASSEMBLE(
               MOVE.L cursor,temp;
               ADD.L  temp,temp;
               ADD.L  temp,temp;
               MOVE.L spsave(temp),S
               );
      ASSEMBLE( TST     (S)+;                      & Test type of block.  &
                BGE     pop_min;
                MOVEM.L (S)+,R0-R14;               & Pop full set.        &
                BRA     pop_done );
pop_min: ASSEMBLE( MOVEM.L (S)+,R13-R14 );         & Pop minimum set.     &
pop_done:ASSEMBLE( RTE );                          & Restore status and PC&
                                                   & Status required only &
                                                   & to match interrupts. &
   END;  & schedule &
```

```
#EJECT;
COMMENT                                                                     preempt
***************************************************************************
*
* EXTERNAL SPECIFICATION FOR preempt
*
* FUNCTION: To save the state of the running process, determine the
*           next process from the list of ready processes according
*           to priority, restore the state of the selected process,
*           and resume execution of the new process.
*
* DECLARATION INFORMATION:
*    SUBROUTINE preempt
*
*    INPUT: none
*
*    OUTPUT: none
*
* EXTERNAL EFFECTS: preempt leaves the calling process in the ready
*                   state.  Only a higher priority ready process will
*                   cause the calling process to be suspended.
*
***************************************************************************
*
* LOGIC INFORMATION FOR preempt
*
* MODULES CALLED: none
*
* INITIAL REFINEMENT:
*
*   Save status word.
*   Enter mutual exclusion state.
*   IF a higher urgency process is ready THEN
*      schedule the highest priority process.
*   Release mutual exclusion state and restore status word.
*
***************************************************************************
;
SUBROUTINE preempt;                                                    ENTRY;
   BEGIN & preempt &
      ASSEMBLE( MOVE   SR,-(S) );               & Push Status word.       &
      ASSEMBLE( ORI   =H0700,SR);               & Disable interrupts.     &

      IF (ready AND preempt_mask[running]) <> 0 THEN
         schedule;

      ASSEMBLE( MOVE   (S)+,SR );               & Restore Status word.    &
   END;  & preempt &
```

```
#EJECT;
COMMENT                                                                   send
**************************************************************************
*
* EXTERNAL SPECIFICATION FOR send
*
* FUNCTION: Send "signal" to a process awaiting the "signal".
*
* DECLARATION INFORMATION:
*    PROCEDURE  send(signal)
*       VALUE   signal
*       INTEGER signal
*
*    INPUT:  signal       integer       resource identification number
*
*    OUTPUT: none
*
* EXTERNAL EFFECTS: If a process is awaiting the signal, it is made
*           ready.
*           The calling process remains running.
*
* CAUTION:  This algorithm has better run-time efficiency, but
*           requires that 1) the calling process releases the resource
*           as its next step, 2) the calling process "wait" for a
*           signal as its next step, or 3) that the condition that
*           is being signalled to the waiting process is in no way
*           invalidated before the calling process releases the
*           resource of code or waits for a signal.
*           It is also important that no other process (despite a
*           possible higher urgency) invalidate the signalled
*           condition before the waiting process resumes execution.
*           If the above conditions cannot be guaranteed, then
*           another algorithm (replacement or in addition) must
*           to be implemented to guarantee that the process sending
*           the signal yields the processor to the signallee
*           and that the signallee be given priority over other
*           processes.  Obviously, this would mean more run-time
*           overhead, and would be unsatisfactory for interrupts.
*           Additionally, the above algorithm can result in a
*           significant delay before the signalled process is
*           scheduled if the signalling process, or higher priority
*           process does not wait for some condition soon after
*           calling this "send" procedure.  This is not likely to
*           cause a problem, but should be considered.  The
*           references below treat this subject succinctly.
*
* COMMENTS: For now, only one process may be waiting for a single
*           signal.  See comment for "wait" function.
*
*           The sending of the raw_ready signals is implemented in-line
*           in the yadc data acquisition process for execution-time
*           efficiency.  In this instance, there is no schedule
*           operation.  Rather, it only sets the ready bit of the
*           waiting process and depends upon the preempt in the idle
*           loop to do the scheduling.  This is workable only because
*           the waiting processes are the data processing processes and
```

```
*           are among the lowest priority processes (near idle).
*
*           References:  Hoare, "Monitors: An Operating System
*           structuring Concept", Comm of the ACM, Vol 17, No. 10,
*           Oct 1974. Howard, "Signalling in Monitors", Proc. of
*           2nd Int'l Conf on Software Engineering, San Francisco,
*           1974, p47-52. [The term "resource" used here is synonamous
*           with Hoare's "monitor".
*
************************************************************************
*
* LOGIC INFORMATION FOR send
*
* MODULES CALLED: none
*
* INITIAL REFINEMENT:
*
*    IF a process is awaiting the signal THEN
*       Enter mutual exclusion state.
*       Ready the signalled process.
*       Unlink the signalled process.
*       Exit mutual exclusion state.
*    ELSE nop.
*
*         NOTE:  The calling process does not relinquish the processor.
*                The signalled process will not obtain the processor
*                   until some process "waits" for a signal or
*                   interrupt.
*
************************************************************************
;
PROCEDURE  send(signal);                         & See CAUTION above!    &
   VALUE   signal;
   INTEGER signal;                                                 ENTRY;
   BEGIN & send &

      IF (counter[signal] := counter[signal] + 1) <= 0 THEN
                                                & If a process is        &
         BEGIN & if &                           & awaiting the signal... &
            ASSEMBLE( MOVE   SR,-(S) );         & Save Status word.      &
            ASSEMBLE( ORI    =H0700,SR);        & Disable interrupts.    &
            ready := SBIT(ready,link[signal]);    & Make it ready and    &
            ASSEMBLE( MOVE   (S)+,SR );         & Restore Status word.   &
         END if;

   END;  & send &
```

```
#EJECT;
COMMENT                                                                   wait
************************************************************************
*
* EXTERNAL SPECIFICATION FOR wait
*
* FUNCTION: suspend the calling process awaiting "signal", and
*           schedule another process.
*
* DECLARATION INFORMATION:
*    PROCEDURE  wait(signal)
*       VALUE   signal
*       INTEGER signal
*
*    INPUT:  signal       integer    resource identification number.
*
*    OUTPUT: none
*
* EXTERNAL EFFECTS: The calling process is suspended, and another
*                   process is scheduled.
*
* COMMENTS: Initially, only one process will be allowed to wait on
*           a single signal variable, although there is no programmed
*           enforcement of this.  If it later proves to be
*           desirable to allow multiple processes to be queued
*           awaiting signal to be sent, it may be implemented by
*           a separate procedure using a single process signal
*           variable or by establishing a queue for the primitive
*           signal variable.
*
*           The wait on the raw_ready signal by the data processing
*           processes in implemented in-line in the data processing
*           processes for execution-time efficiency.  Since there is
*           only one process waiting for these signals, the link is
*           entered only during initialization.  This is no problem
*           since the link is only consulted after the signal count is
*           tested to assure that there is a process waiting.
*
************************************************************************
*
* LOGIC INFORMATION FOR wait
*
* MODULES CALLED: kernel (schedule)
*
* INITIAL REFINEMENT:
*
*    IF signal has not already been sent
*       THEN
*          Enter mutual exclusion state.
*          IF an interrupt didn't send the signal after the test
*             THEN
*                Add the running process to the queue of process(es)
*                    awaiting the signal.
*                Block the running process and schedule a new process.
*          ELSE an interrupt did send the signal and suspension is not
*             necessary.
```

```
*          Exit mutual exclusion state.
*       ELSE
*         continue
*
* COMMENT:  It is possible for an interrupt to occur after the signal
*           counter is decremented but before interrupts are disabled.
*           If the interrupt sends the signal (increments the counter)
*           the test after the interrupts are disabled will catch the
*           fact.  An alternative would be to disable interrupts prior
*           to decrementing the counter, but this would require two
*           time-consuming status register modifications on every call.
*           The approach implemented only penalizes when a suspension
*           is imminent.
*
**********************************************************************
;
PROCEDURE  wait(signal);
   VALUE   signal;
   INTEGER signal;                                              ENTRY;
   BEGIN & wait &

      IF (counter[signal] := counter[signal] - 1) < 0 THEN
                    & interrupt can occur here --^; so test later.     &
         BEGIN & if &                         & If signal not already &
                                              & sent, wait for one.   &
            ASSEMBLE( MOVE   SR,-(S) );       & Push Status word.     &
            ASSEMBLE( ORI   =H0700,SR);       & Disable interrupts.   &
            IF counter[signal] < 0 THEN
               BEGIN & if &               & There was no interim send. &
                  ready := RBIT(ready,running);      & Make not ready  &
                  link[signal] := running;           & Link caller.    &
                  schedule;
               END;  & if &
            ASSEMBLE( MOVE   (S)+,SR );       & Restore Status word.  &
                                              & (restores interrupts).&
         END if;

   END;  & wait &
```

```
#EJECT;
COMMENT                                                              awaited
**********************************************************************
*
* EXTERNAL SPECIFICATION FOR awaited
*
* FUNCTION: test whether any process is waiting for the signal.
*
* DECLARATION INFORMATION:
*    BOOLEAN PROCEDURE awaited(signal)
*       VALUE   signal
*       INTEGER signal
*
*    INPUT:  signal       integer    resource identification number.
*
*    OUTPUT: awaited      boolean    true if a process is awaiting the
*                                    signal, flase otherwise.
*
* EXTERNAL EFFECTS: None.
*
**********************************************************************
*
* LOGIC INFORMATION FOR awaited
*
* MODULES CALLED: none
*
* INITIAL REFINEMENT:
*
*    IF a process is waiting for the signal
*       THEN
*          Return true.
*       ELSE
*          Return false.
*
**********************************************************************
;
BOOLEAN PROCEDURE awaited(signal);
   VALUE   signal;
   INTEGER signal;                                                ENTRY;
   BEGIN & awaited &
      awaited := counter[signal] < 0;
   END;  & awaited &
```

```
#EJECT;
COMMENT                                                              pending
**********************************************************************
*
* EXTERNAL SPECIFICATION FOR pending
*
* FUNCTION: test whether a signal is pending.
*
* DECLARATION INFORMATION:
*    BOOLEAN PROCEDURE pending(signal)
*       VALUE   signal
*       INTEGER signal
*
*    INPUT:  signal       integer    resource identification number.
*
*    OUTPUT: pending      boolean    true if a signal is pending.
*                                    false otherwise.
*
* EXTERNAL EFFECTS: None.
*
**********************************************************************
*
* LOGIC INFORMATION FOR pending
*
* MODULES CALLED: none
*
* INITIAL REFINEMENT:
*
*    IF a signal is pending
*       THEN
*          Return true.
*       ELSE
*          Return false.
*
**********************************************************************
;
BOOLEAN PROCEDURE pending(signal);
   VALUE   signal;                                                  ENTRY;
   INTEGER signal;
   BEGIN & pending &
      pending := counter[signal] > 0;
   END;  & pending &
```

```
#EJECT;
COMMENT                                                                waitio
************************************************************************
*
* EXTERNAL SPECIFICATION FOR waitio
*
* FUNCTION: suspend the calling process awaiting an interrupt from the
*           "device", and schedule another process.
*
* DECLARATION INFORMATION:
*    PROCEDURE  waitio(device)
*
*    INPUT:  device     byte    device number for the device awaited.
*
*    OUTPUT: none
*
* EXTERNAL EFFECTS: The calling process is suspended, and another
*                   process is scheduled.
*                   The interrupt request register in the interrupt
*                   controller is cleared for the designated device
*                   to allow another interrupt or a lower priority
*                   pending interrupt to be recognized.
*
* COMMENTS: Only one process may wait for an interrupt from a device
*           at any given time.  In order to simplify and speed the
*           processing of interrupts, the device-process relationship
*           is fixed at compile time.
*
************************************************************************
*
* LOGIC INFORMATION FOR waitio
*
* MODULES CALLED: kernel (schedule)
*
* INITIAL REFINEMENT:
*
*    Enter mutual exclusion state.
*    Clear the interrupt request bit in the interrupt controller.
*    Block the running process and schedule a new process.
*    Exit mutual exclusion state.
*
************************************************************************
;
PROCEDURE waitio(device);
   VALUE device;
   BYTE  device;                                              ENTRY;
   BEGIN & waitio &

      ASSEMBLE( MOVE   SR,-(S) );              & Push Status word.      &
      ASSEMBLE( ORI   =H0700,SR);              & Disable interrupts.    &
      irack(device);                           & Clears priority mask.  &
      iren(device);                            & Enable interrupt.      &
      ready := RBIT(ready,running);
      schedule;
      ASSEMBLE( MOVE   (S)+,SR );              & Restore Status word.   &
                                               & (restores interrupts).&



                  END;  & waitio &
```

```
#EJECT;
COMMENT                                                          acquire
**********************************************************************
*
* EXTERNAL SPECIFICATION FOR acquire
*
* FUNCTION: to obtain exclusive access to a resource,
*           and to suspend the calling process if the section is
*           already busy, waiting until it is released.
*
* DECLARATION INFORMATION:
*    PROCEDURE  acquire(resource)
*       VALUE   resource
*       INTEGER resource
*
*    INPUT:  resource   integer  resource identification number (rin).
*
*    OUTPUT: none
*
* EXTERNAL EFFECTS:  If the calling process is suspended due to the
*                    resource being busy, a new process is scheduled.
*
**********************************************************************
*
* LOGIC INFORMATION FOR acquire
*
* MODULES CALLED: kernel (schedule)
*
* INTIAL REFINEMENT:
*
*    IF the resource is busy,
*       THEN enter mutual exclusion state,
*          IF an interrupt didn't release the resource after the test
*             THEN
*                Add the calling process to the queue of processes
*                      awaiting access to the resource,
*                Block the running process and schedule a new process.
*             ELSE an interrupt did release the resource and suspension
*                   is not necessary.
*          Exit mutual exclusion state.
*
* COMMENT:  It is possible for an interrupt to occur after the resource
*           counter is decremented but before interrupts are disabled.
*           If the interrupt releases the resource (increments the
*           counter the test after the interrupts are disabled will
*           catch the fact.  This is only pertinent when there
*           were no processes previously awaiting the resource.
*           If this occurs, the acquiring process will not have
*           been linked yet and release will simply ready the
*           An alternative would be to disable interrupts
*           prior to decrementing the counter, but this would
*           require two time-consuming status register modifications on
*           every call.  The approach implemented only penalizes when a
*           suspension is imminent.
*
**********************************************************************
```

```
;
PROCEDURE  acquire(resource);
   VALUE   resource;
   INTEGER resource;                                                    ENTRY;
   BEGIN & acquire &
      INTEGER cursor = REGISTER 9;

      ASSEMBLE( MOVE SR,-(S) );                          & Save Status word.  &
      ASSEMBLE( ORI  =H0700,SR);                         & Disable interrupts.&
      IF (counter[resource] := counter[resource] - 1) < 0 THEN
         BEGIN & if &                                    & Resource is busy.  &
            link[running] := nil;
            ready := RBIT(ready,running);                & Make not ready.    &
            cursor := resource;
            WHILE link[cursor]<>nil DO                   & Find tail of list. &
               cursor := link[cursor];
            link[cursor] := running;                   & Link calling process &
                                                       & to the tail of queue &
                                                       & of processes awaiting &
                                                       & access to the resource&
            IF running = owner[resource] THEN                         & DEBUG &
               fatal(deadlock);                                       & DEBUG &
            schedule;
            & "owner" updated upon unlink during "release" &
         END  & if &
      ELSE                                                            & DEBUG &
         owner[resource] := running;                                  & DEBUG &
      ASSEMBLE( MOVE (S)+,SR );                        & Restore Status word. &

   END; & acquire &
```

```
#EJECT;
COMMENT                                                    conditional_acquire
**************************************************************************
*
* EXTERNAL SPECIFICATION FOR conditional_acquire
*
* FUNCTION: to obtain exclusive access to a resource only if not already
*           busy.  Returns TRUE if the resource was successfully
*           acquired, FALSE if not.
*
* DECLARATION INFORMATION:
*    PROCEDURE  conditional_acquire(resource)
*       VALUE   resource
*       INTEGER resource
*
*    INPUT:  resource   integer  resource identification number (rin).
*
*    OUTPUT: none
*
* EXTERNAL EFFECTS:  none.
*
**************************************************************************
*
* LOGIC INFORMATION FOR conditional_acquire
*
* MODULES CALLED: none
*
* INTIAL REFINEMENT:
*
*    IF the resource is busy THEN
*       return FALSE,
*    ELSE
*       make the resource busy and return TRUE.
*
**************************************************************************
;
BOOLEAN PROCEDURE conditional_acquire(resource);
   VALUE   resource;
   INTEGER resource;                                             ENTRY;
   BEGIN & conditional_acquire &

      ASSEMBLE( MOVE   SR,-(S) );              & Save Status word.     &
      ASSEMBLE( ORI   =H0700,SR);              & Disable interrupts.   &
      IF (counter[resource] := counter[resource] - 1) < 0 THEN
         BEGIN & if &
            counter[resource] := counter[resource] + 1;   & restore it &
            ASSEMBLE( MOVE   (S)+,SR );          & restore status word &
            conditional_acquire := FALSE;
         END   & if &
      ELSE
         BEGIN & else &
            owner[resource] := running;                        & DEBUG &
            ASSEMBLE( MOVE   (S)+,SR );          & restore status word &
            conditional_acquire := TRUE;
         END;  & else &


                    END; & conditional_acquire &
```

```
#EJECT;
COMMENT                                                              release
**********************************************************************
*
* EXTERNAL SPECIFICATION FOR release
*
* FUNCTION: to release exclusive access to a resource,
*           and to make ready any processes awaiting access.
*
* DECLARATION INFORMATION:
*    PROCEDURE release(resource)
*       VALUE resource
*       INTEGER resource
*
*    INPUT:   resource    integer    resource identification number.
*
*    OUTPUT:  none
*
* EXTERNAL EFFECTS: makes ready the first process awaiting access, if
*                   any.
*
**********************************************************************
*
* LOGIC INFORMATION FOR release
*
* MODULES CALLED: none
*
* INITIAL REFINEMENT:
*
*    IF no process is awaiting resource access,
*       THEN resource becomes non-busy,
*    ELSE
*       enter mutual exclusion state
*       make the waiting process ready
*       unlink the first waiting process and make it the resource's
*             owner.
*       exit mutual exclusion state
*
*    NOTE:  release does not relinquish the processor to the waiting
*           process.  The waiting process will not have an opportunity
*           to be scheduled until a running process waits, or is
*           blocked attempting to acquire a busy resource.
*
* COMMENT:  There is no test to prevent releasing a non-acquired
*           resource.  If that were to occur, release would be a non-
*           operation, simply making the idle process ready which is
*           always ready anyway.
*
* COMMENT:  It is possible for an interrupt to occur after the resource
*           counter is decremented but before interrupts are disabled
*           during an acquire.  If the interrupt releases the resource
*           (increments the counter) the test in acquire after
*           interrupts are disabled will catch the fact.  This is only
*           pertinent when there were no processes previously awaiting
*           the resource.  If this occurs, the acquiring process will
*           not have been linked yet and release will simply ready the
```

```
*           idle (0) process as above for releaseing a non-acquired
*           resource.  See comments under acquire for alternatives and
*           reasons for the current approach.
*
***********************************************************************
;
PROCEDURE  release(resource);
   VALUE   resource;
   INTEGER resource;                                            ENTRY;
   BEGIN & release &
      INTEGER cursor = REGISTER 9;

      ASSEMBLE( MOVE   SR,-(S) );                 & Save Status word.  &
      ASSEMBLE( ORI   =H0700,SR);                 & Disable interrupts.&
      IF (counter[resource] := counter[resource]+1) <= 0 THEN
         BEGIN
            cursor := link[resource];
            owner[resource] := cursor;                         & DEBUG &
            link[resource] := link[cursor];       & Unlink process.    &
            ready := SBIT(ready,cursor);          & Make process ready &
         END;  & if &
      ASSEMBLE( MOVE   (S)+,SR );                & Restore Status word &

   END;  & release &
```

```
#EJECT;
COMMENT                                                           delay
***********************************************************************
*
* EXTERNAL SPECIFICATION FOR delay
*
* FUNCTION: to suspend a process for the duration of the specified
*          delay_time.
*
* DECLARATION INFORMATION:
*    PROCEDURE  delay(delay_time)
*       VALUE   delay_time
*       INTEGER delay_time
*
*    INPUT:  delay_time   integer   time in multiples of 32 usec.
*                         [ full 65535 -- not 2's complement ]
*                         minimum = 32 usec = 1     = %0001
*                                   50 usec = 2     = %0002
*                                   100 usec= 3     = %0003
*                                   200 usec= 6     = %0006
*                                   500 usec= 16    = %0010
*                                   1 msec  = 31    = %001F
*                                   2 msec  = 62    = %003E
*                                   5 msec  = 156   = %009C
*                                   10 msec = 313   = %0139
*                                   20 msec = 625   = %0271
*                                   50 msec = 1563  = %061B
*                                   100 msec= 3125  = %0C35
*                                   200 msec= 6250  = %186A
*                                   500 msec= 15625 = %3D09
*                                   1 sec   = 31250 = %7A12
*                                   2 sec   = 62500 = %F424
*                         maximum = 2.1 sec = 65535 = %FFFF
*    OUTPUT: none
*
* EXTERNAL EFFECTS:
*    Upon completion of the delay time interval, the process will be
* made ready, but will only be scheduled if it is the highest priority
* process ready at that time [applies to delay_time >= 16 (500 usec)].
*
* COMMENTS:
*    "delay" is intended to be used by only a single caller at one
* time.  Any subsequent caller will be suspended attempting to
* acquire the time (resource) and its requested delay will then be
* performed upon resumption.  For this reason, unbridled use of
* "delay" will only guarantee a delay of at least the specified time
* and possibly more.
*    The intended use of "delay" is for providing delays for VCO
* settling, settling time after an external analog out step before
* making measurements, etc, which are mutually exclusive.
*    Consider using the general purpose "pause" routine whenever
* possible.
*
* BUGS:
*    The interrupt routine that reschedules the suspended process
* should implement the "preempt" to eliminate an unnecessary pair of
```

```
* process swaps should the interrupted process have higher priority than
* the "delayed" process.
*
*************************************************************************
*
* LOGIC INFORMATION FOR delay
*
* MODULES CALLED: kernel (preempt)
*
* INTIAL REFINEMENT:
*    acquire delay timer.
*    IF delay > 500 microseconds THEN
*       save running process's id in delay_timer_id.
*       start timer.
*       waitio(delay_timer).
*       preempt upon return in case interrupted process has priority.
*       release delay timer.
*    ELSE
*       wait in a programmed loop.
*
*************************************************************************
;
  PROCEDURE  delay(delay_time);
     VALUE   delay_time;
     INTEGER delay_time;                                          ENTRY;
     BEGIN & delay &
        BYTE CONSTANT latch_time := 0;
        BYTE    delay_timer    = io + %61;
        BYTE    timer_command  = io + %67;
        BYTE    delay_time_lsb = delay_time + 1;
        BYTE    delay_time_msb = delay_time;

        IF (delay_time AND %FFF0) <> 0 THEN
           BEGIN & if &                   & delay > 500 microseconds &

              acquire(delay_timer_resource);

              delay_timer_id := running;           & save process id &
                                                   &    for return.  &

        & 8253 does not allow timer loading to be interrupted per     &
        & Intel Information Sheet 1-2-79 "How the 8253 Really Works". &
              ASSEMBLE( MOVE SR,     -(S) );     & Push status word  &
              ASSEMBLE( ORI  =H0700, SR   );     & Disable interrupts &
              delay_timer := delay_time_lsb;            & start timer &
              delay_timer := delay_time_msb;
              ASSEMBLE( MOVE (S)+,   SR   );     & Restore status word&

              waitio(delay_timer_vctr);            & suspend thyself &
              irdis(delay_timer_vctr);

              delay_timer_id := idle_process;
              release(delay_timer_resource);

              preempt;                             & any higher pri- &
                                                   & ority processes &
```

```
                                                        & (like the one we&
                                                        & just intrrptd)? &
                                                        & See BUG above.  &
            END   & if &
         ELSE                                  & delay < 500 microseconds &
            BEGIN & else &
               TRAP(refresh_vctr);&refr mem for even straight thru time&
               delay_time := delay_time - 1;          & for set-up time &
                  WHILE delay_time > 0 DO
                     BEGIN & while &
                        TRAP(refresh_vctr);             & refresh memory &
                        TRAP(refresh_vctr);             & [ 15 usec/TRAP &
                        delay_time := delay_time - 1; &   at 8 MHz]     &
                     END;  & while &
            END;  & else &

      END;  & delay &
```

```
#EJECT;
COMMENT                                                                 pause
*************************************************************************
*
* EXTERNAL SPECIFICATION FOR pause
*
* FUNCTION: to suspend a process for the duration of the specified
*           interval.
*
* DECLARATION INFORMATION:
*    PROCEDURE  pause(interval)
*       VALUE   interval
*       INTEGER interval
*
*    INPUT:  interval   integer   time in multiples of 125 msec.
*                                 maximum value = 32767 (68.3 minutes)
*
*    OUTPUT: none
*
* EXTERNAL EFFECTS:
*    Upon completion of the pause interval, the process will be
* made ready, but will only be scheduled if it is the highest priority
* process ready at that time.
*
* COMMENTS:
*    The pause interval is counted on the basis of 125 millisecond
* "ticks" from the hardware clock. The actual pause will be
* the requested interval plus zero/minus one tick.  For example,
* pause(9) could result in a delay of from 1 to 1.125 seconds.
* Similarly, pause(1) could result in a delay of 125 milliseconds,
* or no delay at all.
*    There is a companion routine called "delay" for shorter delays, but
* it is restricted to use by mutually exclusive routines -- it is not
* reentrant.
*
*************************************************************************
*
* LOGIC INFORMATION FOR pause
*
* MODULES CALLED: schedule
*
* INTIAL REFINEMENT:
*    disable interrupts.
*    check validity of requested interval.
*    save running process's id in linked-list of waiting processes.
*    schedule
*    enable interrupts.
*
*************************************************************************
;
   PROCEDURE  pause(interval);
      VALUE   interval;
      INTEGER interval;                                           ENTRY;
      BEGIN & pause &
         INTEGER ptr;
         INTEGER prev_ptr;
```

```
      IF interval >= 0 THEN
         BEGIN & if &

            ASSEMBLE( MOVE   SR,-(S) );      & Push Status word.     &
            ASSEMBLE( ORI   =H0700,SR);      & Disable interrupts.   &

            prev_ptr := pause_list;
            ptr := link[ pause_list ];

            WHILE ( (ptr <> nil) AND (counter[ptr] < interval) ) DO
               BEGIN & while &               & Find place in list.   &
                  interval := interval - counter[ptr];
                  prev_ptr := ptr;
                  ptr := link[ptr];
               END;  & while &

            link[running] := ptr;            & Add caller to list.   &
            counter[running] := interval;
            link[prev_ptr] := running;

            IF ptr <> nil THEN               & Update next counter.  &
               counter[ptr] := counter[ptr] - interval;

            ready := RBIT(ready,running);    & Make not ready.       &
            schedule;

            ASSEMBLE( MOVE  (S)+,SR  );      & Restore Status word.  &
                                             & (restores interrupts).&

         END;  & if &

   END;  & pause &
```

```
#EJECT;
COMMENT                                                           terminate
***********************************************************************
*
* EXTERNAL SPECIFICATION FOR terminate
*
* FUNCTION: To terminate the running process.
*
* DECLARATION INFORMATION:
*    SUBROUTINE terminate
*
*    INPUT:  none
*
*    OUTPUT: none
*
***********************************************************************
*
* LOGIC INFORMATION FOR terminate
*
* MODULES CALLED:  none
*
* INITIAL REFINEMENT:
*
*    Make the process not ready.
*    Schedule the highest priority ready process.
*
***********************************************************************
;
   SUBROUTINE terminate;                                            ENTRY;
      BEGIN
         ready := RBIT(ready,running);
         ASSEMBLE( MOVE   SR,-(S)  );                 & Push status word.&
         ASSEMBLE( ORI   =H0700,SR );                 & Disable interrupt&
         schedule;
         ASSEMBLE( MOVE   (S)+,SR  );                 & Restore status.  &
      END terminate;
```

```
#EJECT;
COMMENT                                                                  abort
**********************************************************************
*
* EXTERNAL SPECIFICATION FOR abort
*
* FUNCTION: To terminate the designated process.
*
* DECLARATION INFORMATION:
*    PROCEDURE abort(id)
*
*    INPUT:  id    integer    process id.
*
*    OUTPUT: none
*
* COMMENT:  In order to abort a process, one must be careful not to
*    leave the process on any wait list where it might be rescheduled
*    at a later time.  Similarly, the process may own some resources
*    as a result of being interrupted, or -- heaven forbid -- as the
*    result of the code not releasing a resource prior to suspending
*    itself while waiting for a signal or interrupt.
*
**********************************************************************
*
* LOGIC INFORMATION FOR abort
*
* MODULES CALLED:  none
*
* INITIAL REFINEMENT:
*
*    Make the process not ready.
*    Schedule the highest priority ready process.
*
**********************************************************************
;
  PROCEDURE  abort(id);
     VALUE   id;
     INTEGER id;                                                  ENTRY;
     BEGIN & abort &
        ready := RBIT(ready,id);
        ASSEMBLE( MOVE   SR,-(S)  );              & Save status.      &
        ASSEMBLE( ORI   =H0700,SR );              & Disable interrupt&
        schedule;
        ASSEMBLE( MOVE   (S)+,SR  );              & Restore status.   &
     END abort;
```

```
#EJECT;
COMMENT                                                                  run
**************************************************************************
*
* EXTERNAL SPECIFICATION FOR run
*
* FUNCTION: To begin execution of a new (or dormant) process.
*
* DECLARATION INFORMATION:
*    PROCEDURE run(processid)
*       VALUE processid
*       INTEGER processid
*
*    INPUT:  processid   integer  process id of the process to run.
*
*.   OUTPUT: none
*
* COMMENTS:  can be used in conjunction with create as follows:
*            run( create(process,stacksize,ungency) )
*
**************************************************************************
*
* LOGIC INFORMATION FOR run
*
* MODULES CALLED:  none
*
* INITIAL REFINEMENT:
*
*    Initialize stack and saved process state information.
*    Make the process ready.
*    Schedule the highest priority ready process, including the new
*       process.
*
**************************************************************************
;
  PROCEDURE  run(processid);
     VALUE.  processid;
     INTEGER processid;                                          ENTRY;
     BEGIN
        INTEGER CONSTANT activation_size := 18;
        DOUBLE process;
        DOUBLE term;
        DOUBLE marker;
        DOUBLE stack = REGISTER 9;
        term := ADRS(terminate);
        stack := initialsp[processid];
        marker := stack + 2;
        spsave[processid] := stack - activation_size;
        max_sp[processid] := spsave[processid];                  & DEBUG &
        process := initialpc[processid];

        ASSEMBLE(
                 MOVE.L term,-2(stack);         & Terminate routine.   &
                 MOVE.L process,-6(stack);      & Initial p.c.         &
                 MOVE   =H2000,-8(stack);       & Processor status wd. &
                 MOVE.L marker,-12(stack);      & Stack Marker (M=R14) &
```

```
            MOVE.L =H12345678,-16(stack); & R13                &
          & MOVE   min_registers,-activation_size(stack)  &
            MOVE   =D0,          -activation_size(stack)
            );                             & Mark size of push.   &
   ready := SBIT(ready,processid);
   ASSEMBLE( MOVE.L SR,-(S)  );            & Save status.         &
   ASSEMBLE( ORI   =H0700,SR );            & Disable interrupts.  &
   schedule;
   ASSEMBLE( MOVE.L (S)+,SR  );            & Restore status.      &
END run;
```

```
#EJECT;
COMMENT                                                                    create
**************************************************************************
*
* EXTERNAL SPECIFICATION FOR create
*
* FUNCTION: Initialize the process record for a new process.
*
* DECLARATION INFORMATION:
*    INTEGER PROCEDURE create(process,stacksize,urgent)
*       VALUE process, stack, urgent
*       DOUBLE process
*       INTEGER stacksize, urgent
*
*    INPUT:   process     double        address of the outer procedure
*                                       that defines the process,
*                                       e.g. ADRS(procname).
*             stacksize   integer       stack space to allocate for
*                                       the process (in words).
*             urgent      integer       the urgency (priority) to be
*                                       assigned to the process.
*
*    OUTPUT:  create      integer       returns process id of created
*                                       process.
*
*·COMMENTS: Create currently assumes unique values of urgency (which
*           also should be contiguous to avoid wasting space and time).
*
**************************************************************************
*
* LOGIC INFORMATION FOR create
*
* MODULES CALLED: none
*
* INITIAL REFINEMENT:
*
*    Set process's urgency.
*    Decrement available stack marker by process's stack size.
*    Set process's initial stack address.
*    Set process's initial program counter value (begin execution
*       address).
*    Assign and return a process id number.
*
**************************************************************************
;
   INTEGER PROCEDURE create(process, stacksize, urgent);
      VALUE process, stacksize, urgent;
      DOUBLE process;
      INTEGER stacksize, urgent;                                    ENTRY;
      BEGIN
         INTEGER POINTER ptr;                                   & DEBUG &
         INTEGER id = urgent;                   & May later compute a  &
                                                & different id.        &
         urgency[id] := urgent;
         datasize[id] := stacksize;
         stack_top := stack_top - stacksize;    & Order of execution   &
```

```
      initialsp[id] := stack_top + stacksize;& is important for     &
                                             & reentrancy.          &
      initialpc[id] := process;
      IF ( (stack_top   AND %0001FFFF) <                     & DEBUG &
           (ADRS(mark1) AND %0001FFFF)                       & DEBUG &
         ) THEN                                              & DEBUG &
         fatal(process_creation_error);                      & DEBUG &
      create := id;

      max_sp[id] := initialsp[id];                           & DEBUG &
      stack_limit[id] := stack_top;                          & DEBUG &
      IF id <> 0 THEN                  & init stack space &  & DEBUG &
         STPNTR(ptr,initialsp[id])                           & DEBUG &
      ELSE                                                   & DEBUG &
         STPNTR(ptr,initialsp[0]-256);                       & DEBUG &
      REPEAT ARIGHT(stacksize,1) DO                          & DEBUG &
         BEGIN                                               & DEBUG &
            ptr := stack_fill;                               & DEBUG &
            STPNTR(ptr,ADRS(ptr[-1]) );                      & DEBUG &
         END;                                                & DEBUG &
   END create;



#EJECT;
COMMENT                                                        signal_init
************************************************************************
*
************************************************************************
;
   PROCEDURE signal_init(signal,count);
      VALUE signal,count;
      INTEGER signal,count;                                         ENTRY;
                                          & Count normally = 0.         &
      BEGIN & signal_init &
         counter[signal] := count;        & +n = |n| signals pending.&
                                          &  0 = no signals pending  &
                                          & -n = |n| proc's waiting. &
         link[signal] := nil;
      END signal_init;


   PROCEDURE resource_init(resource);
      VALUE resource;
      INTEGER resource;                                             ENTRY;
      BEGIN & resource_init &
         counter[resource] := 1;          & 1 = notbusy.             &
                                          & 0 = busy, no one waiting.&
                                          & -n = |n| proc's waiting. &
         link[resource] := nil;
      END resource_init;
```

```
#EJECT;
COMMENT                                                  IO DRIVER MODULES
**************************************************************************
*
* IO DRIVER modules merged here.
*
**************************************************************************
;



#EJECT;
COMMENT                            bottom box interrupt service routine;

   SUBROUTINE intrpt_bottom;                                       ENTRY;
         & Must be SUBROUTINE.      INTERRUPT's LINK/UNLK kills it. &
      BEGIN
         LABEL pop_min,
               pop_done;
      &  INTEGER CONSTANT min_registers := 0;      declared in skernel &
      &  INTEGER CONSTANT all_registers := -1;     declared in skernel &
         INTEGER id = REGISTER 9;
         DOUBLE spsave_bottom_id = spsave + 4*bottom_id;

         ASSEMBLE(
                   MOVEM.L R0-R14,-(S);         & Push registers.      &
                 & MOVE    all_registers,-(S) & & Mark size of push.   &
                   MOVE    =D-1,-(S)
                   );

         id := running;
         ASSEMBLE(
                  ADD.L  id,id;
                  ADD.L  id,id;
                  MOVE.L S,spsave(id);
                  MOVE.L spsave_bottom_id, S
                  );
         running := bottom_id;
         ready := SBIT(ready,bottom_id);
         ASSEMBLE(
                  TST.W   (S)+;              & Test type of block.  &
                  BGE     pop_min;
                  MOVEM.L (S)+,R0-R14;       & Pop full set.        &
                  BRA     pop_done
                  );
pop_min: ASSEMBLE(MOVEM.L (S)+,R13-R14 );    & Pop minimum set.     &
pop_done:ASSEMBLE(RTE);
      END intrpt_bottom;
```

```
#EJECT;
COMMENT                                    rpg interrupt service routine;

   SUBROUTINE intrpt_rpg;                                          ENTRY;
            & Must be SUBROUTINE.      INTERRUPT's LINK/UNLK kills it. &
      BEGIN
         LABEL pop_min,
               pop_done;
      &  INTEGER CONSTANT min_registers := 0;      declared in skernel &
      &  INTEGER CONSTANT all_registers := -1;     declared in skernel &
         INTEGER id = REGISTER 9;
         DOUBLE spsave_rpg_id = spsave + 4*rpg_id;

         ASSEMBLE(
                    MOVEM.L R0-R14,-(S);         & Push registers.      &
                  & MOVE    all_registers,-(S) & & Mark size of push.   &
                    MOVE    =D-1,-(S)
                    );

         id := running;
         ASSEMBLE(
                   ADD.L   id,id;
                   ADD.L   id,id;
                   MOVE.L  S,spsave(id);
                   MOVE.L  spsave_rpg_id, S
                   );
         running := rpg_id;
         ready := SBIT(ready,rpg_id);
         ASSEMBLE(
                   TST.W    (S)+;              & Test type of block.  &
                   BGE      pop_min;
                   MOVEM.L  (S)+,R0-R14;       & Pop full set.        &
                   BRA      pop_done
                   );
pop_min: ASSEMBLE(MOVEM.L (S)+,R13-R14 );      & Pop minimum set.     &
pop_done:ASSEMBLE(RTE);
      END intrpt_rpg;
```

```
#EJECT;
COMMENT                          top keyboard interrupt service routine;

   SUBROUTINE intrpt_top_key;                                      ENTRY;
            & Must be SUBROUTINE.      INTERRUPT's LINK/UNLK kills it. &
      BEGIN
         LABEL pop_min,
               pop_done;
      &  INTEGER CONSTANT min_registers := 0;      declared in skernel &
      &  INTEGER CONSTANT all_registers := -1;     declared in skernel &
         INTEGER id = REGISTER 9;
         DOUBLE spsave_top_key_id = spsave + 4*top_key_id;

         ASSEMBLE(
                   MOVEM.L R0-R14,-(S);          & Push registers.      &
                 & MOVE    all_registers,-(S) & & Mark size of push.   &
                   MOVE    =D-1,-(S)
                   );

         id := running;
         ASSEMBLE(
                  ADD.L  id,id;
                  ADD.L  id,id;
                  MOVE.L S,spsave(id);
                  MOVE.L spsave_top_key_id, S
                  );
         running := top_key_id;
         ready := SBIT(ready,top_key_id);
         ASSEMBLE(
                  TST.W   (S)+;                 & Test type of block.  &
                  BGE     pop_min;
                  MOVEM.L (S)+,R0-R14;          & Pop full set.        &
                  BRA     pop_done
                  );
pop_min: ASSEMBLE(MOVEM.L (S)+,R13-R14 );      & Pop minimum set.     &
pop_done:ASSEMBLE(RTE);
      END intrpt_top_key;
```

```
#EJECT;
COMMENT                                      uart interrupt service routine;

   SUBROUTINE intrpt_uart;                                             ENTRY;
         & Must be SUBROUTINE.      INTERRUPT's LINK/UNLK kills it. &
      BEGIN
         LABEL pop_min,
               pop_done;
      &  INTEGER CONSTANT min_registers := 0;      declared in skernel &
      &  INTEGER CONSTANT all_registers := -1;     declared in skernel &
         INTEGER id = REGISTER 9;
         DOUBLE spsave_uart_id = spsave + 4*uart_id;

         ASSEMBLE(
                   MOVEM.L R0-R14,-(S);         & Push registers.       &
                 & MOVE    all_registers,-(S) & & Mark size of push.    &
                   MOVE    =D-1,-(S)
                   );

         id := running;
         ASSEMBLE(
                  ADD.L  id,id;
                  ADD.L  id,id;
                  MOVE.L S,spsave(id);
                  MOVE.L spsave_uart_id, S
                  );
         running := uart_id;
         ready := SBIT(ready,uart_id);
         ASSEMBLE(
                  TST.W   (S)+;              & Test type of block.  &
                  BGE     pop_min;
                  MOVEM.L (S)+,R0-R14;       & Pop full set.        &
                  BRA     pop_done
                  );
pop_min: ASSEMBLE(MOVEM.L (S)+,R13-R14 );    & Pop minimum set.     &
pop_done:ASSEMBLE(RTE);
      END intrpt_uart;
```

```
#EJECT;
COMMENT                        priv_ib_srq     interrupt service routine;

   SUBROUTINE intrpt_priv_ib_srq;                                ENTRY;
            & Must be SUBROUTINE.      INTERRUPT's LINK/UNLK kills it. &
      BEGIN
         LABEL pop_min,
               pop_done;
      &  INTEGER CONSTANT min_registers := 0;      declared in skernel &
      &  INTEGER CONSTANT all_registers := -1;     declared in skernel &
         INTEGER id = REGISTER 9;
         DOUBLE spsave_priv_ib_srq_id = spsave + 4*priv_ib_srq_id;

         ASSEMBLE(
                   MOVEM.L R0-R14,-(S);         & Push registers.      &
                 & MOVE    all_registers,-(S) & & Mark size of push.   &
                   MOVE    =D-1,-(S)
                   );

         id := running;
         ASSEMBLE(
                  ADD.L  id,id;
                  ADD.L  id,id;
                  MOVE.L S,spsave(id);
                  MOVE.L spsave_priv_ib_srq_id, S
                  );
         running := priv_ib_srq_id;
         ready := SBIT(ready,priv_ib_srq_id);
         ASSEMBLE(
                  TST.W   (S)+;                 & Test type of block.  &
                  BGE     pop_min;
                  MOVEM.L (S)+,R0-R14;          & Pop full set.        &
                  BRA     pop_done
                  );
pop_min: ASSEMBLE(MOVEM.L (S)+,R13-R14 );       & Pop minimum set.     &
pop_done:ASSEMBLE(RTE);
      END intrpt_priv_ib_srq ;
```

```
#EJECT;
COMMENT                        delay_timer    interrupt service routine;

   SUBROUTINE intrpt_delay_timer;                                  ENTRY;
            & Must be SUBROUTINE.      INTERRUPT's LINK/UNLK kills it. &
      BEGIN
         LABEL pop_min,
               pop_done;
      &  INTEGER CONSTANT min_registers := 0;      declared in skernel &
      &  INTEGER CONSTANT all_registers := -1;     declared in skernel &
         INTEGER id = REGISTER 9;
         INTEGER id2 = REGISTER 6;

         ASSEMBLE(
                  MOVEM.L R0-R14,-(S);          & Push registers.      &
                & MOVE    all_registers,-(S) &  & Mark size of push.   &
                  MOVE    =D-1,-(S)
                  );

         ASSEMBLE(
                  MOVE   running,id;

                  ADD.L  id,id;                & stash away interrupted &
                  ADD.L  id,id;                &    process's SP.       &
                  MOVE.L S,spsave(id);

                  MOVE   delay_timer_id,id2;   & 'cause will need both  &
                  MOVE   id2,id;               &    addr and data reg's &
                  MOVE   id2,running;
                  ADD.L  id,id;                & get delayed process's  &
                  ADD.L  id,id;                &    SP.                 &
                  MOVE.L spsave(id), S
                  );

         ready := SBIT(ready,id2);
         ASSEMBLE(
                  TST.W    (S)+;                & Test type of block.  &
                  BGE      pop_min;
                  MOVEM.L  (S)+,R0-R14;         & Pop full set.        &
                  BRA      pop_done
                  );
pop_min: ASSEMBLE(MOVEM.L (S)+,R13-R14 );       & Pop minimum set.     &
pop_done:ASSEMBLE(RTE);
      END intrpt_delay_timer ;
```

```
#EJECT;
COMMENT                                        tick interrupt service routine
**************************************************************************
*
* LOGIC INFORMATION FOR tick
*
* MODULES CALLED kernel (schedule)
*
* INITIAL REFINEMENT:
*    save working register set
*    restore working register set
*    RTE (to restore status word)
*
**************************************************************************
;
SUBROUTINE intrpt_tick;                                            ENTRY;
   BEGIN & intrpt_tick &
      INTEGER CONSTANT delta := 1;        & count increments per tick  &
      INTEGER          ptr    = REGISTER 6;

      ASSEMBLE( MOVEM.L R0-R14,-(S) );

      ptr := link[pause_list];

      IF (ptr <> nil) AND ((counter[ptr] := counter[ptr] - 1) <= 0)
               THEN
         BEGIN & if &

            DO                                          & Unlink and start &
               BEGIN & do &                             &   processes that &
                  ready := SBIT(ready,ptr);              &   are timed-out. &
                  link[pause_list] := link[ptr];
                  ptr := link[pause_list];
               END   & do &
            UNTIL ( (ptr = nil) OR (counter[ptr] > 0) );

            IF (ready AND preempt_mask[running]) <> 0 THEN
               schedule;                                & Same as preempt  &
                                                        &   without JSR.   &
         END;  & if &

      update_hpib_leds;

      ASSEMBLE( MOVEM.L (S)+,R0-R14 );
      ASSEMBLE( RTE );

   END;  & intrpt_tick &
```

```
#EJECT;
COMMENT                                                         init_kernel
**********************************************************************
*
* EXTERNAL SPECIFICATION FOR init_kernel
*
* FUNCTION: To initialize the kernel data structures for no processes
*           except the idle process.
*
* DECLARATION INFORMATION:
*    PROCEDURE init_kernel
*
*    INPUT:  none
*
*    OUTPUT: none
*
* EXTERNAL EFFECTS: none
*
**********************************************************************
*
* LOGIC INFORMATION FOR init_kernel
*
* MODULES CALLED: none
*
* INITIAL REFINEMENT:
*
*    Initialize kernel data (link,ready,counter,stack_top).
*    Initialize data for this main/idle process (id=0).
*               (running,ready,stack_top,initialsp,initialpc,urgency).
*    Initialize delay timer.
*    Initialize tick.
*
**********************************************************************
;
  PROCEDURE init_kernel;                                           ENTRY;
     BEGIN
        BYTE    CONSTANT delay_timer_mode := %38; & mode 4, binary,    &
                                                 & lsb first, timer0 &
        BYTE    CONSTANT idleurgency      := 0;
        INTEGER CONSTANT idlesize         := %200;
        BYTE    timer_command = io + %67;
        INTEGER index;
        INTEGER idleid;

        DOUBLE  SUBROUTINE stackbase;
           BEGIN
              ASSEMBLE( EXT $RAM$ );
              ASSEMBLE( MOVE.L $RAM$,R0 );
              ASSEMBLE( SUB    =D2,R0 );
           END;

        DOUBLE  SUBROUTINE beginexecutionaddress;
           BEGIN
              ASSEMBLE( EXT $RAM$ );
              ASSEMBLE( MOVE.L $RAM$+4,R0 );
           END;
```

```
    ASSEMBLE( MOVE   SR,-(S)  );        & Save status word.        &
    ASSEMBLE( ORI   =H0700,SR );        & Disable Interrupts.      &

    stack_top := ADRS(mark0); & dummys for loadmap marks && DEBUG &
    stack_top := ADRS(mark1);                             & DEBUG &
    stack_top := ADRS(mark3);                             & DEBUG &
    stack_top := ADRS(mark_dg_base);                      & DEBUG &
    stack_top := ADRS(mark_dg_top);                       & DEBUG &

    stack_top := ADRS(mark_stack); & this dummy is req'd to force &
          & the linker to load a module for resetting the initial &
          & stack pointer $RAM$ value (returned by stackbase)     &

    stack_top := stackbase;
    FOR index := 0 UNTIL max_process DO                   & DEBUG &
       BEGIN & for &                                      & DEBUG &
          spsave[index] := 0;                             & DEBUG &
          initialsp[index] := 0;                          & DEBUG &
          initialpc[index] := 0;                          & DEBUG &
          datasize[index] := 0;                           & DEBUG &
          urgency[index] := -1;                           & DEBUG &
          max_sp[index] := 0;                             & DEBUG &
          stack_limit[index] := 0;                        & DEBUG &
       END for;                                           & DEBUG &
    FOR index := 0 UNTIL max_rin DO
       BEGIN & for &
          link[index]    := nil;
          counter[index] := 0;         & necessary for "pause" &
       END for;
    FOR index := min_rin UNTIL max_rin DO                 & DEBUG &
       owner[index] := -1;                                & DEBUG &
    ready := 0;                     & All bits = false.        &
    idleid := create(beginexecutionaddress,idlesize,idleurgency);
    ready := SBIT(ready,idleid);
    running := idleid;

    delay_timer_id := idle_process;
    resource_init(delay_timer_resource);
    timer_command := delay_timer_mode; & Initialize delay timer.  &
    iradr( ADRS(intrpt_delay_timer), delay_timer_vctr );
    irdis( delay_timer_vctr );      & disable until "delay" is &
                                    & called.  If interrupted  &
                                    & between iradr and irdis, &
                                    & it will only enable idle.&
    link[pause_list] := nil;
    iradr( ADRS(intrpt_tick), tick_vctr );

    ASSEMBLE( MOVE   (S)+,SR  );        & Restore status word.     &
 END init_kernel;
                                                          & DEBUG &
                                                          & DEBUG &
                                                          & DEBUG &
```

```
#EJECT;                                                          & DEBUG &
COMMENT                                                 snapshot & DEBUG &
**************************************************************** & DEBUG &
*                                                                & DEBUG &
* FUNCTION: To dump the kernel data in a meaningful manner.     & DEBUG &
*                                                                & DEBUG &
**************************************************************** & DEBUG &
;                                                                & DEBUG &
PROCEDURE  snapshot;                                      ENTRY; & DEBUG &
BEGIN & snapshot &                                               & DEBUG &
   INTEGER i;                                                    & DEBUG &
   INTEGER POINTER stack_data;                                   & DEBUG &
                                                                 & DEBUG &
   CRLF;                                                         & DEBUG &
   WSTR("run="); WHEX(running);                                  & DEBUG &
   WSTR(" rdy="); WHEX(ready);                                   & DEBUG &
   WSTR(" stktop="); WHex(stack_top,8); CRLF;                    & DEBUG &
   WSTR("  #   link  ctr  spsave"); CRLF;                        & DEBUG &
   FOR i := 0 TO max_process DO                                  & DEBUG &
      BEGIN & for &                                              & DEBUG &
         WHEX(i);                                                & DEBUG &
         WHEX(link[i]);                                          & DEBUG &
         WHEX(counter[i]);                                       & DEBUG &
         WHex(spsave[i],8);                                      & DEBUG &
         CRLF;                                                   & DEBUG &
      END for;                                                   & DEBUG &
   WSTR("  #   link  ctr  owner "); CRLF;                        & DEBUG &
   FOR i := min_rin TO max_rin DO                                & DEBUG &
      BEGIN & for &                                              & DEBUG &
         WHEX(i);                                                & DEBUG &
         WHEX(link[i]);                                          & DEBUG &
         WHEX(counter[i]);                                       & DEBUG &
         WHEX(owner[i]);                                         & DEBUG &
         CRLF;                                                   & DEBUG &
      END for;                                                   & DEBUG &
   TRAP(15);                                                     & DEBUG &
END snapshot;                                                    & DEBUG &

END$ module "kernel"

                                                                 & DEBUG &
                                                                 & DEBUG &
                                                                 & DEBUG &
```

```
#EJECT;                                                          & DEBUG &
COMMENT                                      MINIMUM  snapshot  & DEBUG &
**************************************************************  & DEBUG &
*                                                                & DEBUG &
* FUNCTION: To dump the kernel data in a meaningful manner.      & DEBUG &
*                                                                & DEBUG &
**************************************************************  & DEBUG &
;                                                                & DEBUG &
PROCEDURE  snapshot;                                     ENTRY;  & DEBUG &
BEGIN & snapshot &                                               & DEBUG &
   INTEGER i;                                                    & DEBUG &
   INTEGER POINTER stack_data;                                   & DEBUG &
                                                                 & DEBUG &
   CRLF;                                                         & DEBUG &
   WSTR("run   = "); WHEX(running); CRLF;                        & DEBUG &
   WSTR("rdy   = "); WHEX(ready);   CRLF;                        & DEBUG &
   WSTR("stktop= "); WHex(stack_top,8); CRLF;                    & DEBUG &
   WSTR("  #   link  ctr  spsave"); CRLF;                        & DEBUG &
   FOR i := 0 TO max_process DO                                  & DEBUG &
      BEGIN & for &                                              & DEBUG &
         WHEX(i);                                                & DEBUG &
         WHEX(link[i]);                                          & DEBUG &
         WHEX(counter[i]);                                       & DEBUG &
         WHex(spsave[i],8);                                      & DEBUG &
         CRLF;                                                   & DEBUG &
      END for;                                                   & DEBUG &
   WSTR("  #   link  ctr  owner "); CRLF;                        & DEBUG &
   FOR i := min_rin TO max_rin DO                                & DEBUG &
      BEGIN & for &                                              & DEBUG &
         WHEX(i);                                                & DEBUG &
         WHEX(link[i]);                                          & DEBUG &
         WHEX(counter[i]);                                       & DEBUG &
         WHex(owner[i]);                                         & DEBUG &
         CRLF;                                                   & DEBUG &
      END for;                                                   & DEBUG &
   TRAP(15);                                                     & DEBUG &
END snapshot;                                                    & DEBUG &

                                                                 & DEBUG &
                                                                 & DEBUG &
                                                                 & DEBUG &
```

```
#EJECT;                                                        & DEBUG &
COMMENT                                               snapshot & DEBUG &
************************************************************** & DEBUG &
*                                                              & DEBUG &
* FUNCTION: To dump the kernel data in a meaningful manner.    & DEBUG &
*                                                              & DEBUG &
************************************************************** & DEBUG &
;                                                              & DEBUG &
PROCEDURE  snapshot;                                    ENTRY; & DEBUG &
BEGIN & snapshot &                                             & DEBUG &
   INTEGER i;                                                  & DEBUG &
   INTEGER POINTER stack_data;                                 & DEBUG &
                                                               & DEBUG &
   CRLF;                                                       & DEBUG &
   WSTR("running   = "); WHEX(running); CRLF;                  & DEBUG &
   WSTR("ready     = "); WHEX(ready);   CRLF;                  & DEBUG &
   WSTR("stack_top = "); WHex(stack_top,8); CRLF;              & DEBUG &
   CRLF;                                                       & DEBUG &
WSTR(" # link ctr  spsave");
   CRLF;                                                       & DEBUG &
   FOR i := 0 TO max_process DO                                & DEBUG &
      BEGIN & for &                                            & DEBUG &
         WHex(i,2);                                            & DEBUG &
         WHex(link[i],2);                                      & DEBUG &
         WHex(counter[i],4);                                   & DEBUG &
         WHex(spsave[i],8);                                    & DEBUG &
         CRLF;                                                 & DEBUG &
      END for;                                                 & DEBUG &
   CRLF;                                                       & DEBUG &
   WSTR(" # link ctr owner");                                  & DEBUG &
   CRLF;                                                       & DEBUG &
   FOR i := min_rin TO max_rin DO                              & DEBUG &
      BEGIN & for &                                            & DEBUG &
         WHex(i,2);                                            & DEBUG &
         WHex(link[i],2);                                      & DEBUG &
         WHex(counter[i],4);                                   & DEBUG &
         WHex(owner[i],2);                                     & DEBUG &
         CRLF;                                                 & DEBUG &
      END for;                                                 & DEBUG &
   CRLF;                                                       & DEBUG &
   WSTR("Stack for running process "); CRLF;                   & DEBUG &
   STPNTR(stack_data, ((initialsp[running]-datasize[running])  & DEBUG &
         AND %FFFFFFF0) );                                     & DEBUG &
   REPEAT ( 1 + ARIGHT(datasize[running],4) ) DO               & DEBUG &
      BEGIN & repeat &                                         & DEBUG &
         WHex(ADRS(stack_data),8);                             & DEBUG &
         REPEAT 8 DO                                           & DEBUG &
            BEGIN & repeat &                                   & DEBUG &
               WHex(stack_data,4);                             & DEBUG &
               STPNTR(stack_data,                              & DEBUG &
                     ADRS(stack_data[1]) );                    & DEBUG &
            END repeat;                                        & DEBUG &
         CRLF;                                                 & DEBUG &
      END repeat;                                              & DEBUG &
   CRLF;                                                       & DEBUG &
   WSTR("<return> for more");                                  & DEBUG &
```

```
    CRLF;                                                   & DEBUG &
    WHILE RCHAR <> %0D DO ; & wait for carriage return &    & DEBUG &
    FOR i := 0 TO max_process DO                            & DEBUG &
       BEGIN & for &                                        & DEBUG &
          IF urgency[i] <> %FF THEN                         & DEBUG &
             BEGIN & if &                                   & DEBUG &
                CRLF;                                       & DEBUG &
                WSTR("Process "); WHex(i,2); CRLF;          & DEBUG &
                STPNTR(stack_data, ((initialsp[i]-datasize[i]) & DEBUG &
                      AND %FFFFFFF0) );                     & DEBUG &
                REPEAT ( 1 + ARIGHT(datasize[i],4) ) DO     & DEBUG &
                   BEGIN & repeat &                         & DEBUG &
                      WHex(ADRS(stack_data),8);             & DEBUG &
                      REPEAT 8 DO                           & DEBUG &
                         BEGIN & repeat &                   & DEBUG &
                            WHex(stack_data,4);             & DEBUG &
                            STPNTR(stack_data,              & DEBUG &
                                  ADRS(stack_data[1]) );    & DEBUG &
                         END repeat;                        & DEBUG &
                      CRLF;                                 & DEBUG &
                   END repeat;                              & DEBUG &
             END if;                                        & DEBUG &
       END for;                                             & DEBUG &
    TRAP(15);                                               & DEBUG &
 END snapshot;                                              & DEBUG &
```

```
#EJECT;
COMMENT                                                    update/status log
*************************************************************************
* CHANGES:
*   18 Mar  83: Corrected "send" to set the link to nil (assumes that
*               there is never more than one process awaiting a signal
*               -- linked).  Also removed the linking that was present
*               in "wait".
*   12 Nov  82: Corrected "intrpt_tick" to save all registers before
*               suspending the process.
*   09 Nov  82: Corrected interrupt initialization for "delay", and
*               initialization/reset of delay_timer_id variable to
*               point to the idle process when not in use.
*   14 Apr  82: Deleted the interrupt routine for the public hp-ib.
*   01 Apr  82: Changed "schedule" to utilize the multiplier's normalize
*               function rather than the previous bit test and loop to
*               determine the highest priority ready process.
*   26 Mar  82: Added programmed delay for times under 500 microseconds
*               in "delay".
*   08 Jan  82: Added "pending" procedure.
*   06 Jan  82: Added "pause" and "tick" procedures.
*   11 Nov  81: Added timing information to the header.
*   28 Sept 81: Added "delay" procedure, including interrupt service
*               and initialization.  Modified init_kernel to
*               initialize the delay timer counter.
*   25 Sept 81: Corrected the ready vs running compare in preempt.
*   23 Sept 81: Changed schedule, run, and driver routines to minimize
*               the number of registers pushed during each process
*               swap
*   04 Oct  82: Added test for memory overflow not caught at link time,
*               including room for stack allocation.
*
*************************************************************************
;


  INTEGER CONSTANT offset          := -64,         & negative values &
                   zero_token      := offset + 0,  & keep these      &
                   one_token       := offset + 1,  & separate from   &
                   two_token       := offset + 2,  & command token   &
                   three_token     := offset + 3,  & values.         &
                   four_token      := offset + 4,
                   five_token      := offset + 5,
                   six_token       := offset + 6,
                   seven_token     := offset + 7,
                   eight_token     := offset + 8,
                   nine_token      := offset + 9,
                   decimal_token   := offset + 10,
                   minus_token     := offset + 11,
                   backspace_token := offset + 13;
```

```
M68KL,P,"keys"
BEGIN

#FILE ckeys.work;
#FILE ccmddecl.work;

GLOBAL INTEGER TABLE top_key_table:=
        cmd_u4,                 &  0 &
        nine_token,             &  1 &
        eight_token,            &  2 &
        seven_token,            &  3 &
        cmd_illegal,            &  4 &
        cmd_illegal,            &  5 &
        cmd_key_1,              &  6 &
        cmd_key_5,              &  7 &
        cmd_u3,                 &  8 &
        six_token,              &  9 &
        five_token,             & 10 &
        four_token,             & 11 &
        cmd_entry_off,          & 12 &
        cmd_illegal,            & 13 &
        cmd_key_2,              & 14 &
        cmd_key_6,              & 15 &
        cmd_u2,                 & 16 &
        three_token,            & 17 &
        two_token,              & 18 &
        one_token,              & 19 &
        cmd_down,               & 20 &
        cmd_illegal,            & 21 &
        cmd_key_3,              & 22 &
        cmd_key_7,              & 23 &
        cmd_enter,              & 24 &
        minus_token,            & 25 &
        decimal_token,          & 26 &
        zero_token,             & 27 &
        cmd_up,                 & 28 &
        cmd_prior_menu,         & 29 &
        cmd_key_4,              & 30 &
        cmd_key_8,              & 31 &
        cmd_illegal,            & 32 &
        cmd_mkrval,             & 33 &
        backspace_token,        & 34 &
        cmd_illegal;            & 35 &

GLOBAL INTEGER TABLE bot_key_table:=
        cmd_ch1,                   & 00 &
        cmd_illegal,               & 01 &
        cmd_illegal,               & 02 &
        cmd_illegal,               & 03 &
        cmd_sl1,                   & 04 &
        cmd_sl2,                   & 05 &
        cmd_mag,                   & 06 &
        cmd_phase,                 & 07 &
        cmd_ch2,                   & 08 &
        cmd_illegal,               & 09 &
```

```
              cmd_illegal,                  & 10 &
              cmd_illegal,                  & 11 &
              cmd_s21,                      & 12 &
              cmd_s22,                      & 13 &
              cmd_delay,                    & 14 &
              cmd_polar,                    & 15 &
              cmd_cal_menu,                 & 16 &
              cmd_domain_menu,              & 17 &
              cmd_display_menu,             & 18 &
              cmd_marker_menu,              & 19 &
              cmd_param_menu,               & 20 &
              cmd_illegal,                  & 21 &
              cmd_format_menu,              & 22 &
              cmd_illegal,                  & 23 &
              cmd_illegal,                  & 24 &
              cmd_illegal,                  & 25 &
              cmd_preset,  & lab pilot 1      26 &
              cmd_local,                    & 27 &
              cmd_save,                     & 28 &
              cmd_recall,                   & 29 &
              cmd_preset,  & proto N          30 &
              cmd_illegal,                  & 31 &
              cmd_scale,                    & 32 &
              cmd_auto_scale,               & 33 &
              cmd_illegal,                  & 34 &
              cmd_start,                    & 35 &
              cmd_center,                   & 36 &
              cmd_illegal,                  & 37 &
              cmd_illegal,                  & 38 &
              cmd_illegal,                  & 39 &
              cmd_ref_value,                & 40 &
              cmd_ref_position,             & 41 &
              cmd_illegal,                  & 42 &
              cmd_stop,                     & 43 &
              cmd_span,                     & 44 &
              cmd_illegal,                  & 45 &
              cmd_illegal,                  & 46 &
              cmd_illegal,                  & 47 &
              cmd_response_menu,            & 48 &
              cmd_illegal,                  & 49 &
              cmd_illegal,                  & 50 &
              cmd_stimulus_menu,            & 51 &
              cmd_illegal,                  & 52 &
              cmd_illegal,                  & 53 &
              cmd_illegal,                  & 54 &
              cmd_illegal,                  & 55 &
              cmd_illegal,                  & 56 &
              cmd_illegal,                  & 57 &
              cmd_copy,                     & 58 &
              cmd_tape_menu,                & 59 &
              cmd_system_menu,              & 60 &
              cmd_illegal,                  & 61 &
              cmd_measurement_restart,      & 62 &
              cmd_illegal;                  & 63 &

     END$
```

```
COMMENT
  Configures bit pairs to correspond to softkeys that are used.
  SKnm = softkey position n contains m lines.
  BSKn = softkey position n that brings up another menu
  n    = 1..8
  m    = 0..2
;

INTEGER CONSTANT

  SK11 := 1,
  SK12 := 2,
  SK13 := 3,
  SK21 := 4,
  SK22 := 8,
  SK23 := %C,
  SK31 := %10,
  SK32 := %20,
  SK33 := %30,
  SK41 := %40,
  SK42 := %80,
  SK43 := %C0,
  SK51 := %100,
  SK52 := %200,
  SK53 := %300,
  SK61 := %400,
  SK62 := %800,
  SK63 := %C00,
  SK71 := %1000,
  SK72 := %2000,
  SK73 := %3000,
  SK81 := %4000,
  SK82 := %8000,
  SK83 := %C000,

  BSK1 := %100,
  BSK2 := %200,
  BSK3 := %400,
  BSK4 := %800,
  BSK5 := %1000,
  BSK6 := %2000,
  BSK7 := %4000,
  BSK8 := %8000;

COMMENT
       The rest of this file is software generated by GENSK.LANI,
       Any changes must be made to the input file, SKINFO.WORK.
       ***********************************************************
       The following are softkey menu tables configured as follows:
         word 1 = MSByte: corresponding keys that bring up new menus
                  LSByte: menu's highlight bitmap
         word 2 = menu configuration using constants SKnm
         word 3 = keycode number corresponding to softkeys used
          etc.
         word N = up to 10 keycode values
```

```
;
$ END OF DIRECT COPY OF FILE
;           DOCUMENTATION FOR FRONT PANEL/COMMAND INPUT FILE
;
; "$"   Everything before is copied as is into the output file.
;       Anything desired in the output file without being processed
;       by the "BIG TABLE GENERERATOR" (GENSK) must occur before the "$"
;       provided that it does not reference anything generated after
;       the "$".
;
; ";"   Just for comments.  Will be ignored on input and not copied to
;       any of the output files.
;
; "*"   Starts/seperates softkey menus.  Must occur after "$" and before
;       "#" in the input file.  An error message will be displayed
;       otherwise. Formatted softkey/command information tables are out-
;       put to #FILE FSKEY.
;
; "."   Indicates and prefixes a softkey menu constant name that will be
;       put in #FILE FMENU.WORK which contains these constants and their
;       values.  The values are ordered sequentially as softkey menus are
;       read in and processed.  Must occur immediately after menu
;       menu indicator (.) otherwise an error/warning message will be
;       displayed and the constant identifier MENUn will be used.
;       (n = computed constant value)
;
; "-"   Starts/seperates individual softkeys and/or softkey positions.
;       Must occur between menu indicators (*).  Only up to 8 softkey
;       entries will be recognized (everything else afterwards until the
;       next menu indicator (*) will be ignored).  Empty or unused
;       softkey positions which occur between occupied softkeys or keys
;       which create unused positions at the top of the menu must have a
;       blank entry between softkey seperators (-).  However, it is not
;       necessary to do this for unused softkeys which create contiguous
;       gaps at the bottom of the menu.
;
;       SOFTKEY ANNOTATION FORMAT:
;         <l1> :: "alpha" | byte | "alpha"+<l1> | byte+<l1>
;         <l2> :: same as above
;       where <l1> = 1st line of softkey
;             <l2> = 2nd line of softkey
;       Input lines are direct copies to output file.
;       There is no error checking for the following restrictions:
;         - ALPHA types must be enclosed in algol delimiters (")
;         - Start in column 1, no blanks between ALPHA/BYTE combinations
;           (i.e.  "line 1" + 122  should be  "line 1"+122).
;         - Each line should not exceed 10 characters/bytes.
;
;       BRACKET CHARACTERS:
;       sk_bracket_n (n=2..7) is a byte constant that will generate a
;       character bracketing off n softkey annotations from the first
;       line of a softkey entry position.  It should be the last
;       character of the first line of a softkey position heading off
;       a bracketed group of softkeys.  If the softkey annotation
```

```
;      heading off the bracketed group consists of a single line, then
;      a two line entry should be created.  See the following examples:
;      e.g.  two-line annotation:               one-line annotation:
;         "LINE ONE"+sk_bracket_4           sk_bracket_4
;         "LINE TWO"                        half_vt+"LINE ONE"
;
;      NOTE:  Softkey annotations should be the FIRST piece of info.
;      within softkey entries !!!
;
; "["  Prefixes and indicates a command token constant for a softkey
;      entry or front panel/HP-IB command code.  An error message
;      will be displayed if more than one command value indicator occurs
;      in a single softkey entry.  Constant values are determined
;      sequentially and correspond to the occurrence of each softkey
;      entry (whether or not it has a command value indicator).
;      These constants and their and values can be found in
;      #FILEs corresponding to the most recent filename read via
;      "0".."9","A"..O" prefixes.
;
; "]"  Indicates and prefixes duplicate command token constants which
;      have been previously declared to correspond to an identical
;      function AND refer to the same annotation (for softkeys).
;      This eliminates more than one command code per identical
;      function.  In this case, case statement entries (',') should be
;      omitted since they are taken care of by the previously declared
;      command code.
;      NOTE:  Must occur within softkey entries ('-') or after '#'.
;      Any case statement entries (',') following it will be ignored.
;      Any case statement entries before it will cause this entry to
;      be unrecognized (only within softkey entry information).
;
; ","  Indicate and prefix Algol statements to be executed corresponding
;      to the current command token (softkey entry/HP-IB primtive) being
;      processed.  They may occur only within softkey entries or after
;      command token constants.  They should not proceed ']' prefixes.
;      NOTE:  Syntax errors will not be checked.
;
; "^"  Indicates that a softkey brings up another menu.  "^" is followed
;      by the menu number (immediate or constant) of the menu that
;      softkey is to generate.  Only one "^" per softkey entry allowed.
;
; "A".."O" and
; "0".."9"
;      Marks the start of a group of case statements enclosed in a
;      PROCn procedure (n = 0..25, (A=10,B=11..O=25)) and its
;      corresponding command token constants.  A filename MUST proceed
;      each character entry (which can only be used ONCE):
;            <char><filename>
;      There will be two seperate files produced using the given file
;      name: 1) C<filename>  for command token constants
;            2) F<filename>  for corresponding case statements
;      All command token constants (indicated by '[') and corresponding
;      segments of code (indicated by ',') will be read into these
;      files.
;      These character prefixes may occur after the '$', before or after
;      menu entries, at the beginning or end of softkey entries, or
```

```
;       before command token entries '[' occuring after '#'.
;
;       NOTE: The module which includes F<filename> must also include
;       #FILE FCOMMAND.WORK or an external declaration of the integer
;       variable command_token.
;
; "#"   Indicates the end of menu entries and ignores any entries found
;       after the occurrence of "#". Only command value indicators, ([)
;       or (]), immediately followed by statement indicators (,) are
;       processed. This segment of the input file is for HPIB primitives
;       which do not have corresponding softkeys, and for front panel
;       keys which need command values in order to be processed.
;       Error messages are displayed for any input other than that just
;       described.
;
; "@"   Indicates that a command token entry is a software option.
;       It should be followed by a number 0..9 which identifies the
;       which software option that particular command is under (i.e.
;       time domain commands = 1, error correction commands = 2, etc.).
;       The INFO parameter (string) passed upon running GENSK contains
;       a string of software option numbers (0..9). Each digit will
;       correspond to a software option family that will generate the
;       Algol statements (via ",") for a command token entry. These
;       program statements are omitted, otherwise.
;       Command token entries without the "@" directive are not options
;       and will not omit program statements in their entries.
```

ldtmgr.work.L

```
*EJECT**********
.TAPE_MENU
-
"DIRECTORY"
[cmd_directory
,IF valid_directory THEN
,  BEGIN
,     gen_menu(DIRECTORY_MENU, 1);
,     list_directory;
,  END;
--------
"STORE"
,setup_tape_op(record_op);
--------
"LOAD"
,setup_tape_op(restore_op);
--------
"DELETE"
,setup_tape_op(delete_op);
--------
"UN-DELETE"
,undelete_file;
--------

--------

--------
"INITIALIZE"
"TAPE"
^INIT_TAPE_MENU
--------
```

```
*EJECT**********
.INIT_TAPE_MENU
--------
"INIT TAPE?"
"YES"
,init;
--------
"NO"
,previous_menu;
--------
```

```
*EJECT***********
.DIRECTORY_MENU
--------
"RESTORE"
"DISPLAY"
[cmd_directory_off
--------

--------

--------
"NEXT"
"PAGE"
[cmd_next_page
,list_directory;
--------
"PREVIOUS"
"PAGE"
[cmd_prev_page
,list_directory;
--------

--------
"FIRST"
"PAGE"
[cmd_first_page
,list_directory;
--------
"LAST"
"PAGE"
[cmd_last_page
,list_directory;
--------
```

```
*EJECT**********
.DATA2_MENU
--
"RAW"
"DATA"
,gen_file_menu(s_param_file);
--------
"DATA"
,gen_file_menu(data_file);
--------
"FORMATTED"
"DATA"
,gen_file_menu(format_file);
--------

--------
"USER"
"DISPLAY"
,gen_file_menu (display_file);
--------

--------

--------
"MACHINE"
"DUMP"
[cmd_machine_dump
,gen_file_menu(machine_file);
--------
```

```
*EJECT**********
.DATA1 MENU

"INSTRUMENT"
"STATE"
,gen_reg_menu(state_file);
--------
"INSTRUMENT"
"STATES 1-5"
,gen_file_menu(state_set);
--------
"MEMORY"
"TRACE"
,gen_reg_menu(memory_file);
--------
"MEMORY"
"TRACES 1-4"
,gen_file_menu(memory_set);
--------
"CAL SET"
,gen_reg_menu(cal_file);
--------
"CAL SETS"
"1-8"
,gen_file_menu(cal_set);
--------
"CAL KIT"
,gen_reg_menu(cal_std_file);
--------
"MORE"
{cmd_more
,& dummy statement &;
^DATA2_MENU
--------
```

```
*EJECT***********
.ABORT_MENU
--------
"ABORT"
--------
```

```
*EJECT***********
.FILE_MENU
-
"DATA TYPE "
"* FILE 1"
[cmd_file_1
,file_chosen;
--------
" "
"* FILE 2"
[cmd_file_2
,file_chosen;
--------
" "
"* FILE 3"
,file_chosen;
--------
" "
"* FILE 4"
,file_chosen;
--------
" "
"* FILE 5"
,file_chosen;
--------
" "
"* FILE 6"
,file_chosen;
--------
" "
"* FILE 7"
,file_chosen;
--------
" "
"* FILE 8"
[cmd_file8
,file_chosen;
--------
```

```
*EJECT***********
.REG_MENU
-     -
"DATA TYPE "
"* 1 "
[cmd_reg_1
,reg_chosen;
--------
" "
"* 2 "
[cmd_reg_2
,reg_chosen;
--------
" "
"* 3 "
[cmd_reg_3
,reg_chosen;
--------
" "
"* 4 "
[cmd_reg_4
,reg_chosen;
--------
"(POWER UP)"
"* 5 "
[cmd_reg_5
,reg_chosen;
--------
" "
"* 6 "
[cmd_reg_6
,reg_chosen;
--------
" "
"* 7 "
[cmd_reg_7
,reg_chosen;
--------
" "
"LAST STATE"
[cmd_reg_8
,reg_chosen;
--------

3resp.work.L
```

```
*EJECT******
.RESPONSE_MENU
--------
"ELECTRICAL"+sk_bracket_2
"DELAY"
[cmd_elect_delay
,select_active_function( active_electrical_length );
--------
"AUTO DELAY"
[cmd_auto_delay
,warn( command_not_implemented );
--------
"PHASE"
"OFFSET"
[cmd_phase_offset
,select_active_function( active_phase_offset );
--------
"MAGNITUDE"
"OFFSET"
,warn( command_not_implemented );
,& select_active_function( active_magnitude_offset ); &
--------
"AVERAGING"+sk_bracket_2
"ON/RESTART"
[cmd_if_avg_on
,if_average_on;
--------
"OFF"
[cmd_if_avg_off
,if_average_off;
--------
"SMOOTHING"+sk_bracket_2
"ON "
[cmd_smoothing_on
,display_smoothing_on;
--------
"OFF"
[cmd_smoothing_off
,display_smoothing_off;
--------
```

```
*EJECT*********
.IF_GAIN_MENU
--------
"TEST"+sk_bracket_2
"AMP. GAIN"
[cmd_if_test_port
^IF_GAIN_MENU2
,new_if_gain_port( test_port );
--------
"REFERENCE"
"AMP. GAIN"
[cmd_if_ref_port
^IF_GAIN_MENU2
,new_if_gain_port( ref_port );
--------

--------

--------

--------

--------

--------

--------
```

```
*EJECT*******
.IF_GAIN_MENU2
--------
"GAIN"+sk_bracket_6
"0 (MIN.)"
[cmd_if_no_gain
,new_if_gain( if_no_gain );
--------
" 1 "
[cmd_if_12db_gain
,new_if_gain( if_12db_gain );
--------
" 2 "
[cmd_if_24db_gain
,new_if_gain( if_24db_gain );
--------
" 3 "
[cmd_if_36db_gain
,new_if_gain( if_36db_gain );
--------
"4 (MAX.)"
[cmd_if_48db_gain
,new_if_gain( if_48db_gain );
--------
"AUTO"
[cmd_if_gain_auto
,new_if_gain( auto_range );
--------

--------

--------

4stim.work.L
```

```
*EJECT*******
.STIMULUS_MENU
--------
"POWER"
"MENU"
[cmd_power_menu
^POWER_MENU
--------
"SWEEP"
"TIME"
[cmd_sweep_time
,select_active_function(active_sweep_time);
--------
"NUMBER of"
"POINTS"
^N_POINTS_MENU
[cmd_n_points_menu
--------

--------
"SINGLE"+sk_bracket_3
"POINT"
[cmd_cw
,BEGIN
,  hilight_on( cmd_cw, cmd_stepped);
,  cw_mode;
,END;
--------
"RAMP"
[cmd_swept
,BEGIN
,  hilight_on( cmd_cw, cmd_stepped);
,  swept_mode;
,END;
--------
"STEP"
[cmd_stepped
,BEGIN
,  hilight_on( cmd_cw, cmd_stepped);
,  stepped_mode;
,END;
--------
"MORE"
^STIMULUS2_MENU
]cmd_more
--------
```

```
*EJECT*********
.N_POINTS_MENU
--------
"POINTS:"+sk_bracket_4
"51 "
[cmd_51_points
,new_step_size( 16 );
--------
"101"
[cmd_101_points
,new_step_size( 8 );
--------
"201"
[cmd_201_points
,new_step_size( 4 );
--------
"401"
[cmd_401_points
,new_step_size( 2 );
--------

--------

--------

--------

--------
```

```
*EJECT*******
.POWER_MENU
--------
"POWER"
[cmd_source_power
,select_active_function(active_source_power);
--------

--------
"SLOPE"+sk_bracket_2
"ON "
[cmd_power_slope
,BEGIN
,   hilight_on( cmd_power_slope, cmd_power_slope_off );
,   set_entry_ch_integer( power_slope_on, ch_power_slope_mode );
,   wrt_priv_ib_source( sl1, newline);
,   select_active_function( active_power_slope );
,END;
--------
"OFF"
[cmd_power_slope_off
,BEGIN
,   hilight_on( cmd_power_slope, cmd_power_slope_off );
,   set_entry_ch_integer( power_slope_off, ch_power_slope_mode );
,   select_active_off( active_power_slope );
,   wrt_priv_ib_source( sl0, "");
,END;
--------

--------
"ATTENUATOR"+sk_bracket_2
"PORT 1"
[cmd_atten_port1
,select_active_function(active_atten_port1);
--------
"PORT 2"
[cmd_atten_port2
,select_active_function(active_atten_port2);
--------

--------
```

```
*EJECT*******
.STIMULUS2_MENU
--------
sk_bracket_4
half_vt+"HOLD"
[cmd_hold
,hold_sweep;
--------
"SINGLE"
[cmd_single
,single_sweep;
--------
"NUMBER of"
"GROUPS"
[cmd_n_groups_kbd
,select_active_function(active_n_groups_kbd);
--------
"CONTINUAL"
[cmd_continuous
,continuous_sweep;
--------
"STIMULUS"
"OFFSET"
,BEGIN                                                          & DEBUG &
,warn(command_not_implemented );                                & DEBUG &
,& select_active_function( active_stimulus_offset ); &
,END;                                                           & DEBUG &
--------

--------
sk_bracket_2
half_vt+"Ch1 = Ch2"
[cmd_couple_stimulus
,BEGIN
,  hilight_on( cmd_couple_stimulus, cmd_uncouple_stimulus );
,  set_coupled_stimulus_status( TRUE );
,END;
--------
"Ch1 "+163+" Ch2"
[cmd_uncouple_stimulus
,BEGIN
,  hilight_on( cmd_couple_stimulus, cmd_uncouple_stimulus );
,  set_coupled_stimulus_status( FALSE );
,END;
--------
```

```
*EJECT********
.DEVICE_READY_MENU
--------

--------
"PRESS TO"
"CONTINUE"
,BEGIN
,   previous_menu;
,   device_reversed;
,END;
--------

--------

--------

--------

--------

--------

--------

5params.work.L
```

```
*EJECT*******
.PARAM_MENU
--------
"a"+177+sk_bracket_4
[cmd_user1
,new_parameter( user1 );
--------
"b"+178
[cmd_user2
,new_parameter( user2 );
--------
"a"+178
[cmd_user3
,new_parameter( user3 );
--------
"b"+177
[cmd_user4
,new_parameter( user4 );
--------

--------

--------
"REDEFINE"
"PARAMETER"
^REDEF_MENU
[cmd_redefine_param
--------

--------
```

```
*EJECT*******
.REDEF_MENU
--------
"REDEFINE"+sk_bracket_6
"DRIVE"
^REDEF_DRIVE_MENU
--------
"PHASE LOCK"
^REDEF_LOCK_MENU
--------
"NUMERATOR"
^REDEF_NUM_MENU
--------
"DENOMI-"
"NATOR"
^REDEF_DENOM_MENU
--------
"CONVERSION"
^REDEF_CONV_MENU
--------
"PARAMETER"
"LABEL"
[cmd_label_parameter
,warn( command_not_implemented );
--------

--------
"REDEFINE"
"DONE"
[cmd_redefine_done
,pop_menu( PARAM_MENU );
--------
```

```
*EJECT*******
.REDEF_DRIVE_MENU
--------
"DRIVE"+sk_bracket_3
"PORT 1"
,redefine_param( driven_port, driven_a1 );
--------
"PORT 2"
,redefine_param( driven_port, driven_a2 );
--------
"NONE"
,redefine_param( driven_port, driven_none );
--------

--------

--------

--------

--------

--------
```

```
*EJECT*******
.REDEF_LOCK_MENU
--------
"LOCK to"+sk_bracket_3
"a1 "
,redefine_param( phase_lock_port, lock_to_a1 );
--------
"a2 "
,redefine_param( phase_lock_port, lock_to_a2 );
--------
"NONE"
,redefine_param( phase_lock_port, lock_donot_care );
--------

--------

--------

--------

--------

--------
```

```
*EJECT*******
.REDEF_NUM_MENU
--------
"NUMERATOR"+sk_bracket_5
"b1 "
,redefine_param( numerator_port, num_b1 );
--------
"b2 "
,redefine_param( numerator_port, num_b2 );
--------
"a1 "
,redefine_param( numerator_port, num_a1 );
--------
"a2 "
,redefine_param( numerator_port, num_a2 );
--------
"SERVICE"
"SELECTIONS"
^REDEF_NUM2_MENU
--------

--------

--------

--------
```

```
*EJECT*******
.REDEF_NUM2_MENU
--------
"100 kHz"+sk_bracket_8
"TEST CAL"
,redefine_param( numerator_port, num_100khz_cal );
--------
"100 kHz"
"REF CAL"
,redefine_param( numerator_port, num_ref_100khz_cal );
--------
"DETECTOR"
"GROUND"
,redefine_param( numerator_port, num_detector_gnd );
--------
"ADC GROUND"
,redefine_param( numerator_port, num_adc_gnd );
--------
"VCAL"
,redefine_param( numerator_port, num_vcal );
--------
"VREF"
,redefine_param( numerator_port, num_vref );
--------
"TEMP. 1"
,redefine_param( numerator_port, num_temp1 );
--------
"TEMP. 2"
,redefine_param( numerator_port, num_temp2 );
--------
```

```
*EJECT*******
.REDEF_DENOM_MENU
--------
"DENOM."+sk_bracket_4
"a1 "
,redefine_param( denominator_port, denom_a1 );
--------
"a2 "
,redefine_param( denominator_port, denom_a2 );
--------
"b1 "
,redefine_param( denominator_port, denom_b1 );
--------
"NO RATIO"
,redefine_param( denominator_port, denom_no_ratio );
--------

--------

--------

--------
```

```
*EJECT*******
.REDEF_CONV_MENU
--------
"CONVERT"+sk_bracket_4
"to   S"
[cmd_convert_off
,redefine_param( parameter_conversion, conv_off );
--------
"to 1/S"
[cmd_convert_recip
,redefine_param( parameter_conversion, conv_reciprocal );
--------
"to   Z"
[cmd_convert_to_z
,redefine_param( parameter_conversion, conv_s_to_z );
--------
"to   Y"
[cmd_convert_to_y
,redefine_param( parameter_conversion, conv_s_to_y );
--------

--------

--------

--------

--------

6format.work.L
```

```
*EJECT*******
.FORMAT_MENU
--------
sk_bracket_8
half_vt+'SWR"
[cmd_swr
,new_format( fmt_swr );
--------
"LINEAR"
"MAGNITUDE"
[cmd_linear_mag
,new_format( fmt_linear_mag );
--------
"POLAR w/"
"LIN MKR"
[cmd_linear_polar
,new_format( fmt_linear_polar );
--------
"POLAR w/"
"LOG MKR"
[cmd_log_polar
,new_format( fmt_log_polar );
--------
"POLAR w/"
"Re/Im MKR"
[cmd_imag_vs_real
,new_format( fmt_imag_vs_real );
--------
"INVERTED"
"SMITH"
[cmd_y_smith
,new_format( fmt_y_smith );
--------
"IMAGINARY"
[cmd_imaginary
,new_format( fmt_imaginary );
--------
"REAL"
[cmd_real
,new_format( fmt_real );
--------

Bdommenu.work.L
```

```
*EJECT*********
.DOMAIN_MENU
--------
sk_bracket_4
half_vt+"FREQUENCY"
[cmd_freq_domain
,BEGIN
,   hilight_on( cmd_freq_domain, cmd_aux_domain);
,   set_domain( freq_domain );
,END;
--------
"TIME"
"LOW PASS"
^LOW_PASS_FREQ
[cmd_low_pass_request
--------
"TIME"
"BAND PASS"
[cmd_time_domain
,BEGIN
,   hilight_on( cmd_freq_domain, cmd_aux_domain);
,   set_domain( time_domain );
,END;
--------
"AUX. VOLT"
"OUTPUT"
[cmd_aux_domain
,BEGIN
,   warn( command_not_implemented );                        & DEBUG &
,   hilight_on( cmd_freq_domain, cmd_aux_domain);
,   set_domain( aux_domain );
,END;
--------

--------
"SPECIFY"+sk_bracket_2
"TIME"
[cmd_setup_time_domain
^TIME_SETUP_MENU
--------
"GATE"
[cmd_setup_gate_domain
^GATE_SETUP_MENU
,select_active_gate( 0 );                      & turn on gate markers &
--------

--------
```

```
*EJECT*******
.LOW_PASS_FREQ
--------

--------
"SET FREQ."
"(LOW PASS)"
[cmd_tdr_domain
,BEGIN
,   tdr_check;
,   hilight_key( cmd_low_pass_request, cmd_freq_domain, cmd_aux_domain);
,   set_domain( tdr_domain );
,   previous_menu;
,END;
--------

--------

--------

--------

--------

--------

--------
```

```
*EJECT*******
.TIME_SETUP_MENU
--------
"LOW PASS:"+sk_bracket_2
"STEP"
[cmd_tdr_step
,BEGIN
,   hilight_on( cmd_tdr_step, cmd_tdr_impulse);
,   set_entry_ch_integer( step_tdr, ch_tdr_stimulus_type );
,   update_domain_vars;
,END;
--------
"IMPULSE"
[cmd_tdr_impulse
,BEGIN
,   hilight_on( cmd_tdr_step, cmd_tdr_impulse);
,   set_entry_ch_integer( impulse_tdr, ch_tdr_stimulus_type );
,   update_domain_vars;
,END;
--------

--------

--------
"WINDOW:"+sk_bracket_3
"MAXIMUM"
[cmd_max_time_window
,set_time_window( max_window);
--------
"NORMAL"
[cmd_normal_time_window
,set_time_window( normal_window);
--------
"MINIMUM"
[cmd_min_time_window
,set_time_window( min_window);
--------

--------
```

```
*EJECT*******
.GATE_SETUP_MENU
--------
"GATE"+sk_bracket_2
"ON"
[cmd_gate_on
,BEGIN
,   set_entry_ch_integer( gate_on, ch_gating );
,   set_gate_status;
,END;
--------
"OFF"
[cmd_gate_off
,BEGIN
,   set_entry_ch_integer( gate_off, ch_gating );
,   marker_state := marker_state AND gate_markers_off;
,   set_gate_status;
,END;
--------
"GATE"+sk_bracket_4
"START"
[cmd_gate_start
,select_active_gate( active_gate_start );
--------
"STOP"
[cmd_gate_stop
,select_active_gate( active_gate_stop );
--------
"CENTER"
[cmd_gate_center
,select_active_gate( active_gate_center );
--------
"SPAN"
[cmd_gate_span
,select_active_gate( active_gate_span );
--------
"GATE SHAPE"
^GATE_SHAPE_MENU
--------

--------
```

```
*EJECT*******
.GATE_SHAPE_MENU
--------

--------

--------

--------

--------
"GATE SHAPE"+sk_bracket_4
"MAXIMUM"
[cmd_max_gate_window
,set_gate_window( max_gate );
--------
"WIDE"
[cmd_wide_gate_window
,set_gate_window( wide_gate );
--------
"NORMAL"
[cmd_normal_gate_window
,set_gate_window( normal_gate );
--------
"MINIMUM"
[cmd_min_gate_window
,set_gate_window( min_gate );
--------

7calmenu.work.L
```

```
*EJECT*******
.CAL_MENU
--------
"CORRECTION"+sk_bracket_3
"ON"
[cmd_correction_on
,correction_on(default_cal_set);
--------
"OFF"
[cmd_correction_off
,correction_off;
--------
"SELECT"
"CAL SET"
[cmd_correction_default
,BEGIN
,   tell( select_cal_set );
,   gen_cal_info( no_op );
,END;
--------

--------
"CALIBRATE"+sk_bracket_3
"( KIT #1 )"
[cmd_cal_kit_1
,if_correct_off_select_cal_kit( 1 );
--------
"CALIBRATE"
"( KIT #2 )"
[cmd_cal_kit_2
,if_correct_off_select_cal_kit( 2 );
--------
"RESUME CAL"
"SEQUENCE"
,resume_cal;
--------
"MORE"
]cmd_more
^MORE_CAL
--------
```

```
*EJECT******
.MORE_CAL
--------
"REFERENCE"
"PLANES"
^REF_PLANE_MENU
[cmd_ref_plane_menu
--------
"SET Z"+176
,select_active_function( active_system_z0 );
--------
"CAL SWEEP"
"VOLTAGE"
,warn(command_not_implemented);
--------

--------
"MODIFY KIT"+sk_bracket_2
"( KIT #1 )"
[cmd_modify_cal_kit_1
^MODIFY_CAL_KIT_MENU
,select_cal_kit( 1 );
--------
"MODIFY KIT"
"( KIT #2 )"
[cmd_modify_cal_kit_2
^MODIFY_CAL_KIT_MENU
,select_cal_kit( 2 );
--------

--------
"DELETE A"
"CAL SET"
[cmd_delete_cal
,BEGIN
,   tell( select_delete_cal_set );
,   gen_cal_info( clear_op );
,END;
--------
```

```
*EJECT*******
.REF_PLANE_MENU
--------

--------

--------
sk_bracket_2
half_vt+"PLANE 1"
[cmd_ref_plane_1
,select_active_function( active_ref_plane_1 );
--------
"PLANE 2"
[cmd_ref_plane_2
,select_active_function( active_ref_plane_2 );
--------

--------

--------

--------

--------
```

```
*EJECT******
.CAL_TYPE_MENU
--------

--------
"SET FREQ."
"(LOW PASS)"
[cmd_freq_setup
,tdr_check;
--------

--------
"FREQUENCY"+sk_bracket_5
"RESPONSE"
[cmd_response_type
,set_cal_type( response );
--------
"S"+177+177+"  "
"1-PORT"
[cmd_1_port_1_type
,set_cal_type( one_port_on_1 );
--------
"S"+178+178+"  "
"1-PORT"
[cmd_1_port_2_type
,set_cal_type( one_port_on_2 );
--------
"ONE-PATH"
"2-PORT"
[cmd_simple_2_port_type
,set_cal_type( simple_two_port );
--------
"FULL"
"2-PORT"
[cmd_2_port_type
,set_cal_type( two_port );
--------
```

```
*EJECT*******
.PORT_ONE_REFL
--------
"S"+177+177+"  "+sk_bracket_3
"PORT1 STD1"
[cmd_port1_std1
,set_std_class( port1_1st_std );
--------
"PORT1 STD2"
[cmd_port1_std2
,set_std_class( port1_2nd_std );
--------
"PORT1 STD3"
[cmd_port1_std3
,set_std_class( port1_3rd_std );
--------

--------

--------

--------

--------
"SAVE"
"S"+177+177+" CAL"
[cmd_done_1_port_on_1
,cal_done( done_1_port_on_1 );
--------
```

```
*EJECT*******
.PORT_TWO_REFL
--------
"S"+178+178+"  "+sk_bracket_3
"PORT2 STD1"
[cmd_port2_std1
,set_std_class( port2_1st_std );
--------
"PORT2 STD2"
[cmd_port2_std2
,set_std_class( port2_2nd_std );
--------
"PORT2 STD3"
[cmd_port2_std3
,set_std_class( port2_3rd_std );
--------

--------

--------

--------

--------
"SAVE"
"S"+178+178+" CAL"
[cmd_done_1_port_on_2
,cal_done( done_1_port_on_2 );
--------
```

```
*EJECT*******
.CAL_MENU2
--------
sk_bracket_3
half_vt+"REFLECT'N"
[cmd_cal_reflection
^REFLECTION_MENU
,check_refl_status;
--------
"TRANS-"
"MISSION"
[cmd_cal_thru
^TRANSMISSION_MENU
,tell( connect_thru );
--------
"ISOLATION"
[cmd_cal_isolation
^ISOLATION_MENU
,tell( isolate_ports );
--------

--------

--------

--------

--------
"SAVE"
"2-PORT CAL"
[cmd_done_2_port
,cal_done( done_2_port );
--------
```

```
*EJECT********
.REFLECTION_MENU
--------
"S"+177+177+"  "+sk_bracket_3
"PORT1 STD1"
]cmd_port1_std1
--------
"PORT1 STD2"
]cmd_port1_std2
--------
"PORT1 STD3"
]cmd_port1_std3
--------
"S"+178+178+"  "+sk_bracket_3
"PORT2 STD1"
]cmd_port2_std1
--------
"PORT2 STD2"
]cmd_port2_std2
--------
"PORT2 STD3"
]cmd_port2_std3
--------

--------
"REFLECT'N"
"DONE"
[cmd_done_reflection
,cal_done( done_reflection );
--------
```

```
*EJECT*******
.TRANSMISSION_MENU
--------

--------
"FWD.TRANS."
"FWD_TRANS_"
[cmd_fwd_transmission
,   set_std_class( trans_fwd_std );
--------
"FWD.MATCH"
"FWD_MATCH_"
[cmd_fwd_match
,   set_std_class( match_fwd_std  );
--------
"REV.TRANS."
"REV_TRANS_"
[cmd_rev_transmission
,   set_std_class( trans_rev_std );
--------
"REV.MATCH"
"REV_MATCH_"
[cmd_rev_match
,   set_std_class( match_rev_std );
--------

--------

--------
"TRANS."
"DONE"
[cmd_done_trans
,cal_done( done_trans );
--------
```

```
*EJECT*******
.ISOLATION_MENU
--------

--------

--------
"OMIT"
"ISOLATION"
[cmd_omit_isolation
,omit_isolation;
--------

--------
"FWD ISOL'N"
"FWD_ISOLN_"
[cmd_fwd_isolation
,set_std_class( isoln_fwd_std );
--------
"REV ISOL'N"
"REV_ISOLN_"
[cmd_rev_isolation
,set_std_class( isoln_rev_std );
--------

--------
"ISOLATION"
"DONE"
[cmd_done_isolation
,cal_done(done_isol);
--------
```

```
*EJECT*******
.CAL_MENU3
--------
sk_bracket_3
half_vt+"REFLECT'N"
[cmd_cal_simple_reflection
^SIMPLE_REFLECTION_MENU
,check_refl_status;
--------
"TRANS-"
"MISSION"
[cmd_cal_simple_thru
^SIMPLE_TRANSMISSION_MENU
,tell( connect_thru );
--------
"ISOLATION"
[cmd_cal_simple_isolation
^SIMPLE_ISOLATION_MENU
,tell( isolate_ports );
--------

--------

--------

--------

--------
"SAVE"
"2-PORT CAL"
]cmd_done_2_port
--------
```

```
*EJECT*******
.SIMPLE_REFLECTION_MENU
--------
"S"+177+177+sk_bracket_3
"PORT1 STD1"
]cmd_port1_std1
--------
"PORT1 STD2"
]cmd_port1_std2
--------
"PORT1 STD3"
]cmd_port1_std3
--------

--------

--------

--------

--------
"REFLECT'N"
"DONE"
[cmd_done_simple_reflection
,cal_done( done_1_port_on_1 );
--------
```

```
*EJECT*******
.SIMPLE_TRANSMISSION_MENU
--------

--------
"FWD.TRANS."
"FWD_TRANS_"
]cmd_fwd_transmission
--------
"FWD.MATCH"
"FWD_MATCH_"
]cmd_fwd_match
--------

--------

--------

--------

--------
"TRANS."
"DONE"
]cmd_done_trans
--------
```

```
*EJECT*******
.SIMPLE_ISOLATION_MENU
--------

--------

--------
"OMIT"
"ISOLATION"
]cmd_omit_isolation
--------

--------
"FWD ISOL'N"
"FWD_ISOLN_"
]cmd_fwd_isolation
--------

--------

--------
"ISOLATION"
"DONE"
]cmd_done_isolation
--------
```

```
*EJECT*******
.STD_CLASS_MENU
--------
"STANDARD 1"
[cmd_class_std1
,set_element( 1 );
--------
"STANDARD 2"
[cmd_class_std2
,set_element( 2 );
--------
"STANDARD 3"
[cmd_class_std3
,set_element( 3 );
--------
"STANDARD 4"
[cmd_class_std4
,set_element( 4 );
--------
"STANDARD 5"
[cmd_class_std5
,set_element( 5 );
--------
"STANDARD 6"
[cmd_class_std6
,set_element( 6 );
--------
"STANDARD 7"
[cmd_class_std7
,set_element( 7 );
--------
"STANDARDS "
"DONE"
[cmd_class_done
,cal_done(done_class);
--------
```

```
*EJECT*******
.SLIDING_LOAD_MENU
--------
"SLIDE IS"
"SET"
,acquire_data;
--------

--------

--------

--------

--------

--------

--------
"SLIDING"
"LOAD DONE"
,compute_load;
--------

Cstdmenu.work.L
```

```
*EJECT*******
.MODIFY_CAL_KIT_MENU
--------
"SELECT"
"STANDARD"
[cmd_select_std
,select_active_function( active_std_id );
--------

--------
"SPECIFY"
"STD CLASS"
[cmd_specify_classes
^SPECIFY_CLASS_MENU
,tell( select_std_class );
--------
"LABEL"
"STD CLASS"
[cmd_label_classes
,warn( command_not_implemented );
--------

--------
"LABEL"
"CAL KIT"
[cmd_label_cal_kit
,warn( command_not_implemented );
--------

--------
"DONE"
"(DEFINED)"
[cmd_cal_kit_defined
,cal_kit_defined;
--------
```

```
*EJECT*******
.MODIFY_STDS_MENU
--------
"STD TYPE"+sk_bracket_5
"OPEN"
[cmd_define_open
^DEFINE_OPEN_MENU
,define_std( std_open );
--------
"SHORT"
[cmd_define_short
^DEFINE_SHORT_MENU
,define_std( std_short );
--------
"LOAD"
[cmd_define_load
^DEFINE_LOAD_MENU
,BEGIN
,   hilight_load_type;
,   define_std( std_load );
,END;
--------
"DELAY/"
"THRU"
[cmd_define_air_line
^SPECIFY_OFFSET_MENU
,BEGIN
,   hilight_offset_type;
,   define_std( std_thru );
,END;
--------
"ARBITRARY"
"IMPEDANCE"
[cmd_define_z
^SPECIFY_Z_MENU
,BEGIN
,   hilight_load_type;
,   define_std( std_z );
,END;
--------

--------

--------

--------
```

```
*EJECT********
.DEFINE_OPEN_MENU
--------
" C"+176+" "
[cmd_open_c0
,select_active_function( active_open_c0 );
--------
" C"+177+" "
[cmd_open_c1
,select_active_function( active_open_c1 );
--------
" C"+178+" "
[cmd_open_c2
,select_active_function( active_open_c2 );
--------

--------

--------
"SPECIFY"
"OFFSET"
[cmd_specify_offset
^SPECIFY_OFFSET_MENU
,hilight_offset_type;
--------
"LABEL STD"
[cmd_label_cal_std
,warn( command_not_implemented );
--------
"DONE"
"(DEFINED)"
[cmd_cal_std_defined
,pop_menu( MODIFY_CAL_KIT_MENU );
--------
```

```
*EJECT*******
.DEFINE_SHORT_MENU
--------

--------

--------

--------

--------

--------
"SPECIFY"
"OFFSET"
]cmd_specify_offset
^SPECIFY_OFFSET_MENU
--------
"LABEL STD"
]cmd_label_cal_std
--------
"DONE"
"(DEFINED)"
]cmd_cal_std_defined
--------



*EJECT*******
.DEFINE_LOAD_MENU
--------

--------

--------

--------
sk_bracket_2
half_vt+"FIXED"
[cmd_fixed_load
,define_type2( fixed );
--------
"SLIDING"
[cmd_sliding_load
,define_type2( sliding );
--------
"SPECIFY"
"OFFSET"
]cmd_specify_offset
^SPECIFY_OFFSET_MENU
--------
"LABEL STD"
]cmd_label_cal_std
--------
"DONE"
"(DEFINED)"
]cmd_cal_std_defined
--------
```

```
*EJECT*******
.SPECIFY_Z_MENU
--------
" C"+176+" "
]cmd_open_c0
--------
" C"+177+" "
]cmd_open_c1
--------
" C"+178+" "
]cmd_open_c2
--------
sk_bracket_2
half_vt+"FIXED"
]cmd_fixed_load
--------
"SLIDING"
]cmd_sliding_load
--------
"SPECIFY"
"OFFSET"
]cmd_specify_offset
^SPECIFY_OFFSET_MENU
--------
"LABEL STD"
]cmd_label_cal_std
--------
"DONE"
"(DEFINED)"
]cmd_cal_std_defined
--------
```

```
*EJECT*******
.SPECIFY_OFFSET_MENU
--------
"OFFSET"
"DELAY"
[cmd_offset_delay
,select_active_function( active_offset_delay );
--------
"OFFSET"
"LOSS"
[cmd_offset_loss
,select_active_function( active_offset_loss );
--------
"OFFSET"
" Z"+176+" "
[cmd_offset_z0
,select_active_function( active_offset_z0 );
--------
"LOWER"
"FREQUENCY"
[cmd_offset_min_f
,select_active_function( active_offset_min_freq );
--------
"UPPER"
"FREQUENCY"
[cmd_offset_max_f
,select_active_function( active_offset_max_freq );
--------
sk_bracket_2
half_vt+"COAX"
[cmd_coax
,define_type2( coax );
--------
"WAVEGUIDE"
[cmd_waveguide
,define_type2( waveguide );
--------
"DONE"
"(DEFINED)"
,previous_menu;
--------
```

```
*EJECT*******
.SPECIFY_CLASS_MENU
--------
"S"+177+177+":  "
"1st STD"
[cmd_port1_1st_std
,std_class( port1_1st_std );
--------
"2nd STD"
[cmd_port1_2nd_std
,std_class( port1_2nd_std );
--------
"3rd STD"
[cmd_port1_3rd_std
,std_class( port1_3rd_std );
--------
"S"+178+178+":  "
"1st STD"
[cmd_port2_1st_std
,std_class( port2_1st_std );
--------
"2nd STD"
[cmd_port2_2nd_std
,std_class( port2_2nd_std );
--------
"3rd STD"
[cmd_port2_3rd_std
,std_class( port2_3rd_std );
--------
"MORE"
^SPECIFY_CLASS_MENU2
--------
"DONE"
"(SPEC'D)"
[cmd_std_class_specified
,pop_menu(MODIFY_CAL_KIT_MENU);
--------
```

```
*EJECT*******
.SPECIFY_CLASS_MENU2
--------
"TRANS.:"
"FWD STD"
[cmd_trans_fwd_std
,std_class( trans_fwd_std );
--------
"REV STD"
[cmd_trans_rev_std
,std_class( trans_rev_std );
--------

--------
"FREQUENCY"
"RESP. STD"
[cmd_freq_resp_std
,std_class( freq_resp_std );
--------

--------

--------

--------
"DONE"
"(SPEC'D)"
]cmd_std_class_specified
--------

8disp.work.L
```

```
*EJECT*******
.DISPLAY_MENU
--------
"SINGLE "+sk_bracket_2
"CHANNEL"
[cmd_single_ch
,select_trace_mode( single_ch );
--------
"DUAL    "
"CHANNEL"
[cmd_dual_ch
^DUAL_CH_MENU
--------
sk_bracket_4
half_vt+"DATA"
[cmd_data
,set_trace_type( trace_data );
--------
"MEMORY"
[cmd_mem
,set_trace_type( trace_mem );
--------
"DATA "+38
"MEMORY"
[cmd_d_and_m
,set_trace_type( trace_data_and_mem );
--------
"MATH"
"(...)"
[cmd_math
,set_trace_type( entry_ch_integer(ch_math_op) );
--------
"SELECT"
"DEFAULTS"
^DISPLAY_DEFAULT_MENU
--------
"DATA "+169
"MEMORY"
[cmd_d_into_m
,set_trace_type( trace_data_into_mem );
--------
```

```
*EJECT*******
.DUAL_CH_MENU
--------
"2 CHANNEL"+sk_bracket_2
"OVERLAY"
[cmd_overlay
,select_trace_mode( overlay );
--------
"2 CHANNEL"
"SPLIT"
[cmd_split
,select_trace_mode( split );
--------

--------

--------

--------

--------

--------
```

```
*EJECT*******
.DISPLAY_DEFAULT_MENU
--------
"MEMORY"+sk_bracket_5
" 1 "
[cmd_memory1
,select_memory( mem1 );
--------
" 2 "
[cmd_memory2
,select_memory( mem2 );
--------
" 3 "
[cmd_memory3
,select_memory( mem3 );
--------
" 4 "
[cmd_memory4
,select_memory( mem4 );
--------
"MORE"
^MEMORY_MENU
--------

--------
"MATH"
"OPERATIONS"
^MATH_MENU
--------

--------
```

```
*EJECT*******
.MEMORY_MENU
--------

--------

--------

--------

--------
"DATA from"+sk_bracket_2
"CHANNEL 1"
[cmd_memory_ch1
,select_memory( data1 );
--------
"DATA from"
"CHANNEL 2"
[cmd_memory_ch2
,select_memory( data2 );
--------

--------

--------
```

```
*EJECT********
.MATH_MENU
--------

--------

--------

--------
"DATA"+sk_bracket_4
"+ MEMORY"
[cmd_d_plus_m
,select_math_op( trace_data_plus_mem );
--------
"DATA"
"- MEMORY"
[cmd_d_minus_m
,select_math_op( trace_data_minus_mem );
--------
"DATA"
mpy_char+" MEMORY"
[cmd_d_mpy_m
,select_math_op( trace_data_times_mem );
--------
"DATA"
"/ MEMORY"
[cmd_d_div_m
,select_math_op( trace_data_div_mem );
--------

--------

2plot.work.L
```

```
*EJECT*********
.COPY_MENU
--------
"PLOT"+sk_bracket_5
"ALL"
[cmd_plot_all
,select_plot_buffer (all);
--------
"TRACE"
[cmd_plot_trace
,select_plot_buffer (trace);
--------
"GRATICULE"
[cmd_plot_graticule
,select_plot_buffer (grid);
--------
"MARKER(S)"
[cmd_plot_marker
,select_plot_buffer (markers);
--------
"TEXT"
[cmd_plot_text
,select_plot_buffer (annotations);
--------
"SELECT"
"QUADRANT"
^PLOT_SETUP_MENU
--------
"SELECT"
"PEN COLOR"
[cmd_ch1_pen
^PEN_MENU
--------
"MORE"
^PLOTPARM_MENU
--------
```

```
*EJECT*******
.PLOTPARM_MENU
--------
"LIST TRACE"
"VALUES"
[cmd_list_trace
,IF printer_connected THEN
,  BEGIN
,    abort_sweep;
,    list_trace_values;
,    restart_sweep;
,  END;
--------

--------

--------

--------

--------

--------
"SYSTEM"+sk_bracket_2
"PARAMETERS"
^COPY2_MENU
[cmd_system_params
,select_plot_param (sys_params);
--------
"OPERATING"
"PARAMETERS"
^COPY2_MENU
[cmd_op_params
,select_plot_param (op_params);
--------
```

```
*EJECT*******
.PLOT_SETUP_MENU
--------

--------
"X -   LEFT"+sk_bracket_5
"- -  UPPER"
[cmd_quadrant_11
,select_plot_quadrant (upper_left);
--------
"- -   LEFT"
"X -  LOWER"
[cmd_quadrant_21
,select_plot_quadrant (lower_left);
--------
"- X  RIGHT"
"- -  UPPER"
[cmd_quadrant_12
,select_plot_quadrant (upper_right);
--------
"- -  RIGHT"
"- X  LOWER"
[cmd_quadrant_22
,select_plot_quadrant (lower_right);
--------
"X X   FULL"
"X X   PAGE"
[cmd_quadrant_full
,select_plot_quadrant (full_page);
--------

--------

--------
```

```
*EJECT*******
.PEN_MENU
--------
"PEN"+sk_bracket_8
" 1 "
[cmd_pen1
,select_pen(1);
--------
" 2 "
[cmd_pen2
,select_pen (2);
--------
" 3 "
[cmd_pen3
,select_pen (3);
--------
" 4 "
[cmd_pen4
,select_pen (4);
--------
" 5 "
[cmd_pen5
,select_pen (5);
--------
" 6 "
[cmd_pen6
,select_pen (6);
--------
" 7 "
[cmd_pen7
,select_pen (7);
--------
" 8 "
[cmd_pen8
,select_pen (8);
--------
```

```
*EJECT*******
.COPY2_MENU
--------
"RESTORE"
"DISPLAY"
]cmd_directory_off
--------
sk_bracket_2
half_vt+"PRINT"
[cmd_print_params
,IF printer_connected THEN
,  output_parameters;
--------
"PLOT"
[cmd_plot_params
,dump_to_plotter;
--------

--------

--------

--------

--------
"NEXT PAGE"
[cmd_next_op_param
,next_op_param;
--------

9mkr.work.L
```

```
*EJECT*******
.MARKER_MENU
--------
"MARKER"+sk_bracket_6
"        1 "
[cmd_marker_1
,select_marker(1);
--------
"        2 "
[cmd_marker_2
,select_marker(2);
--------
"        3 "
[cmd_marker_3
,select_marker(3);
--------
"        4 "
[cmd_marker_4
,select_marker(4);
--------
"        5 "
[cmd_marker_5
,select_marker(5);
--------
"ALL"
"OFF"
[cmd_marker_off
,select_marker(0);
--------
delta_char+" MODE"
"MENU"
^DELTA_MARKER_MENU
[cmd_delta_marker
--------
"MORE"
^MARKER2_MENU
]cmd_more
--------
```

```
*EJECT*******
.DELTA_MARKER_MENU
--------
sk_bracket_6
half_vt+delta_char+" REF = 1"
[cmd_ref_mkr1
,select_ref_marker( 1 );
--------
delta_char+" REF = 2"
[cmd_ref_mkr2
,select_ref_marker( 2 );
--------
delta_char+" REF = 3"
[cmd_ref_mkr3
,select_ref_marker( 3 );
--------
delta_char+" REF = 4"
[cmd_ref_mkr4
,select_ref_marker( 4 );
--------
delta_char+" REF = 5"
[cmd_ref_mkr5
,select_ref_marker( 5 );
--------
delta_char+" MODE"
"OFF"
[cmd_no_ref_mkr
,select_ref_marker( 0 );
--------

--------

--------
```

```
*EJECT*******
.MARKER2_MENU
--------

--------

--------

--------

--------

--------

--------
"MARKER to"+sk_bracket_2
"MINIMUM"
[cmd_mkr_to_min
,marker_to( mkr_to_min );
--------
"MAXIMUM"
[cmd_mkr_to_max
,marker_to( mkr_to_max );
--------

Asystem.work.L
```

```
*EJECT*******
.SYSTEM_MENU
--------
"TITLE"
[cmd_title
^TITLE_MENU
,select_active_function( active_title );
--------
"HP-IB"
"ADDRESSES"
[cmd_hpib_info
^HPIB_MENU
--------
"CRT"
"OFF"
[cmd_crt_off
,warn(command_not_implemented);
--------

--------

--------

--------

--------
"SERVICE"
"FUNCTIONS"
[cmd_service_menu
^SERVICE_MENU
--------
```

```
*EJECT*******
.TITLE_MENU
--------
"SELECT"
"LETTER"
,enter_title_char( char_index );
--------

--------
"SPACE"
,enter_title_char( space_index );
--------
"BACKSPACE"
,enter_title_char( backspace_index );
--------

--------
"ERASE"
"TITLE"
[cmd_erase_title
,erase_title;
--------

--------
"DONE"
[cmd_title_done
,BEGIN
,   select_active_off( active_title );
,   previous_menu;
,END;
--------
```

```
*EJECT*******
.HPIB_MENU
--------
"8510 HP-IB"+sk_bracket_8
"ADDRESS"
[cmd_8510_addr
,select_active_function( active_8510_hpib_addr );
--------
"SYSTEM BUS"
[cmd_system_bus_addr
,select_active_function( active_system_bus_hpib_addr );
--------
"SOURCE"
[cmd_source_addr
,select_active_function( active_source_hpib_addr );
--------
"TEST SET"
[cmd_test_set_addr
,select_active_function( active_testset_hpib_addr );
--------
"PLOTTER"
[cmd_plotter_addr
,select_active_function( active_plotter_hpib_addr );
--------
"PRINTER"
[cmd_printer_addr
,select_active_function( active_printer_hpib_addr );
--------
"AUTO CMD"
[cmd_auto_cmd_addr
,select_active_function( active_ch_cmd_hpib_addr );
--------
"PASS THRU"
[cmd_pass_thru_addr
,select_active_function( active_pass_thru_hpib_addr );
--------
```

```
*EJECT*******
.SERVICE_MENU
--------
"SOFTWARE"
"REVISION"
[cmd_revision
,select_active_function( active_revision );
--------
"SYSTEM BUS"+sk_bracket_2
"'LOCAL'"
[cmd_privib_local
,BEGIN
,   hilight_on( cmd_privib_local, cmd_privib_remote );
,   abort_sweep;
,   clr_ren_priv_ib;
,   wrt_priv_ib_source(  display_on, " " );
,END;
--------
"'REMOTE'"
[cmd_privib_remote
,BEGIN
,   hilight_on( cmd_privib_local, cmd_privib_remote );
,   abort_sweep;
,COMMENT
,   set_ren_priv_ib;
,COMMENT
,   wrt_priv_ib_source(  display_off, " " );
,   reset_priv_ib_act_funs;
,   restart_sweep;
,END;
--------
"IF GAIN"
^IF_GAIN_MENU
[cmd_if_gain_menu
--------
sk_bracket_3
half_vt+"LOCATION"
[cmd_peek_poke_addr
,select_active_function( active_address );
--------
"PEEK"
[cmd_peek
,select_active_function( active_peek );
--------
"POKE"
[cmd_poke
,select_active_function( active_poke );
--------
"TEST MENU"
[cmd_test_menu
 BEGIN
.   trap_15_type := service_trap;
.   TRAP(15);
,END;
--------
```

```
Ocmdcase.work.L

[cmd_illegal
,warn(invalid_command);
;
; The following commands MUST be contiguous!
; Do NOT insert commands in between (for the parser's sake)
;
[cmd_enter
,keypad_entry(e0);
[cmd_u1
,keypad_entry(e0);
[cmd_u2
,keypad_entry(e3);
[cmd_u3
,keypad_entry(e6);
[cmd_u4
,keypad_entry(e9);
;
; END of contiguous command entries
;
[cmd_mkrval
,marker_value_entry;
[cmd_up
,step_entry(step_up);
[cmd_down
,step_entry(step_down);
[cmd_entry_off
,select_active_function(active_off);
[cmd_save
,gen_save_menu(5);
[cmd_save_1
,save( 1 );
[cmd_save_2
,save( 2 );
[cmd_save_3
,save( 3 );
[cmd_save_4
,save( 4 );
[cmd_save_5
,save( 5 );
[cmd_recall
,gen_save_menu(6);
[cmd_recall_1
,recall( 1 );
[cmd_recall_2
,recall( 2 );
[cmd_recall_3
,recall( 3 );
[cmd_recall_4
,recall( 4 );
[cmd_recall_5
,recall( 5 );
[cmd_recall_last
```

```
,recall( 8 );
[cmd_tape_menu
,gen_menu(TAPE_MENU, 0);
[cmd_copy
,gen_menu(COPY_MENU, 0);
[cmd_doc
,warn(command_not_implemented);
[cmd_quote
,select_active_function(active_off);
[cmd_label
,select_active_function(active_off);
[cmd_key_1
,process_softkey(1);
[cmd_key_2
,process_softkey(2);
[cmd_key_3
,process_softkey(3);
[cmd_key_4
,process_softkey(4);
[cmd_key_5
,process_softkey(5);
[cmd_key_6
,process_softkey(6);
[cmd_key_7
,process_softkey(7);
[cmd_key_8
,process_softkey(8);
[cmd_ch1
,select_entry_ch(1);
[cmd_s11
,BEGIN & s11 &
,   hilight_off( cmd_user1, cmd_user4);
,   new_parameter(s11);
,END;  & s11 &
[cmd_s12
,BEGIN & s12 &
,   hilight_off( cmd_user1, cmd_user4);
,   new_parameter(s12);
,END;  & s12 &
[cmd_s21
,BEGIN & s21 &
,   hilight_off( cmd_user1, cmd_user4);
,   new_parameter(s21);
,END;  & s21 &
[cmd_s22
,BEGIN & s22 &
,   hilight_off( cmd_user1, cmd_user4);
,   new_parameter(s22);
,END;  & s22 &
[cmd_mag
,new_format( fmt_log_mag );
[cmd_phase
,new_format( fmt_phase );
[cmd_ch2
,select_entry_ch(2);
[cmd_delay
```

```
,new_format( fmt_delay );
[cmd_polar
,new_format( fmt_z_smith );
[cmd_param_menu
,gen_menu(PARAM_MENU, 0);
[cmd_format_menu
,gen_menu(FORMAT_MENU, 0);
[cmd_preset
,recall_preset_state;
[cmd_local
,gen_menu(HPIB_MENU, 1);
[cmd_scale
,select_active_function(active_scale);
[cmd_ref_value
,select_active_function(active_ref_value);
[cmd_start
,select_active_stimulus(active_start);
[cmd_stop
,select_active_stimulus(active_stop);
[cmd_ref_position
,select_active_function(active_ref_pos);
[cmd_auto_scale
,auto_scale;
[cmd_center
,select_active_stimulus(active_center);
[cmd_span
,select_active_stimulus(active_span);
[cmd_response_menu
,gen_menu(RESPONSE_MENU, 0);
[cmd_stimulus_menu
,gen_menu(STIMULUS_MENU, 0);
[cmd_cal_menu
,gen_menu(CAL_MENU, 0);
[cmd_display_menu
,gen_menu(DISPLAY_MENU, 0);
[cmd_marker_menu
,BEGIN
,   select_marker( active_marker );
,   gen_menu(MARKER_MENU, 0);
,END;
[cmd_system_menu
,gen_menu(SYSTEM_MENU, 0);
[cmd_prior_menu
,previous_menu;
[cmd_measurement_restart
,measurement_restart;
[cmd_domain_menu
,gen_menu(DOMAIN_MENU, 0);
[cmd_abort_command
,abort_command := TRUE;
[cmd_input_data
,pub_ib_input_select( data_input );
[cmd_input_formatted
,pub_ib_input_select( formatted_input );
[cmd_input_rawl
,pub_ib_input_select( rawl_input );
```

```
[cmd_input_raw2
,pub_ib_input_select( raw2_input );
[cmd_input_raw3
,pub_ib_input_select( raw3_input );
[cmd_input_raw4
,pub_ib_input_select( raw4_input );
[cmd_input_cal_coeff1
,pub_ib_input_select( cal_coeff1_input );
[cmd_input_cal_coeff2
,pub_ib_input_select( cal_coeff2_input );
[cmd_input_cal_coeff3
,pub_ib_input_select( cal_coeff3_input );
[cmd_input_cal_coeff4
,pub_ib_input_select( cal_coeff4_input );
[cmd_input_cal_coeff5
,pub_ib_input_select( cal_coeff5_input );
[cmd_input_cal_coeff6
,pub_ib_input_select( cal_coeff6_input );
[cmd_input_cal_coeff7
,pub_ib_input_select( cal_coeff7_input );
[cmd_input_cal_coeff8
,pub_ib_input_select( cal_coeff8_input );
[cmd_input_cal_coeff9
,pub_ib_input_select( cal_coeff9_input );
[cmd_input_cal_coeff10
,pub_ib_input_select( cal_coeff10_input );
[cmd_input_cal_coeff11
,pub_ib_input_select( cal_coeff11_input );
[cmd_input_cal_coeff12
,pub_ib_input_select( cal_coeff12_input );
[cmd_block_a
,pub_ib_input;
[cmd_output_formatted
,pub_ib_output_select( formatted_output );
[cmd_output_active
,pub_ib_output_select( active_output );
[cmd_output_marker
,pub_ib_output_select( marker_output );
[cmd_output_status
,pub_ib_output_select( status_output );
[cmd_output_id
,pub_ib_output_select( id_output );
[cmd_output_data
,pub_ib_output_select( data_output );
[cmd_output_raw1
,pub_ib_output_select( raw1_output );
[cmd_output_raw2
,pub_ib_output_select( raw2_output );
[cmd_output_raw3
,pub_ib_output_select( raw3_output );
[cmd_output_raw4
,pub_ib_output_select( raw4_output );
[cmd_output_cal_coeff1
,pub_ib_output_select( cal_coeff1_output );
[cmd_output_cal_coeff2
,pub_ib_output_select( cal_coeff2_output );
```

```
[cmd_output_cal_coeff3
,pub_ib_output_select( cal_coeff3_output );
[cmd_output_cal_coeff4
,pub_ib_output_select( cal_coeff4_output );
[cmd_output_cal_coeff5
,pub_ib_output_select( cal_coeff5_output );
[cmd_output_cal_coeff6
,pub_ib_output_select( cal_coeff6_output );
[cmd_output_cal_coeff7
,pub_ib_output_select( cal_coeff7_output );
[cmd_output_cal_coeff8
,pub_ib_output_select( cal_coeff8_output );
[cmd_output_cal_coeff9
,pub_ib_output_select( cal_coeff9_output );
[cmd_output_cal_coeff10
,pub_ib_output_select( cal_coeff10_output );
[cmd_output_cal_coeff11
,pub_ib_output_select( cal_coeff11_output );
[cmd_output_cal_coeff12
,pub_ib_output_select( cal_coeff12_output );
[cmd_output_memory
,pub_ib_output_select( memory_output );
[cmd_output_error
,pub_ib_output_select( error_output );
[cmd_hpib_talk
,pub_ib_output;
[cmd_srq_mask
,select_active_function( active_srq_mask_primary );
[cmd_clear_status
,clear_serial_poll;
[cmd_xfer_binary
,pub_ib_format_select( output_binary);
[cmd_xfer_ascii
,pub_ib_format_select( output_ascii);
[cmd_xfer_ieee2
,pub_ib_format_select( output_ieee_double);
[cmd_xfer_ieee1
,pub_ib_format_select( output_ieee_single);
[cmd_keycode
,select_active_function( active_keycode );
[cmd_output_plot
,pub_ib_output_select(plot_output);
[cmd_monitor
,BEGIN
,   trap_15_type := normal_trap_15;
,   TRAP(15);
,END;
[cmd_n_groups_hpib
,select_active_function(active_n_groups_hpib);
[cmd_output_key
,pub_ib_output_select( key_output );
[cmd_cal_set_1
,select_default_set( 1 );
[cmd_cal_set_2
,select_default_set( 2 );
[cmd_cal_set_3
```

```
,select_default_set( 3 );
[cmd_cal_set_4
,select_default_set( 4 );
[cmd_cal_set_5
,select_default_set( 5 );
[cmd_cal_set_6
,select_default_set( 6 );
[cmd_cal_set_7
,select_default_set( 7 );
[cmd_cal_set_8
,select_default_set( 8 );
```

```
M68KL,P,"marker"
BEGIN

#FILE fannot.work;                              & for annotate_mkr_value &
#FILE cmkr.work;
#FILE factive.work;
#FILE factive2.work;
#FILE facttbl.work;
#FILE cchtable.work;
#FILE fchtable.work;
#FILE fchtab2.work;
#FILE fchdata.work;
#FILE fstimuli.work;
#FILE cdisplay.work;
#FILE fdisplay.work;
#FILE cscreen.work;
#FILE ctrace.work;
#FILE fmenu.work;
#FILE crins.work;
#FILE fkernel.work;
#FILE fmarks.work;
#FILE fcommand.work;                                & for command_token &
#FILE cdomain.work;                         & for time_ and tdr_domain &
#FILE fdispram.work;                                & for wrt_disp_byte &


TYPELENGTH USER3 : 6;

INTEGER CONSTANT  max_marker  := 5;
INTEGER CONSTANT  coord_mask  := %0FFF;

GLOBAL INTEGER active_marker;
INTEGER ref_marker;

INTEGER TABLE cmd_mkr :=
      cmd_marker_off,
      cmd_marker_1,
      cmd_marker_2,
      cmd_marker_3,
      cmd_marker_4,
      cmd_marker_5;

INTEGER TABLE cmd_ref_mkr :=
      cmd_no_ref_mkr,
      cmd_ref_mkr1,
      cmd_ref_mkr2,
      cmd_ref_mkr3,
      cmd_ref_mkr4,
      cmd_ref_mkr5;

ALPHA TABLE mkr_ref_off :=
      "",
      " 1 ",
      " 2 ",
```

```
        " 3 ",
        " 4 ",
        " 5 ";

ALPHA TABLE mkr_ref_on :=
        "",
        delta_char+" REF = 1 ",
        delta_char+" REF = 2 ",
        delta_char+" REF = 3 ",
        delta_char+" REF = 4 ",
        delta_char+" REF = 5 ";

BYTE TABLE mkr_ref_suffix :=
        ' , ' , ' , ' ,                       &  0  no ref marker &
        blink_on, '-, '1, blink_off,     &  4  ref marker 1 &
        blink_on, '-, '2, blink_off,     &  8  ref marker 2 &
        blink_on, '-, '3, blink_off,     & 12  ref marker 3 &
        blink_on, '-, '4, blink_off,     & 16  ref marker 4 &
        blink_on, '-, '5, blink_off;     & 20  ref marker 5 &

INTEGER TABLE active_mkr :=
        0, & unused &
        active_marker1,
        active_marker2,
        active_marker3,
        active_marker4,
        active_marker5;
INTEGER TABLE ch_marker :=
        0, & unused &
        ch_marker1,
        ch_marker2,
        ch_marker3,
        ch_marker4,
        ch_marker5,
        ch_gate_start,
        ch_gate_center,
        ch_gate_stop;
INTEGER TABLE mkr_position :=
        mkr11_position,
        mkr21_position,
        mkr12_position,
        mkr22_position,
        mkr13_position,
        mkr23_position,
        mkr14_position,
        mkr24_position,
        mkr15_position,
        mkr25_position,
        mkr16_position,  & gate start &
        mkr26_position,
        mkr17_position,  & gate center &
        mkr27_position,
        mkr18_position,  & gate stop &
        mkr28_position;
INTEGER TABLE mkr_display :=
        mkr11_display,
```

```
                    mkr21_display,
                    mkr12_display,
                    mkr22_display,
                    mkr13_display,
                    mkr23_display,
                    mkr14_display,
                    mkr24_display,
                    mkr15_display,
                    mkr25_display,
                    mkr16_display,  & gate start &
                    mkr26_display,
                    mkr17_display,  & gate center &
                    mkr27_display,
                    mkr18_display,  & gate stop &
                    mkr28_display;


#EJECT;
COMMENT                                              marker_on_if_not
***********************************************************************
*
***********************************************************************
;
SUBROUTINE marker_on_if_not;
   BEGIN & marker_on_if_not &
      IF (marker_state AND %003E) = 0 THEN        & no markers were on &
         BEGIN & if &            & keep same as select_marker sequence &
            hilight_key( cmd_mkr[active_marker],
                         cmd_marker_1,
                         cmd_marker_off
                       );
            marker_state := SBIT( marker_state, active_marker );
            IF ref_marker <> 0 THEN     & display reference marker too &
               marker_state := SBIT( marker_state, ref_marker );
         END;  & if &
   END;  & marker_on_if_not &
```

```
#EJECT;
COMMENT                                                             select_marker
*****************************************************************************
*
*****************************************************************************
;
PROCEDURE  select_marker( mkr );
   VALUE   mkr;
   INTEGER mkr;                                                          ENTRY;
   BEGIN & select_marker &
      hilight_key( cmd_mkr[mkr], cmd_marker_1, cmd_marker_off );
      IF mkr = 0 THEN
         BEGIN & if &
            marker_state := marker_state AND %FFC1; & turn off markers &
            IF (  (active_function >= active_marker1) AND
                  (active_function <= active_marker5)
               ) THEN          & turn off active function annotations &
               select_active_function( active_off );
         END   & if &
      ELSE & marker <> 0 &
         BEGIN & else &                       & also in marker_on_if_not &
            active_marker := mkr;
            marker_state := SBIT( marker_state, mkr );
            IF ref_marker <> 0 THEN     & display reference marker too &
               marker_state := SBIT( marker_state, ref_marker );
            select_active_function( active_mkr[mkr] );
         END;  & else &
   END;  & select_marker &
```

```
#EJECT;
COMMENT                                                     select_ref_marker
**********************************************************************
*
**********************************************************************
;
PROCEDURE  select_ref_marker( mkr );
   VALUE   mkr;
   INTEGER mkr;                                                    ENTRY;
   BEGIN & select_ref_marker &
      INTEGER i,
              j;
      ALPHA   active_label;
      BYTE POINTER active_array = active_label;
      BYTE POINTER ref_label;

      IF ref_marker <> 0 THEN      & erase delta_char from old ref mkr &
         change_softkey( mkr_ref_off[ref_marker],
                         cmd_mkr[ref_marker],
                         IF ref_marker=1 THEN 2 ELSE 1
                       );
      IF mkr <> 0 THEN                   & add delta_char to new ref mkr &
         change_softkey( mkr_ref_on[mkr],
                         cmd_mkr[mkr],
                         IF mkr=1 THEN 2 ELSE 1
                       );

      & add "-N" suffix to the active function annotation &
      STPNTR( ref_label, ADRS( mkr_ref_suffix[ ALEFT(mkr,2) ] ) );
      FOR i := active_marker1 UNTIL active_marker5 DO
         BEGIN & for &
            active_label := active_function_label[i];
            FOR j := 0 UNTIL 3 DO
               wrt_disp_byte( ADRS(active_array[j+9]), ref_label[j] );
         END;  & for &
      ref_marker := mkr;

      hilight_key( cmd_ref_mkr[mkr], cmd_ref_mkr1, cmd_no_ref_mkr );

      IF mkr = 0 THEN                      & turn off delta marker mode &
         select_active_function( active_previous )         & new status &
      ELSE IF (marker_state AND %003E) = 0 THEN       & no marker is on &
         select_marker( mkr )
      ELSE
         BEGIN & else &
            select_active_function( active_mkr[active_marker] );
            marker_state := SBIT( marker_state, mkr );
         END;  & else &

      previous_menu;

   END;  & select_ref_marker &
```

```
#EJECT;
COMMENT                                                         marker_point
**************************************************************************
*
* The point number of the marker on the specified channel.
* 0 to number of points (not 0 to 800).
*
**************************************************************************
;
INTEGER PROCEDURE marker_point( mkr, ch );
   VALUE   mkr, ch;
   INTEGER mkr, ch;                                                  ENTRY;
   BEGIN & marker_point &
      INTEGER point,
              i;

      & get point -- 0 to 800 &
      point := point_at_ch_stimulus( ch_quad(ch_marker[mkr],ch), ch );

      i := ARIGHT( step_size, 1 );                          & divide by 2 &
      point := point + i;                           & round, not truncate &
      WHILE i > 0 DO
         BEGIN & while &
            point := ARIGHT( point, 1 );
            i := ARIGHT(i,1);                               & divide by 2 &
         END;  & while &
         & faster way to do point := point_at_stimulus/step_size &
         &    since step_size is always a power of two. &

      marker_point := point;

   END;  & marker_point &


#EJECT;
COMMENT                                                      ch_marker_value
**************************************************************************
*
* value of the specified marker on the specified channel.
*
**************************************************************************
;
USER3 PROCEDURE ch_marker_value( mkr, ch );
   VALUE   mkr, ch;
   INTEGER mkr, ch;                                                  ENTRY;
   BEGIN & ch_marker_value &
      INTEGER  index;               & index into formatted data array &
      USER3 POINTER data_ptr;       & pointer to formatted data array &

      index := marker_point( mkr, ch );
      STPNTR( data_ptr, ch_double(ch_f_base, ch) );
COMMENT the compiler does not properly index USER3 pointers yet
      ch_marker_value := data_ptr[index];                       & DEBUG &
      STPNTR( data_ptr, ADRS(data_ptr) + 6*index );             & DEBUG &
      ch_marker_value := data_ptr;                              & DEBUG &

   END;  & ch_marker_value &
```

```
#EJECT;
COMMENT                                                              marker_value
*****************************************************************************
*
* value of the specified marker for the current_entry_channel
*
*****************************************************************************
;
USER3 PROCEDURE marker_value( mkr );
   VALUE   mkr;
   INTEGER mkr;                                                           ENTRY;
   BEGIN & marker_value &
      marker_value := ch_marker_value( mkr, current_entry_ch );
   END;  & marker_value &
```

```
#EJECT;
COMMENT                                                              ch_mkr_value
*****************************************************************************
*
* value of the active marker for the specified channel.
*
*****************************************************************************
;
USER3 PROCEDURE ch_mkr_value(ch);
   VALUE   ch;
   INTEGER ch;                                                            ENTRY;
   BEGIN & ch_mkr_value &
      USER3   mkr_value,
              ref_mkr_value;

      marker_on_if_not;
      mkr_value := ch_marker_value( active_marker, ch );

      IF ref_marker <> 0 THEN
         BEGIN & if &
            ref_mkr_value := ch_marker_value( ref_marker, ch );
            ASSEMBLE( MOVEM.L mkr_value,      R0-R1          ;
                      SWAP    R1                             ;
                      MOVEM.L ref_mkr_value,  R2-R3          ;
                      SWAP    R3                             ;
                      JSRX    SUBE                           ;
                      SWAP    R1                             ;
                      MOVEM.L R0-R1,          mkr_value
                    );
         END;  & if &
      ch_mkr_value := mkr_value;

   END;  & ch_mkr_value &
```

```
#EJECT;
COMMENT                                                          mkr_value
**************************************************************************
*
* value of the active marker for the current_entry_ch.
*
**************************************************************************
;
USER3 PROCEDURE mkr_value;                                          ENTRY;
   BEGIN & mkr_value &
      mkr_value := ch_mkr_value( current_entry_ch );
   END;  & mkr_value &


#EJECT;
COMMENT                                                 mkr_stimulus_at_pt
**************************************************************************
*
* Returns stimulus value for the point nearest the marker.
*
**************************************************************************
;
QUAD PROCEDURE mkr_stimulus_at_pt( mkr );
   VALUE   mkr;
   INTEGER mkr;                                                     ENTRY;
   BEGIN & mkr_stimulus_at_pt &
      INTEGER      i,
                point;

      point := marker_point( mkr, current_entry_ch );
      i := step_size;
      WHILE ( i := ARIGHT(i,1) ) <> 0 DO
         point := ALEFT(point,1);              & multiply by step_size &
      mkr_stimulus_at_pt := entry_stimulus_at_point( point );

   END;  & mkr_stimulus_at_pt &
```

```
#EJECT;
COMMENT                                                    mkr_stimulus_value
*************************************************************************
*
* stimulus value of the active marker.
*
*************************************************************************
;
QUAD PROCEDURE mkr_stimulus_value;                                  ENTRY;
   BEGIN & mkr_stimulus_value &

      marker_on_if_not;

      IF ref_marker <> 0 THEN
         mkr_stimulus_value := mkr_stimulus_at_pt( active_marker )
                                  - mkr_stimulus_at_pt( ref_marker )
      ELSE & ref_marker = 0 &
         mkr_stimulus_value := mkr_stimulus_at_pt( active_marker );

   END;  & mkr_stimulus_value &
```

```
#EJECT;
COMMENT                                                              put_marker
*******************************************************************************
*
*******************************************************************************
;
PROCEDURE  put_marker( mkr );
   VALUE   mkr;
   INTEGER mkr;                                                         ENTRY;
   BEGIN & put_marker &
      INTEGER  ch,
               d_state,
               m_state,
               x_point,
               mkr_index,        & a precomputed index of [ ch, mkr ] &
               mkr_end,                            & the jump target &
               dg_x,                  & x_coordinate display contents &
               dg_y,                  & y_coordinate   "       "      &
               dg_addr,
               temp_domain;
      INTEGER POINTER dg_ptr;

      FOR ch := 1 TO max_ch DO                & change to "1 TO 2" &
         BEGIN & for &
            d_state := ch_integer( ch_d_state, ch );
            m_state := ch_integer( ch_m_state, ch );
            mkr_index := (mkr-1)*max_ch + (ch-1);
            dg_addr := mkr_position[mkr_index];
            mkr_end := mkr_display[mkr_index] + mkr_size;

            IF ( TBIT( marker_state, mkr ) AND
                 ( (d_state = d_on) OR (m_state = m_on) )
               ) THEN
               BEGIN & if &
                  x_point := ALEFT( marker_point(mkr,ch), 1 );
                             & times two -- two coordinates / point &

                  & which trace gets the marker &
                  IF d_state = d_on THEN
                     STPNTR( dg_ptr, ch_double(ch_trace_base,ch) )
                  ELSE & memory trace only &
                     STPNTR( dg_ptr, ch_double(ch_m_trace_base,ch) );

                  dg_x := dg_ptr[ x_point ] AND coord_mask;
                  dg_y := dg_ptr[ x_point + 1 ] AND coord_mask;
                  dg_addr := move2( dg_addr, dg_x, dg_y );

                  IF ( (mkr = active_marker) AND
                       (ch = current_entry_ch)
                     ) THEN
                     dg_addr := printch(dg_addr, primary_marker)
                  ELSE IF mkr <= max_marker THEN        & normal marker &
                     dg_addr := printch( dg_addr, marker )
                  ELSE                                    & gate marker &
                     BEGIN & else &
                        temp_domain := ch_integer(ch_domain, ch);
```

```
                IF ( (temp_domain = time_domain) OR
                     (temp_domain = tdr_domain)
                   ) THEN
                   dg_addr := printch( dg_addr, gate_marker );
             END;  & else &

          IF mkr <= max_marker THEN
             BEGIN & if &
                dg_addr := printch( dg_addr, (mkr + '0) );
                IF ( (mkr = ref_marker) AND
                     (ch  = current_entry_ch)
                   ) THEN
                   BEGIN & if &
                     dg_addr := setattribute(dg_addr, blink);
                     dg_addr := printch(dg_addr, delta_char);
                     dg_addr := setattribute(dg_addr,blinkoff);
                   END;  & if &
             END;  & if &

        END;  & if &
      dg_addr := jmp( dg_addr, mkr_end );
    END;  & for &

END;  & put_marker &
```

```
#EJECT;
COMMENT                                                      update_marks
*************************************************************************
*
* update markers, sweep update mark, and first point so that they
* follow changes in the data.
*
* "partial_update_marks" has no acquire/release so that it can be called
* by process 0, the idle process.  It must call the routine only on the
* condition that no one else has acquired the resource.
*
*************************************************************************
;
PROCEDURE  partial_update_marks;                                  ENTRY;
   BEGIN & partial_update_marks &
      INTEGER mkr;

      FOR mkr := 1 TO (max_marker + 3) DO
         put_marker( mkr );
      annotate_mkr_value;
      put_update_mark;
      reset_first_point;

   END;  & partial_update_marks &


SUBROUTINE update_marks;                                          ENTRY;
   BEGIN & update_marks &
      acquire( trace_marks );
      partial_update_marks;
      release( trace_marks );
   END;  & update_marks &
```

```
#EJECT;
COMMENT                                                          init_markers
*************************************************************************
*
*************************************************************************
;
PROCEDURE  init_markers;                                               ENTRY;
   BEGIN & init_markers &
      INTEGER mkr;

      ref_marker       := 0;
      hilight_off( cmd_delta_marker, cmd_delta_marker );
      active_marker    := 1;
      FOR mkr := 1 UNTIL 5 DO
         change_softkey( mkr_ref_off[mkr],
                         cmd_mkr[mkr],
                         IF mkr=1 THEN 2 ELSE 1
                       );
      select_marker( 0 );
   END;  & init_markers &


#FILE fmkr.work;

END$
```

```
INTEGER CONSTANT

TAPE_MENU:= 0,
INIT_TAPE_MENU:= 1,
DIRECTORY_MENU:= 2,
DATA2_MENU:= 3,
DATA1_MENU:= 4,
ABORT_MENU:= 5,
FILE_MENU:= 6,
REG_MENU:= 7,
RESPONSE_MENU:= 8,
IF_GAIN_MENU:= 9,
IF_GAIN_MENU2:= 10,
STIMULUS_MENU:= 11,
N_POINTS_MENU:= 12,
POWER_MENU:= 13,
STIMULUS2_MENU:= 14,
DEVICE_READY_MENU:= 15,
PARAM_MENU:= 16,
REDEF_MENU:= 17,
REDEF_DRIVE_MENU:= 18,
REDEF_LOCK_MENU:= 19,
REDEF_NUM_MENU:= 20,
REDEF_NUM2_MENU:= 21,
REDEF_DENOM_MENU:= 22,
REDEF_CONV_MENU:= 23,
FORMAT_MENU:= 24,
DOMAIN_MENU:= 25,
LOW_PASS_FREQ:= 26,
TIME_SETUP_MENU:= 27,
GATE_SETUP_MENU:= 28,
GATE_SHAPE_MENU:= 29,
CAL_MENU:= 30,
MORE_CAL:= 31,
REF_PLANE_MENU:= 32,
CAL_TYPE_MENU:= 33,
PORT_ONE_REFL:= 34,
PORT_TWO_REFL:= 35,
CAL_MENU2:= 36,
REFLECTION_MENU:= 37,
TRANSMISSION_MENU:= 38,
ISOLATION_MENU:= 39,
CAL_MENU3:= 40,
SIMPLE_REFLECTION_MENU:= 41,
SIMPLE_TRANSMISSION_MENU:= 42,
SIMPLE_ISOLATION_MENU:= 43,
STD_CLASS_MENU:= 44,
SLIDING_LOAD_MENU:= 45,
MODIFY_CAL_KIT_MENU:= 46,
MODIFY_STDS_MENU:= 47,
DEFINE_OPEN_MENU:= 48,
DEFINE_SHORT_MENU:= 49,
DEFINE_LOAD_MENU:= 50,
SPECIFY_Z_MENU:= 51,
SPECIFY_OFFSET_MENU:= 52,
```

```
SPECIFY_CLASS_MENU:= 53,
SPECIFY_CLASS_MENU2:= 54,
DISPLAY_MENU:= 55,
DUAL_CH_MENU:= 56,
DISPLAY_DEFAULT_MENU:= 57,
MEMORY_MENU:= 58,
MATH_MENU:= 59,
COPY_MENU:= 60,
PLOTPARM_MENU:= 61,
PLOT_SETUP_MENU:= 62,
PEN_MENU:= 63,
COPY2_MENU:= 64,
MARKER_MENU:= 65,
DELTA_MARKER_MENU:= 66,
MARKER2_MENU:= 67,
SYSTEM_MENU:= 68,
TITLE_MENU:= 69,
HPIB_MENU:= 70,
SERVICE_MENU:= 71,
LAST_MENU := 72;
```

```
M68KL,P,"menu"
BEGIN

#FILE fterm.work;
#FILE cdebug.work;
#FILE cmenu.work;
#FILE fdisplay.work;
#FILE fskey.work;              & tables of info. to generate softkeys  &
#FILE fscreen.work;            & general constant display vectors      &
#FILE fskpos.work;             & tables of softkey positioning vectors &
#FILE fcommand.work;           & command token/pending variables       &
#FILE fdispram.work;           & changing softkey strings in display   &
#FILE fchdata2.work;           & hilite bitmap information, hilite_info&
#FILE fchtable.work;           & current entry channel for hilighting  &
#FILE cchconst.work;           & ch 1 and ch 2 constant values         &

INTEGER CONSTANT
  hilite_max:= 367,          & determined from hilite_bitmap entries   &
  max_depth := 8;

GLOBAL
INTEGER
  menu_level;                & current level of menu being displayed   &

GLOBAL                       & make max_depth change in fmenu.work&
INTEGER ARRAY                & with actual constant              &
  level_info [0:max_depth];  &contains menu # at corr. menu levels&

INTEGER ARRAY
  char_cnt[0:7],       & max # chars to be highlighted in softkey  &
  keycode [0:7],       & contains keycode values of current menu   &
  next_menu [0:7];     & menu number corresponding to new menu key &

INTEGER POINTER
  menu_ptr;            & points to address of current menu         &

INTEGER
  menu_hilite,
  menu_config,         & 8 2-bit softkey menu config = # lines/key &
  menu_map;            & menu hilite and new menu softkey bitmap   &

BOOLEAN menu_on;       & menu on/off toggle flag for [PREVIOUS] key&
```

```
#EJECT;
COMMENT
$DOC+

NAME--
  highlight_menu
*************************************************************************
*
* SHORT DESCRIPTION--
*   Hilights certain softkeys of the current softkey menu
*
* EXTENDED DESCRIPTION--
*   This routine hilights softkey menus according to HILITE_BITMAP,
*   in which each bit corresponds to all softkey command token values.
*   The hilighting characters are up to 10 underscores (ie: "--------").
*   These variable length hilighting characters are indexed from a
*   local table in which the location of the character corresponds to
*   the length of the hilight.  The length of the hilight is determined
*   from another table (global) containing the length of the longest
*   softkey annotation for each softkey for the currently displayed
*   menu.
*   Display information starts at SK_HIGHLIGHT_DISPLAY and uses
*   FSCREEN.WORK constants as x,y vectors.
*   Softkey menu information which contains the number of lines per
*   softkey annotation indicates where the hilight character is to be
*   drawn.
*
* INPUTS--  none
*
* OUTPUTS--
*   display softkey highlighting
*
* ROUTINES CALLED--
*   move
*   printch
*   jmp
*
* ERROR CONDITIONS AND RECOVERY-- none
*
* NOTES--
*   This routine is also used for turning off hilights
*
* AUTHOR--
*
*************************************************************************
*
* INITIAL REFINEMENT--
*   Clear softkey hilight display
*   IF a menu is currently being displayed THEN
*     DO the following for each softkey:
*       IF a softkey is being displayed THEN
*         IF that softkey's bit is set in the hilight bitmap THEN
*           display a hilight char for that softkey
*
*************************************************************************
*
```

```
* REVISION LOG--
*
*****************************************************************************
DECLARATION--
;
PROCEDURE highlight_menu;                                             ENTRY;
&
$DOC-&

BEGIN
  INTEGER i;
  INTEGER y,lgth,disp;
  BYTE underline;
  BYTE TABLE hilite_char := 0,
    hilight_1, hilight_2, hilight_3, hilight_4, hilight_5,
    hilight_6, hilight_7, hilight_8, hilight_9, hilight_10;

  disp := move (sk_highlight_display, sk_x, sk11_y);
  IF menu_on THEN
  FOR i:= 0 TO 7 DO
    IF (y:=keycode[i]) <> 0 THEN                          & valid softkey &
    IF (y > hilite_max) THEN                              & DEBUG &
      BEGIN WSTR("hilite bitmap overflow"); CRLF; END     & DEBUG &
    ELSE
      IF TBIT(hilite_info[current_entry_ch-1,RIGHT(y,4)],y AND %0F) THEN
        BEGIN
          underline := hilite_char[lgth:=char_cnt[i]]; & hilight key   &
          y := sk_line2[i];                           & double line y pos'n  &
          IF TBIT(menu_config,i+i) THEN
            y := y + 64;                              & single line y pos'n  &
          disp := move (disp, blanks[lgth], y);
          disp := printch( disp, underline);
        END;
  disp := jmp(disp,sk_highlight_display+sk_highlight_size);
END highlight_menu;
```

```
#EJECT;
COMMENT
$DOC+

NAME--
  blank_softkey
**************************************************************************
*
* SHORT DESCRIPTION--
*   blanks out softkey annotation on softkey menu display
*
* EXTENDED DESCRIPTION--
*   Disables command processing for softkey i and displays a blank
*   annotation for that softkey position (where i = 0..7
*
* INPUTS--
*   i = softkey position number (0..7)
*
* OUTPUTS--
*   blank softkey annotation for softkey position i.
*   non-functional command code value for softkey i
*
* ROUTINES CALLED--
*   print_string
*
* ERROR CONDITIONS AND RECOVERY--
*   The value of input i must be 1..8.
*   There is no range checking included to enforce this since the
*   routine is very local and invoked from controlled loops using
*   control variable values between 0 and 7 (inclusively).
*
* NOTES--
*   Used in blanking out/disabling entire softkey menu or certain
*   softkeys that are not used in a menu.
*
* AUTHOR--
*
**************************************************************************
*
* INITIAL REFINEMENT--
*   set command code value corresponding to softkey i to 0
*   print 2 blank lines in softkey position i
*
**************************************************************************
*
* REVISION LOG--
*
**************************************************************************
DECLARATION--
;
PROCEDURE blank_softkey (i);  VALUE i; INTEGER i;                ENTRY;
&
$DOC-&

BEGIN
  keycode[i] := 0;

        print_string(" ", sk1_size,field[i]);
        print_string(" ", sk2_size,field[i+8]);
      END;
```

```
#EJECT;
COMMENT
$DOC+

NAME--
  kill_softkeys
*************************************************************************
*
* SHORT DESCRIPTION--
*   inactivates current softkey menu information
*
* EXTENDED DESCRIPTION--
*   Disables all softkey command processing by setting corresponding
*   command code values to non-functional (0) and blanking out softkey
*   annotations.  Also initializes current softkey menu highlighting
*   bitmap and that indicates which currently displayed softkey(s) are
*   to be highlighted.
*
* INPUTS--
*   none
*
* OUTPUTS--
*   non-functional softkey command codes
*   non-highlighting and menu bitmap
*
* ROUTINES CALLED--
*   blank_softkey
*
* ERROR CONDITIONS AND RECOVERY--
*   none
*
* NOTES--
*   Used for blanking out outer level menu with [PREVIOUS] hard key from
*   the front panel, and as part of power up or instrument preset.
*
* AUTHOR--
*
*************************************************************************
*
* INITIAL REFINEMENT--
*   set all softkey command codes to 0
*   blank out all softkey annotations
*   reset current menu level to 0 (first level)
*   initialize current menu highlighting bitmap
*   eliminate any displayed highlights
*
*************************************************************************
*
* REVISION LOG--
*
*************************************************************************
DECLARATION--
;
SUBROUTINE kill_softkeys;  ENTRY;
&
$DOC-&
```

```
            BEGIN
              menu_on := FALSE;
              FOR menu_map := 0 TO 7 DO
                blank_softkey (menu_map);
              menu_level := menu_map := 0;
              highlight_menu;
            END kill_softkeys;


$EJECT;
SUBROUTINE init_softkeys;                                    ENTRY;
BEGIN
  FOR menu_map := 0 TO max_depth DO
    level_info[menu_map] := -1;
  kill_softkeys;
END init_softkeys;
```

```
#EJECT;
COMMENT
$DOC+

NAME--
  change_softkey
*************************************************************************
*
* SHORT DESCRIPTION--
*   changes a line in a softkey's annotation
*
* EXTENDED DESCRIPTION--
*   This routine replaces a softkey annotation line given the new
*   string, the corresponding softkey command code, and the line number
*   in which the string occurs.  Range checking and side effects are
*   described in ERROR CONDITIONS AND RECOVERY.
*   If the softkey annotation being modified is contained in a menu
*   being currently displayed, the modification will not be seen until
*   the menu is re-generated.
*
* INPUTS--
*   new_line = replacement string
*   cmd_code = command token value corresponding to softkey
*   line_no  = 1st or 2nd line of softkey to be changed
*
* OUTPUTS--  none
*
* ROUTINES CALLED--  none
*
* ERROR CONDITIONS AND RECOVERY--
*   Range checking and correction is done on softkey line number to
*   be changed and the maximum string length allowed per new line.
*   If not enough space was allocated for a softkey line to accomodate
*   the maximum string length then another softkey's annotation could
*   be potentially overwritten w/ new characters (one of which ends up
*   being the length byte of the overwritten string).  Fortunately,
*   this does not cause a software "crash" but one of the softkey menus
*   may contain unusually long strings.
*   No range checking is done on command token values that are passed
*   (which may cause unintentional modifications to parts of memory).
*   Therefore it behooves one to utilize the command token constants
*   created by GENSK in SKINFO!!!
*
* NOTES--
*   As a rule of thumb, softkey annotations that are apt to run-time
*   modifications, should be allocated the maximum number of characters
*   anticipated or allowed in a label.  This is pre-defined in the
*   SKINFO file which generates the softkey tables.  Currently, the
*   maximum string length allowed per softkey line is 10 characters.
*
* AUTHOR--
*
*************************************************************************
*
* INITIAL REFINEMENT--
*
```

```
************************************************************************
*
* REVISION LOG--
*   8-2-83    -- used "wrt_disp_str" routine to change softkey labels
*                (general purpose routine for writing strings to display
*                 memory which is where the labels are located.)
*
************************************************************************
DECLARATION--
;
PROCEDURE change_softkey (new_line, cmd_token, line_no);
  VALUE new_line, cmd_token, line_no;
  ALPHA new_line; INTEGER cmd_token, line_no;                      ENTRY;
&
$DOC-&

BEGIN
  DOUBLE old_addr;
  ALPHA old_str=old_addr;
  BYTE POINTER new_str=new_line;
  INTEGER n;

  IF line_no >= 2 THEN         & restrict to only 1 to 2 lines/softkey &
    line_no := 1
  ELSE
  IF line_no <= 1 THEN
    line_no := 0;

  IF (n:=LBL_INDEX[2*(cmd_token-1)+line_no]) > 0 THEN
    BEGIN              & check for existing annotation in softkey line &
      IF new_str > sk2_size THEN                   & check string lgth &
        new_str := sk2_size;
    & old_str := ADRS(SK_LABEL)+n &
      old_str := SK_LABEL [n];
      wrt_disp_str (old_addr, new_line);
    END;
END change_softkey;
```

```
#EJECT;
COMMENT
$DOC+

NAME--
  hilight_off
***************************************************************************
*
* SHORT DESCRIPTION--
*   turns off a all highlights in a set of softkey commands
*
* EXTENDED DESCRIPTION--
*   This routine will clear hilighting bits corresponding to a range of
*   given command token values from a set of softkey functions.
*   An integer array "hilite_bitmap" contain the softkey hilighting bits
*   to be cleared.  Integer divide by/modulo 16 is used to get the
*   correct bit in the array corresponding to a command token value.
*
* INPUTS--
*   first = lower limit of the command value set
*   last  = upper limit of the command value set
*
* OUTPUTS--  new hilight bitmap
*
* ROUTINES CALLED--  none
*
* ERROR CONDITIONS AND RECOVERY--
*   first > last --> no bits are read or cleared
*
* NOTES--
*   All hilighting bits corresponding to values from "first" to "last"
*   are all cleared.  Therefore, some thought should be given when
*   arranging softkey command functions in SKINFO.WORK so that sets of
*   particular functions occur contiguously.
*
* AUTHOR--
*
***************************************************************************
*
* INITIAL REFINEMENT--
*   IF command values to be un-hilighted are within range THEN
*     clear corresponding bits in hilight bitmaps
*     update hilighting on display
*
***************************************************************************
*
* REVISION LOG--
*   3/29/83   -- added limit checks to if command values exceed the
*                maximum number of bits available in the hilight bitmap.
*   8/18/83   -- changed hilite_bitmap to a 2 dimensional array,
*                hilite_info to accomodate 2-channel coupled and
*                uncoupled softkey functions that are hilighted.
*                Added a coupled hilighting bitmap (coupled_bitmap) to
*                indicate whether or not a softkey is coupled/uncoupled.
*                Check the coupled bitmap and unhilight softkeys under
*                current entry channel for uncoupled softkeys or
```

```
*                 unhilight softkeys under both channels for coupled
*                 softkeys.
*
****************************************************************************
DECLARATION--
;
PROCEDURE hilight_off (first, last);
  VALUE first, last;  INTEGER first, last;                          ENTRY;
&
$DOC-&

BEGIN
  INTEGER index=REGISTER 6;
  INTEGER x,key_cnt,trash;
  INTEGER POINTER map1,map2;
  BOOLEAN all_coupled;
  IF first > hilite_max THEN
    first := hilite_max;
  IF last > hilite_max THEN
    last := hilite_max;
  index := RIGHT(first,4);                & first/16 to get bitmap index &
  key_cnt := last-first;                  & number of keys in group &
  x := first AND %0F;                     & 1st softkey bit to clear &
  all_coupled := TBIT (coupled_bitmap [index], x);
  IF key_cnt >= 0 THEN                    & clear out hilights for group &
    BEGIN
      DO BEGIN
        IF all_coupled THEN               & point to bitmaps to unhilight&
          BEGIN    & for coupled softkeys &
            STPNTR (map1, ADRS(hilite_info [0,index]));
            STPNTR (map2, ADRS(hilite_info [1,index]));
          END
        ELSE
          BEGIN    & for uncoupled softkeys &
            STPNTR (map1, ADRS(hilite_info[current_entry_ch-1,index]));
            STPNTR (map2, ADRS(trash));
          END;
        DO BEGIN                          & unhilight 1  word at a time  &
          map1 := RBIT (map1, x);
          map2 := RBIT (map2, x);
        END UNTIL ((key_cnt:=key_cnt-1)<0) OR ((x:=x+1)=16);
        x := 0;
        index := index+1;
      END UNTIL (key_cnt < 0);
      highlight_menu;
    END;
   IF menu_debug THEN
    BEGIN
      WSTR("hilite off:"); WHEX(first); WHEX(last); CRLF;
    END;
END hilight_off;
```

```
#EJECT;
COMMENT
$DOC+

NAME--
  hilight_command
*************************************************************************
*
* SHORT DESCRIPTION--
*   sets hilighting corresponding to current command token value
*
* EXTENDED DESCRIPTION--
*   This routine hilights the command value passed as a parameter by
*   setting the corresponding bit in the hilight bitmap and updating
*   the display hilight.
*
* INPUTS--
*   value = softkey function command value to be hilighted
*
* OUTPUTS--  none
*
* ROUTINES CALLED--
*   hilight_menu
*
* ERROR CONDITIONS AND RECOVERY--
*   none
*
* NOTES--
*
* AUTHOR--
*
*************************************************************************
*
* INITIAL REFINEMENT--
*   IF command value is within range THEN
*     set corresonding bit in hilight bitmap
*     update hilight display
*
*************************************************************************
*
* REVISION LOG--
*   3/29/83   -- added hilight bitmap limit check
*   8/18/83   -- changed hilite_bitmap to a 2 dimensional array,
*                hilite_info to accomodate 2-channel coupled and
*                uncoupled softkey functions that are hilighted.
*                Added a coupled hilighting bitmap (coupled_bitmap) to
*                indicate whether or not a softkey is coupled/uncoupled.
*                Check the coupled bitmap and hilight softkey under
*                current entry channel for uncoupled softkey or
*                hilight softkey under both channels for coupled
*                softkey.
*
*************************************************************************
DECLARATION--
;
PROCEDURE hilight_command (value);
```

```
  VALUE value;  INTEGER value;                                    ENTRY;
&
$DOC-&
BEGIN
  INTEGER bit_pos;
  INTEGER POINTER ch1_pos, ch2_pos;
  IF value <= hilite_max THEN
    BEGIN
      menu_hilite := RIGHT (value,4);                       & value DIV 16 &
      bit_pos := %0F AND value;                             & value MOD 16 &
      IF menu_debug THEN
        BEGIN WSTR("hilite cmd:"); WHEX(value); WHEX(menu_hilite);
              WHEX(bit_pos); END;
      STPNTR (ch1_pos, ADRS(hilite_info [0,menu_hilite]));
      STPNTR (ch2_pos, ADRS(hilite_info [1,menu_hilite]));
      IF TBIT (coupled_bitmap[menu_hilite],bit_pos) THEN
        BEGIN           & softkeys are coupled, hilight both channels &
          ch1_pos := SBIT(ch1_pos,bit_pos);
          ch2_pos := SBIT(ch2_pos,bit_pos);
          IF menu_debug THEN WSTR(" coupled");
        END
      ELSE                & softkeys uncoupled, use current entry chan  &
        IF current_entry_ch = ch1 THEN
          ch1_pos := SBIT(ch1_pos, bit_pos)
        ELSE
          ch2_pos := SBIT(ch2_pos, bit_pos);
      highlight_menu;                 & update current highlight display &
    END;
    IF menu_debug THEN CRLF;
END hilight_command;
```

```
#EJECT;
COMMENT
$DOC+

NAME--
  hilight_command_token
*****************************************************************************
*
* SHORT DESCRIPTION--
*   similar to hilight_command
*
* EXTENDED DESCRIPTION--
*   This routine uses hilight_command to hilight a softkey cooresponding
*   to the current command_token value.
*
* INPUTS--   none
*
* OUTPUTS--  none
*
* ROUTINES CALLED--
*   hilight_command
*
* ERROR CONDITIONS AND RECOVERY--
*   none
*
* NOTES--
*
* AUTHOR--
*
*****************************************************************************
*
* INITIAL REFINEMENT--
*   calls hilight_command with command_token as a parameter
*
*****************************************************************************
*
* REVISION LOG--
*
*****************************************************************************
DECLARATION--
;
SUBROUTINE hilight_command_token;                                      ENTRY;
&
$DOC-&

BEGIN
  hilight_command (command_token);
END hilight_command_token;
```

```
#EJECT;
COMMENT
$DOC+
NAME--
  hilight_on
*************************************************************************
*
* SHORT DESCRIPTION--
*   hilights current command token softkey and unhilight a given set of
*   of command values
*
* EXTENDED DESCRIPTION--
*   This routines unhilights the range of given command values and
*   hilights the current command token value corresponding to a
*   softkey function. (In effect, the routines "hilight_off" and
*   "hilight_command_token" are called.)
*
* INPUTS--
*   first = lower limit of command values to unhilight
*   last  = upper limit of command values to unhilight
*
* OUTPUTS--  none
*
* ROUTINES CALLED--
*   hilight_off
*   hilight_command_token
*
* ERROR CONDITIONS AND RECOVERY--
*   none
*
* NOTES--
*
* AUTHOR--
*
*************************************************************************
*
* INITIAL REFINEMENT--
*   Calls hilight_off and hilight_command_token
*
*************************************************************************
*
* REVISION LOG--
*
*************************************************************************
DECLARATION--
;
PROCEDURE hilight_on (first, last);
  VALUE first,last;  INTEGER first,last;                          ENTRY;
&
$DOC-&

BEGIN
  hilight_off (first, last);
  hilight_command_token;
END higlight_on;
```

```
#EJECT;
COMMENT
$DOC+

NAME--
  hilight_key
**************************************************************************
*
* SHORT DESCRIPTION--
*   similar to routine "hilight_on"
*
* EXTENDED DESCRIPTION--
*   This routine is identical to "hilight_on" except that the
*   current command_token value is not used and another command value
*   that is passed as a parameter instead corresponds to the softkey
*   function to be hilighted.
*
* INPUTS--
*   key_pos = softkey command value to be hilighted
*   first   = lower limit of command values to unhilight
*   last    = upper limit of command values to unhilight
*
* OUTPUTS-- none
*
* ROUTINES CALLED--
*   hilight_off
*   hilight_command
*
* ERROR CONDITIONS AND RECOVERY--
*
* NOTES--
*
* AUTHOR--
*
**************************************************************************
*
* INITIAL REFINEMENT--
*   Calls hilight_off and hilight_command
*
**************************************************************************
*
* REVISION LOG--
*
**************************************************************************
DECLARATION--
;
PROCEDURE hilight_key (key_pos, first, last);
  VALUE key_pos, first, last;  INTEGER key_pos, first, last;      ENTRY;
&
$DOC-&

BEGIN
  hilight_off (first, last);
  hilight_command (key_pos);
END hilight_key;
```

```
#EJECT;
COMMENT
$DOC+

NAME--
  gen_menu
******************************************************************************
*
* SHORT DESCRIPTION--
*   displays softkey menu identified by MENU_NUM
*
* EXTENDED DESCRIPTION--
*   Generates a softkey menu, MENU_NUM, whose constant values are found
*   found in #FILE CMENU.WORK.  Updates current MENU_LEVEL (depth) and
*   its corresponding menu number in a menu depth table, INFO_LEVEL.
*   The softkey command code table, KEYCODE is updated with the new
*   menu's command codes found in that menu's information table.
*   When printing softkey label annotations on the display, single line
*   annotations are centered (via half LF char).  Unused softkeys are
*   annotated with a blank (this eliminates any previous menu annotation
*   in that position) and corresponding command codes are set to zero.
*   Menu hilight bitmap is updated using command code hilight bitmap.
*   Menu highlighting is invoked at the end to either eliminate previous
*   highlights or display highlights corresponding to the current menu.
*
* INPUTS--
*   menu_num     = number of softkey menu to be generated
*   level_increm = -n returning to a previous menu n levels up
*                   0 outermost level menu (hardkey generated)
*                   1 bringing up a new menu (softkey generated)
*
* OUTPUTS--
*   softkey menu annotations to dispaly gen.
*
* ROUTINES CALLED--
*   blank_softkey
*   highlight_menu
*   print_string (external)
*   print_ch     (external)
*
* ERROR CONDITIONS AND RECOVERY--
*   Range checking is done for "bogus" MENU_NUM values and attempts to
*   return to previous menus from the outermost level, or bring up new
*   menus exceeding maximum menu depth, MAX_DEPTH.  This can be removed
*   to gain speed when we're sure all calls have valid menu numbers.
*   Invalid menu numbers and trying to return from outer level menus
*   aborts the routine.  Attempts to bring up menus exceeding the
*   maximum depth will store menu information on top of the deepest
*   menu information in LEVEL_INFO.
*
* NOTES--
*   Softkey annotation positioning vectors and display addresses are
*   initialized in SDISPLAY.WORK
*
* AUTHOR--
*
```

```
************************************************************************
*
* INITIAL REFINEMENT--
*   If invalid menu number values and menu depths then
*     Else
*   Update menu level
*   Make entry in menu depth table
*   Using the current menu information table,
*     store command code value in current softkey command code table
*     get number of lines per softkey
*     center annotation if single line softkey
*     print softkey annotations on display
*     update menu hilight bitmap using command code hilight bitmap
*   highlight menu
*
************************************************************************
*
* REVISION LOG--
*  07-27-82:  Added code to right justify all softkey annotations
*  11-28-83:  Added check to prevent generating a menu identical to
*             the outermost menu on the stack.
*
************************************************************************
DECLARATION--
;
PROCEDURE gen_menu (num, level_increm);
VALUE num, level_increm;  INTEGER num, level_increm;              ENTRY;
&
$DOC-&

BEGIN

INTEGER CONSTANT max_lgth := 10;
ALPHA annot;
BYTE POINTER lgth=annot;
INTEGER i,                  & loop control variable to gen softkey menu &
  n1,n2,                    & label index to particular softkey line    &
  line2,                    & index to annotation table for 2nd line    &
  key;                      & softkey count (not 1 to 1 with position)  &
BYTE ch;                    & half_lf or null character &

  key := 1;
  IF NOT ((level_info[menu_level] = num)     & don't gen duplic. menu &
     AND (level_increm <> 0)) THEN
  IF (num >= 0) AND (num < LAST_MENU) THEN    & range check menu no.    &
  IF (menu_level:=menu_level+level_increm) < 0 THEN
    menu_level := 0
  ELSE
  BEGIN
    IF (level_increm = 0) OR NOT menu_on THEN
      menu_level := 0
    ELSE                                      & menu depth range check &
    IF menu_level > max_depth THEN
      menu_level := max_depth;
    menu_on := TRUE;
    STPNTR (menu_ptr, SK_MENU[num]);                & get menu address &
```

```
    level_info[menu_level] := num;                  & current menu no. &
    menu_map := menu_ptr&[0]&;           & highlighting configuration  &
    menu_config := menu_ptr[1];          & number of lines per softkey &
    FOR i := 0 TO 7 DO
    IF (RIGHT(menu_config,2*i) AND %03)>0 THEN
      BEGIN      & fill in keycode table value and print softkey label &
        n1 := 2*((keycode[i]:=menu_ptr[key:=key+1])-1);
        IF (line2:=LBL_INDEX[n1+1])=0 THEN          & center single line &
          ch := half_lf                             & softkey annotation &
        ELSE
          ch := 0;                        & indicates 2 lines in softkey &
        printch (field[i]-1,ch);
      & annot := ADRS(SK_LABEL)+LBL_INDEX[n1]  &
        annot := SK_LABEL[LBL_INDEX[n1]];  & right justify 1st sk line &
        n1 := n2 := 0;
        IF (n1:=lgth&[0]&)>max_lgth OR (n1<0) THEN n1 := max_lgth;
        IF ((lgth[n1] AND %6F) < 8) THEN   & bracket character fix     &
          n1 := n1-1;                      & 10010xxx mask &
        move(field[i]-4,blanks[n1],sk_line1[i]);
        print_string (annot,sk1_size,field[i]);
      & annot := SK_LABEL+line2 &
        annot := SK_LABEL[line2];
        IF ch = 0 THEN                            & right justify 2nd line &
          BEGIN
            IF (n2:=lgth&[0]&)>max_lgth OR (n2<0) THEN n2 := max_lgth;
            IF (lgth[1]=(ch:=half_vt)) THEN     & put half_vt in a byte &
              n2 := n2-1;
            move (field[i+8]-2,blanks[n2],sk_line2[i]);
          END;
        print_string (annot,sk2_size,field[i+8]);
        IF TBIT(menu_map,i+8) THEN
          next_menu[i] := menu_ptr[key:=key+1];
        char_cnt[i] := (IF n1 > n2 THEN n1 ELSE n2);     & longest line &
      END
    ELSE
      blank_softkey(i);
    highlight_menu;
  END;
END gen_menu;
```

```
#EJECT;
COMMENT
$DOC+

NAME--
  process_softkey
**************************************************************************
*
* SHORT DESCRIPTION--
*   extracts command code corresponding to the current softkey function
*
* EXTENDED DESCRIPTION--
*   This routine is called only be command in response to a softkey
*   being pressed on the front panel.  It extracts the command code
*   value corresponding to that softkey position from the current menu,
*   sets the command_pending flag to continue to executing commands off
*   the current command code value, and brings up any menu that is to be
*   generated from that softkey.
*
* INPUTS--
*   softkey position
*
* OUTPUTS--
*   command code value
*   new menu, if any
*
* ROUTINES CALLED--
*   gen_menu
*
* ERROR CONDITIONS AND RECOVERY--
*   softkey position ranges from 1..8 (no range checking done)
*
* NOTES--
*
* AUTHOR--
*
**************************************************************************
*
* INITIAL REFINEMENT--
*   set new command token
*   set command_pending flag
*   if this softkey brings up a new menu then
*     generate it on the display
*
**************************************************************************
*
* REVISION LOG--
*
**************************************************************************
DECLARATION--
;
PROCEDURE process_softkey (num);
VALUE num;  INTEGER num;                                          ENTRY;
&
$DOC-&
```

```
BEGIN
  command_token := keycode[num-1];
  command_pending := TRUE;
  IF TBIT(menu_map,num+7) THEN
    gen_menu(next_menu[num-1],1);
END process_softkey;
```

```
#EJECT;
COMMENT
$DOC+

NAME--
  previous_menu
************************************************************************
*
* SHORT DESCRIPTION--
*   brings up menu previous to current one if one exists, or a blank
*   menu otherwise
*
* EXTENDED DESCRIPTION--
*   This routine is function of the [PREVIOUS] front panel key which
*   returns to the previously displayed menu which brought up the
*   current menu, or toggles (turn off/on) the outermost level menu
*   displays.  Once a menu display is off, the softkeys are no longer
*   activated (that is, they are functionless).
*
* INPUTS--   none
*
* OUTPUTS--  previous or no softkey menu
*
* ROUTINES CALLED--
*   gen_menu
*   kill_softkeys
*   print_string
*
* ERROR CONDITIONS AND RECOVERY--
*   none
*
* NOTES--
*   For outermost level menus with dynamic labels (ie. SAVE/RECALL menu)
*   a special check is thrown in to re-display the dynamic annotations.
*
* AUTHOR--
*
************************************************************************
*
* INITIAL REFINEMENT--
*   If not outermost level menu then
*     generate previous softkey menu which brought it up
*   Else
*   If a menu is current up then
*     blank out current menu (should be outermost menu at this point)
*   Else
*     regenerate outermost level menu
*
************************************************************************
*
* REVISION LOG--
*
************************************************************************
DECLARATION--
;
PROCEDURE previous_menu;                                          ENTRY;
```

```
&
$DOC-&

BEGIN
  #FILE fdatamgr.work;                          & for gen_last_reg_menu &
  INTEGER prior_menu;
  IF (menu_level = 0) AND (menu_on) THEN
    kill_softkeys
  ELSE
  IF menu_level >= 0 THEN
    BEGIN
      prior_menu := level_info [IF menu_level > 0 THEN
                                    menu_level-1
                                  ELSE
                                    menu_level];
      IF prior_menu = REG_MENU THEN
        gen_last_reg_menu
      ELSE
        gen_menu (prior_menu, (IF menu_level > 0 THEN -1 ELSE 0));
    END;
END previous_menu;
```

```
#EJECT;
COMMENT
$DOC+

NAME--
  pop_menu
******************************************************************************
*
* SHORT DESCRIPTION--
*   pop to given menu number within current softkey menu stack
*
* EXTENDED DESCRIPTION--
*   This routine gives the flexibility of popping to an arbitrary menu
*   from within the current menu stack w/o having to know how many
*   menu levels to back up to.  The current menu stack is scanned from
*   the most recent menu level to the outermost menu level until the
*   requested menu (MENU_NUM) is found.  A requested menu not found
*   within the menu stack becomes the outermost menu.  The menu stack
*   and related menu variables are automatically updated during the
*   menu search prior to displaying the requested menu.
*
* INPUTS--   menu_num = menu number to pop to
*
* OUTPUTS--  new softkey menu on display
*
* ROUTINES CALLED--
*   gen_menu
*
* ERROR CONDITIONS AND RECOVERY--
*   none
*
* NOTES--
*   This routine will only generate previous menus displayed before the
*   current one.
*
* AUTHOR--
*
******************************************************************************
*
* INITIAL REFINEMENT--
*   IF current menu level > 0 THEN
*     scan previous menus and update menu stack pointer until
*       the requested menu number is found in the stack
*       or menu stack pointer points to the outermost menu
*     generate requested menu
*
******************************************************************************
*
* REVISION LOG--
*
******************************************************************************
DECLARATION--
;
PROCEDURE pop_menu (menu_num);
  VALUE menu_num;  INTEGER menu_num;                                ENTRY;
&
```

```
$DOC-&

BEGIN
  INTEGER pop_cnt,
          menu_position=REGISTER 6;
  IF menu_level > 0 THEN
    BEGIN
      pop_cnt := 0;
      menu_position := menu_level;
      DO  pop_cnt := pop_cnt-1
      UNTIL
        (menu_num = level_info [menu_position:=menu_position-1])  OR
        (menu_position = 0);
      IF (level_info[menu_position] = menu_num) THEN
        gen_menu (menu_num, pop_cnt);
    END;
END pop_menu;


END$
```

```
#FILE cscreen2.work;         & soft-key and menu character constants &

INTEGER CONSTANT
   longest_function_label := 26,
   words_per_ch    := 28,                  & see character set    &
                                           & statistics, 6 Oct 83 &
   ch1_annot_col   := 3,                       & screen positions &
   ch2_annot_col   := 28,
   title_row       := 5,
   title_col       := ch1_annot_col,
   error_row       := 6,
   error_col       := 4,
   function_row    := 8,
   function_col    := 4,
   entry_row       := 9,
   entry_col       := 6,
   entry_aux_row   := 10,
   entry_aux_col   := ch1_annot_col,
   xgrat           := 128,                       & for graticule &
   ygrat           := 384,                       & for graticule &
   max_grat        := 3200,                      & for graticule &
   enhancement_col:= 1,
   dirty_row       := 6,
   correction_row  := 7,
   averaging_row   := 8,
   smoothing_row   := 9,
   gating_row      := 10,
   math_row        := 11,
   delay_row       := 12,
   external_row    := 13,
   offset_row      := 14,
   sk_x            := 3424,                & soft key coordinates &
   sk11_y          := 3966,
   sk12_y          := 3838,
   sk21_y          := 3418,
   sk22_y          := 3290,
   sk31_y          := 2870,
   sk32_y          := 2742,
   sk41_y          := 2322,
   sk42_y          := 2194,
   sk51_y          := 1774,
   sk52_y          := 1646,
   sk61_y          := 1226,
   sk62_y          := 1098,
   sk71_y          := 678,
   sk72_y          := 550,
   sk81_y          := 130,
   sk82_y          := 2,
   trace1_x        := xgrat,
   trace1_y        := ygrat + max_grat/2,
   trace1m_x       := xgrat,
   trace1m_y       := ygrat + max_grat/2,
   trace2_x        := xgrat,
   trace2_y        := ygrat + max_grat/2,
   trace2m_x       := xgrat,
```

```
    trace2m_y        := ygrat + max_grat/2,
    param_row        := 1,
    param1_col       := ch1_annot_col,
    param2_col       := ch2_annot_col,
    format1_col      := ch1_annot_col + 11,
    format2_col      := ch2_annot_col + 11,
    ref_row          := 2,
    ref1_col         := ch1_annot_col,
    ref2_col         := ch2_annot_col,
    scale_row        := 3,
    scale1_col       := ref1_col + 4,
    scale2_col       := ref2_col + 4,
    mkr_row          := 4,
    mkr1_col         := ch1_annot_col,
    mkr1_real_col    := mkr1_col + 2,
    mkr1_imag_col    := mkr1_col + 13,
    mkr2_col         := ch2_annot_col,
    mkr2_real_col    := mkr2_col + 2,
    mkr2_imag_col    := mkr2_col + 13,
    mkr_stim_row     := 30,
    mkr1_stim_col    := ch1_annot_col,
    mkr2_stim_col    := ch2_annot_col,
    start_row        := 31,
    start_col        := (ch1_annot_col+ch2_annot_col)/2,
    start1_col       := ch1_annot_col,
    start2_col       := ch2_annot_col,
    stop_row         := 32,
    stop_col         := start_col,
    stop1_col        := start1_col,
    stop2_col        := start2_col,


& display block allocations. &

    start_display := 0,
    start_size    := 10,                    & fixed by "init_screen" &

& error &
    error_position := start_display + start_size,
    error_display  := error_position + 4,
    error_size     := 48,

& title &
    title_position := error_display + error_size,
    title_display  := title_position + 4,
    title_size     := 50,                   & change also schdata &

& blank screen &
    blank_screen      := title_display + title_size,

& function &
    function_position := blank_screen + 1,
    function_display  := function_position + 4,
    function_string_size := longest_function_label,
    function_size     := function_string_size *
```

```
   words_per_ch,

& text (overlays function) &
   text_position     := function_position,
   text_display      := function_display,
   text_size         := function_size,

& entry &
   entry_position    := function_display + function_size,
   entry_display     := entry_position + 4,
   entry_string_size := 20,
   entry_size        := entry_string_size * words_per_ch,
   entry2_position   := entry_display + entry_size,
   entry2_display    := entry2_position + 4,

& entry_aux &
   entry_aux_position := entry2_display + entry_size,
   entry_aux_display  := entry_aux_position + 4,
   entry_aux_size     := title_size + 4,     & title is longest use.   &
                                             & 4 extra for title arrow &
& enhancement annotation &
   dirty_position       := entry_aux_display + entry_aux_size,
   dirty_display        := dirty_position + 4,
   enhancement_size     := 1,
   gating_position      := dirty_display + enhancement_size,
   gating_display       := gating_position + 2,
   correction_position  := gating_display + enhancement_size,
   correction_display   := correction_position + 2,
   averaging_position   := correction_display + enhancement_size,
   averaging_display    := averaging_position + 2,
   smoothing_position   := averaging_display + enhancement_size,
   smoothing_display    := smoothing_position + 2,
   delay_position       := smoothing_display + enhancement_size,
   delay_display        := delay_position + 2,
   math_position        := delay_display + enhancement_size,
   math_display         := math_position + 2,
   external_position    := math_display + enhancement_size,
   external_display     := external_position + 2,
   offset_position      := external_display + enhancement_size,
   offset_display       := offset_position + 2,

& sk11 &
   sk11_position := offset_display + enhancement_size,
   sk11_display  := sk11_position + 6,
   sk1_size      := 11,              & sk2_size + 1 for sk_bracket_n &
& sk12 &
   sk12_position := sk11_display + sk1_size,
   sk12_display  := sk12_position + 4,
   sk2_size      := 10,                        & must be even # bytes &
& sk21 &
   sk21_position := sk12_display + sk2_size,
   sk21_display  := sk21_position + 6,
& sk22 &
   sk22_position := sk21_display + sk1_size,
   sk22_display  := sk22_position + 4,
& sk31 &
```

```
    sk31_position := sk22_display + sk2_size,
    sk31_display  := sk31_position + 6,
 & sk32 &
    sk32_position := sk31_display + sk1_size,
    sk32_display  := sk32_position + 4,
 & sk41 &
    sk41_position := sk32_display + sk2_size,
    sk41_display  := sk41_position + 6,
 & sk42 &
    sk42_position := sk41_display + sk1_size,
    sk42_display  := sk42_position + 4,
 & sk51 &
    sk51_position := sk42_display + sk2_size,
    sk51_display  := sk51_position + 6,
 & sk52 &
    sk52_position := sk51_display + sk1_size,
    sk52_display  := sk52_position + 4,
 & sk61 &
    sk61_position := sk52_display + sk2_size,
    sk61_display  := sk61_position + 6,
 & sk62 &
    sk62_position := sk61_display + sk1_size,
    sk62_display  := sk62_position + 4,
 & sk71 &
    sk71_position := sk62_display + sk2_size,
    sk71_display  := sk71_position + 6,
 & sk72 &
    sk72_position := sk71_display + sk1_size,
    sk72_display  := sk72_position + 4,
 & sk81 &
    sk81_position := sk72_display + sk2_size,
    sk81_display  := sk81_position + 6,
 & sk82 &
    sk82_position := sk81_display + sk1_size,
    sk82_display  := sk82_position + 4,
 & sk_highlight &
    sk_hilight_off := sk82_display + sk2_size,

    sk_highlight_position := sk_hilight_off + 1,
    sk_highlight_display  := sk_highlight_position + 4,
    sk_highlight_size     := 30,

 & hop skip and jump &
    jump_all := sk_highlight_display + sk_highlight_size,

 & CHANNEL 1 &
    channel1_position := jump_all + 1,

 & jump over channel 1 &
    jump_channel1 := channel1_position,

 & trace update mark &
    update_mark1_position := jump_channel1 + 1,
    update_mark1_display  := update_mark1_position + 4,
    update_mark_size      := 6,
```

```
& traces &
   trace1_position := update_mark1_display + update_mark_size,
   trace1_display  := trace1_position + 4,
   trace_size      := 810,

& trace id mark &
   trace_mark1_position := trace1_display + trace_size,
   trace_mark1_display  := trace_mark1_position + 4,
   trace_mark_size      := 9,

& end trace 1 &
   end_trace1 := trace_mark1_display + trace_mark_size,

& memory trace &
   trace1m_position := end_trace1,
   trace1m_display  := trace1m_position + 4,

& marker 1 &
   mkr11_position := trace1m_display + trace_size,
   mkr11_display  := mkr11_position + 4,
   mkr_size       := 7,

& marker 2 &
   mkr12_position := mkr11_display + mkr_size,
   mkr12_display  := mkr12_position + 4,

& marker 3 &
   mkr13_position := mkr12_display + mkr_size,
   mkr13_display  := mkr13_position + 4,

& marker 4 &
   mkr14_position := mkr13_display + mkr_size,
   mkr14_display  := mkr14_position + 4,

& marker 5 &
   mkr15_position := mkr14_display + mkr_size,
   mkr15_display  := mkr15_position + 4,

& marker 6 - gate start &
   mkr16_position := mkr15_display + mkr_size,
   mkr16_display  := mkr16_position + 4,

& marker 7 - gate center &
   mkr17_position := mkr16_display + mkr_size,
   mkr17_display  := mkr17_position + 4,

& marker 8 - gate stop &
   mkr18_position := mkr17_display + mkr_size,
   mkr18_display  := mkr18_position + 4,

& channel 1 graticule &
   graticule1_position := mkr18_display + mkr_size,
   graticule1_display  := graticule1_position + 4,
   graticule_size      := 2000,

& channel 1 reference line &
```

```
   ref_line1_position := graticule1_display + graticule_size,
   ref_line1_display  := ref_line1_position + 4,
   ref_line_size      := 10,

   hilight_ch1 := ref_line1_display + ref_line_size,

& parameter 1 &
   param1_position := hilight_ch1 + 1,
   param1_display  := param1_position + 4,
   param_size      := 8,

& math 1 &
& no position vectors -- follows param1 immediately &
   math1_display  := param1_display + param_size,
   math_size      := 8,

& format 1 &
   format1_position:= math1_display + math_size,
   format1_display := format1_position + 4,
   format_size     := 9,

& reference value label 1 &
   ref1_label_position := format1_display + format_size,
   ref1_label_display  := ref1_label_position + 4,
   ref_label_size      := 4,

& reference value 1 &
& no position vectors -- follows ref1_label immediately &
   ref1_display := ref1_label_display + ref_label_size,
   ref_size     := 14,

& reference suffix 1 &
& no position vectors -- follows ref1 immediately &
   ref1_suffix_display := ref1_display + ref_size,
   ref_suffix_size     := 6,

& scale/div 1 &
   scale1_position := ref1_suffix_display + ref_suffix_size,
   scale1_display  := scale1_position + 4,
   scale_size      := 13,

& scale suffix 1 &
& no position vectors -- follows scale1 immediately &
   scale1_suffix_display := scale1_display + scale_size,
   scale_suffix_size     := 7,

& marker value label 1 &
   mkr1_label_position := scale1_suffix_display + scale_suffix_size,
   mkr1_label_display  := mkr1_label_position + 4,
   mkr_label_size      := 6,

& marker real value 1 &
   mkr1_real_position := mkr1_label_display + mkr_label_size,
   mkr1_real_display := mkr1_real_position + 4,
   mkr_display_size  := 15,
```

```
& marker imag value 1 &
   mkr1_imag_position := mkr1_real_display + mkr_display_size,
   mkr1_imag_display  := mkr1_imag_position + 4,

& marker stimulus value 1 &
   mkr1_stim_position := mkr1_imag_display + mkr_display_size,
   mkr1_stim_display  := mkr1_stim_position + 4,
   stim_size          := 15,

& marker stimulus suffix suffix 1 &
& no position vectore -- follows mkr1_stim_display immediately &
   mkr1_stim_suffix_display := mkr1_stim_display + stim_size,
   stim_suffix_size         := 5,

& start/center mode 1 &
   start1_mode_position := mkr1_stim_suffix_display + stim_suffix_size,
   start1_mode_display  := start1_mode_position + 4,
   stim_mode_size       := 6,

& start/center 1 &
& no position vectors -- follows start1_mode immediately &
   start1_display  := start1_mode_display + stim_mode_size,

& start/center suffix 1 &
& no position vectore -- follows start1_display immediately &
   start1_suffix_display := start1_display + stim_size,

& stop/span mode 1 &
   stop1_mode_position := start1_suffix_display + stim_suffix_size,
   stop1_mode_display  := stop1_mode_position + 4,

& stop/span 1 &
& no position vectors -- follows stop1_mode immediately &
   stop1_display  := stop1_mode_display + stim_mode_size,

& stop/span suffix 1 &
& no position vectore -- follows stop1_display immediately &
   stop1_suffix_display := stop1_display + stim_size,

   hilight_ch1_off := stop1_suffix_display + stim_suffix_size,

& end of channel 1 &
   end_ch1_position := hilight_ch1_off + 1,

& CHANNEL 2 &                 & size constants are same as channel 1 &
   channel2_position := end_ch1_position,

& jump over channel 2 &
   jump_channel2 := channel2_position,

& trace update mark &
   update_mark2_position := jump_channel2 + 1,
   update_mark2_display  := update_mark2_position + 4,

& traces &
   trace2_position := update_mark2_display + update_mark_size,
```

```
   trace2_display  := trace2_position + 4,

& trace id mark -- no position vector, uses last trace point &
   trace_mark2_display  := trace2_display + trace_size,

   end_trace2           := trace_mark2_display + trace_mark_size,

& memory trace &
   trace2m_position := end_trace2,
   trace2m_display  := trace2m_position + 4,

& marker 1 &
   mkr21_position := trace2m_display + trace_size,
   mkr21_display  := mkr21_position + 4,

& marker 2 &
   mkr22_position := mkr21_display + mkr_size,
   mkr22_display  := mkr22_position + 4,

& marker 3 &
   mkr23_position := mkr22_display + mkr_size,
   mkr23_display  := mkr23_position + 4,

& marker 4 &
   mkr24_position := mkr23_display + mkr_size,
   mkr24_display  := mkr24_position + 4,

& marker 5 &
   mkr25_position := mkr24_display + mkr_size,
   mkr25_display  := mkr25_position + 4,

& marker 6 - gate start &
   mkr26_position := mkr25_display + mkr_size,
   mkr26_display  := mkr26_position + 4,

& marker 7 - gate center &
   mkr27_position := mkr26_display + mkr_size,
   mkr27_display  := mkr27_position + 4,

& marker 8 - gate stop &
   mkr28_position := mkr27_display + mkr_size,
   mkr28_display  := mkr28_position + 4,

& channel 2 graticule &
   graticule2_position := mkr28_display + mkr_size,
   graticule2_display  := graticule2_position + 4,

& channel 2 reference line &
   ref_line2_position := graticule2_display + graticule_size,
   ref_line2_display  := ref_line2_position + 4,

   hilight_ch2 := ref_line2_display + ref_line_size,

& parameter 2 &
   param2_position := hilight_ch2 + 1,
   param2_display  := param2_position + 4,
```

```
& math 2 &
& no position vectors -- follows param2 immediately &
   math2_display  := param2_display + param_size,

& format 2 &
   format2_position:= math2_display + math_size,
   format2_display := format2_position + 4,

& refence value label 2 &
   ref2_label_position := format2_display + format_size,
   ref2_label_display  := ref2_label_position + 4,

& reference value 2 &
& no position vectors -- follows ref2_label immediately &
   ref2_display := ref2_label_display + ref_label_size,

& reference suffix 2 &
& no position vectors -- follows ref2 immediately &
   ref2_suffix_display := ref2_display + ref_size,

& scale/div 2 &
   scale2_position := ref2_suffix_display + ref_suffix_size,
   scale2_display  := scale2_position + 4,

& scale suffix 2 &
& no position vectors -- follows scale2 immediately &
   scale2_suffix_display := scale2_display + scale_size,

& marker value label 2 &
   mkr2_label_position := scale2_suffix_display + scale_suffix_size,
   mkr2_label_display  := mkr2_label_position + 4,

& marker real value 2 &
   mkr2_real_position := mkr2_label_display + mkr_label_size,
   mkr2_real_display := mkr2_real_position + 4,

& marker imag value 2 &
   mkr2_imag_position := mkr2_real_display + mkr_display_size,
   mkr2_imag_display  := mkr2_imag_position + 4,

& marker stimulus value 2 &
   mkr2_stim_position := mkr2_imag_display + mkr_display_size,
   mkr2_stim_display  := mkr2_stim_position + 4,

& marker stimulus suffix suffix 2 &
& no position vectore -- follows mkr2_stim_display immediately &
   mkr2_stim_suffix_display := mkr2_stim_display + stim_size,

& start/center mode 2 &
   start2_mode_position := mkr2_stim_suffix_display + stim_suffix_size,
   start2_mode_display  := start2_mode_position + 4,

& start/center 2 &
& no position vectors -- follows start2_mode immediately &
   start2_display  := start2_mode_display + stim_mode_size,
```

```
& start/center suffix 2 &
& no position vectore -- follows start2_display immediately &
   start2_suffix_display := start2_display + stim_size,

& stop/span mode 2 &
   stop2_mode_position := start2_suffix_display + stim_suffix_size,
   stop2_mode_display  := stop2_mode_position + 4,

& stop/span 2 &
& no position vectors -- follows stop2_mode immediately &
   stop2_display  := stop2_mode_display + stim_mode_size,

& stop/span suffix 2 &
& no position vectore -- follows stop2_display immediately &
   stop2_suffix_display := stop2_display + stim_size,

   hilight_ch2_off := stop2_suffix_display + stim_suffix_size,

& end of channel 2 &
   end_ch2_position := hilight_ch2_off + 1,

& update raw marks &
   update_raw_position := end_ch2_position,
   update_raw_display  := update_raw_position + 4,
   update_raw_size      := 3,

& user display &
   user_display := update_raw_display + update_raw_size,

& end position &
   end_position  := %2FFF,

& character set &
   character_set := %3000;
```

```
#EJECT;
COMMENT
$DOC+

NAME--
  skey
**************************************************************************
*
* SHORT DESCRIPTION--
*   contains tables which configure softkey menus
*
* EXTENDED DESCRIPTION--
*   This is a seperately compiled module which contains the following
*   tables of information used to generated softkey menus:
*
*     - softkey menu tables, SKS0..SKSn (where n=number of menus)
*     - table of addresses to softkey menu configuration tables
*     - table of softkey annotations
*     - table of indices to table of softkey annotations
*       (indexed by command code value of each softkey)
*
*   These tables are generated by a pre-processor which uses an input
*   file containing the actual softkey menu information in a modifiable
*   and picturesque format.
*
* INPUTS--
*   none
*
* OUTPUTS--
*   none
*
* ROUTINES CALLED--
*   none
*
* ERROR CONDITIONS AND RECOVERY--
*   none
*
* NOTES--
*   Any changes to be made in these tables must be made in the input
*   file (SKINFO) to the program (GENSK) which generates these tables.
*
* AUTHOR--
*
**************************************************************************
*
* INITIAL REFINEMENT--
*   NA
*
**************************************************************************
*
* REVISION LOG--
*
**************************************************************************
DECLARATION--
  INTEGER TABLE SKS0..SKSn
  DOUBLE TABLE MENU
```

```
                    INTEGER TABLE LBL_INDEX
                    ALPHA TABLE SK_LABEL

                  $DOC-;


#EJECT;
COMMENT
$DOC+

NAME--
  SKS0..SKSn
*************************************************************************
*
* SHORT DESCRIPTION--
*   Tables of softkey menu configuration
*
* EXTENDED DESCRIPTION--
*   Each menu table is variable in length depending on the number of
*   softkeys per menu and how many of those softkeys bring up other
*   menus.  The tables are configured as follows:
*
*      +-----------------------------------+
*      | B15 | B14 | B13 |....| B2 | B1 | B0 | softkey position bitmap
*      +-----------------------------------+
*      | B15 | .... | B8  |   not used      | "next menu" bitmap
*      +-----------------------------------+
*      |  softkey command token value       |
*      +-----------------------------------+
*      |  "next menu" number based on bitmap |
*      +-----------------------------------+
*                        :
*                        :
*      +-----------------------------------+
*      |  softkey command token value       | up to 8 possible softkeys
*      +-----------------------------------+
*      |  "next menu" number based on bitmap | up to 8 "next menu" ptrs
*      +-----------------------------------+
*
*   The first word of each table contains 8 bit pairs (B0/B1..B14/B15)
*   corresponding to 8 softkey positions on the display (top to bottom).
*   Each pair of bits can contain a value indicating the following:
*      0 = no active softkey in this softkey position
*      1 = active softkey containing 1 line of annotation
*      2 = active softkey containing 2 lines of annotation
*
*   The most significant byte (B8..B15) of the second word contains a
*   bitmap where each set bit corresponds to softkeys which bring up
*   another menu.  The least significant byte of this word is not used
*   as part of the configuration.
*
*   The rest of the words in each table are command token values
*   corresponding to each active softkey as they occur in the softkey
*   position bitmap.  These words are followed by softkey menu numbers
*   only if the "next menu" bitmap indicates another menu is to be
*   brought up by that softkey.
*
* INPUTS--
*   none
*
* OUTPUTS--
*   none
```

```
*
* ROUTINES CALLED--
*   none
*
* ERROR CONDITIONS AND RECOVERY--
*   none
*
* NOTES--
*
* AUTHOR--
*
*************************************************************************
*
* INITIAL REFINEMENT--
*   NA
*
*************************************************************************
*
* REVISION LOG--
*
*************************************************************************

DECLARATION--

  INTEGER TABLE SKS0
          :
          :
  INTEGER TABLE SKSn

$DOC-;
```

```
#EJECT;
COMMENT
$DOC+

NAME--
  SK_MENU
**********************************************************************
*
* SHORT DESCRIPTION--
*   Table of softkey menu addresses
*
* EXTENDED DESCRIPTION--
*   This table contains the addresses of each softkey menu configuration
*   table.  Each menu configuration is identified by an integer constant
*   which is used an an index into this table in order to access the
*   corresponding address for that menu.
*
* INPUTS--
*   none
*
* OUTPUTS--
*   none
*
* ROUTINES CALLED--
*   none
*
* ERROR CONDITIONS AND RECOVERY--
*   none
*
* NOTES--
*
* AUTHOR--
*
**********************************************************************
*
* INITIAL REFINEMENT--
*   NA
*
**********************************************************************
*
* REVISION LOG--
*
**********************************************************************

DECLARATION--

  DOUBLE TABLE SK_MENU

$DOC-;
```

```
#EJECT;
COMMENT
$DOC+

NAME--
  SK_LABEL
*************************************************************************
*
* SHORT DESCRIPTION--
*   Table of softkey annotations
*
* EXTENDED DESCRIPTION--
*   This table contains strings from 1 to 10 characters long which are
*   used to label softkeys.  Each string is unique and occurs only once
*   in this table.  Softkeys which share common strings or simply have
*   unique strings use this table to look up the labels needed to
*   display the annotated menu.
*
*   The table is indexed using a pair of values from another table.
*   These values index the strings which correspond to the first and
*   second line (if any) of each softkey function.
*
* INPUTS--
*   none
*
* OUTPUTS--
*   none
*
* ROUTINES CALLED--
*   none
*
* ERROR CONDITIONS AND RECOVERY--
*   none
*
* NOTES--
*
* AUTHOR--
*
*************************************************************************
*
* INITIAL REFINEMENT--
*   NA
*
*************************************************************************
*
* REVISION LOG--
*
*************************************************************************
DECLARATION--

  GLOBAL ALPHA TABLE SK_LABEL

$DOC-;
```

```
#EJECT;
COMMENT
$DOC+

NAME--
  LBL_INDEX
*************************************************************************
*
* SHORT DESCRIPTION--
*   Table of indices to table of softkey labels
*
* EXTENDED DESCRIPTION--
*   This table contain indices which occur in pairs used to index the
*   table of softkey labels (SK_LABEL) in order to access the first and
*   second line (if any) of each softkey.  If a softkey contains only
*   one line, then the second index of the index pair will be 0 (which
*   indexes a blank line).
*
*   The index pairs are arranged in order of softkey command token
*   values.  This enables a command token value multiplied by 2 to
*   to index into the location of an index pair.
*
* INPUTS--
*   none
*
* OUTPUTS--
*   none
*
* ROUTINES CALLED--
*   none
*
* ERROR CONDITIONS AND RECOVERY--
*   none
*
* NOTES--
*
* AUTHOR--
*
*************************************************************************
*
* INITIAL REFINEMENT--
*   NA
*
*************************************************************************
*
* REVISION LOG--
*
*************************************************************************

DECLARATION--

  GLOBAL INTEGER TABLE LBL_INDEX

$DOC-;
```

```
M68KL,P,"skey" BEGIN

#FILE cmenu.work;
#FILE cscreen.work;
COMMENT
  Configures bit pairs to correspond to softkeys that are used.
  SKnm = softkey position n contains m lines.
  BSKn = softkey position n that brings up another menu
  n    = 1..8
  m    = 0..2
;
INTEGER CONSTANT
  SK11 := 1,
  SK12 := 2,
  SK13 := 3,
  SK21 := 4,
  SK22 := 8,
  SK23 := %C,
  SK31 := %10,
  SK32 := %20,
  SK33 := %30,
  SK41 := %40,
  SK42 := %80,
  SK43 := %C0,
  SK51 := %100,
  SK52 := %200,
  SK53 := %300,
  SK61 := %400,
  SK62 := %800,
  SK63 := %C00,
  SK71 := %1000,
  SK72 := %2000,
  SK73 := %3000,
  SK81 := %4000,
  SK82 := %8000,
  SK83 := %C000,
  BSK1 := %100,
  BSK2 := %200,
  BSK3 := %400,
  BSK4 := %800,
  BSK5 := %1000,
  BSK6 := %2000,
  BSK7 := %4000,
  BSK8 := %8000;
COMMENT
       The rest of this file is software generated by GENSK.LANI,
       Any changes must be made to the input file, SKINFO.WORK.
       ******************************************************************
       The following are softkey menu tables configured as follows:
         word 1 = MSByte: corresponding keys that bring up new menus
                  LSByte: menu's highlight bitmap
         word 2 = menu configuration using constants SKnm
         word 3 = keycode number corresponding to softkeys used
          etc.
         word N = up to 10 keycode values
```

```
;
INTEGER TABLE SKS0 :=        & TAPE_MENU &
BSK8+0,
SK11+SK21+SK31+SK41+SK51+SK82+0,
  1,   & "DIRECTORY"   &
  2,   & "STORE"   &
  3,   & "LOAD"   &
  4,   & "DELETE"   &
  5,   & "UN-DELETE"   &
  6,   & "INITIALIZE" "TAPE" &
INIT_TAPE_MENU;


INTEGER TABLE SKS1 :=        & INIT_TAPE_MENU &
0,
SK12+SK21+0,
  7,   & "INIT TAPE?" "YES" &
  8;   & "NO"   &


INTEGER TABLE SKS2 :=        & DIRECTORY_MENU &
0,
SK12+SK42+SK52+SK72+SK82+0,
  9,   & "RESTORE" "DISPLAY" &
 10,   & "NEXT" "PAGE" &
 11,   & "PREVIOUS" "PAGE" &
 12,   & "FIRST" "PAGE" &
 13;   & "LAST" "PAGE" &


INTEGER TABLE SKS3 :=        & DATA2_MENU &
0,
SK12+SK21+SK32+SK52+SK82+0,
 14,   & "RAW" "DATA" &
 15,   & "DATA"   &
 16,   & "FORMATTED" "DATA" &
 17,   & "USER" "DISPLAY" &
 18;   & "MACHINE" "DUMP" &


INTEGER TABLE SKS4 :=        & DATA1_MENU &
BSK8+0,
SK12+SK22+SK32+SK42+SK51+SK62+SK71+SK81+0,
 19,   & "INSTRUMENT" "STATE" &
 20,   & "INSTRUMENT" "STATES 1-5" &
 21,   & "MEMORY" "TRACE" &
 22,   & "MEMORY" "TRACES 1-4" &
 23,   & "CAL SET"   &
 24,   & "CAL SETS" "1-8" &
 25,   & "CAL KIT"   &
 26,   & "MORE"   &
DATA2_MENU;


INTEGER TABLE SKS5 :=        & ABORT_MENU &
0,
```

```
SK11+0,
 27;   & "ABORT"   &

INTEGER TABLE SKS6 :=        & FILE_MENU &
0,
SK12+SK22+SK32+SK42+SK52+SK62+SK72+SK82+0,
 28,   & "DATA TYPE " "* FILE 1" &
 29,   & " " "* FILE 2" &
 30,   & " " "* FILE 3" &
 31,   & " " "* FILE 4" &
 32,   & " " "* FILE 5" &
 33,   & " " "* FILE 6" &
 34,   & " " "* FILE 7" &
 35;   & " " "* FILE 8" &

INTEGER TABLE SKS7 :=        & REG_MENU &
0,
SK12+SK22+SK32+SK42+SK52+SK62+SK72+SK82+0,
 36,   & "DATA TYPE " "* 1 " &
 37,   & " " "* 2 " &
 38,   & " " "* 3 " &
 39,   & " " "* 4 " &
 40,   & "(POWER UP)" "* 5 " &
 41,   & " " "* 6 " &
 42,   & " " "* 7 " &
 43;   & " " "LAST STATE" &

INTEGER TABLE SKS8 :=        & RESPONSE_MENU &
0,
SK12+SK21+SK32+SK42+SK52+SK61+SK72+SK81+0,
 44,   & "ELECTRICAL"+sk_bracket_2 "DELAY" &
 45,   & "AUTO DELAY"   &
 46,   & "PHASE" "OFFSET" &
 47,   & "MAGNITUDE" "OFFSET" &
 48,   & "AVERAGING"+sk_bracket_2 "ON/RESTART" &
 49,   & "OFF"   &
 50,   & "SMOOTHING"+sk_bracket_2 "ON " &
 51;   & "OFF"   &

INTEGER TABLE SKS9 :=        & IF_GAIN_MENU &
BSK1+BSK2+0,
SK12+SK22+0,
 52,   & "TEST"+sk_bracket_2 "AMP. GAIN" &
IF_GAIN_MENU2,
 53,   & "REFERENCE" "AMP. GAIN" &
IF_GAIN_MENU2;

INTEGER TABLE SKS10 :=        & IF_GAIN_MENU2 &
0,
SK12+SK21+SK31+SK41+SK51+SK61+0,
 54,   & "GAIN"+sk_bracket_6 "0 (MIN.)" &
```

```
 55,   & " 1 "   &
 56,   & " 2 "   &
 57,   & " 3 "   &
 58,   & "4 (MAX.)"   &
 59;   & "AUTO"   &


INTEGER TABLE SKS11 :=        & STIMULUS_MENU &
BSK1+BSK3+BSK8+0,
SK12+SK22+SK32+SK52+SK61+SK71+SK81+0,
 60,   & "POWER" "MENU" &
POWER_MENU,
 61,   & "SWEEP" "TIME" &
 62,   & "NUMBER of" "POINTS" &
N_POINTS_MENU,
 63,   & "SINGLE"+sk_bracket_3 "POINT" &
 64,   & "RAMP"   &
 65,   & "STEP"   &
 26,   & "MORE"   &
STIMULUS2_MENU;


INTEGER TABLE SKS12 :=        & N_POINTS_MENU &
0,
SK12+SK21+SK31+SK41+0,
 66,   & "POINTS:"+sk_bracket_4 "51 " &
 67,   & "101"   &
 68,   & "201"   &
 69;   & "401"   &


INTEGER TABLE SKS13 :=        & POWER_MENU &
0,
SK11+SK32+SK41+SK62+SK71+0,
 70,   & "POWER"   &
 71,   & "SLOPE"+sk_bracket_2 "ON " &
 72,   & "OFF"   &
 73,   & "ATTENUATOR"+sk_bracket_2 "PORT 1" &
 74;   & "PORT 2"   &


INTEGER TABLE SKS14 :=        & STIMULUS2_MENU &
0,
SK11+SK21+SK32+SK41+SK52+SK71+SK81+0,
 75,   & sk_bracket_4 half_vt+"HOLD" &
 76,   & "SINGLE"   &
 77,   & "NUMBER of" "GROUPS" &
 78,   & "CONTINUAL"   &
 79,   & "STIMULUS" "OFFSET" &
 80,   & sk_bracket_2 half_vt+"Ch1 = Ch2" &
 81;   & "Ch1 "+163+" Ch2"   &


INTEGER TABLE SKS15 :=        & DEVICE_READY_MENU &
0,
SK22+0,
```

```
 82;   & "PRESS TO" "CONTINUE" &

INTEGER TABLE SKS16 :=        & PARAM_MENU &
BSK7+0,
SK11+SK21+SK31+SK41+SK72+0,
 83,   & "a"+177+sk_bracket_4   &
 84,   & "b"+178   &
 85,   & "a"+178   &
 86,   & "b"+177   &
 87,   & "REDEFINE" "PARAMETER" &
REDEF_MENU;

INTEGER TABLE SKS17 :=        & REDEF_MENU &
BSK1+BSK2+BSK3+BSK4+BSK5+0,
SK12+SK21+SK31+SK42+SK51+SK62+SK82+0,
 88,   & "REDEFINE"+sk_bracket_6 "DRIVE" &
REDEF_DRIVE_MENU,
 89,   & "PHASE LOCK"   &
REDEF_LOCK_MENU,
 90,   & "NUMERATOR"   &
REDEF_NUM_MENU,
 91,   & "DENOMI-" "NATOR" &
REDEF_DENOM_MENU,
 92,   & "CONVERSION"   &
REDEF_CONV_MENU,
 93,   & "PARAMETER" "LABEL" &
 94;   & "REDEFINE" "DONE" &

INTEGER TABLE SKS18 :=        & REDEF_DRIVE_MENU &
0,
SK12+SK21+SK31+0,
 95,   & "DRIVE"+sk_bracket_3 "PORT 1" &
 96,   & "PORT 2"   &
 97;   & "NONE"   &

INTEGER TABLE SKS19 :=        & REDEF_LOCK_MENU &
0,
SK12+SK21+SK31+0,
 98,   & "LOCK to"+sk_bracket_3 "a1 " &
 99,   & "a2 "   &
100;   & "NONE"   &

INTEGER TABLE SKS20 :=        & REDEF_NUM_MENU &
BSK5+0,
SK12+SK21+SK31+SK41+SK52+0,
101,   & "NUMERATOR"+sk_bracket_5 "b1 " &
102,   & "b2 "   &
103,   & "a1 "   &
104,   & "a2 "   &
105,   & "SERVICE" "SELECTIONS" &
REDEF_NUM2_MENU;
```

```
INTEGER TABLE SKS21 :=        & REDEF_NUM2_MENU &
0,
SK12+SK22+SK32+SK41+SK51+SK61+SK71+SK81+0,
106,   & "100 kHz"+sk_bracket_8 "TEST CAL" &
107,   & "100 kHz" "REF CAL" &
108,   & "DETECTOR" "GROUND" &
109,   & "ADC GROUND"   &
110,   & "VCAL"   &
111,   & "VREF"   &
112,   & "TEMP. 1"   &
113;   & "TEMP. 2"   &


INTEGER TABLE SKS22 :=        & REDEF_DENOM_MENU &
0,
SK12+SK21+SK31+SK41+0,
114,   & "DENOM."+sk_bracket_4 "a1 " &
115,   & "a2 "   &
116,   & "b1 "   &
117;   & "NO RATIO"   &


INTEGER TABLE SKS23 :=        & REDEF_CONV_MENU &
0,
SK12+SK21+SK31+SK41+0,
118,   & "CONVERT"+sk_bracket_4 "to   S" &
119,   & "to 1/S"   &
120,   & "to   Z"   &
121;   & "to   Y"   &


INTEGER TABLE SKS24 :=        & FORMAT_MENU &
0,
SK11+SK22+SK32+SK42+SK52+SK62+SK71+SK81+0,
122,   & sk_bracket_8 half_vt+"SWR" &
123,   & "LINEAR" "MAGNITUDE" &
124,   & "POLAR w/" "LIN MKR" &
125,   & "POLAR w/" "LOG MKR" &
126,   & "POLAR w/" "Re/Im MKR" &
127,   & "INVERTED" "SMITH" &
128,   & "IMAGINARY"   &
129;   & "REAL"   &


INTEGER TABLE SKS25 :=        & DOMAIN_MENU &
BSK2+BSK6+BSK7+0,
SK11+SK22+SK32+SK42+SK62+SK71+0,
130,   & sk_bracket_4 half_vt+"FREQUENCY" &
131,   & "TIME" "LOW PASS" &
LOW_PASS_FREQ,
132,   & "TIME" "BAND PASS" &
133,   & "AUX. VOLT" "OUTPUT" &
134,   & "SPECIFY"+sk_bracket_2 "TIME" &
TIME_SETUP_MENU,
```

```
135,   & "GATE"   &
GATE_SETUP_MENU;

INTEGER TABLE SKS26 :=        & LOW_PASS_FREQ &
0,
SK22+0,
136;   & "SET FREQ." "(LOW PASS)" &

INTEGER TABLE SKS27 :=        & TIME_SETUP_MENU &
0,
SK12+SK21+SK52+SK61+SK71+0,
137,   & "LOW PASS:"+sk_bracket_2 "STEP" &
138,   & "IMPULSE"   &
139,   & "WINDOW:"+sk_bracket_3 "MAXIMUM" &
140,   & "NORMAL"   &
141;   & "MINIMUM"   &

INTEGER TABLE SKS28 :=        & GATE_SETUP_MENU &
BSK7+0,
SK12+SK21+SK32+SK41+SK51+SK61+SK71+0,
142,   & "GATE"+sk_bracket_2 "ON" &
143,   & "OFF"   &
144,   & "GATE"+sk_bracket_4 "START" &
145,   & "STOP"   &
146,   & "CENTER"   &
147,   & "SPAN"   &
148,   & "GATE SHAPE"   &
GATE_SHAPE_MENU;

INTEGER TABLE SKS29 :=        & GATE_SHAPE_MENU &
0,
SK52+SK61+SK71+SK81+0,
149,   & "GATE SHAPE"+sk_bracket_4 "MAXIMUM" &
150,   & "WIDE"   &
151,   & "NORMAL"   &
152;   & "MINIMUM"   &

INTEGER TABLE SKS30 :=        & CAL_MENU &
BSK8+0,
SK12+SK21+SK32+SK52+SK62+SK72+SK81+0,
153,   & "CORRECTION"+sk_bracket_3 "ON" &
154,   & "OFF"   &
155,   & "SELECT" "CAL SET" &
156,   & "CALIBRATE"+sk_bracket_3 "( KIT #1 )" &
157,   & "CALIBRATE" "( KIT #2 )" &
158,   & "RESUME CAL" "SEQUENCE" &
 26,   & "MORE"   &
MORE_CAL;

INTEGER TABLE SKS31 :=        & MORE_CAL &
```

```
BSK1+BSK5+BSK6+0,
SK12+SK21+SK32+SK52+SK62+SK82+0,
159,  & "REFERENCE" "PLANES" &
REF_PLANE_MENU,
160,  & "SET Z"+176   &
161,  & "CAL SWEEP" "VOLTAGE" &
162,  & "MODIFY KIT"+sk_bracket_2 "( KIT #1 )" &
MODIFY_CAL_KIT_MENU,
163,  & "MODIFY KIT" "( KIT #2 )" &
MODIFY_CAL_KIT_MENU,
164;  & "DELETE A" "CAL SET" &


INTEGER TABLE SKS32 :=        & REF_PLANE_MENU &
0,
SK31+SK41+0,
165,  & sk_bracket_2 half_vt+"PLANE 1" &
166;  & "PLANE 2"   &


INTEGER TABLE SKS33 :=        & CAL_TYPE_MENU &
0,
SK22+SK42+SK52+SK62+SK72+SK82+0,
167,  & "SET FREQ." "(LOW PASS)" &
168,  & "FREQUENCY"+sk_bracket_5 "RESPONSE" &
169,  & "S"+177+177+" " "1-PORT" &
170,  & "S"+178+178+" " "1-PORT" &
171,  & "ONE-PATH" "2-PORT" &
172;  & "FULL" "2-PORT" &


INTEGER TABLE SKS34 :=        & PORT_ONE_REFL &
0,
SK12+SK21+SK31+SK82+0,
173,  & "S"+177+177+"  "+sk_bracket_3 "PORT1 STD1" &
174,  & "PORT1 STD2"   &
175,  & "PORT1 STD3"   &
176;  & "SAVE" "S"+177+177+" CAL" &


INTEGER TABLE SKS35 :=        & PORT_TWO_REFL &
0,
SK12+SK21+SK31+SK82+0,
177,  & "S"+178+178+"  "+sk_bracket_3 "PORT2 STD1" &
178,  & "PORT2 STD2"   &
179,  & "PORT2 STD3"   &
180;  & "SAVE" "S"+178+178+" CAL" &


INTEGER TABLE SKS36 :=        & CAL_MENU2 &
BSK1+BSK2+BSK3+0,
SK11+SK22+SK31+SK82+0,
181,  & sk_bracket_3 half_vt+"REFLECT'N" &
REFLECTION_MENU,
182,  & "TRANS-" "MISSION" &
TRANSMISSION_MENU,
```

```
183,  & "ISOLATION"   &
ISOLATION_MENU,
184;  & "SAVE" "2-PORT CAL" &


INTEGER TABLE SKS37 :=        & REFLECTION_MENU &
0,
SK12+SK21+SK31+SK42+SK51+SK61+SK82+0,
173,  & "S"+177+177+"  "+sk_bracket_3 "PORT1 STD1" &
174,  & "PORT1 STD2"   &
175,  & "PORT1 STD3"   &
177,  & "S"+178+178+"  "+sk_bracket_3 "PORT2 STD1" &
178,  & "PORT2 STD2"   &
179,  & "PORT2 STD3"   &
185;  & "REFLECT'N" "DONE" &


INTEGER TABLE SKS38 :=        & TRANSMISSION_MENU &
0,
SK22+SK32+SK42+SK52+SK82+0,
186,  & "FWD.TRANS." "FWD_TRANS_" &
187,  & "FWD.MATCH" "FWD_MATCH_" &
188,  & "REV.TRANS." "REV_TRANS_" &
189,  & "REV.MATCH" "REV_MATCH_" &
190;  & "TRANS." "DONE" &


INTEGER TABLE SKS39 :=        & ISOLATION_MENU &
0,
SK32+SK52+SK62+SK82+0,
191,  & "OMIT" "ISOLATION" &
192,  & "FWD ISOL'N" "FWD_ISOLN_" &
193,  & "REV ISOL'N" "REV_ISOLN_" &
194;  & "ISOLATION" "DONE" &


INTEGER TABLE SKS40 :=        & CAL_MENU3 &
BSK1+BSK2+BSK3+0,
SK11+SK22+SK31+SK82+0,
195,  & sk_bracket_3 half_vt+"REFLECT'N" &
SIMPLE_REFLECTION_MENU,
196,  & "TRANS-" "MISSION" &
SIMPLE_TRANSMISSION_MENU,
197,  & "ISOLATION"   &
SIMPLE_ISOLATION_MENU,
184;  & "SAVE" "2-PORT CAL" &


INTEGER TABLE SKS41 :=        & SIMPLE_REFLECTION_MENU &
0,
SK12+SK21+SK31+SK82+0,
173,  & "S"+177+177+"  "+sk_bracket_3 "PORT1 STD1" &
174,  & "PORT1 STD2"   &
175,  & "PORT1 STD3"   &
198;  & "REFLECT'N" "DONE" &
```

```
INTEGER TABLE SKS42 :=       & SIMPLE_TRANSMISSION_MENU &
0,
SK22+SK32+SK82+0,
186,   & "FWD.TRANS." "FWD_TRANS_" &
187,   & "FWD.MATCH" "FWD_MATCH_" &
190;   & "TRANS." "DONE" &


INTEGER TABLE SKS43 :=       & SIMPLE_ISOLATION_MENU &
0,
SK32+SK52+SK82+0,
191,   & "OMIT" "ISOLATION" &
192,   & "FWD ISOL'N" "FWD_ISOLN_" &
194;   & "ISOLATION" "DONE" &


INTEGER TABLE SKS44 :=       & STD_CLASS_MENU &
0,
SK11+SK21+SK31+SK41+SK51+SK61+SK71+SK82+0,
199,   & "STANDARD 1"   &
200,   & "STANDARD 2"   &
201,   & "STANDARD 3"   &
202,   & "STANDARD 4"   &
203,   & "STANDARD 5"   &
204,   & "STANDARD 6"   &
205,   & "STANDARD 7"   &
206;   & "STANDARDS " "DONE" &


INTEGER TABLE SKS45 :=       & SLIDING_LOAD_MENU &
0,
SK12+SK82+0,
207,   & "SLIDE IS" "SET" &
208;   & "SLIDING" "LOAD DONE" &


INTEGER TABLE SKS46 :=       & MODIFY_CAL_KIT_MENU &
BSK3+0,
SK12+SK32+SK42+SK62+SK82+0,
209,   & "SELECT" "STANDARD" &
210,   & "SPECIFY" "STD CLASS" &
SPECIFY_CLASS_MENU,
211,   & "LABEL" "STD CLASS" &
212,   & "LABEL" "CAL KIT" &
213;   & "DONE" "(DEFINED)" &


INTEGER TABLE SKS47 :=       & MODIFY_STDS_MENU &
BSK1+BSK2+BSK3+BSK4+BSK5+0,
SK12+SK21+SK31+SK42+SK52+0,
214,   & "STD TYPE"+sk_bracket_5 "OPEN" &
DEFINE_OPEN_MENU,
215,   & "SHORT"    &
DEFINE_SHORT_MENU,
216,   & "LOAD"    &
```

```
DEFINE_LOAD_MENU,
217,  & "DELAY/" "THRU" &
SPECIFY_OFFSET_MENU,
218,  & "ARBITRARY" "IMPEDANCE" &
SPECIFY_Z_MENU;


INTEGER TABLE SKS48 :=        & DEFINE_OPEN_MENU &
BSK6+0,
SK11+SK21+SK31+SK62+SK71+SK82+0,
219,    & " C"+176+" "    &
220,    & " C"+177+" "    &
221,    & " C"+178+" "    &
222,    & "SPECIFY" "OFFSET" &
SPECIFY_OFFSET_MENU,
223,    & "LABEL STD"    &
224;    & "DONE" "(DEFINED)" &


INTEGER TABLE SKS49 :=        & DEFINE_SHORT_MENU &
BSK6+0,
SK62+SK71+SK82+0,
222,    & "SPECIFY" "OFFSET" &
SPECIFY_OFFSET_MENU,
223,    & "LABEL STD"    &
224;    & "DONE" "(DEFINED)" &


INTEGER TABLE SKS50 :=        & DEFINE_LOAD_MENU &
BSK6+0,
SK41+SK51+SK62+SK71+SK82+0,
225,    & sk_bracket_2 half_vt+"FIXED" &
226,    & "SLIDING"    &
222,    & "SPECIFY" "OFFSET" &
SPECIFY_OFFSET_MENU,
223,    & "LABEL STD"    &
224;    & "DONE" "(DEFINED)" &


INTEGER TABLE SKS51 :=        & SPECIFY_Z_MENU &
BSK6+0,
SK11+SK21+SK31+SK41+SK51+SK62+SK71+SK82+0,
219,    & " C"+176+" "    &
220,    & " C"+177+" "    &
221,    & " C"+178+" "    &
225,    & sk_bracket_2 half_vt+"FIXED" &
226,    & "SLIDING"    &
222,    & "SPECIFY" "OFFSET" &
SPECIFY_OFFSET_MENU,
223,    & "LABEL STD"    &
224;    & "DONE" "(DEFINED)" &


INTEGER TABLE SKS52 :=        & SPECIFY_OFFSET_MENU &
0,
SK12+SK22+SK32+SK42+SK52+SK61+SK71+SK82+0,
```

```
227,   & "OFFSET" "DELAY" &
228,   & "OFFSET" "LOSS" &
229,   & "OFFSET" " Z"+176+" " &
230,   & "LOWER" "FREQUENCY" &
231,   & "UPPER" "FREQUENCY" &
232,   & sk_bracket_2 half_vt+"COAX" &
233,   & "WAVEGUIDE"  &
234;   & "DONE" "(DEFINED)" &


INTEGER TABLE SKS53 :=        & SPECIFY_CLASS_MENU &
BSK7+0,
SK12+SK21+SK31+SK42+SK51+SK61+SK71+SK82+0,
235,   & "S"+177+177+":  " "1st STD" &
236,   & "2nd STD"   &
237,   & "3rd STD"   &
238,   & "S"+178+178+":  " "1st STD" &
239,   & "2nd STD"   &
240,   & "3rd STD"   &
241,   & "MORE"   &
SPECIFY_CLASS_MENU2,
242;   & "DONE" "(SPEC'D)" &


INTEGER TABLE SKS54 :=        & SPECIFY_CLASS_MENU2 &
0,
SK12+SK21+SK42+SK82+0,
243,   & "TRANS.:" "FWD STD" &
244,   & "REV STD"   &
245,   & "FREQUENCY" "RESP. STD" &
242;   & "DONE" "(SPEC'D)" &


INTEGER TABLE SKS55 :=        & DISPLAY_MENU &
BSK2+BSK7+0,
SK12+SK22+SK31+SK41+SK52+SK62+SK72+SK82+0,
246,   & "SINGLE "+sk_bracket_2 "CHANNEL" &
247,   & "DUAL    " "CHANNEL" &
DUAL_CH_MENU,
248,   & sk_bracket_4 half_vt+"DATA" &
249,   & "MEMORY"   &
250,   & "DATA "+38 "MEMORY" &
251,   & "MATH" "(...)" &
252,   & "SELECT" "DEFAULTS" &
DISPLAY_DEFAULT_MENU,
253;   & "DATA "+169 "MEMORY" &


INTEGER TABLE SKS56 :=        & DUAL_CH_MENU &
0,
SK12+SK22+0,
254,   & "2 CHANNEL"+sk_bracket_2 "OVERLAY" &
255;   & "2 CHANNEL" "SPLIT" &


INTEGER TABLE SKS57 :=        & DISPLAY_DEFAULT_MENU &
```

```
BSK5+BSK7+0,
SK12+SK21+SK31+SK41+SK51+SK72+0,
256,  & "MEMORY"+sk_bracket_5 " 1 " &
257,  & " 2 "   &
258,  & " 3 "   &
259,  & " 4 "   &
260,  & "MORE"   &
MEMORY_MENU,
261,  & "MATH" "OPERATIONS" &
MATH_MENU;

INTEGER TABLE SKS58 :=      & MEMORY_MENU &
0,
SK52+SK62+0,
262,  & "DATA from"+sk_bracket_2 "CHANNEL 1" &
263;  & "DATA from" "CHANNEL 2" &

INTEGER TABLE SKS59 :=      & MATH_MENU &
0,
SK42+SK52+SK62+SK72+0,
264,  & "DATA"+sk_bracket_4 "+ MEMORY" &
265,  & "DATA" "- MEMORY" &
266,  & "DATA" mpy_char+" MEMORY" &
267;  & "DATA" "/ MEMORY" &

INTEGER TABLE SKS60 :=      & COPY_MENU &
BSK6+BSK7+BSK8+0,
SK12+SK21+SK31+SK41+SK51+SK62+SK72+SK81+0,
268,  & "PLOT"+sk_bracket_5 "ALL" &
269,  & "TRACE"   &
270,  & "GRATICULE"   &
271,  & "MARKER(S)"   &
272,  & "TEXT"   &
273,  & "SELECT" "QUADRANT" &
PLOT_SETUP_MENU,
274,  & "SELECT" "PEN COLOR" &
PEN_MENU,
275,  & "MORE"   &
PLOTPARM_MENU;

INTEGER TABLE SKS61 :=      & PLOTPARM_MENU &
BSK7+BSK8+0,
SK12+SK72+SK82+0,
276,  & "LIST TRACE" "VALUES" &
277,  & "SYSTEM"+sk_bracket_2 "PARAMETERS" &
COPY2_MENU,
278,  & "OPERATING" "PARAMETERS" &
COPY2_MENU;

INTEGER TABLE SKS62 :=      & PLOT_SETUP_MENU &
0,
```

```
SK22+SK32+SK42+SK52+SK62+0,
279,   & "X -    LEFT"+sk_bracket_5 "- -  UPPER" &
280,   & "- -    LEFT" "X -  LOWER" &
281,   & "- X  RIGHT" "- -  UPPER" &
282,   & "- -  RIGHT" "- X  LOWER" &
283;   & "X X    FULL" "X X   PAGE" &


INTEGER TABLE SKS63 :=       & PEN_MENU &
0,
SK12+SK21+SK31+SK41+SK51+SK61+SK71+SK81+0,
284,   & "PEN"+sk_bracket_8 " 1 " &
285,   & " 2 "   &
286,   & " 3 "   &
287,   & " 4 "   &
288,   & " 5 "   &
289,   & " 6 "   &
290,   & " 7 "   &
291;   & " 8 "   &


INTEGER TABLE SKS64 :=       & COPY2_MENU &
0,
SK12+SK21+SK31+SK81+0,
  9,   & "RESTORE" "DISPLAY" &
292,   & sk_bracket_2 half_vt+"PRINT" &
293,   & "PLOT"    &
294;   & "NEXT PAGE"    &


INTEGER TABLE SKS65 :=       & MARKER_MENU &
BSK7+BSK8+0,
SK12+SK21+SK31+SK41+SK51+SK62+SK72+SK81+0,
295,   & "MARKER"+sk_bracket_6 "        1 " &
296,   & "          2 "   &
297,   & "          3 "   &
298,   & "          4 "   &
299,   & "          5 "   &
300,   & "ALL" "OFF" &
301,   & delta_char+" MODE" "MENU" &
DELTA_MARKER_MENU,
 26,   & "MORE"    &
MARKER2_MENU;


INTEGER TABLE SKS66 :=       & DELTA_MARKER_MENU &
0,
SK11+SK21+SK31+SK41+SK51+SK62+0,
302,   & sk_bracket_6 half_vt+delta_char+" REF = 1" &
303,   & delta_char+" REF = 2"   &
304,   & delta_char+" REF = 3"   &
305,   & delta_char+" REF = 4"   &
306,   & delta_char+" REF = 5"   &
307;   & delta_char+" MODE" "OFF" &
```

```
INTEGER TABLE SKS67 :=        & MARKER2_MENU &
0,
SK72+SK81+0,
308,   & "MARKER to"+sk_bracket_2 "MINIMUM" &
309;   & "MAXIMUM"   &


INTEGER TABLE SKS68 :=        & SYSTEM_MENU &
BSK1+BSK2+BSK8+0,
SK11+SK22+SK32+SK82+0,
310,   & "TITLE"   &
TITLE_MENU,
311,   & "HP-IB" "ADDRESSES" &
HPIB_MENU,
312,   & "CRT" "OFF" &
313,   & "SERVICE" "FUNCTIONS" &
SERVICE_MENU;


INTEGER TABLE SKS69 :=        & TITLE_MENU &
0,
SK12+SK31+SK41+SK62+SK81+0,
314,   & "SELECT" "LETTER" &
315,   & "SPACE"   &
316,   & "BACKSPACE"   &
317,   & "ERASE" "TITLE" &
318;   & "DONE"   &


INTEGER TABLE SKS70 :=        & HPIB_MENU &
0,
SK12+SK21+SK31+SK41+SK51+SK61+SK71+SK81+0,
319,   & "8510 HP-IB"+sk_bracket_8 "ADDRESS" &
320,   & "SYSTEM BUS"   &
321,   & "SOURCE"   &
322,   & "TEST SET"   &
323,   & "PLOTTER"   &
324,   & "PRINTER"   &
325,   & "AUTO CMD"   &
326;   & "PASS THRU"   &


INTEGER TABLE SKS71 :=        & SERVICE_MENU &
BSK4+0,
SK12+SK22+SK31+SK41+SK51+SK61+SK71+SK81+0,
327,   & "SOFTWARE" "REVISION" &
328,   & "SYSTEM BUS"+sk_bracket_2 "'LOCAL'" &
329,   & "'REMOTE'"   &
330,   & "IF GAIN"   &
IF_GAIN_MENU,
331,   & sk_bracket_3 half_vt+"LOCATION" &
332,   & "PEEK"   &
333,   & "POKE"   &
334;   & "TEST MENU"   &
```

```
COMMENT  Softkey menu table containing addresses of
         softkey menus indexed by menu number;

GLOBAL DOUBLE TABLE SK_MENU :=
  ADRS(SKS0),
  ADRS(SKS1),
  ADRS(SKS2),
  ADRS(SKS3),
  ADRS(SKS4),
  ADRS(SKS5),
  ADRS(SKS6),
  ADRS(SKS7),
  ADRS(SKS8),
  ADRS(SKS9),
  ADRS(SKS10),
  ADRS(SKS11),
  ADRS(SKS12),
  ADRS(SKS13),
  ADRS(SKS14),
  ADRS(SKS15),
  ADRS(SKS16),
  ADRS(SKS17),
  ADRS(SKS18),
  ADRS(SKS19),
  ADRS(SKS20),
  ADRS(SKS21),
  ADRS(SKS22),
  ADRS(SKS23),
  ADRS(SKS24),
  ADRS(SKS25),
  ADRS(SKS26),
  ADRS(SKS27),
  ADRS(SKS28),
  ADRS(SKS29),
  ADRS(SKS30),
  ADRS(SKS31),
  ADRS(SKS32),
  ADRS(SKS33),
  ADRS(SKS34),
  ADRS(SKS35),
  ADRS(SKS36),
  ADRS(SKS37),
  ADRS(SKS38),
  ADRS(SKS39),
  ADRS(SKS40),
  ADRS(SKS41),
  ADRS(SKS42),
  ADRS(SKS43),
  ADRS(SKS44),
  ADRS(SKS45),
  ADRS(SKS46),
  ADRS(SKS47),
  ADRS(SKS48),
  ADRS(SKS49),
  ADRS(SKS50),
  ADRS(SKS51),
```

```
ADRS(SKS52),
ADRS(SKS53),
ADRS(SKS54),
ADRS(SKS55),
ADRS(SKS56),
ADRS(SKS57),
ADRS(SKS58),
ADRS(SKS59),
ADRS(SKS60),
ADRS(SKS61),
ADRS(SKS62),
ADRS(SKS63),
ADRS(SKS64),
ADRS(SKS65),
ADRS(SKS66),
ADRS(SKS67),
ADRS(SKS68),
ADRS(SKS69),
ADRS(SKS70),
ADRS(SKS71),
0;

COMMENT  Softkey labels accessed by key label tables;

GLOBAL ALPHA TABLE SK_LABEL :=
  &  0 &  " ",
  &  1 &  "DIRECTORY",
  &  2 &  "STORE",
  &  3 &  "LOAD",
  &  4 &  "DELETE",
  &  5 &  "UN-DELETE",
  &  6 &  "INITIALIZE",
  &  7 &  "TAPE",
  &  8 &  "INIT TAPE?",
  &  9 &  "YES",
  & 10 &  "NO",
  & 11 &  "RESTORE",
  & 12 &  "DISPLAY",
  & 13 &  "NEXT",
  & 14 &  "PAGE",
  & 15 &  "PREVIOUS",
  & 16 &  "FIRST",
  & 17 &  "LAST",
  & 18 &  "RAW",
  & 19 &  "DATA",
  & 20 &  "FORMATTED",
  & 21 &  "USER",
  & 22 &  "MACHINE",
  & 23 &  "DUMP",
  & 24 &  "INSTRUMENT",
  & 25 &  "STATE",
  & 26 &  "STATES 1-5",
  & 27 &  "MEMORY",
  & 28 &  "TRACE",
  & 29 &  "TRACES 1-4",
```

```
& 30 &  "CAL SET",
& 31 &  "CAL SETS",
& 32 &  "1-8",
& 33 &  "CAL KIT",
& 34 &  "MORE",
& 35 &  "ABORT",
& 36 &  "DATA TYPE ",
& 37 &  "* FILE 1",
& 38 &  " ",
& 39 &  "* FILE 2",
& 40 &  "* FILE 3",
& 41 &  "* FILE 4",
& 42 &  "* FILE 5",
& 43 &  "* FILE 6",
& 44 &  "* FILE 7",
& 45 &  "* FILE 8",
& 46 &  "* 1 ",
& 47 &  "* 2 ",
& 48 &  "* 3 ",
& 49 &  "* 4 ",
& 50 &  "(POWER UP)",
& 51 &  "* 5 ",
& 52 &  "* 6 ",
& 53 &  "* 7 ",
& 54 &  "LAST STATE",
& 55 &  "ELECTRICAL"+sk_bracket_2,
& 56 &  "DELAY",
& 57 &  "AUTO DELAY",
& 58 &  "PHASE",
& 59 &  "OFFSET",
& 60 &  "MAGNITUDE",
& 61 &  "AVERAGING"+sk_bracket_2,
& 62 &  "ON/RESTART",
& 63 &  "OFF",
& 64 &  "SMOOTHING"+sk_bracket_2,
& 65 &  "ON ",
& 66 &  "TEST"+sk_bracket_2,
& 67 &  "AMP. GAIN",
& 68 &  "REFERENCE",
& 69 &  "GAIN"+sk_bracket_6,
& 70 &  "0 (MIN.)",
& 71 &  " 1 ",
& 72 &  " 2 ",
& 73 &  " 3 ",
& 74 &  "4 (MAX.)",
& 75 &  "AUTO",
& 76 &  "POWER",
& 77 &  "MENU",
& 78 &  "SWEEP",
& 79 &  "TIME",
& 80 &  "NUMBER of",
& 81 &  "POINTS",
& 82 &  "SINGLE"+sk_bracket_3,
& 83 &  "POINT",
& 84 &  "RAMP",
& 85 &  "STEP",
```

```
& 86 &  "POINTS:"+sk_bracket_4,
& 87 &  "51 ",
& 88 &  "101",
& 89 &  "201",
& 90 &  "401",
& 91 &  "SLOPE"+sk_bracket_2,
& 92 &  "ATTENUATOR"+sk_bracket_2,
& 93 &  "PORT 1",
& 94 &  "PORT 2",
& 95 &  sk_bracket_4,
& 96 &  half_vt+"HOLD",
& 97 &  "SINGLE",
& 98 &  "GROUPS",
& 99 &  "CONTINUAL",
& 100 & "STIMULUS",
& 101 & sk_bracket_2,
& 102 & half_vt+"Ch1 = Ch2",
& 103 & "Ch1 "+163+" Ch2",
& 104 & "PRESS TO",
& 105 & "CONTINUE",
& 106 & "a"+177+sk_bracket_4,
& 107 & "b"+178,
& 108 & "a"+178,
& 109 & "b"+177,
& 110 & "REDEFINE",
& 111 & "PARAMETER",
& 112 & "REDEFINE"+sk_bracket_6,
& 113 & "DRIVE",
& 114 & "PHASE LOCK",
& 115 & "NUMERATOR",
& 116 & "DENOMI-",
& 117 & "NATOR",
& 118 & "CONVERSION",
& 119 & "LABEL",
& 120 & "DONE",
& 121 & "DRIVE"+sk_bracket_3,
& 122 & "NONE",
& 123 & "LOCK to"+sk_bracket_3,
& 124 & "a1 ",
& 125 & "a2 ",
& 126 & "NUMERATOR"+sk_bracket_5,
& 127 & "b1 ",
& 128 & "b2 ",
& 129 & "SERVICE",
& 130 & "SELECTIONS",
& 131 & "100 kHz"+sk_bracket_8,
& 132 & "TEST CAL",
& 133 & "100 kHz",
& 134 & "REF CAL",
& 135 & "DETECTOR",
& 136 & "GROUND",
& 137 & "ADC GROUND",
& 138 & "VCAL",
& 139 & "VREF",
& 140 & "TEMP. 1",
& 141 & "TEMP. 2",
```

```
& 142 &    "DENOM."+sk_bracket_4,
& 143 &    "NO RATIO",
& 144 &    "CONVERT"+sk_bracket_4,
& 145 &    "to   S",
& 146 &    "to 1/S",
& 147 &    "to   Z",
& 148 &    "to   Y",
& 149 &    sk_bracket_8,
& 150 &    half_vt+"SWR",
& 151 &    "LINEAR",
& 152 &    "POLAR w/",
& 153 &    "LIN MKR",
& 154 &    "LOG MKR",
& 155 &    "Re/Im MKR",
& 156 &    "INVERTED",
& 157 &    "SMITH",
& 158 &    "IMAGINARY",
& 159 &    "REAL",
& 160 &    half_vt+"FREQUENCY",
& 161 &    "LOW PASS",
& 162 &    "BAND PASS",
& 163 &    "AUX. VOLT",
& 164 &    "OUTPUT",
& 165 &    "SPECIFY"+sk_bracket_2,
& 166 &    "GATE",
& 167 &    "SET FREQ.",
& 168 &    "(LOW PASS)",
& 169 &    "LOW PASS:"+sk_bracket_2,
& 170 &    "IMPULSE",
& 171 &    "WINDOW:"+sk_bracket_3,
& 172 &    "MAXIMUM",
& 173 &    "NORMAL",
& 174 &    "MINIMUM",
& 175 &    "GATE"+sk_bracket_2,
& 176 &    "ON",
& 177 &    "GATE"+sk_bracket_4,
& 178 &    "START",
& 179 &    "STOP",
& 180 &    "CENTER",
& 181 &    "SPAN",
& 182 &    "GATE SHAPE",
& 183 &    "GATE SHAPE"+sk_bracket_4,
& 184 &    "WIDE",
& 185 &    "CORRECTION"+sk_bracket_3,
& 186 &    "SELECT",
& 187 &    "CALIBRATE"+sk_bracket_3,
& 188 &    "( KIT #1 )",
& 189 &    "CALIBRATE",
& 190 &    "( KIT #2 )",
& 191 &    "RESUME CAL",
& 192 &    "SEQUENCE",
& 193 &    "PLANES",
& 194 &    "SET Z"+176,
& 195 &    "CAL SWEEP",
& 196 &    "VOLTAGE",
& 197 &    "MODIFY KIT"+sk_bracket_2,
```

```
& 198 &   "MODIFY KIT",
& 199 &   "DELETE A",
& 200 &   half_vt+"PLANE 1",
& 201 &   "PLANE 2",
& 202 &   "FREQUENCY"+sk_bracket_5,
& 203 &   "RESPONSE",
& 204 &   "S"+177+177+"  ",
& 205 &   "1-PORT",
& 206 &   "S"+178+178+"  ",
& 207 &   "ONE-PATH",
& 208 &   "2-PORT",
& 209 &   "FULL",
& 210 &   "S"+177+177+"  "+sk_bracket_3,
& 211 &   "PORT1 STD1",
& 212 &   "PORT1 STD2",
& 213 &   "PORT1 STD3",
& 214 &   "SAVE",
& 215 &   "S"+177+177+" CAL",
& 216 &   "S"+178+178+"  "+sk_bracket_3,
& 217 &   "PORT2 STD1",
& 218 &   "PORT2 STD2",
& 219 &   "PORT2 STD3",
& 220 &   "S"+178+178+" CAL",
& 221 &   sk_bracket_3,
& 222 &   half_vt+"REFLECT'N",
& 223 &   "TRANS-",
& 224 &   "MISSION",
& 225 &   "ISOLATION",
& 226 &   "2-PORT CAL",
& 227 &   "REFLECT'N",
& 228 &   "FWD.TRANS.",
& 229 &   "FWD_TRANS_",
& 230 &   "FWD.MATCH",
& 231 &   "FWD_MATCH_",
& 232 &   "REV.TRANS.",
& 233 &   "REV_TRANS_",
& 234 &   "REV.MATCH",
& 235 &   "REV_MATCH_",
& 236 &   "TRANS.",
& 237 &   "OMIT",
& 238 &   "FWD ISOL'N",
& 239 &   "FWD_ISOLN_",
& 240 &   "REV ISOL'N",
& 241 &   "REV_ISOLN_",
& 242 &   "S"+177+177+sk_bracket_3,
& 243 &   "STANDARD 1",
& 244 &   "STANDARD 2",
& 245 &   "STANDARD 3",
& 246 &   "STANDARD 4",
& 247 &   "STANDARD 5",
& 248 &   "STANDARD 6",
& 249 &   "STANDARD 7",
& 250 &   "STANDARDS ",
& 251 &   "SLIDE IS",
& 252 &   "SET",
& 253 &   "SLIDING",
```

```
& 254 &    "LOAD DONE",
& 255 &    "STANDARD",
& 256 &    "SPECIFY",
& 257 &    "STD CLASS",
& 258 &    "(DEFINED)",
& 259 &    "STD TYPE"+sk_bracket_5,
& 260 &    "OPEN",
& 261 &    "SHORT",
& 262 &    "DELAY/",
& 263 &    "THRU",
& 264 &    "ARBITRARY",
& 265 &    "IMPEDANCE",
& 266 &    " C"+176+" ",
& 267 &    " C"+177+" ",
& 268 &    " C"+178+" ",
& 269 &    "LABEL STD",
& 270 &    half_vt+"FIXED",
& 271 &    "LOSS",
& 272 &    " Z"+176+" ",
& 273 &    "LOWER",
& 274 &    "FREQUENCY",
& 275 &    "UPPER",
& 276 &    half_vt+"COAX",
& 277 &    "WAVEGUIDE",
& 278 &    "S"+177+177+":  ",
& 279 &    "1st STD",
& 280 &    "2nd STD",
& 281 &    "3rd STD",
& 282 &    "S"+178+178+":  ",
& 283 &    "(SPEC'D)",
& 284 &    "TRANS.:",
& 285 &    "FWD STD",
& 286 &    "REV STD",
& 287 &    "RESP. STD",
& 288 &    "SINGLE "+sk_bracket_2,
& 289 &    "CHANNEL",
& 290 &    "DUAL   ",
& 291 &    half_vt+"DATA",
& 292 &    "DATA "+38,
& 293 &    "MATH",
& 294 &    "(...)",
& 295 &    "DEFAULTS",
& 296 &    "DATA "+169,
& 297 &    "2 CHANNEL"+sk_bracket_2,
& 298 &    "OVERLAY",
& 299 &    "2 CHANNEL",
& 300 &    "SPLIT",
& 301 &    "MEMORY"+sk_bracket_5,
& 302 &    " 4 ",
& 303 &    "OPERATIONS",
& 304 &    "DATA from"+sk_bracket_2,
& 305 &    "CHANNEL 1",
& 306 &    "DATA from",
& 307 &    "CHANNEL 2",
& 308 &    "DATA"+sk_bracket_4,
& 309 &    "+ MEMORY",
```

```
& 310 &    "- MEMORY",
& 311 &    mpy_char+" MEMORY",
& 312 &    "/ MEMORY",
& 313 &    "PLOT"+sk_bracket_5,
& 314 &    "ALL",
& 315 &    "GRATICULE",
& 316 &    "MARKER(S)",
& 317 &    "TEXT",
& 318 &    "QUADRANT",
& 319 &    "PEN COLOR",
& 320 &    "LIST TRACE",
& 321 &    "VALUES",
& 322 &    "SYSTEM"+sk_bracket_2,
& 323 &    "PARAMETERS",
& 324 &    "OPERATING",
& 325 &    "X -   LEFT"+sk_bracket_5,
& 326 &    "- -  UPPER",
& 327 &    "- -   LEFT",
& 328 &    "X -  LOWER",
& 329 &    "- X  RIGHT",
& 330 &    "- -  RIGHT",
& 331 &    "- X  LOWER",
& 332 &    "X X   FULL",
& 333 &    "X X   PAGE",
& 334 &    "PEN"+sk_bracket_8,
& 335 &    " 5 ",
& 336 &    " 6 ",
& 337 &    " 7 ",
& 338 &    " 8 ",
& 339 &    half_vt+"PRINT",
& 340 &    "PLOT",
& 341 &    "NEXT PAGE",
& 342 &    "MARKER"+sk_bracket_6,
& 343 &    "         1 ",
& 344 &    "         2 ",
& 345 &    "         3 ",
& 346 &    "         4 ",
& 347 &    "         5 ",
& 348 &    delta_char+" MODE",
& 349 &    sk_bracket_6,
& 350 &    half_vt+delta_char+" REF = 1",
& 351 &    delta_char+" REF = 2",
& 352 &    delta_char+" REF = 3",
& 353 &    delta_char+" REF = 4",
& 354 &    delta_char+" REF = 5",
& 355 &    "MARKER to"+sk_bracket_2,
& 356 &    "TITLE",
& 357 &    "HP-IB",
& 358 &    "ADDRESSES",
& 359 &    "CRT",
& 360 &    "FUNCTIONS",
& 361 &    "LETTER",
& 362 &    "SPACE",
& 363 &    "BACKSPACE",
& 364 &    "ERASE",
& 365 &    "8510 HP-IB"+sk_bracket_8,
```

```
& 366 &   "ADDRESS",
& 367 &   "SYSTEM BUS",
& 368 &   "SOURCE",
& 369 &   "TEST SET",
& 370 &   "PLOTTER",
& 371 &   "PRINTER",
& 372 &   "AUTO CMD",
& 373 &   "PASS THRU",
& 374 &   "SOFTWARE",
& 375 &   "REVISION",
& 376 &   "SYSTEM BUS"+sk_bracket_2,
& 377 &   "'LOCAL'",
& 378 &   "'REMOTE'",
& 379 &   "IF GAIN",
& 380 &   half_vt+"LOCATION",
& 381 &   "PEEK",
& 382 &   "POKE",
& 383 &   "TEST MENU",
& 999 &   " ";


COMMENT  Softkey label indexes for each softkey;

GLOBAL INTEGER TABLE LBL_INDEX :=
     1,  0,   & "DIRECTORY"    &
     2,  0,   & "STORE"   &
     3,  0,   & "LOAD"   &
     4,  0,   & "DELETE"   &
     5,  0,   & "UN-DELETE"    &
     6,  7,   & "INITIALIZE" "TAPE"  &
     8,  9,   & "INIT TAPE?" "YES"  &
    10,  0,   & "NO"    &
    11, 12,   & "RESTORE" "DISPLAY"  &
    13, 14,   & "NEXT" "PAGE"  &
    15, 14,   & "PREVIOUS" "PAGE"  &
    16, 14,   & "FIRST" "PAGE"  &
    17, 14,   & "LAST" "PAGE"  &
    18, 19,   & "RAW" "DATA"  &
    19,  0,   & "DATA"    &
    20, 19,   & "FORMATTED" "DATA"  &
    21, 12,   & "USER" "DISPLAY"  &
    22, 23,   & "MACHINE" "DUMP"  &
    24, 25,   & "INSTRUMENT" "STATE"  &
    24, 26,   & "INSTRUMENT" "STATES 1-5"  &
    27, 28,   & "MEMORY" "TRACE"  &
    27, 29,   & "MEMORY" "TRACES 1-4"  &
    30,  0,   & "CAL SET"    &
    31, 32,   & "CAL SETS" "1-8"  &
    33,  0,   & "CAL KIT"   &
    34,  0,   & "MORE"   &
    35,  0,   & "ABORT"   &
    36, 37,   & "DATA TYPE " "* FILE 1"  &
    38, 39,   & " " "* FILE 2"  &
    38, 40,   & " " "* FILE 3"  &
    38, 41,   & " " "* FILE 4"  &
    38, 42,   & " " "* FILE 5"  &
```

```
38, 43,    & " " "* FILE 6"  &
38, 44,    & " " "* FILE 7"  &
38, 45,    & " " "* FILE 8"  &
36, 46,    & "DATA TYPE " "* 1 "  &
38, 47,    & " " "* 2 "  &
38, 48,    & " " "* 3 "  &
38, 49,    & " " "* 4 "  &
50, 51,    & "(POWER UP)" "* 5 "  &
38, 52,    & " " "* 6 "  &
38, 53,    & " " "* 7 "  &
38, 54,    & " " "LAST STATE"  &
55, 56,    & "ELECTRICAL"+sk_bracket_2 "DELAY"  &
57,  0,    & "AUTO DELAY"   &
58, 59,    & "PHASE" "OFFSET"  &
60, 59,    & "MAGNITUDE" "OFFSET"  &
61, 62,    & "AVERAGING"+sk_bracket_2 "ON/RESTART"  &
63,  0,    & "OFF"    &
64, 65,    & "SMOOTHING"+sk_bracket_2 "ON "  &
63,  0,    & "OFF"    &
66, 67,    & "TEST"+sk_bracket_2 "AMP. GAIN"  &
68, 67,    & "REFERENCE" "AMP. GAIN"  &
69, 70,    & "GAIN"+sk_bracket_6 "0 (MIN.)"  &
71,  0,    & " 1 "    &
72,  0,    & " 2 "    &
73,  0,    & " 3 "    &
74,  0,    & "4 (MAX.)"    &
75,  0,    & "AUTO"    &
76, 77,    & "POWER" "MENU"  &
78, 79,    & "SWEEP" "TIME"  &
80, 81,    & "NUMBER of" "POINTS"  &
82, 83,    & "SINGLE"+sk_bracket_3 "POINT"  &
84,  0,    & "RAMP"    &
85,  0,    & "STEP"    &
86, 87,    & "POINTS:"+sk_bracket_4 "51 "  &
88,  0,    & "101"    &
89,  0,    & "201"    &
90,  0,    & "401"    &
76,  0,    & "POWER"    &
91, 65,    & "SLOPE"+sk_bracket_2 "ON "  &
63,  0,    & "OFF"   &
92, 93,    & "ATTENUATOR"+sk_bracket_2 "PORT 1"  &
94,  0,    & "PORT 2"    &
95, 96,    & sk_bracket_4 half_vt+"HOLD"  &
97,  0,    & "SINGLE"    &
80, 98,    & "NUMBER of" "GROUPS"  &
99,  0,    & "CONTINUAL"    &
100, 59,   & "STIMULUS" "OFFSET"  &
101,102,   & sk_bracket_2 half_vt+"Ch1 = Ch2"  &
103,  0,   & "Ch1 "+163+" Ch2"   &
104,105,   & "PRESS TO" "CONTINUE"  &
106,  0,   & "a"+177+sk_bracket_4    &
107,  0,   & "b"+178    &
108,  0,   & "a"+178    &
109,  0,   & "b"+177    &
110,111,   & "REDEFINE" "PARAMETER"  &
112,113,   & "REDEFINE"+sk_bracket_6 "DRIVE"  &
```

```
114,  0,    & "PHASE LOCK"    &
115,  0,    & "NUMERATOR"    &
116,117,    & "DENOMI-" "NATOR"  &
118,  0,    & "CONVERSION"    &
111,119,    & "PARAMETER" "LABEL"  &
110,120,    & "REDEFINE" "DONE"  &
121, 93,    & "DRIVE"+sk_bracket_3 "PORT 1"  &
 94,  0,    & "PORT 2"    &
122,  0,    & "NONE"    &
123,124,    & "LOCK to"+sk_bracket_3 "a1 "  &
125,  0,    & "a2 "    &
122,  0,    & "NONE"    &
126,127,    & "NUMERATOR"+sk_bracket_5 "b1 "  &
128,  0,    & "b2 "    &
124,  0,    & "a1 "    &
125,  0,    & "a2 "    &
129,130,    & "SERVICE" "SELECTIONS"  &
131,132,    & "100 kHz"+sk_bracket_8 "TEST CAL"  &
133,134,    & "100 kHz" "REF CAL"  &
135,136,    & "DETECTOR" "GROUND"  &
137,  0,    & "ADC GROUND"    &
138,  0,    & "VCAL"    &
139,  0,    & "VREF"    &
140,  0,    & "TEMP. 1"    &
141,  0,    & "TEMP. 2"    &
142,124,    & "DENOM."+sk_bracket_4 "a1 "  &
125,  0,    & "a2 "    &
127,  0,    & "b1 "    &
143,  0,    & "NO RATIO"    &
144,145,    & "CONVERT"+sk_bracket_4 "to   S"  &
146,  0,    & "to 1/S"    &
147,  0,    & "to   Z"    &
148,  0,    & "to   Y"    &
149,150,    & sk_bracket_8 half_vt+"SWR"  &
151, 60,    & "LINEAR" "MAGNITUDE"  &
152,153,    & "POLAR w/" "LIN MKR"  &
152,154,    & "POLAR w/" "LOG MKR"  &
152,155,    & "POLAR w/" "Re/Im MKR"  &
156,157,    & "INVERTED" "SMITH"  &
158,  0,    & "IMAGINARY"    &
159,  0,    & "REAL"    &
 95,160,    & sk_bracket_4 half_vt+"FREQUENCY"  &
 79,161,    & "TIME" "LOW PASS"  &
 79,162,    & "TIME" "BAND PASS"  &
163,164,    & "AUX. VOLT" "OUTPUT"  &
165, 79,    & "SPECIFY"+sk_bracket_2 "TIME"  &
166,  0,    & "GATE"    &
167,168,    & "SET FREQ." "(LOW PASS)"  &
169, 85,    & "LOW PASS:"+sk_bracket_2 "STEP"  &
170,  0,    & "IMPULSE"    &
171,172,    & "WINDOW:"+sk_bracket_3 "MAXIMUM"  &
173,  0,    & "NORMAL"    &
174,  0,    & "MINIMUM"    &
175,176,    & "GATE"+sk_bracket_2 "ON"  &
 63,  0,    & "OFF"    &
177,178,    & "GATE"+sk_bracket_4 "START"  &
```

```
179,  0,   & "STOP"    &
180,  0,   & "CENTER"    &
181,  0,   & "SPAN"    &
182,  0,   & "GATE SHAPE"    &
183,172,   & "GATE SHAPE"+sk_bracket_4 "MAXIMUM"   &
184,  0,   & "WIDE"    &
173,  0,   & "NORMAL"    &
174,  0,   & "MINIMUM"    &
185,176,   & "CORRECTION"+sk_bracket_3 "ON"   &
 63,  0,   & "OFF"    &
186, 30,   & "SELECT" "CAL SET"   &
187,188,   & "CALIBRATE"+sk_bracket_3 "( KIT #1 )"   &
189,190,   & "CALIBRATE" "( KIT #2 )"   &
191,192,   & "RESUME CAL" "SEQUENCE"   &
 68,193,   & "REFERENCE" "PLANES"   &
194,  0,   & "SET Z"+176    &
195,196,   & "CAL SWEEP" "VOLTAGE"   &
197,188,   & "MODIFY KIT"+sk_bracket_2 "( KIT #1 )"   &
198,190,   & "MODIFY KIT" "( KIT #2 )"   &
199, 30,   & "DELETE A" "CAL SET"   &
101,200,   & sk_bracket_2 half_vt+"PLANE 1"   &
201,  0,   & "PLANE 2"    &
167,168,   & "SET FREQ." "(LOW PASS)"   &
202,203,   & "FREQUENCY"+sk_bracket_5 "RESPONSE"   &
204,205,   & "S"+177+177+"  " "1-PORT"   &
206,205,   & "S"+178+178+"  " "1-PORT"   &
207,208,   & "ONE-PATH" "2-PORT"   &
209,208,   & "FULL" "2-PORT"   &
210,211,   & "S"+177+177+"  "+sk_bracket_3 "PORT1 STD1"   &
212,  0,   & "PORT1 STD2"    &
213,  0,   & "PORT1 STD3"    &
214,215,   & "SAVE" "S"+177+177+" CAL"   &
216,217,   & "S"+178+178+"  "+sk_bracket_3 "PORT2 STD1"   &
218,  0,   & "PORT2 STD2"    &
219,  0,   & "PORT2 STD3"    &
214,220,   & "SAVE" "S"+178+178+" CAL"   &
221,222,   & sk_bracket_3 half_vt+"REFLECT'N"   &
223,224,   & "TRANS-" "MISSION"   &
225,  0,   & "ISOLATION"    &
214,226,   & "SAVE" "2-PORT CAL"   &
227,120,   & "REFLECT'N" "DONE"   &
228,229,   & "FWD.TRANS." "FWD_TRANS_"   &
230,231,   & "FWD.MATCH" "FWD_MATCH_"   &
232,233,   & "REV.TRANS." "REV_TRANS_"   &
234,235,   & "REV.MATCH" "REV_MATCH_"   &
236,120,   & "TRANS." "DONE"   &
237,225,   & "OMIT" "ISOLATION"   &
238,239,   & "FWD ISOL'N" "FWD_ISOLN_"   &
240,241,   & "REV ISOL'N" "REV_ISOLN_"   &
225,120,   & "ISOLATION" "DONE"   &
221,222,   & sk_bracket_3 half_vt+"REFLECT'N"   &
223,224,   & "TRANS-" "MISSION"   &
225,  0,   & "ISOLATION"    &
227,120,   & "REFLECT'N" "DONE"   &
243,  0,   & "STANDARD 1"    &
244,  0,   & "STANDARD 2"    &
```

```
245,  0,    & "STANDARD 3"    &
246,  0,    & "STANDARD 4"    &
247,  0,    & "STANDARD 5"    &
248,  0,    & "STANDARD 6"    &
249,  0,    & "STANDARD 7"    &
250,120,    & "STANDARDS " "DONE"  &
251,252,    & "SLIDE IS" "SET"  &
253,254,    & "SLIDING" "LOAD DONE"  &
186,255,    & "SELECT" "STANDARD"  &
256,257,    & "SPECIFY" "STD CLASS"  &
119,257,    & "LABEL" "STD CLASS"  &
119, 33,    & "LABEL" "CAL KIT"  &
120,258,    & "DONE" "(DEFINED)"  &
259,260,    & "STD TYPE"+sk_bracket_5 "OPEN"  &
261,  0,    & "SHORT"    &
  3,  0,    & "LOAD"    &
262,263,    & "DELAY/" "THRU"  &
264,265,    & "ARBITRARY" "IMPEDANCE"  &
266,  0,    & " C"+176+" "    &
267,  0,    & " C"+177+" "    &
268,  0,    & " C"+178+" "    &
256, 59,    & "SPECIFY" "OFFSET"  &
269,  0,    & "LABEL STD"    &
120,258,    & "DONE" "(DEFINED)"  &
101,270,    & sk_bracket_2 half_vt+"FIXED"  &
253,  0,    & "SLIDING"    &
 59, 56,    & "OFFSET" "DELAY"  &
 59,271,    & "OFFSET" "LOSS"  &
 59,272,    & "OFFSET" " Z"+176+" "  &
273,274,    & "LOWER" "FREQUENCY"  &
275,274,    & "UPPER" "FREQUENCY"  &
101,276,    & sk_bracket_2 half_vt+"COAX"  &
277,  0,    & "WAVEGUIDE"    &
120,258,    & "DONE" "(DEFINED)"  &
278,279,    & "S"+177+177+":  " "1st STD"  &
280,  0,    & "2nd STD"    &
281,  0,    & "3rd STD"    &
282,279,    & "S"+178+178+":  " "1st STD"  &
280,  0,    & "2nd STD"    &
281,  0,    & "3rd STD"    &
 34,  0,    & "MORE"    &
120,283,    & "DONE" "(SPEC'D)"  &
284,285,    & "TRANS.:" "FWD STD"  &
286,  0,    & "REV STD"    &
274,287,    & "FREQUENCY" "RESP. STD"  &
288,289,    & "SINGLE "+sk_bracket_2 "CHANNEL"  &
290,289,    & "DUAL   " "CHANNEL"  &
 95,291,    & sk_bracket_4 half_vt+"DATA"  &
 27,  0,    & "MEMORY"    &
292, 27,    & "DATA "+38 "MEMORY"  &
293,294,    & "MATH" "(...)"  &
186,295,    & "SELECT" "DEFAULTS"  &
296, 27,    & "DATA "+169 "MEMORY"  &
297,298,    & "2 CHANNEL"+sk_bracket_2 "OVERLAY"  &
299,300,    & "2 CHANNEL" "SPLIT"  &
301, 71,    & "MEMORY"+sk_bracket_5 " 1 "  &
```

```
 72,  0,   & " 2 "    &
 73,  0,   & " 3 "    &
302,  0,   & " 4 "    &
 34,  0,   & "MORE"    &
293,303,   & "MATH" "OPERATIONS"  &
304,305,   & "DATA from"+sk_bracket_2 "CHANNEL 1"  &
306,307,   & "DATA from" "CHANNEL 2"  &
308,309,   & "DATA"+sk_bracket_4 "+ MEMORY"  &
 19,310,   & "DATA" "- MEMORY"  &
 19,311,   & "DATA" mpy_char+" MEMORY"  &
 19,312,   & "DATA" "/ MEMORY"  &
313,314,   & "PLOT"+sk_bracket_5 "ALL"  &
 28,  0,   & "TRACE"    &
315,  0,   & "GRATICULE"    &
316,  0,   & "MARKER(S)"    &
317,  0,   & "TEXT"    &
186,318,   & "SELECT" "QUADRANT"  &
186,319,   & "SELECT" "PEN COLOR"  &
 34,  0,   & "MORE"    &
320,321,   & "LIST TRACE" "VALUES"  &
322,323,   & "SYSTEM"+sk_bracket_2 "PARAMETERS"  &
324,323,   & "OPERATING" "PARAMETERS"  &
325,326,   & "X -   LEFT"+sk_bracket_5 "- -  UPPER"  &
327,328,   & "- -   LEFT" "X -  LOWER"  &
329,326,   & "- X  RIGHT" "- -  UPPER"  &
330,331,   & "- -  RIGHT" "- X  LOWER"  &
332,333,   & "X X   FULL" "X X   PAGE"  &
334, 71,   & "PEN"+sk_bracket_8 " 1 "  &
 72,  0,   & " 2 "    &
 73,  0,   & " 3 "    &
302,  0,   & " 4 "    &
335,  0,   & " 5 "    &
336,  0,   & " 6 "    &
337,  0,   & " 7 "    &
338,  0,   & " 8 "    &
101,339,   & sk_bracket_2 half_vt+"PRINT"  &
340,  0,   & "PLOT"   &
341,  0,   & "NEXT PAGE"    &
342,343,   & "MARKER"+sk_bracket_6 "        1 "  &
344,  0,   & "          2 "    &
345,  0,   & "          3 "    &
346,  0,   & "          4 "    &
347,  0,   & "          5 "    &
314, 63,   & "ALL" "OFF"  &
348, 77,   & delta_char+" MODE" "MENU"  &
349,350,   & sk_bracket_6 half_vt+delta_char+" REF = 1"  &
351,  0,   & delta_char+" REF = 2"    &
352,  0,   & delta_char+" REF = 3"    &
353,  0,   & delta_char+" REF = 4"    &
354,  0,   & delta_char+" REF = 5"    &
348, 63,   & delta_char+" MODE" "OFF"  &
355,174,   & "MARKER to"+sk_bracket_2 "MINIMUM"  &
172,  0,   & "MAXIMUM"    &
356,  0,   & "TITLE"    &
357,358,   & "HP-IB" "ADDRESSES"  &
359, 63,   & "CRT" "OFF"  &
```

```
129,360,    & "SERVICE" "FUNCTIONS"  &
186,361,    & "SELECT" "LETTER"  &
362,  0,    & "SPACE"    &
363,  0,    & "BACKSPACE"    &
364,356,    & "ERASE" "TITLE"  &
120,  0,    & "DONE"    &
365,366,    & "8510 HP-IB"+sk_bracket_8 "ADDRESS"  &
367,  0,    & "SYSTEM BUS"    &
368,  0,    & "SOURCE"    &
369,  0,    & "TEST SET"    &
370,  0,    & "PLOTTER"    &
371,  0,    & "PRINTER"    &
372,  0,    & "AUTO CMD"    &
373,  0,    & "PASS THRU"    &
374,375,    & "SOFTWARE" "REVISION"  &
376,377,    & "SYSTEM BUS"+sk_bracket_2 "'LOCAL'"  &
378,  0,    & "'REMOTE'"    &
379,  0,    & "IF GAIN"    &
221,380,    & sk_bracket_3 half_vt+"LOCATION"  &
381,  0,    & "PEEK"    &
382,  0,    & "POKE"    &
383,  0,    & "TEST MENU"    &
   0;

END$
```

```
M68KL,P,"topkbd"
BEGIN

#FILE cids.work;
#FILE fiocnfig.work;
#FILE fkernel.work;
#FILE fkernel2.work;
#FILE fkernel3.work;
#FILE fintrpt.work;
#FILE crins.work;
#FILE ffifo.work;
#FILE ffifos.work;
#FILE fpubib.work;
#FILE cpubib.work;
#FILE fcommand.work;                              & for abort_command &
#FILE cmessag2.work;                               & for all_messages &
#FILE futil2.work;                                & for clear_message &
#FILE fnumber.work;                                  & for get_number &
#FILE fkeys.work;                        & for top_key_table and cmd_... &

BYTE CONSTANT key_clk := %23,        & clock prescaler := 3         &
              key_mod := %02,        & n-key rollover, encoded scan &
              key_erf := %E0,        & clear error flag             &
              key_out := %40,        & set output fifo mode         &
              key_clr := %C1;        & clear key fifo               &
INTEGER CONSTANT key_max       :=  35,
                 key_stat_mask := %0F;

BYTE key_data = io + %81,
     key_stat = io + %83,
     key_cmd  = io + %83;
INTEGER key_code;
GLOBAL INTEGER key_token;


SUBROUTINE init_keyboard_fifo;                                      ENTRY;
   BEGIN
      init_fifo( keyboard_fifo,
                 keyboard_fifo_size,
                 keybd_fifo,
                 keybd_fifo_not_full,
                 keybd_fifo_not_empty );
   END;


SUBROUTINE init_top_keyboard;
   BEGIN & init_top_keyboard &
      key_cmd := key_mod;
      key_cmd := key_clk;
      key_cmd := key_erf;
      key_cmd := key_out;
      key_cmd := key_clr;
   END;  & init_top_keyboard &
```

```
& a process &
PROCEDURE  top_key;                                              ENTRY;
   BEGIN & top_key &

      init_top_keyboard;
      iradr( ADRS(intrpt_top_key), top_key_vctr );

loop: IF (key_stat AND key_stat_mask) = 0 THEN
            waitio(top_key_vctr);  & wait for next keyboard interrupt. &
      abort_command := TRUE;
      IF TBIT(key_stat,6) THEN
         BEGIN
            key_cmd := key_clr;
            IF NOT remote THEN
               write_fifo( keyboard_fifo, cmd_illegal );
         END if tbit
      ELSE
         BEGIN
            key_code := INTEGER(key_data) AND %003F;
            IF key_code > key_max THEN
               BEGIN & if &
                  IF NOT remote THEN
                     write_fifo( keyboard_fifo, cmd_illegal );
               END   & if &
            ELSE
               BEGIN & else &
                  key_token := top_key_table[key_code];
                  set_serial_poll( key_pressed_srq );
                  IF NOT remote THEN
                     write_fifo(keyboard_fifo, key_token);
               END;  & else &
         END else not tbit;

      GO TO loop;

   END; & top_key &



& a process &
PROCEDURE keyboard;                                              ENTRY;
   BEGIN  & keyboard &
      INTEGER token;

loop: token := read_fifo( keyboard_fifo );

      IF token < 0 THEN     & these keys require parsing (0-9,., etc.) &
         BEGIN & if &
            acquire( entry_string );
            token := get_number(token);   & rtns term'r or non-numeric &
                                          & that aborted the entry.    &
            clear_message( all_messages );    & clear warning messages &
            write_fifo( token_fifo, token );
```

```
            IF ((token <= cmd_u4) AND (token >= cmd_enter)) THEN
               BEGIN & if &
                  wait( entry_string_ready );
                  set_serial_poll( entry_complete_srq );
               END;  & if &
            release( entry_string );
         END   & if &
      ELSE IF NOT ((token <= cmd_u4) AND (token >= cmd_enter)) THEN
         & ignore extraneous terminators &
         BEGIN & else if &
            clear_message( all_messages );    & clear warning messages &
            write_fifo( token_fifo, token );
         END;  & else if &

      GO TO loop;

   END;  & keyboard &

END$
```

## Claims

1. A data processing system comprising:
a keyboard including
   - at least one parameter selection key (425) operable to select a measurement parameter comprising a parameter value and a parameter unit;
   - at least one numeric key (431) operable to enter at least one digit of a mantissa of a digital representation of said parameter value; and
   - at least one terminator key (433, 435, 437, 439) operable to enter an exponent of said digital representation of said parameter value;

   and further comprising processor means coupled to said keyboard for receiving said measurement parameter;
   characterized in that
   - said terminator key (433, 435, 437, 439) has associated therewith a pair of reciprocal exponents of said digital representation of said parameter value; and
   - said processor means (143) is adapted to automatically select said parameter unit and one of said reciprocal exponents in response to the selection of said measurement parameter.

2. A data processing system in accordance with claim 1,
characterized by further comprising:
a plurality of dedicated functional keys (423, 425, 427, 429) selectable by a user for selecting frequently used measurement functions for processing the measurement instrument data; and
a plurality of menu keys (411) selectable by a user and used in conjunction with at least one of the plurality of functional keys for selecting less frequently used measurement functions for processing the measurement instrument data.

3. A data processing system in accordance with claim 2, characterized in that each of the plurality of menu keys (411) comprises a plurality of softkeys having functions and labels associated therewith, which functions and labels are alterable by the processor.

4. A data processing system in accordance with one of the claims 1 to 3, characterized in that said processing means comprises memory means (147) coupled to a CPU (143) for storing digitally manipulated data; and
a display means (153, 218) coupled to the CPU (143) and the memory means (147) having a visual display (149) for substantially simultaneously displaying side by side two traces of the data.

5. A data processing system as in claim 4, characterized in that the two side-by-side traces of displayed data each comprise real time data.

6. A data processing system as in claim 4, characterized in that the two side-by-side traces of displayed data each comprise historical data stored in the memory means.

7. A data processing system as in claim 4, characterized in that one of the two side-by-side traces of displayed data comprises real time data and one of the two side-by-side traces of displayed data comprises historical data stored in the memory means.

8. A data processing system as in claim 4, characterized in that it further comprises:
plotter means (155) coupled to the processor means for producing a hard copy output of the two side-by-side traces of data displayed on the visual display.

9. A data processing system as in claim 8, characterized in that the plotter means (155) produces a hard copy output of a plurality of the two side-by-side traces of data displayed on the visual display.

10. A data processing system in accordance with any one of the claims 4 to 9, characterized in that said display means is adapted to display said trace of data having displayed thereon a reference marker and a delta marker for measuring therebetween the amplitude difference in the value of the trace of data.

11. A data processing system as in claim 10, characterized by further comprising;
a keyboard for use by a user to select the positions of the reference marker and the delta marker.

12. A data processing system in accordance with any one of the claims 4 to 11, characterized in that said display means has a visual display for displaying a trace of the data; said trace of data has displayed thereon a marker for indicating a current value of the trace of data; and a keyboard is coupled to the processor, said keyboard having a value key and an equal marker key thereon for sequential use by a user to enter into the processor as the value of the value key the current value of the trace of data indicated by the marker.

**Revendications**

1. Un système de traitement de données pourvu :
d'un clavier comprenant
- au moins une touche (425) de sélection de paramètre qui peut être actionnée pour choisir un paramètre de mesure comprenant une valeur de paramètre et une unité de paramètre ;
- au moins une touche numérique (431) qui peut être actionnée pour entrer au moins un chiffre d'une mantisse d'une représentation numérique de ladite valeur du paramètre ; et
- au moins une touche de fin de programme (433, 435, 437, 439) qui peut être actionnée pour entrer un exposant de ladite représentation numérique de ladite valeur de paramètre ;

et pourvu en outre d'un moyen de traitement couplé audit clavier pour recevoir ledit paramètre de mesure ; caractérisé en ce que
- une paire d'exposants réciproques de ladite représentation numérique de ladite valeur de paramètre est associée à ladite touche de fin de programme (433, 435, 437, 439) ; et
- ledit moyen de traitement (143) est adapté à choisir automatiquement ladite unité de paramètre et l'un desdits exposants réciproques en réponse au choix dudit paramètre de mesure.

2. Un système de traitement de données selon la revendication 1, caractérisé en ce qu'il comprend en outre :
une pluralité de touches fonctionnelles spécialisées (423, 425, 427, 429) qui peuvent être choisies par un utilisateur pour choisir des fonctions de mesure utilisées fréquemment pour traiter les données d'instrument de mesure ; et
une pluralité de touches de menu (411) qui peuvent être choisies par un utilisateur et utilisées en conjonction avec au moins une touche fonctionnelle de la pluralité pour choisir des fonctions de mesure utilisées moins fréquemment pour traiter les données d'instrument de mesure.

3. Un système de traitement de données selon la revendication 2, caractérisé en ce que chacune des touches de menu (411) de la pluralité comprend une pluralité de touches programmables auxquelles sont associées des fonctions et des intitulés, ces fonctions et intitulés pouvant être modifiés par le moyen de traitement.

4. Un système de traitement de données selon l'une des revendications 1 à 3, caractérisé en ce que ledit moyen de traitement comprend un moyen de mémoire (147) couplé à une unité centrale de traitement ou UCT (143) pour mémoriser des données manipulées numériquement ; et
un moyen d'affichage (153, 218) couplé à l'UCT (143) et au moyen de mémoire (147) comportant un affichage visuel (149) pour afficher côte-à-côte, de façon sensiblement simultanée, deux traces des données.

5. Un système de traitement de données selon la revendication 4, caractérisé en ce que les deux traces de données affichées disposées côte-à-côte comprennent chacune des données en temps réel.

6. Un système de traitement de données selon la revendication 4, caractérisé en ce que les deux traces de données affichées disposées côte-à-côte comprennent chacune des données historiques mémorisées dans le moyen de mémoire.

7. Un système de traitement de données selon la revendication 4, caractérisé en ce que l'une des deux traces de données affichées disposées côte-à-côte comprend des données en temps réel et l'une des deux traces de données affichées disposées côte-à-côte comprend des données historiques mémorisées dans le moyen de mémoire.

8. Un système de traitement de données selon la revendication 4, caractérisé en ce qu'il comprend en outre :
un moyen traceur (155) couplé au moyen de traitement pour produire une sortie imprimée sur papier des deux traces de données affichées côte-à-côte sur le moyen d'affichage.

9. Un système de traitement de données selon la revendication 8, caractérisé en ce que le moyen traceur (155) produit une sortie imprimée sur papier d'une pluralité des deux traces de données affichées côte-à-côte sur le moyen d'affichage.

10. Un système de traitement de données selon l'une quelconque des revendications 4 à 9, caractérisé en ce que ledit moyen d'affichage est apte à afficher ladite trace de données sur laquelle sont affichés un repère de référence et un repère de delta ou de différence pour mesurer entre les deux la différence d'amplitude de la valeur de la trace de données.

11. Un système de traitement de données selon la revendication 10, caractérisé en ce qu'il comprend en outre :
un clavier destiné à être utilisé par un utilisateur pour choisir les positions du repère de référence et du repère de différence.

12. Un système de traitement de données selon l'une quelconque des revendications 4 à 11, caractérisé en ce que ledit moyen d'affichage comporte un affichage visuel destiné à afficher une trace des données ; un repère destiné à indiquer une valeur actuelle de la trace de données est affiché sur ladite trace de données ; et un clavier est couplé au moyen de traitement, ledit clavier comportant une touche de valeur et une touche de repère égal en vue d'une utilisation séquentielle par un utilisateur pour entrer dans le moyen de traitement, en tant que valeur de la touche de valeur, la valeur actuelle de la trace de données indiquée par le repère.

**Patentansprüche**

1. Datenverarbeitungssystem, das aufweist:
eine Tastatur einschließlich
- mindestens einer Parameterwähltaste (425), die zur Auswahl eines aus einem Parameterwert und einer Parametereinheit bestehenden Meßparameters betreibbar ist;
- mindestens eine numerische Taste (431), die zur Eingabe mindestens einer Ziffer einer Mantisse einer Digitaldarstellung des Parameterwerts betreibbar ist;

- mindestens eine Abschlußtaste (433,435,437,439), welche zur Eingabe eines Exponenten der Digitaldarstellung des Paramterwerts betreibbar ist; und

weiterhin eine mit der Tastatur verbundene Verarbeitungseinrichtung zum Empfang des Meßparameters,
dadurch gekennzeichnet, daß
- der Abschlußtaste (433, 435, 437, 439) zwei reziproke Exponenten der Digitaldarstellung des Parameterwerts zugeordnet sind;
- die Verarbeitungseinrichtung (143) zur automatischen Auswahl der Parametereinheit und eines der reziproken Exponenten in Übereinstimmung mit der Auswahl des Meßparameters eingerichtet ist.

**2.** Datenverarbeitungssystem nach Anspruch 1,
dadurch gekennzeichnet, daß es weiterhin aufweist:
mehrere besonders zugeordnete Funktionstasten (423, 425, 427, 429), die durch einen Bediener zur Auswahl häufig verwendeter Meßfunktionen zur Verarbeitung der Meßgerätedaten auswählbar sind; und mehrere durch einen Bediener auswählbare Menütasten (411), die in Verbindung mit mindestens einer Funktionstaste zur Auswahl weniger häufig benutzter Meßfunktionen zur Verar - beitung der Meßgerätedaten auswählbar sind.

**3.** Datenverarbeitungssystem nach Anspruch 2,
dadurch gekennzeichnet, daß
jede der Menütasten (411) eine Vielzahl von Softtasten aufweist, welchen durch die Verarbeitungseinrichtung änderbare Funktionen und Bezeichnungen zugeordnet sind.

**4.** Datenverarbeitungssystem nach einem der Ansprüche 1 - 3,
dadurch gekennzeichnet, daß
die Verarbeitungseinrichtung eine mit einer CPU (143) gekoppelte Speichereinrichtung (147) zum digitalen Speichern manipulierter Daten, und
eine mit der CPU (153) und der Speichereinrichtung (147) gekoppelte Anzeigeeinrichtung (143, 218) aufweist, die eine Sichtanzeige (149) aufweist, um zwei Kurven der Daten im wesentlichen gleichzeitig und nebeneinander anzuzeigen.

**5.** Datenverarbeitungssystem nach Anspruch 4,
dadurch gekennzeichnet, daß die zwei nebeneinander angezeigten Kurven der Daten jeweils Echtzeitdaten aufweisen.

**6.** Datenverarbeitungssystem nach Anspruch 4,
dadurch gekennzeichnet, daß
die nebeneinander angezeigten Kurven der Daten jeweils in der Speichereinrichtung gespeicherte vergangene Daten aufweisen.

**7.** Datenverarbeitungssystem nach Anspruch 4,
dadurch gekennzeichnet, daß eine der beiden nebeneinander angezeigten Datenkurven Echtzeitdaten und die andere Datenkurve vergangene, in der Speichereinrichtung gespeicherte Daten aufweist.

**8.** Datenverarbeitungssystem nach Anspruch 4,
dadurch gekennzeichnet, daß es weiterhin
eine Plottereinrichtung (155), die mit der Verarbeitungseinrichtung verbunden ist, um eine Hardcopy mehrerer nebeneinander an der Sichtanzeige angezeigter Datenkurven zu erzeugen aufweist.

**9.** Datenverarbeitungssystem nach Anspruch 8,
dadurch gekennzeichnet, daß
die Plottereinrichtung eine Hardcopy einer Vielzahl der beiden nebeneinander an der Sichtanzeige angezeigten Datenkurven erzeugt.

**10.** Datenverarbeitungssystem nach einem der Ansprüche 4 - 9,
dadurch gekennzeichnet, daß
die Anzeigeeinrichtung zur Anzeige der Datenkurven mit einer Bezugsmarke und einer Deltamarke eingerichtet ist, um zwischen diesen Marken die Amplitudendifferenz in den Werten der Datenkurve zu messen.

**11.** Datenverarbeitungssystem nach Anspruch 10, dadurch gekennzeichnet, daß es weiterhin eine durch einen Benutzer zu benutzende Tastatur zur Auswahl der Positionen der Bezugsmarke und der Deltamarke aufweist.

**12.** Datenverarbeitungssystem nach einem der Ansprüche 4 - 11, dadurch gekennzeichnet, daß die Anzeigeeinrichtung eine Sichtanzeige zur Anzeige einer Datenkurve hat, wobei auf der Datenkurve eine Marke zur Angabe eines laufenden Werts der Datenkurve angezeigt wird, und die Tastatur mit der Verarbeitungseinrichtung gekoppelt ist und eine Wertetaste und eine Gleichheitsmarkierungstaste hat, die sequentiell durch einen Benutzer benutzt werden, um der Verarbeitungseinrichtung als Wert der Wertetaste den laufenden Wert der Datenkurve einzugeben, welchen die Marke angibt.

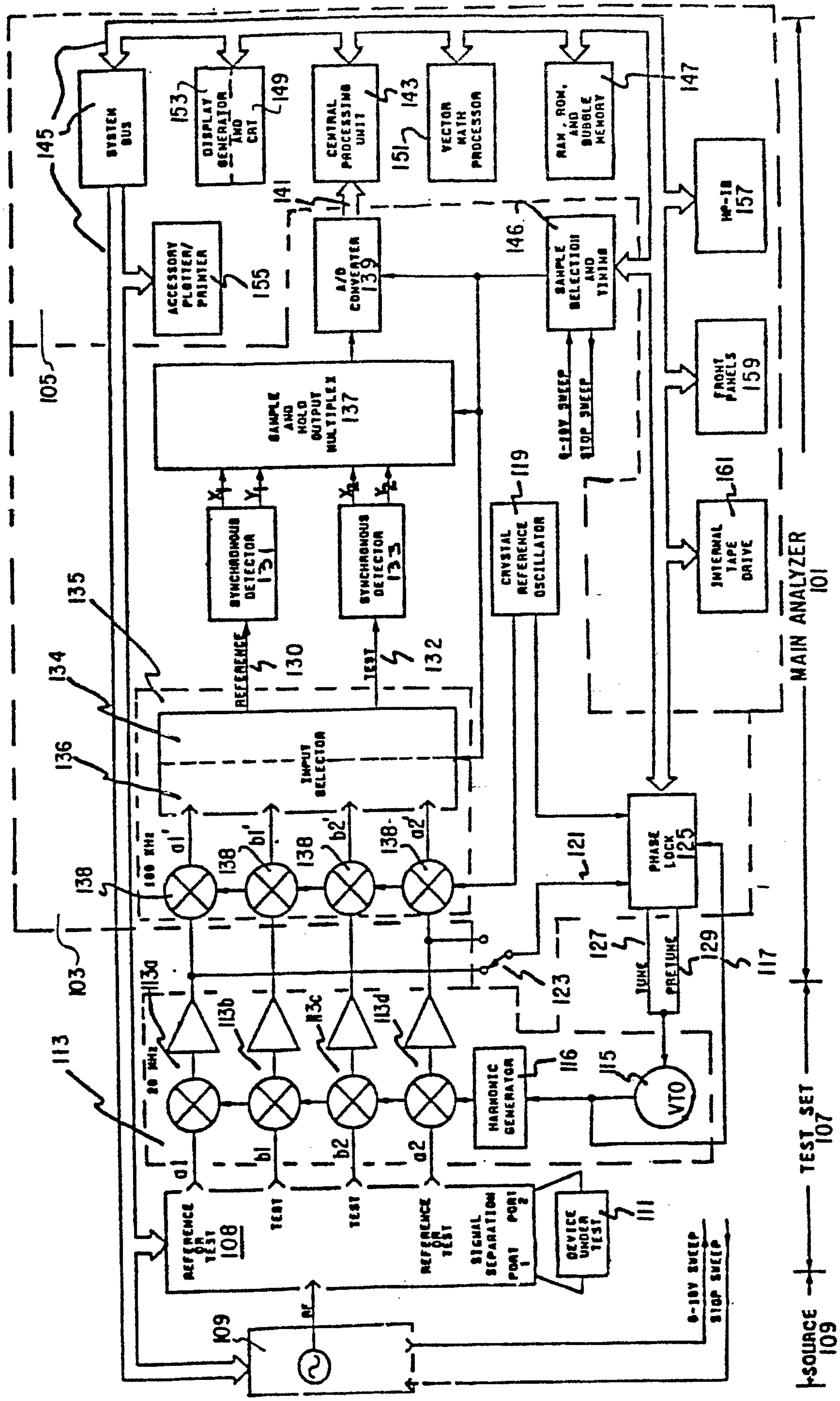
SYSTEM BUS
DISPLAY GENERATOR AND CRT
CENTRAL PROCESSING UNIT
VECTOR MATH PROCESSOR
RAM, ROM, AND BUBBLE MEMORY
HP-IB
ACCESSORY PLOTTER/ PRINTER
A/D CONVERTER 139
SAMPLE SELECTION AND TIMING
FRONT PANELS 159
SAMPLE AND HOLD OUTPUT MULTIPLEX 137
0-10V SWEEP
STOP SWEEP
SYNCHRONOUS DETECTOR 131
SYNCHRONOUS DETECTOR 133
CRYSTAL REFERENCE OSCILLATOR
INTERNAL TAPE DRIVE
MAIN ANALYZER 101
REFERENCE
TEST
INPUT SELECTOR
100 kHz
20 MHz
PHASE LOCK 125
TUNE
PRETUNE
HARMONIC GENERATOR
VTO
REFERENCE OR TEST 108
TEST
TEST
REFERENCE OR TEST
SIGNAL SEPARATION
PORT 1
PORT 2
DEVICE UNDER TEST
RF
TEST SET 107
SOURCE 109
145
153
149
143
151
147
141
146
155
105
157
119
161
135
134
130
132
136
138
121
127
129
123
117
113
113a
113b
113c
113d
116
115
103
111
109
a1
b1
b2
a2
a1'
b1'
b2'
a2'

FIG I

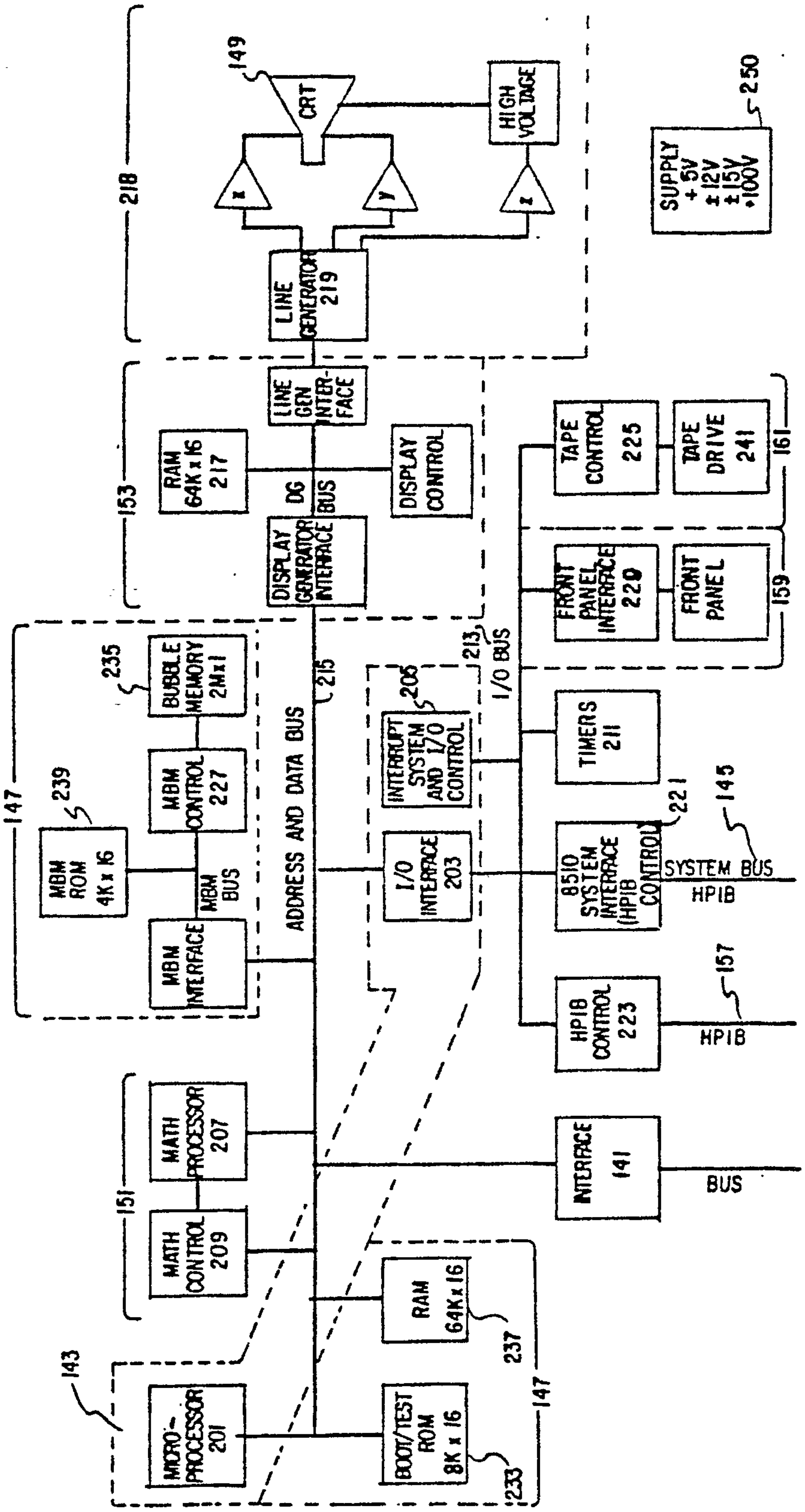
218
149
CRT
HIGH VOLTAGE
LINE GENERATOR 219
250
SUPPLY + 5V ± 12V ± 15V +100V
153
RAM 64K x 16 217
LINE GEN INTER-FACE
DG BUS
DISPLAY CONTROL
DISPLAY GENERATOR INTERFACE
147
235
BUBBLE MEMORY 2M x 1
239
MBM ROM 4K x 16
MBM CONTROL 227
MBM BUS
MBM INTERFACE
ADDRESS AND DATA BUS
215
213
I/O BUS
205
INTERRUPT SYSTEM AND I/O CONTROL
I/O INTERFACE 203
TAPE CONTROL 225
TAPE DRIVE 241
161
FRONT PANEL INTERFACE 220
FRONT PANEL
159
TIMERS 211
221
8510 SYSTEM INTERFACE (HPIB CONTROL)
145
SYSTEM BUS
HPIB
HPIB CONTROL 223
157
HPIB
151
MATH PROCESSOR 207
MATH CONTROL 209
INTERFACE 141
BUS
RAM 64K x 16
237
143
MICRO-PROCESSOR 201
BOOT/TEST ROM 8K x 16
233
147

FIG 2

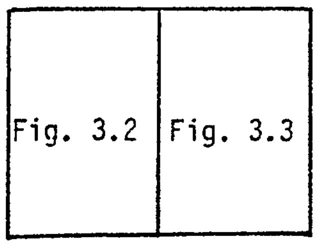


Fig. 3.1

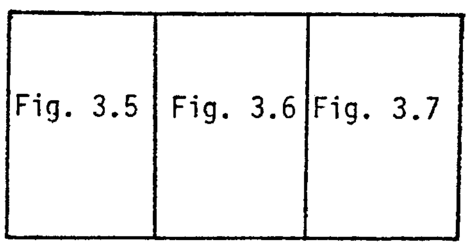


Fig. 3.4

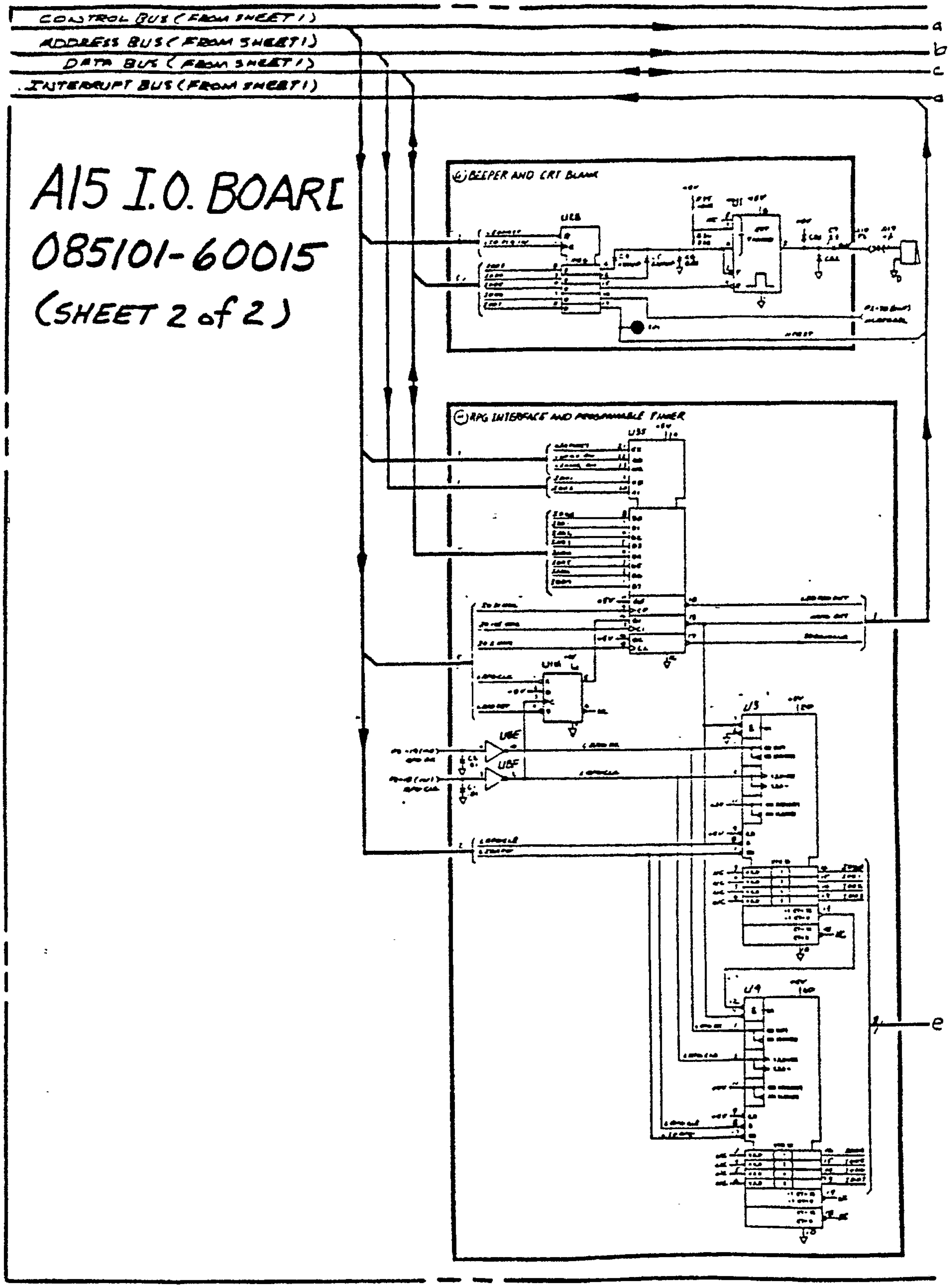
CONTROL BUS (FROM SHEET 1)
ADDRESS BUS (FROM SHEET 1)
DATA BUS (FROM SHEET 1)
INTERRUPT BUS (FROM SHEET 1)
a
b
c
d
e
A15 I.O. BOARD
085101-60015
(SHEET 2 of 2)
BEEPER AND CRT BLANK
RPG INTERFACE AND PROGRAMMABLE TIMER
U35
U3
U4
U8E
U8F

FIG 3.2

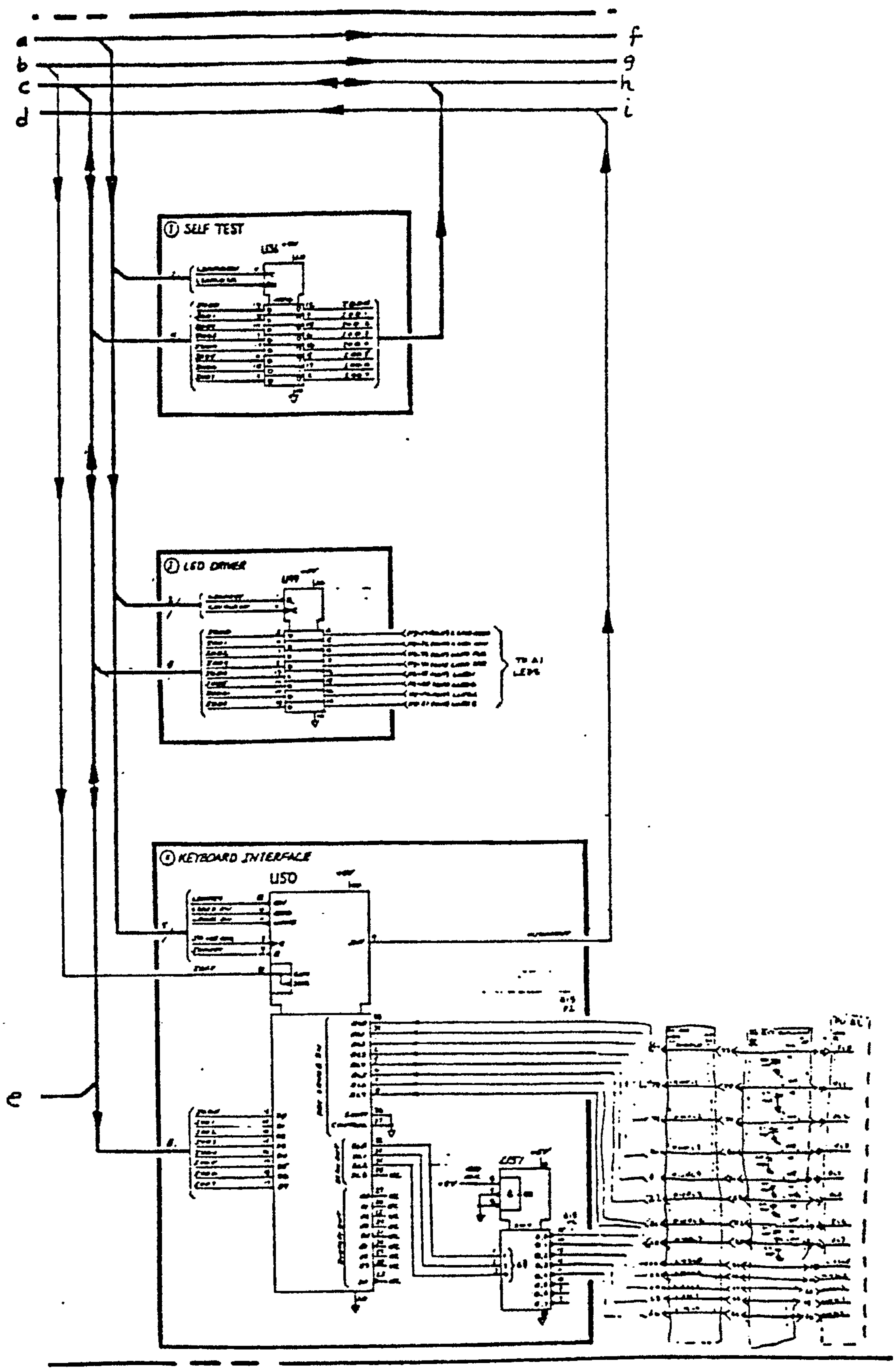
a
b
c
d
e
f
g
h
i
① SELF TEST
② LED DRIVER
④ KEYBOARD INTERFACE
U50
U57

FIG 3.3

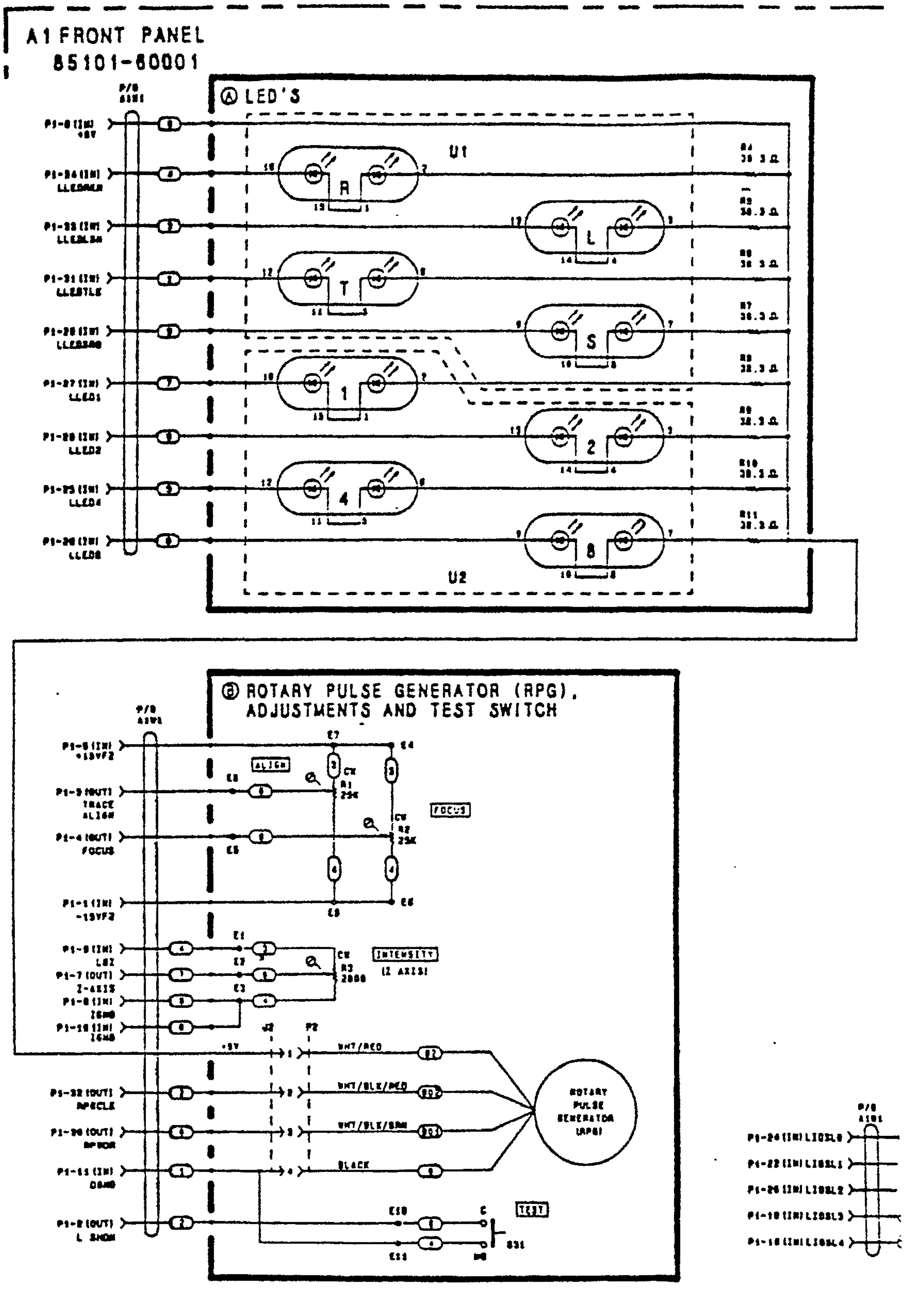
A1 FRONT PANEL
85101-60001
Ⓐ LED'S
U1
U2
R
L
T
S
1
2
4
8
Ⓑ ROTARY PULSE GENERATOR (RPG), ADJUSTMENTS AND TEST SWITCH
ALIGN
FOCUS
INTENSITY
(Z AXIS)
TEST
ROTARY PULSE GENERATOR (RPG)

FIG 3.5

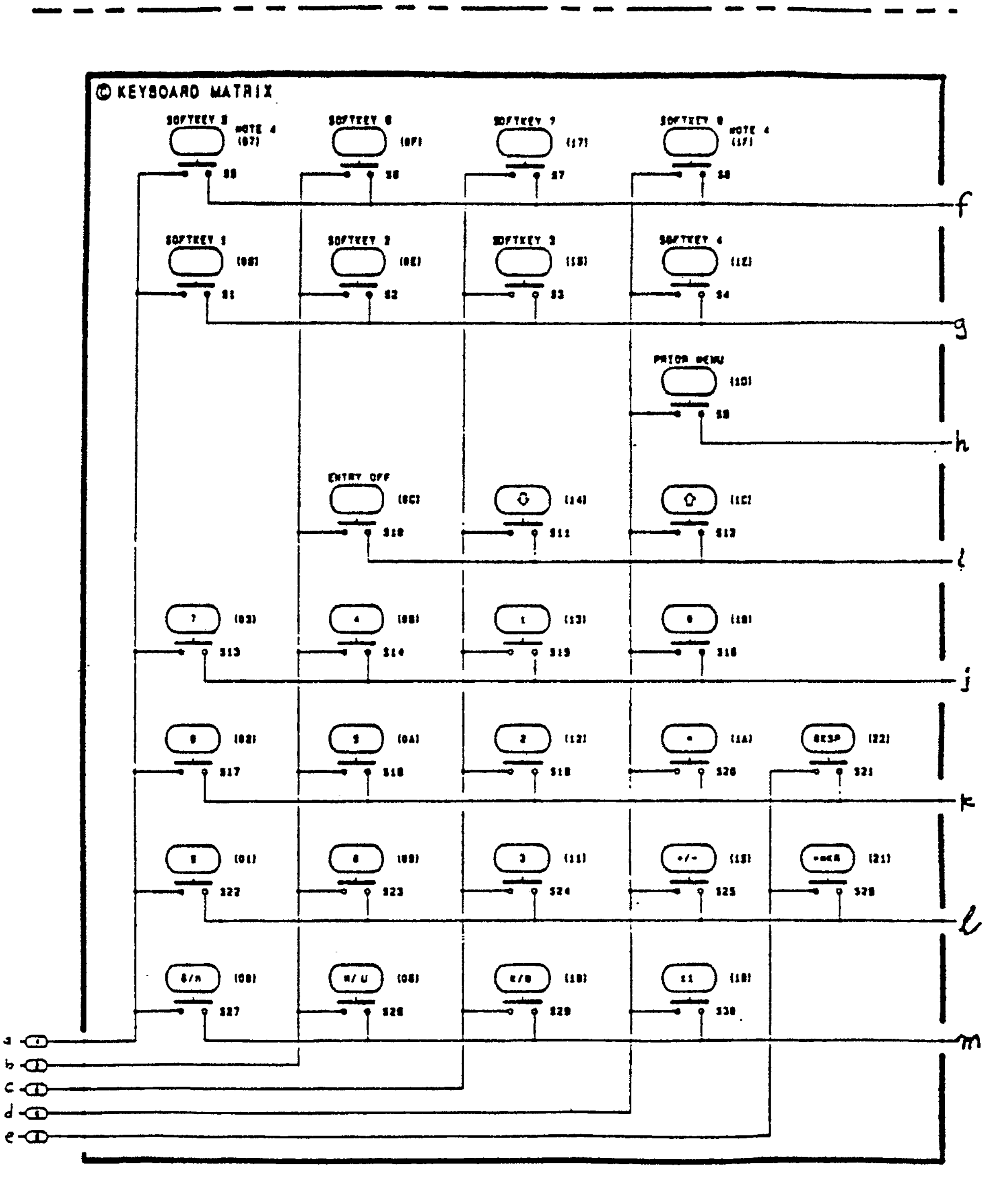


FIG 3.6

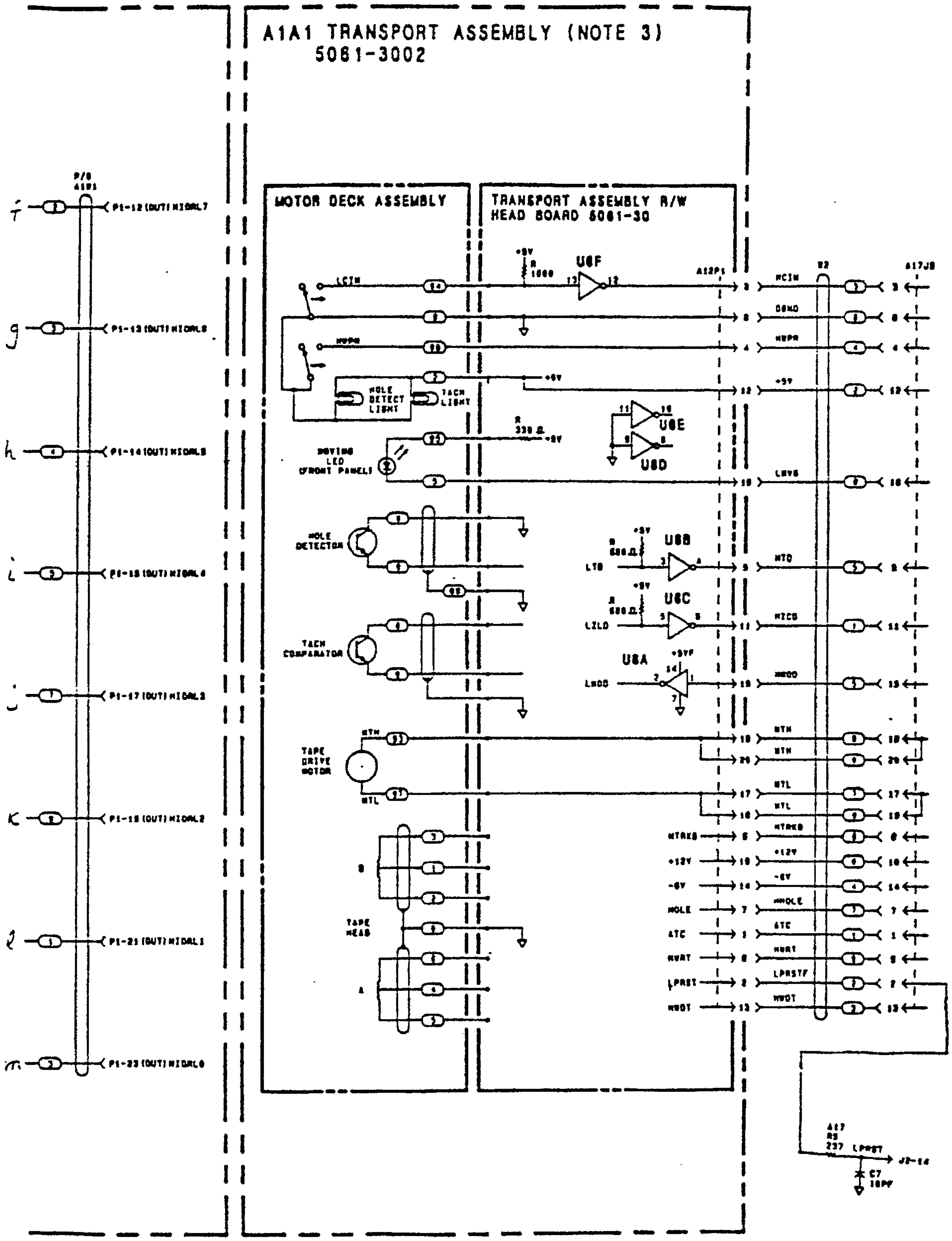
A1A1 TRANSPORT ASSEMBLY (NOTE 3)
5061-3002
MOTOR DECK ASSEMBLY
TRANSPORT ASSEMBLY R/W
HEAD BOARD 5061-30
U6F
U6E
U6D
U6B
U6C
U6A

FIG 3.7

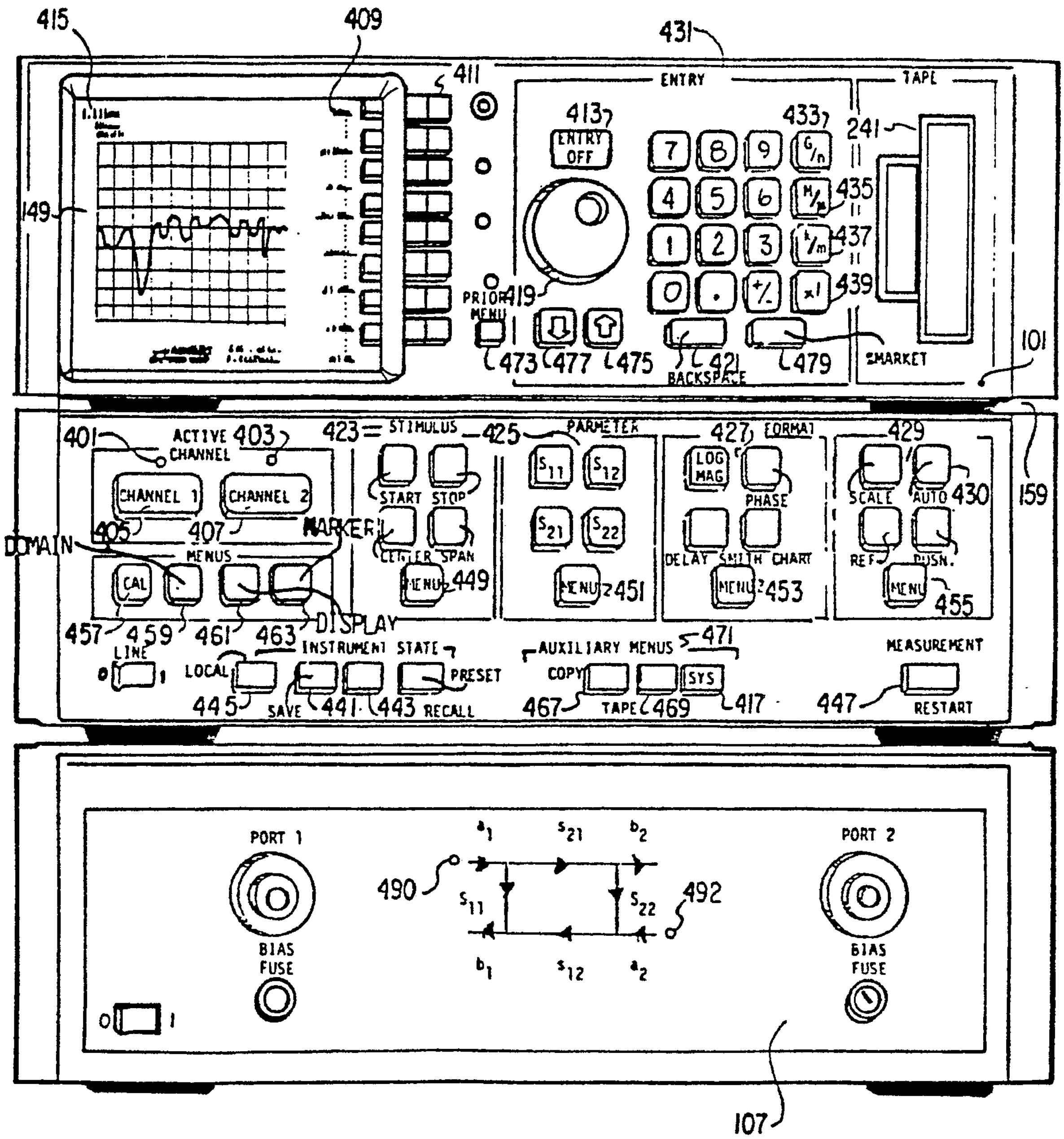
415
409
411
431
ENTRY
TAPE
413
ENTRY OFF
433
7 8 9
4 5 6
1 2 3
0 .
435
437
439
241
149
PRIOR MENU
419
473 477 475
421
BACKSPACE
479
SMARKET
101
401
ACTIVE CHANNEL
403
CHANNEL 1
CHANNEL 2
405 407
423 STIMULUS
START STOP
CENTER SPAN
MENU 449
425 PARMETER
$S_{11}$ $S_{12}$ $S_{21}$ $S_{22}$
MENU 451
427 FORMAT
LOG MAG
PHASE
DELAY SMITH CHART
MENU 453
429
SCALE AUTO 430
REF. POSN.
MENU 455
159
DOMAIN
MARKER
MENUS
CAL
457 459 461 463
DISPLAY
LINE
LOCAL
INSTRUMENT STATE
PRESET
445 SAVE 441 443 RECALL
AUXILIARY MENUS 471
COPY
SYS
467 TAPE 469 417
MEASUREMENT
447 RESTART
PORT 1
PORT 2
$a_1$ $s_{21}$ $b_2$
490
$s_{11}$ $s_{22}$
492
$b_1$ $s_{12}$ $a_2$
BIAS FUSE
BIAS FUSE
107

FIG 4

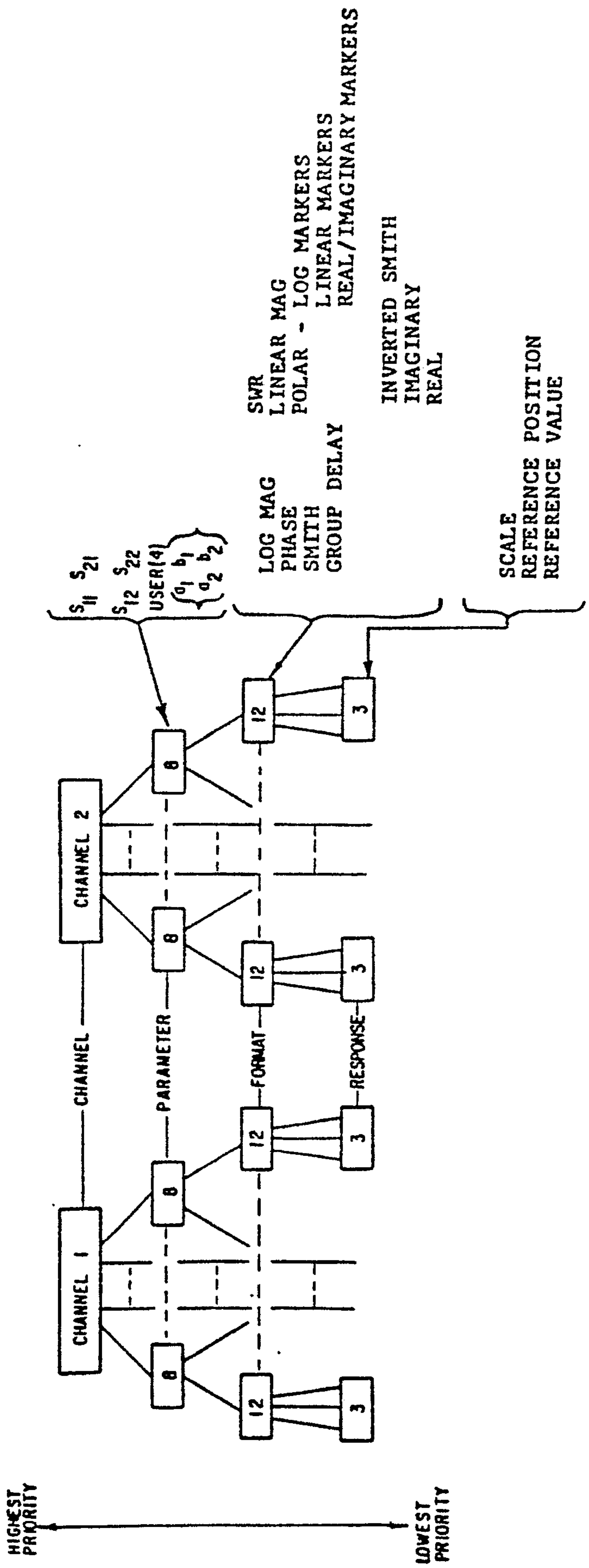
HIGHEST PRIORITY
LOWEST PRIORITY
CHANNEL 1
CHANNEL 2
CHANNEL
PARAMETER
FORMAT
RESPONSE
8
12
3
$S_{11}$ $S_{21}$
$S_{12}$ $S_{22}$
USER(4)
$a_1$ $b_1$
$a_2$ $b_2$
LOG MAG
PHASE
SMITH
GROUP DELAY
SWR
LINEAR MAG
POLAR - LOG MARKERS
LINEAR MARKERS
REAL/IMAGINARY MARKERS
INVERTED SMITH
IMAGINARY
REAL
SCALE
REFERENCE POSITION
REFERENCE VALUE

FIG 5

FIG 6

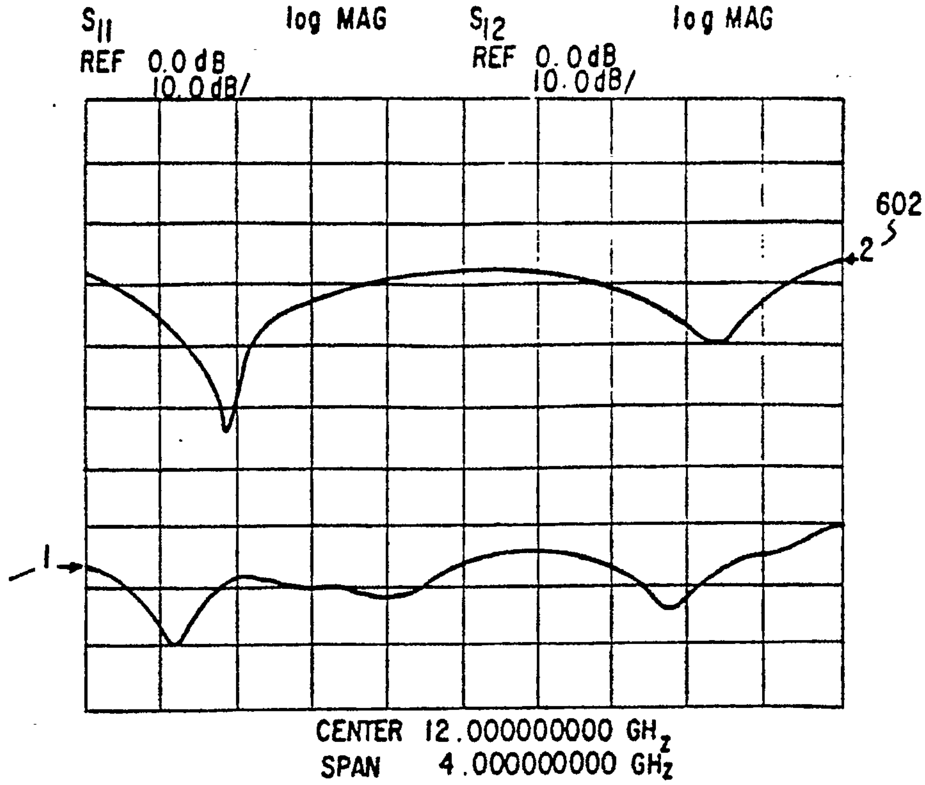
S11 log MAG
REF 0.0 dB
10.0 dB/
S12 log MAG
REF 0.0 dB
10.0 dB/
602
2
1
CENTER 12.000000000 GHz
SPAN 4.000000000 GHz

FIG 7

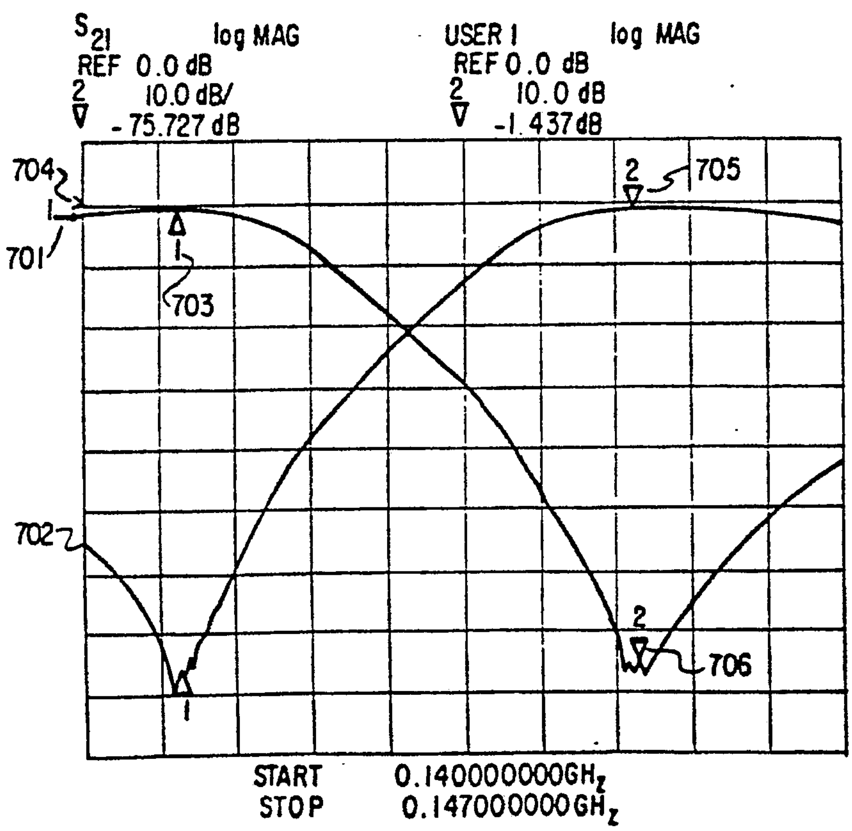
S21 log MAG
REF 0.0 dB
2 10.0 dB/
-75.727 dB
USER 1 log MAG
REF 0.0 dB
2 10.0 dB
-1.437 dB
704
1
701
703
2
705
702
1
2
706
START 0.140000000 GHz
STOP 0.147000000 GHz

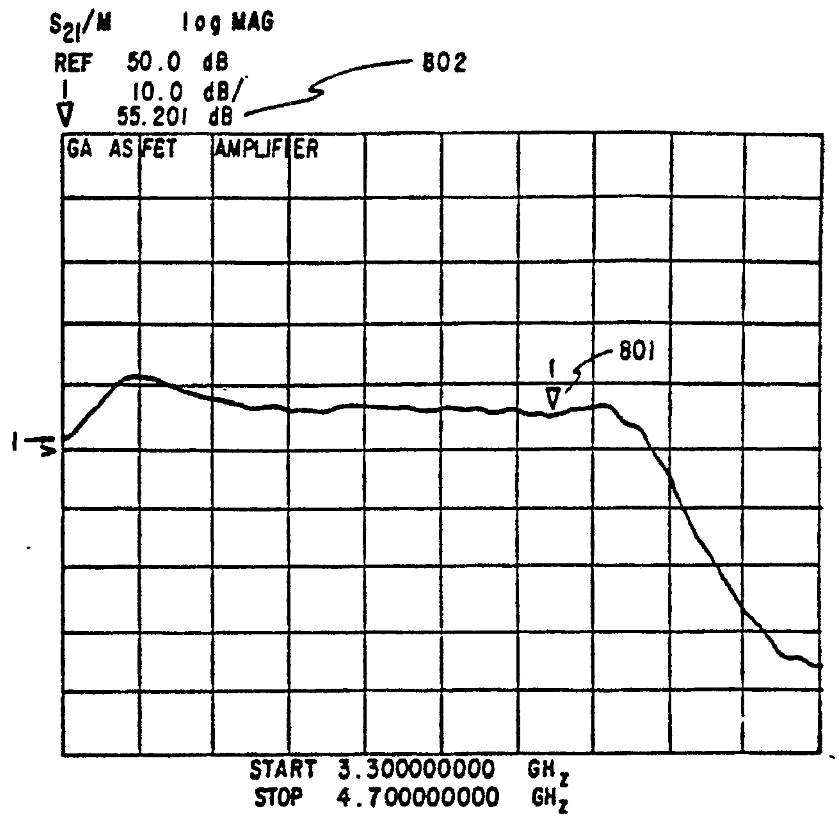
S21/M log MAG
REF 50.0 dB
I 10.0 dB/
∇ 55.201 dB
802
GA AS FET AMPLIFIER
801
START 3.300000000 GHz
STOP 4.700000000 GHz

FIG 8

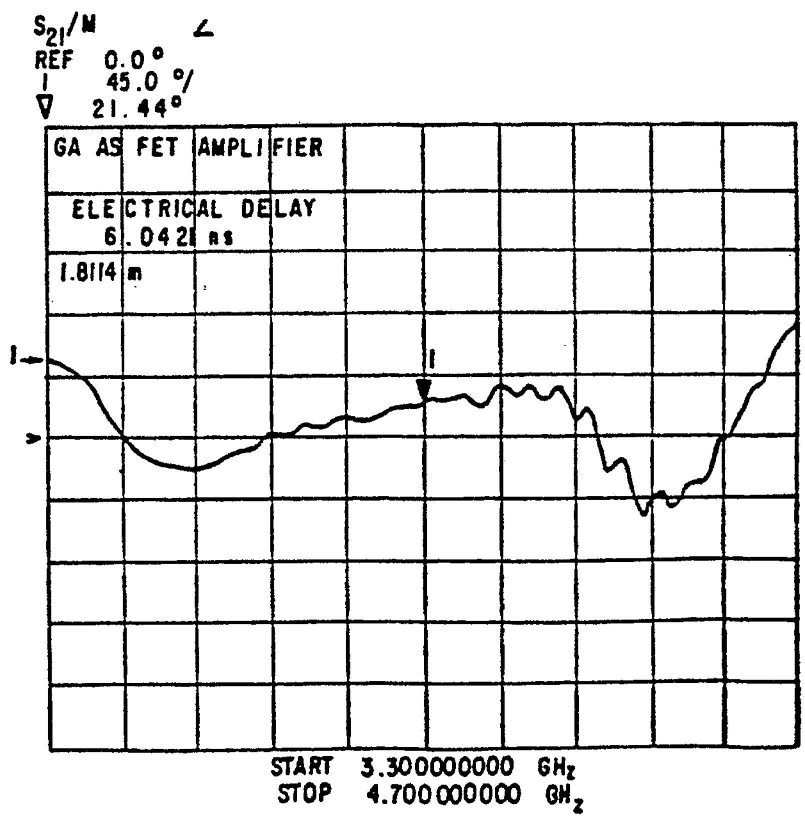
S21/M ∠
REF 0.0°
I 45.0 °/
∇ 21.44°
GA AS FET AMPLIFIER
ELECTRICAL DELAY
6.0421 ns
1.8114 m
START 3.300000000 GHz
STOP 4.700000000 GHz

FIG 9

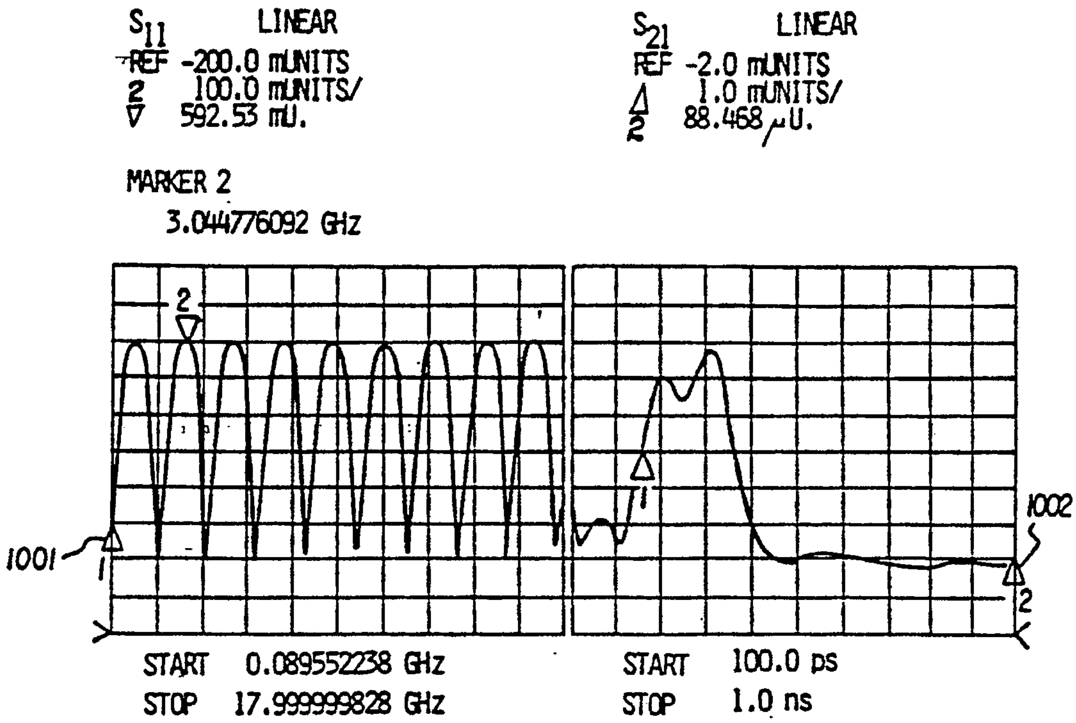
S11 LINEAR
REF -200.0 mUNITS
2 100.0 mUNITS/
∇ 592.53 mU.
MARKER 2
3.044776092 GHz
S21 LINEAR
REF -2.0 mUNITS
Δ 1.0 mUNITS/
2 88.468 μU.
1001
1002
START 0.089552238 GHz
STOP 17.999999828 GHz
START 100.0 ps
STOP 1.0 ns

FIG 10

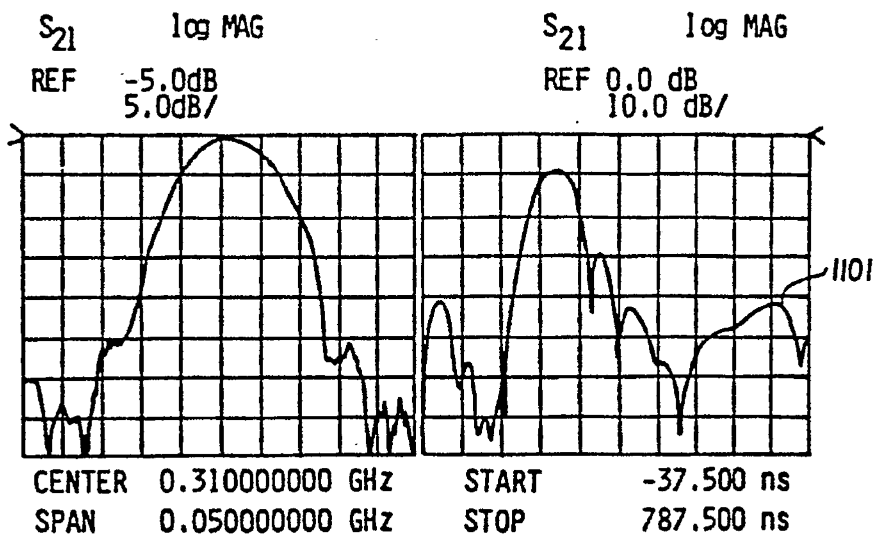
S21 log MAG
REF -5.0dB
5.0dB/
S21 log MAG
REF 0.0 dB
10.0 dB/
1101
CENTER 0.310000000 GHz
SPAN 0.050000000 GHz
START -37.500 ns
STOP 787.500 ns

FIG 11

FIG 12

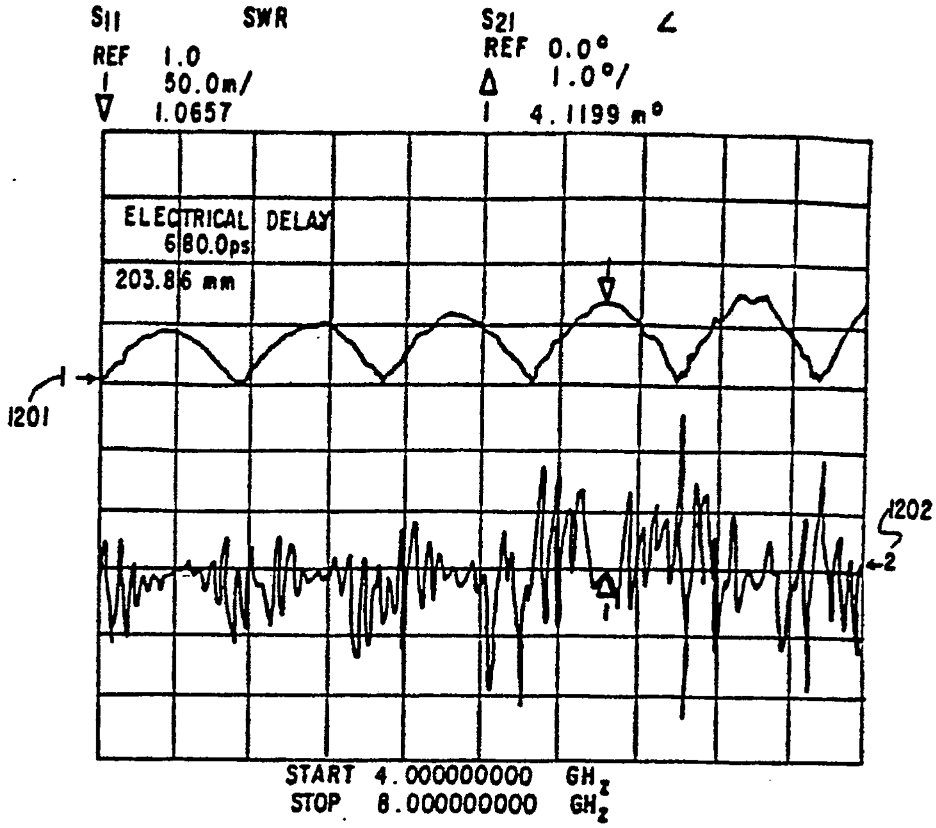
S11 SWR
REF 1.0
1 50.0m/
∇ 1.0657
S21 ∠
REF 0.0°
Δ 1.0°/
1 4.1199 m°
ELECTRICAL DELAY
680.0ps
203.86 mm
1201
1202
START 4.000000000 GHz
STOP 8.000000000 GHz

FIG 13

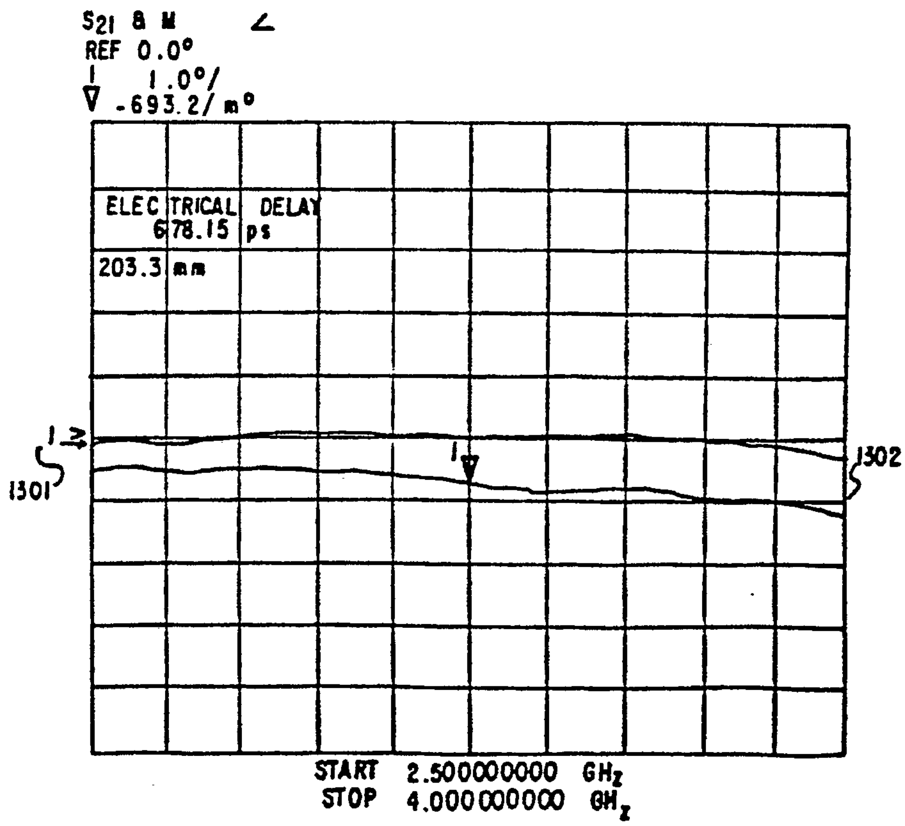
S21 & M ∠
REF 0.0°
1 1.0°/
∇ -693.2/m°
ELECTRICAL DELAY
678.15 ps
203.3 mm
1301
1302
START 2.500000000 GHz
STOP 4.000000000 GHz

FIG 14

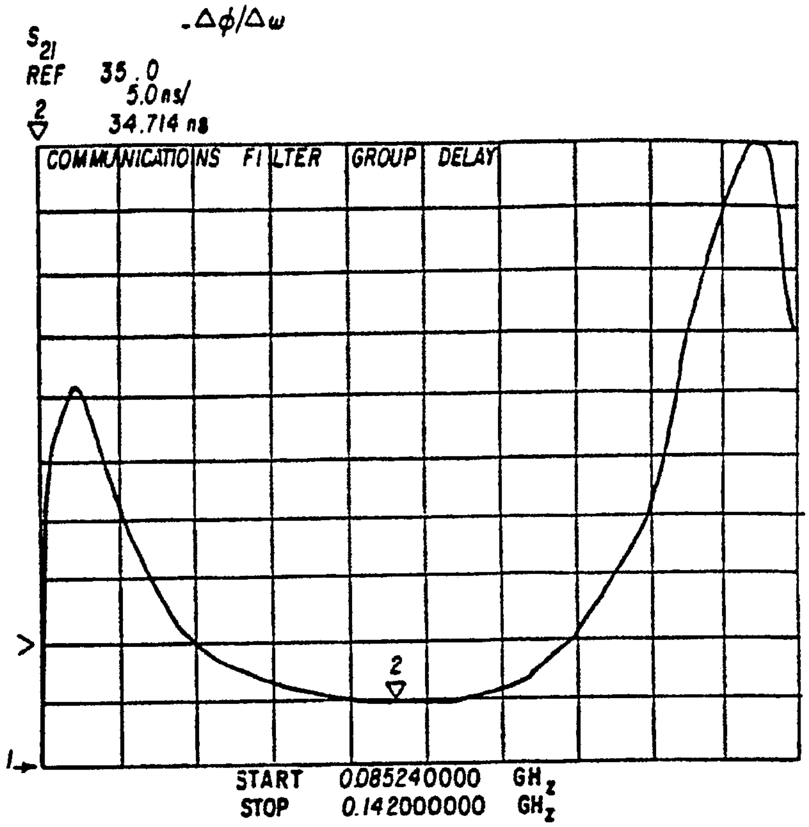


FIG 16

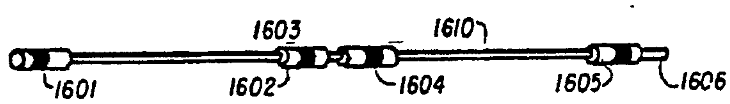


FIG 15

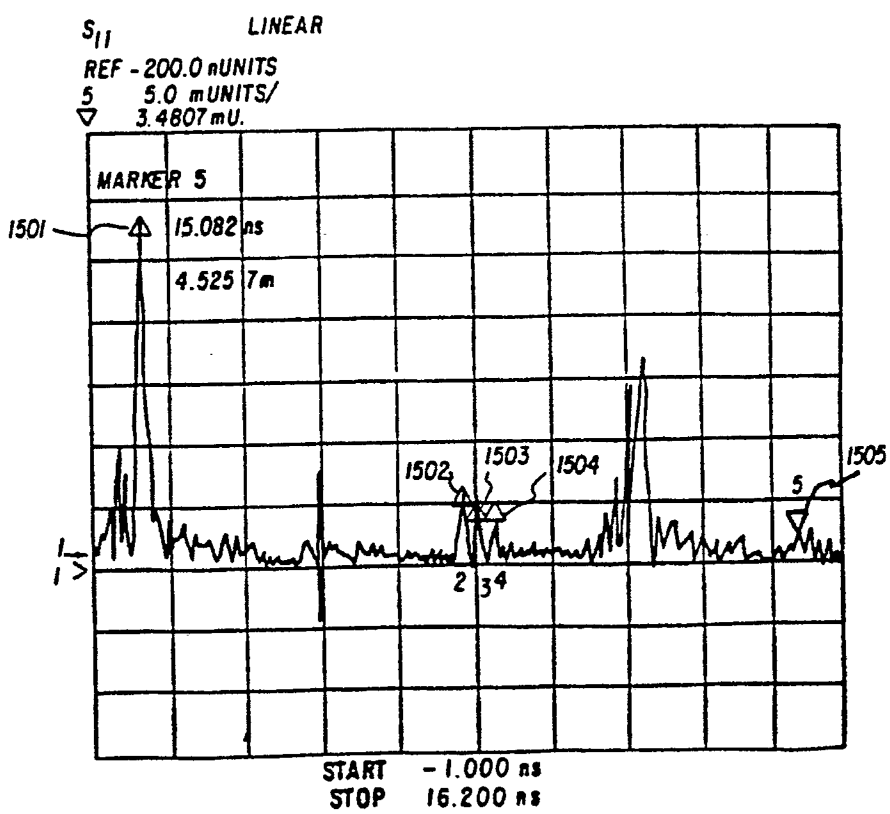

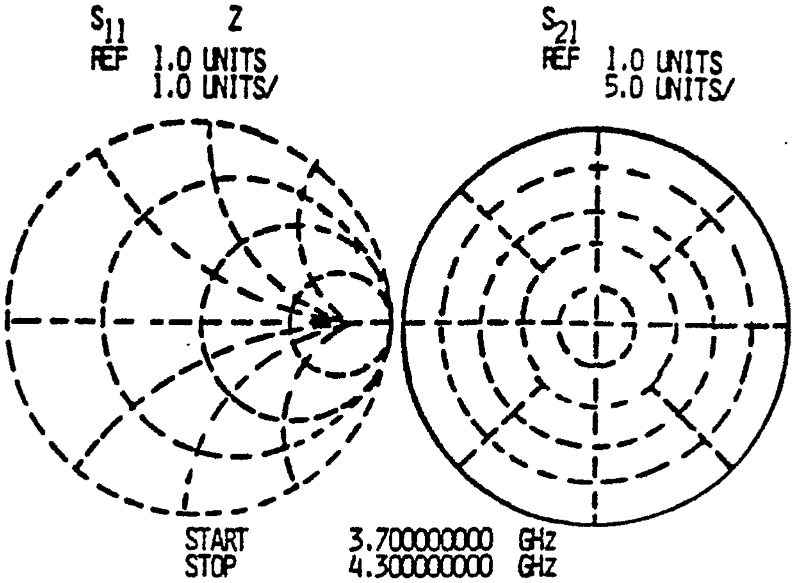

S11 Z
REF 1.0 UNITS
1.0 UNITS/
S21
REF 1.0 UNITS
5.0 UNITS/
START 3.700000000 GHz
STOP 4.300000000 GHz


FIG 17

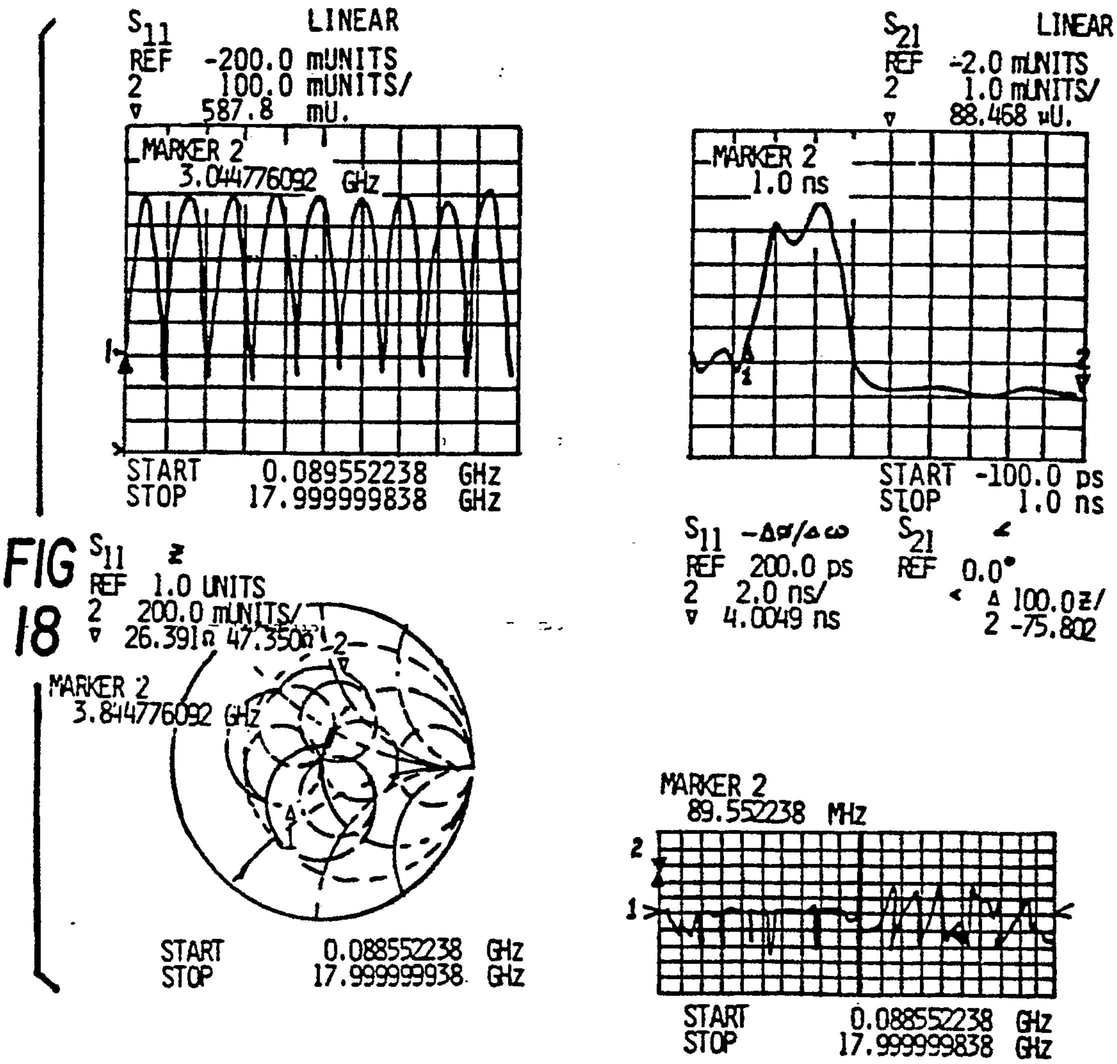

S11 LINEAR
REF -200.0 mUNITS
2 100.0 mUNITS/
▿ 587.8 mU.
MARKER 2
3.044776092 GHz
START 0.089552238 GHz
STOP 17.999999838 GHz
S21 LINEAR
REF -2.0 mUNITS
2 1.0 mUNITS/
▿ 88.468 μU.
MARKER 2
1.0 ns
START -100.0 ps
STOP 1.0 ns
S11 Z
REF 1.0 UNITS
2 200.0 mUNITS/
▿ 26.391Ω 47.350Ω
MARKER 2
3.844776092 GHz
START 0.088552238 GHz
STOP 17.999999938 GHz
S11 -Δφ/Δω
REF 200.0 ps
2 2.0 ns/
▿ 4.0049 ns
S21 ∠
REF 0.0°
∠ Δ 100.0°/
2 -75.802
MARKER 2
89.552238 MHz
START 0.088552238 GHz
STOP 17.999999838 GHz


FIG 18

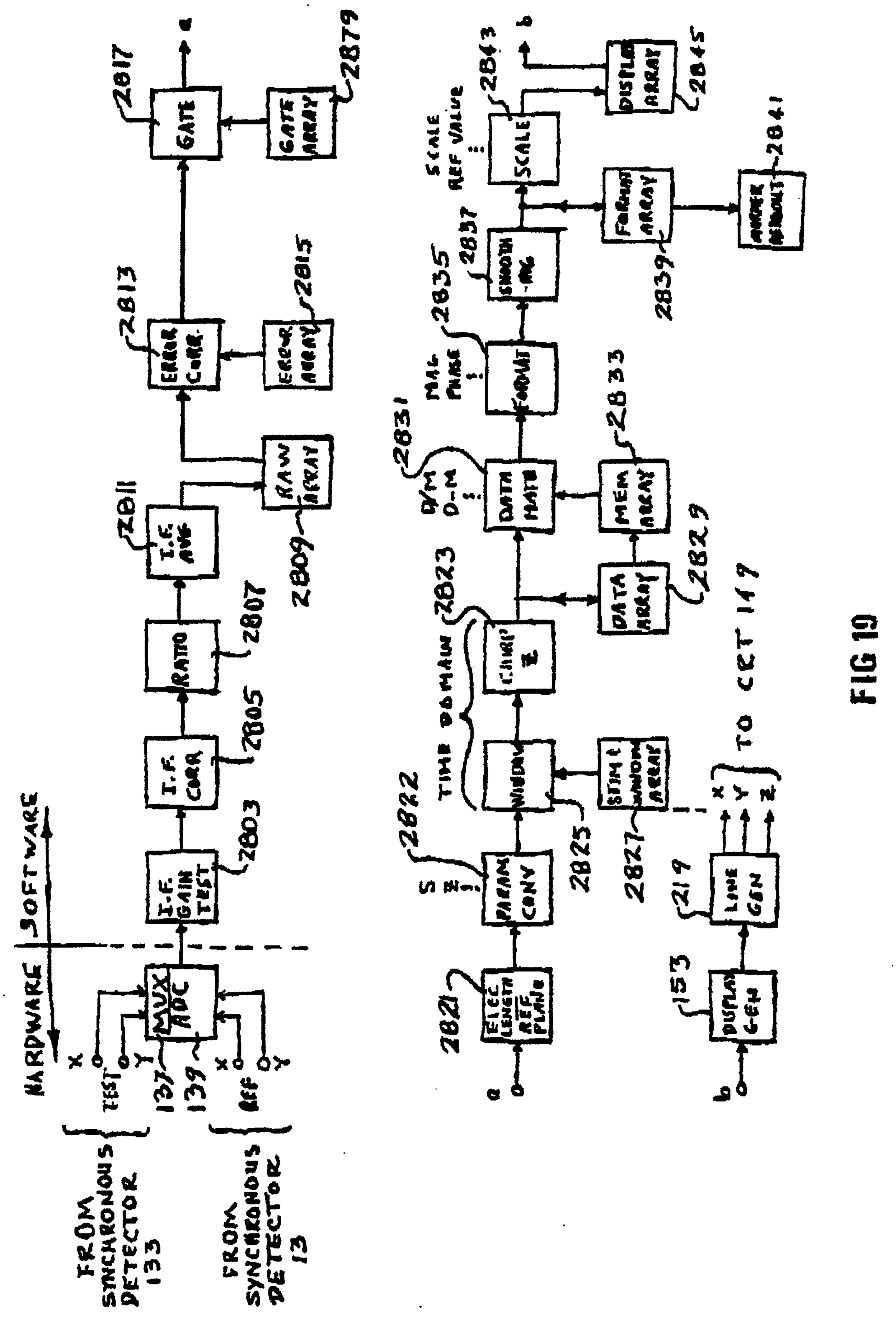
HARDWARE
SOFTWARE
FROM SYNCHRONOUS DETECTOR 133
FROM SYNCHRONOUS DETECTOR 13
TEST
REF
MUX
ADC
I.F. GAIN TEST
I.F. CORR
RATIO
I.F. AVG
RAW ARRAY
ERROR CORR.
ERROR ARRAY
GATE
GATE ARRAY
ELEC LENGTH REF. PLANE
PARAM CONV
WINDOW
CHIRP Z
DATA ARRAY
DATA MATH
MEM ARRAY
FORMAT
SMOOTH-ING
SCALE
FORMAT ARRAY
DISPLAY ARRAY
STIM & WINDOW ARRAY
TIME DOMAIN
DISPLAY GEN
LINE GEN
TO CRT 149

FIG 19

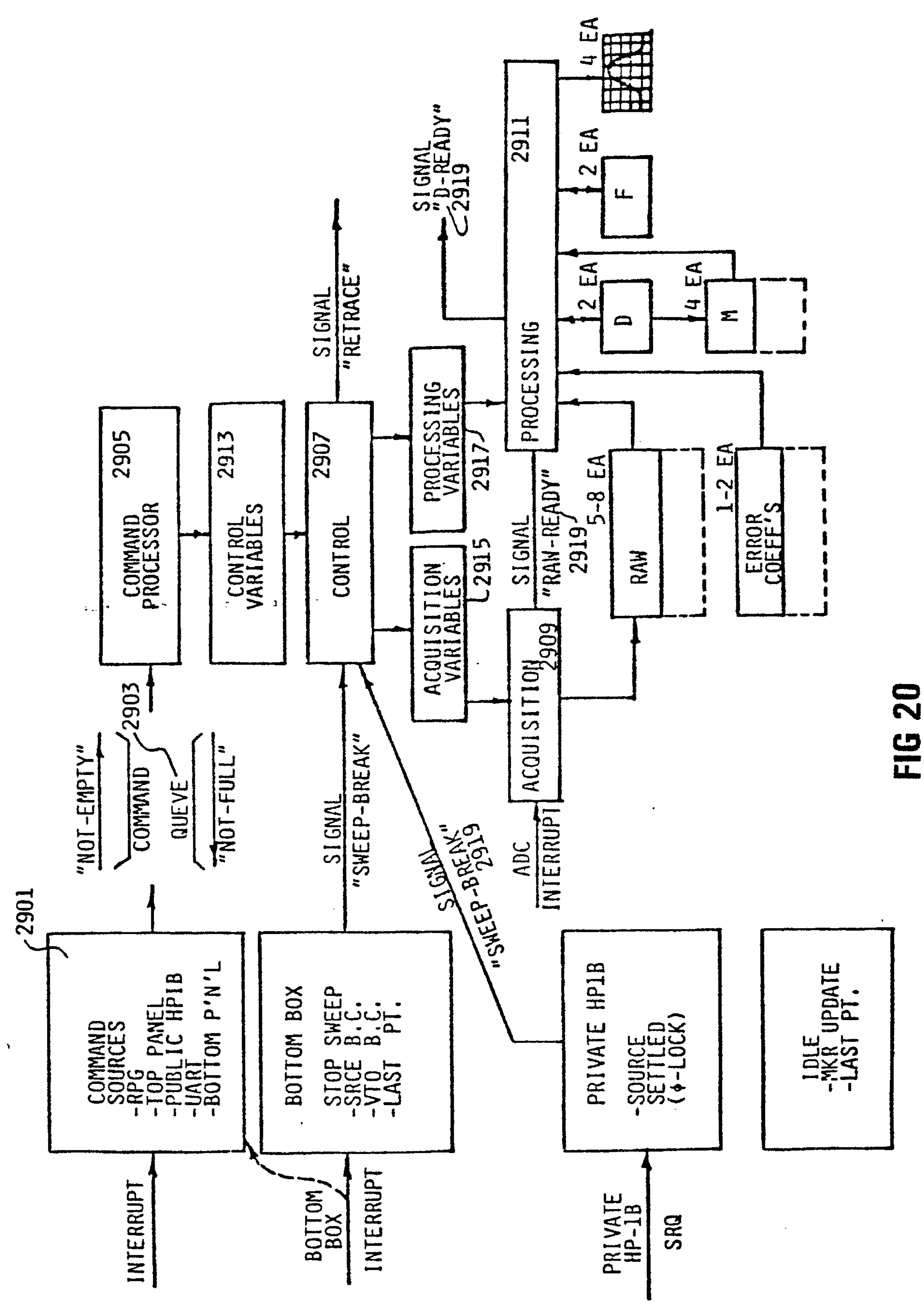
COMMAND SOURCES
-RPG
-TOP PANEL
-PUBLIC HPIB
-UART
-BOTTOM P'N'L
2901
INTERRUPT
BOTTOM BOX
STOP SWEEP
-SRCE B.C.
-VTO B.C.
-LAST PT.
BOTTOM BOX
INTERRUPT
PRIVATE HP1B
-SOURCE SETTLED (φ-LOCK)
PRIVATE HP-1B
SRQ
IDLE
-MKR UPDATE
-LAST PT.
"NOT-EMPTY"
COMMAND
QUEVE
"NOT-FULL"
2903
SIGNAL
"SWEEP-BREAK"
SIGNAL
"SWEEP-BREAK"
2919
ADC
INTERRUPT
COMMAND PROCESSOR
2905
CONTROL VARIABLES
2913
CONTROL
2907
SIGNAL
"RETRACE"
ACQUISITION VARIABLES
2915
PROCESSING VARIABLES
2917
ACQUISITION
2909
SIGNAL
"RAW-READY"
2919
PROCESSING
2911
SIGNAL
"D-READY"
2919
RAW
5-8 EA
ERROR COEFF'S
1-2 EA
D
2 EA
M
4 EA
F
2 EA
4 EA

FIG 20